# EUROPEAN PATENT APPLICATION

(11) **EP 4 635 960 A1**
(43) Date of publication of application: **22.10.2025**
(21) Application number: 23903593.4
(22) Date of filing: 15.12.2023
(51) Int. Cl.: C07F 5/02, C09K 11/06, H10K 50/12, H10K 59/10

(54) **POLYCYCLIC AROMATIC COMPOUND**

(30) Priority: 16.12.2022 JP 2022200762
(71) Applicant: Kyoto University, Kyoto-shi, Kyoto 606-8501 (JP); SK Materials JNC Co., Ltd., Gyeonggi-do, 18469 (KR)
(72) Inventor: HATAKEYAMA Takuji, Kyoto-shi, Kyoto 606-8501 (JP); MINAMI Ryo, Ichihara-shi, Chiba 290-8551 (JP); HIGASHI Makoto, Ichihara-shi, Chiba 290-8551 (JP); TANAKA Hiroyuki, Ichihara-shi, Chiba 290-8551 (JP); MIZUTANI Akihide, Ichihara-shi, Chiba 290-8551 (JP); BABA Daisuke, Ichihara-shi, Chiba 290-8551 (JP)
(74) Representative: Vossius & Partner Patentanwälte Rechtsanwälte mbB
(86) International application number: PCT/JP2023/045035
(87) International publication number: WO 2024/128314

(57) **Abstract**

A polycyclic aromatic compound having a structure represented by Formula (1) is useful as a material for an organic device such as an organic EL element. 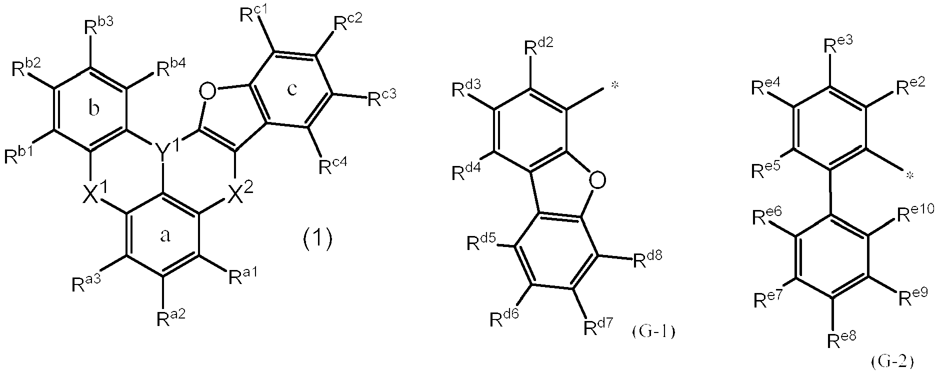 R^{a1} to R^{a3}, R^{b1} to R^{b4}, and R^{c1} to R^{c4} are each hydrogen or a substituent, at least one of R^{c1} to R^{c4} is a substituted or unsubstituted aryl, Y¹ is B, at least one selected from the group consisting of X¹ and X² is >N-R^{NX} having R^{NX} that is a group represented by Formula (G-1) or Formula (G-2), and the rest of X¹ and X² is >N-Ar (Ar is an aryl or the like) or the like, R^{d2} to R^{d8} and R^{e2} to R^{e10} are each hydrogen or a substituent, at least one selected from the group consisting of R^{e5} to R^{e10} is an alkyl, cycloalkyl or aryl, or any aryl ring in Formula (G-2) is condensed with at least one cycloalkane.

## Description

### Technical Field

The present invention relates to a polycyclic aromatic compound. The present invention relates particularly to polycyclic aromatic compounds containing nitrogen and boron. The present invention also relates to a material for an organic device, an organic electroluminescent element, a display device, and a lighting device in which the polycyclic aromatic compound is used.

### Background Art

Heretofore, a display device using an electroluminescent light-emitting device enables power-saving and thinning, and is variously studied, and further, an organic electroluminescent element using an organic material can be readily made lighter and large-sized and is therefore actively investigated. In particular, for development of an organic material having a light-emitting characteristic of emitting a blue color, one of light's three primary colors, as well as development of an organic material having a charge transport performance for holes and electrons (which leads to development of semiconductors and superconductors), various studies have heretofore been actively made irrespective of high-molecular compounds and low-molecular compounds.

An organic electroluminescent element has a structure that contains a pair of electrodes of an anode and a cathode, and one or multiple layers containing an organic compound arranged between the pair of electrodes. The organic compound-containing layer includes a light-emitting layer, and a charge transport/injection layer that transport or inject charges such as holes or electrons, and various types of organic materials suitable for these layers have been developed.

Among them, Patent Document 1 discloses that a polycyclic aromatic compound containing boron is useful as a material for an organic electroluminescent element or the like. Patent Document 1 reports that an organic electroluminescent element containing these polycyclic aromatic compounds have good external quantum efficiency. Patent documents 2-4 disclose polycyclic aromatic compounds containing boron fused with heterocycles such as benzofuran.

### Citation List

### Patent Literature

Patent literature No. 1: WO2015/102118A
Patent literature No. 2: U.S. Patent Application Publication No.2022/0310924 Specification
Patent literature No. 3: WO2021/107743A
Patent literature No. 4: WO2022/191570A

### Summary of Invention

### Technical Problem

As described above, various materials have been developed as materials used in an organic EL element, but to increase the choice of a material for an organic EL element, development of a material made of a compound is desired.

It is an object of the present invention to provide a novel compound useful as a material for an organic device such as an organic EL element.

### Solution to Problem

The present inventors have intensively studied to solve the above problems and have succeeded in producing a new polycyclic aromatic compound having superior light-emitting characteristics as a polycyclic aromatic compound having a similar structure to the compounds described in Patent literatures 1 to 4. Further, it has been found that an excellent organic EL element can be obtained by arranging a layer containing this polycyclic aromatic compound between a pair of electrodes to constitute an organic EL element, thereby completing the present invention. In other words, the present invention provides a polycyclic aromatic compound as described below and further a material for an organic device or the like containing a polycyclic aromatic compound as described below.

The present invention specifically comprises the following configuration.
<1> A polycyclic aromatic compound having a structure consisting of one or two or more structural units represented by Formula (1); 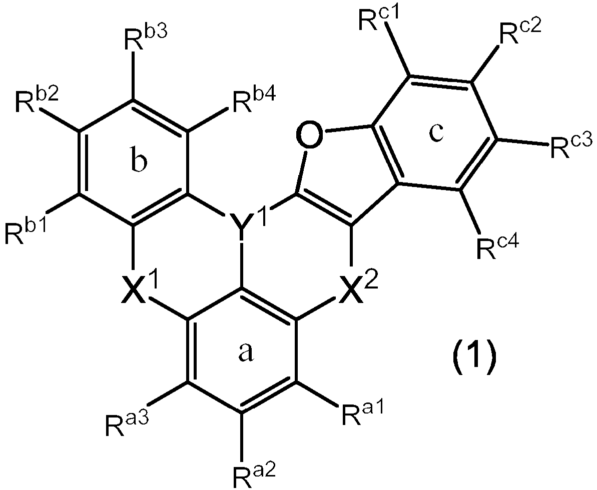 in Formula (1),
   R^{a1} to R^{a3}, R^{b1} to R^{b4}, and R^{c1} to R^{c4} are each independently hydrogen or a substituent,
   any two adjacent groups of R^{a1} to R^{a3}, R^{b1} to R^{b4}, and R^{c1} to R^{c4} may be bonded to each other to form a substituted or unsubstituted aryl ring or a substituted or unsubstituted heteroaryl ring together with the two carbon atoms to which they are bonded,
   provided that at least one of R^{c1} to R^{c4} is a substituted or unsubstituted aryl or a substituted or unsubstituted heteroaryl,
   Y¹ is B, P, P=O, P=S, Al, Ga, As, Si-R, or Ge-R, and R in the Si-R and the Ge-R is a substituted or unsubstituted aryl, a substituted or unsubstituted heteroaryl, a substituted or unsubstituted alkyl, or a substituted or unsubstituted cycloalkyl;
   X¹ and X² are each independently >O, >N-R^{NX}, >C(-R^{CX})₂, >Si(-R^{IX})₂, >S, or >Se, R^{NX} is hydrogen, a substituted or unsubstituted aryl, a substituted or unsubstituted heteroaryl, a substituted or unsubstituted alkyl, or a substituted or unsubstituted cycloalkyl, R^{CX} are each independently hydrogen, a substituted or unsubstituted aryl, a substituted or unsubstituted heteroaryl, a substituted or unsubstituted alkyl, or a substituted or unsubstituted cycloalkyl, the two R^{CX} may form a ring by bonding to each other, R^{IX} are each independently hydrogen, a substituted or unsubstituted aryl, a substituted or unsubstituted heteroaryl, a substituted or unsubstituted alkyl, or a substituted or unsubstituted cycloalkyl, the two R^{IX} may form a ring by bonding to each other, and R^{NX} and/or R^{CX} may be bonded to R^{a3} and/or R^{b1}, or R^{a1} and/or R^{c4} via a linking group or single bond,
   provided that at least one selected from the group consisting of X¹ and X² is >N-R^{NX} having R^{NX} that is a group represented by Formula (G-1) or Formula (G-2), 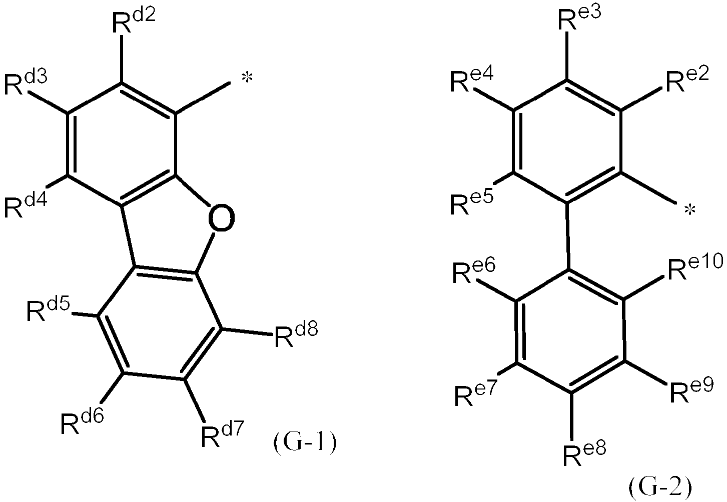
      in Formula (G-1),
         R^{d2} to R^{d8} are each independently hydrogen or a substituent,
         any two adjacent groups of R^{d2} to R^{d8} may be bonded to each other to form a substituted or unsubstituted aryl ring or a substituted or unsubstituted heteroaryl ring together with the two carbon atoms to which they are bonded,
         * indicates a bonding position with the nitrogen atom,
      in Formula (G-2),
         R^{e2} to R^{e10} are each independently hydrogen or a substituent,
         provided that at least one selected from the group consisting of R^{e6} to R^{e10} is a substituent selected from the group consisting of an alkyl, a cycloalkyl that may be substituted with at least one alkyl, and an aryl that may be substituted with at least one alkyl or an optionally alkyl-substituted cycloalkyl, or at least one of the aryl rings or heteroaryl rings in Formula (G-2) is condensed with at least one cycloalkane, at least one hydrogen in the cycloalkane may be replaced with a substituent, and at least one -CH₂- in the cycloalkane may be replaced with -O-,
         * indicates a bonding position with the nitrogen atom,
         at least one of the aryl rings or heteroaryl rings in said structure may be condensed with at least one cycloalkane, at least one hydrogen in the cycloalkane may be replaced with a substituent, and at least one -CH₂- in the cycloalkane may be replaced with -O-,
         in said structure, at least one hydrogen may be replaced with deuterium, at least one nitrogen may be replaced with nitrogen-15 (¹⁵N), at least one sulfur may be replaced with sulfur-33 (³³S), sulfur-34 (³⁴S), or sulfur-36 (³⁶S), at least one oxygen may be replaced with oxygen-17 (¹⁷O) or oxygen-18 (¹⁸O), at least one carbon may be replaced with carbon-13 (¹³C), and at least one boron may be replaced with boron-11 (¹¹B).
<2> The polycyclic aromatic compound according to <1>, wherein any aryl ring or heteroaryl ring in R^{c1} to R^{c4} is not condensed with the cycloalkane.
<3> The polycyclic aromatic compound according to <1> or <2>, wherein R^{c3} is an aryl that may be substituted with an alkyl, and each of R^{c1}, R^{c2}, and R^{c4} is hydrogen.
<4> The polycyclic aromatic compound according to <3>, wherein R^{c3} is phenyl that may be substituted with t-butyl.
<5> The polycyclic aromatic compound according to<1> having a structure consisting of one structural unit represented by Formula (1), wherein
   Y¹ is B,
   R^{a1}, R^{a3}, R^{b1}, R^{b4}, R^{c1}, and R^{c4} are each hydrogen,
   R^{a2} is hydrogen, an unsubstituted alkyl, a cycloalkyl which may be substituted with methyl, an aryl which may be substituted with an alkyl or a cycloalkyl that may be substituted with methyl, a heteroaryl which may be substituted with an alkyl or a cycloalkyl that may be substituted with methyl, a diarylamino which may be substituted with an alkyl or a cycloalkyl that may be substituted with methyl, an arylheteroarylamino which may be substituted with an alkyl or a cycloalkyl that may be substituted with methyl, or a carbazolyl which may be substituted with an alkyl or a cycloalkyl that may be substituted with methyl,
   R^{b2} and R^{b3} are each independently hydrogen, an unsubstituted alkyl, a cycloalkyl which may be substituted with methyl, an aryl which may be substituted with an alkyl or a cycloalkyl that may be substituted with methyl, a heteroaryl which may be substituted with an alkyl or a cycloalkyl that may be substituted with methyl, a diarylamino which may be substituted with an alkyl or a cycloalkyl that may be substituted with methyl, an arylheteroarylamino which may be substituted with an alkyl or a cycloalkyl that may be substituted with methyl, or a carbazolyl which may be substituted with an alkyl or a cycloalkyl that may be substituted with methyl,
   one of R^{c2} and R^{c3} is an aryl which may be substituted with an alkyl, and the other is hydrogen or an aryl which may be substituted with an alkyl,
   X¹ and X² are each independently >N-R^{NX},
   R^{NX} that is not a group represented by Formula (G-1) or Formula (G-2), if present, is an aryl which may be substituted with an alkyl or a cycloalkyl that may be substituted with an alkyl (excluding a group represented by Formula (G-2)), or a heteroaryl which may be substituted with an alkyl or a cycloalkyl that may be substituted with an alkyl (excluding a group represented by Formula (G-1)),

   in Formula (G-1),
      R^{d2} to R^{d8} are each independently hydrogen, an unsubstituted alkyl, a cycloalkyl which may be substituted with methyl, an aryl which may be substituted with an alkyl or a cycloalkyl that may be substituted with methyl, or a heteroaryl which may be substituted with an alkyl or a cycloalkyl that may be substituted with methyl,
      any two adjacent groups of R^{d2} to R^{d8} may be bonded to each other to form benzene ring together with the two carbon atoms to which they are bonded, the benzene ring may be substituted with an unsubstituted alkyl, a cycloalkyl which may be substituted with methyl, an aryl which may be substituted with an alkyl or a cycloalkyl that may be substituted with methyl, or a heteroaryl which may be substituted with an alkyl or a cycloalkyl that may be substituted with methyl,
   in Formula (G-2),
      at least one selected from the group consisting of R^{e6} to R^{e10} is an unsubstituted alkyl, a cycloalkyl which may be substituted with methyl, or an aryl which may be substituted with an alkyl or a cycloalkyl that may be substituted with methyl, or any two adjacent groups of R^{e2} to R^{e10} are bonded to each other to form a partial structure represented by Formula (B-1) or Formula (B-2),
      at least one of aryl rings or heteroaryl rings in Formula (1) other than c ring may have Formula (B-1) or Formula (B-2) as a substituent, 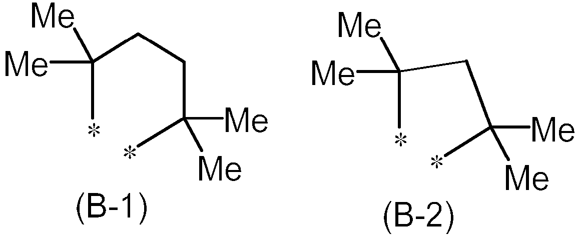
      in Formula (B-1) or Formula (B-2), * indicates a position bonding to each of the adjacent ring constituting atoms,
      at least one hydrogen in said structure may be replaced with deuterium.
<6> The polycyclic aromatic compound according to any one of <1> to <5>. wherein
   at least one selected from the group consisting of X¹ and X² is >N-R^{NX} having R^{NX} that is a group represented by Formula (G-1), and
   said structure does not contain >N-R^{NX} having R^{NX} that is a group represented by Formula (G-2) as X¹ or X².
<7> The polycyclic aromatic compound according to <6>, which is represented by any one of the following formulas; 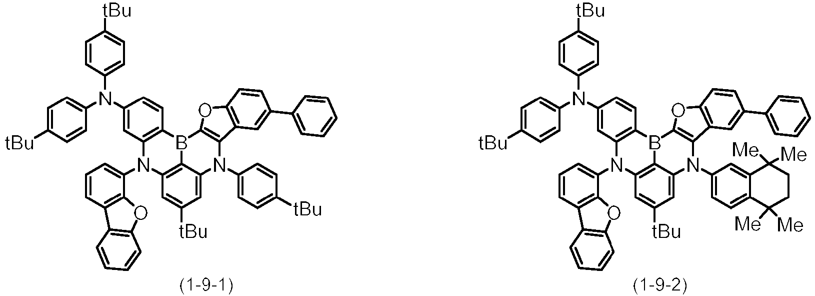 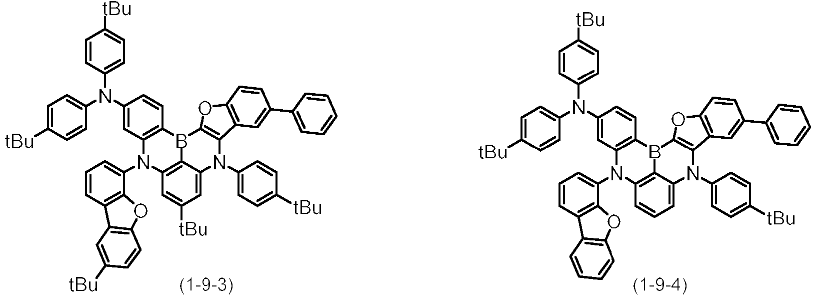 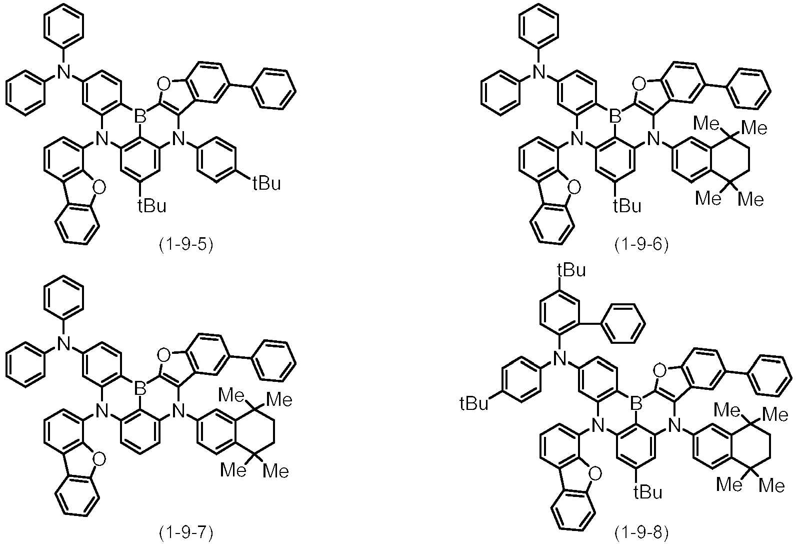 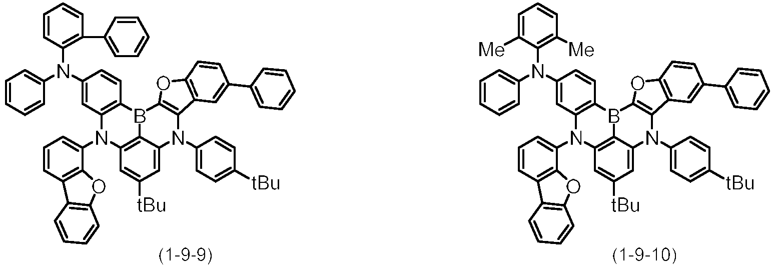 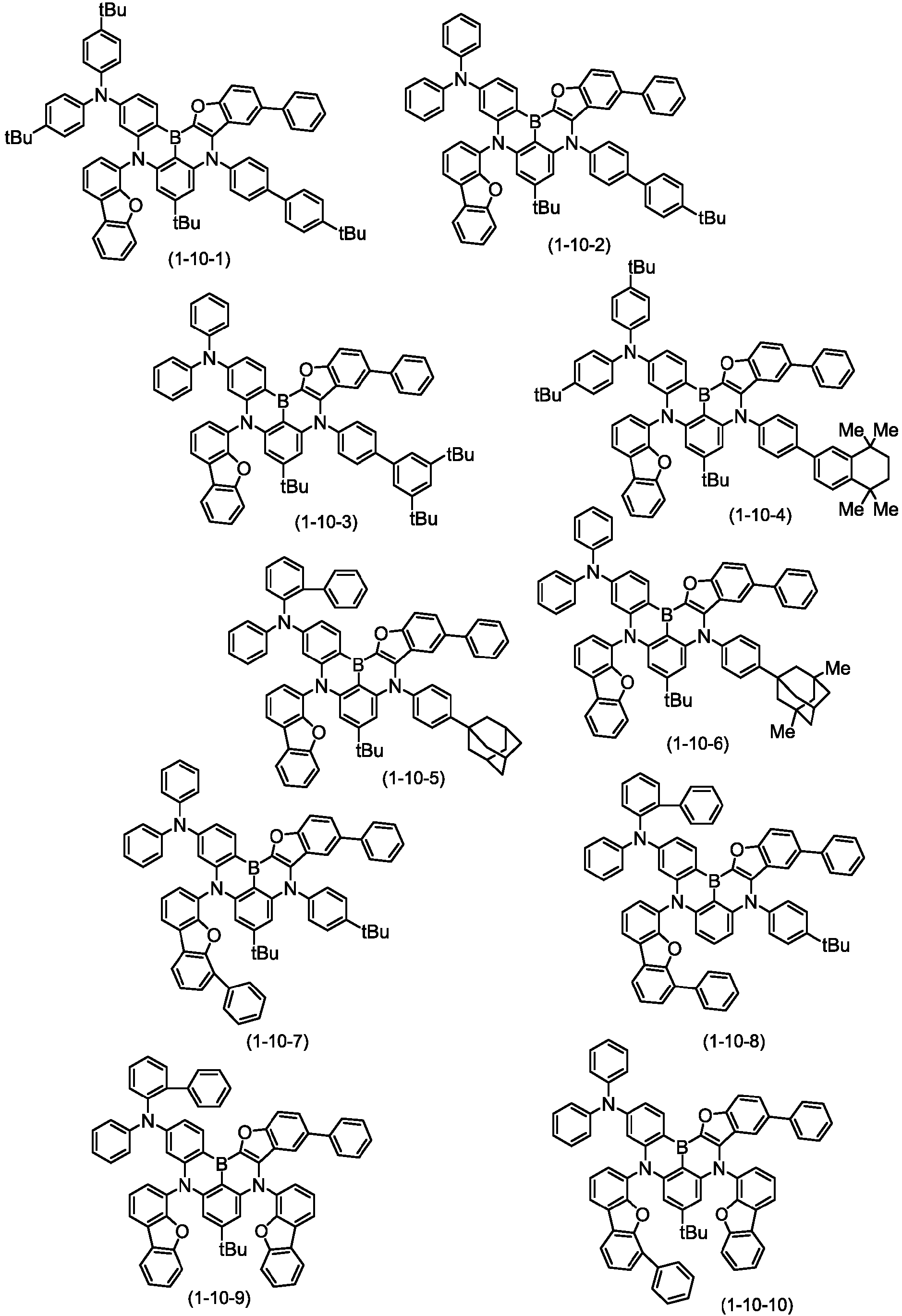 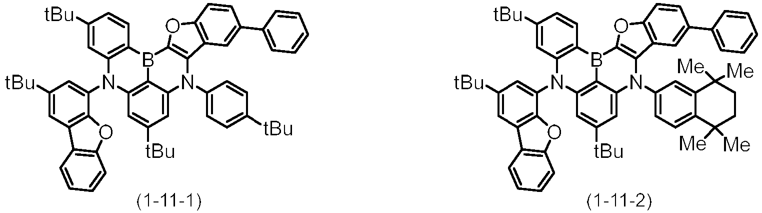 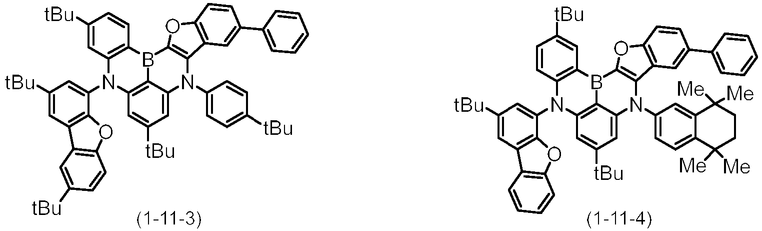 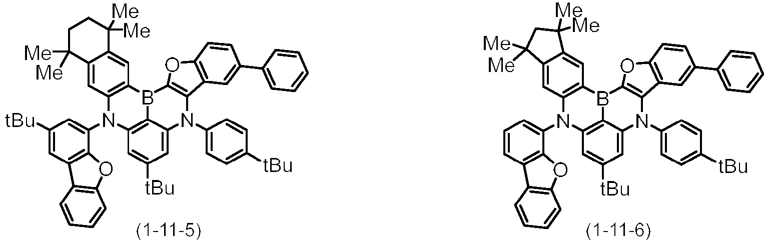 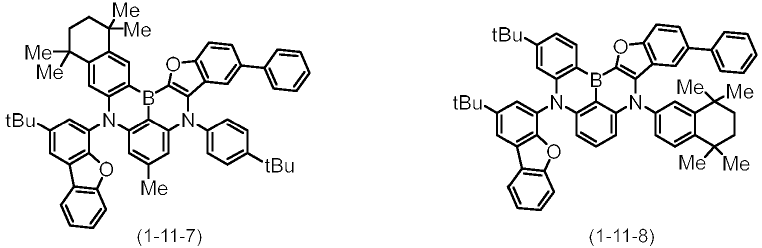 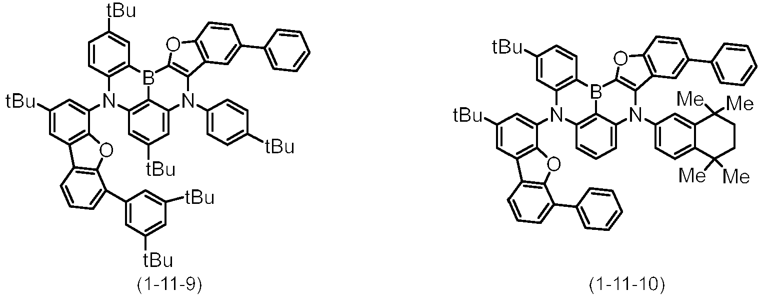 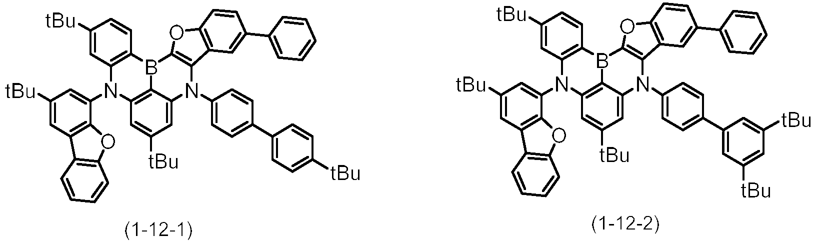 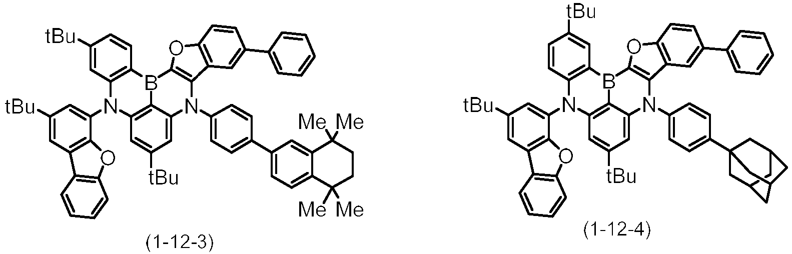 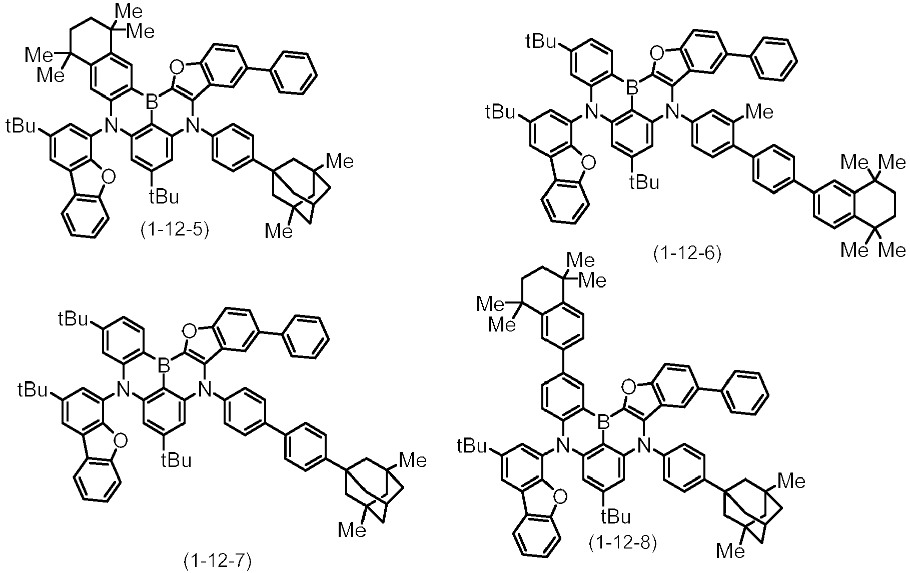 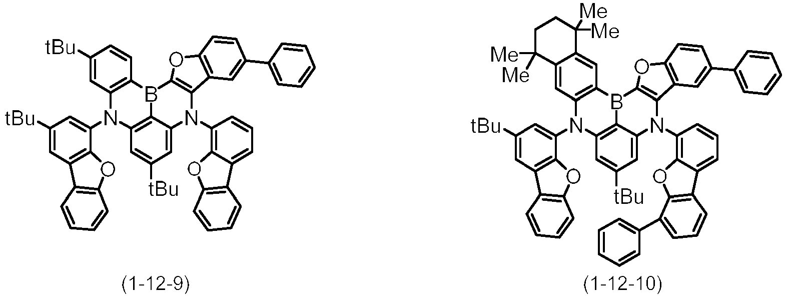 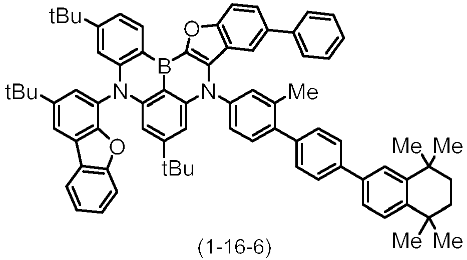 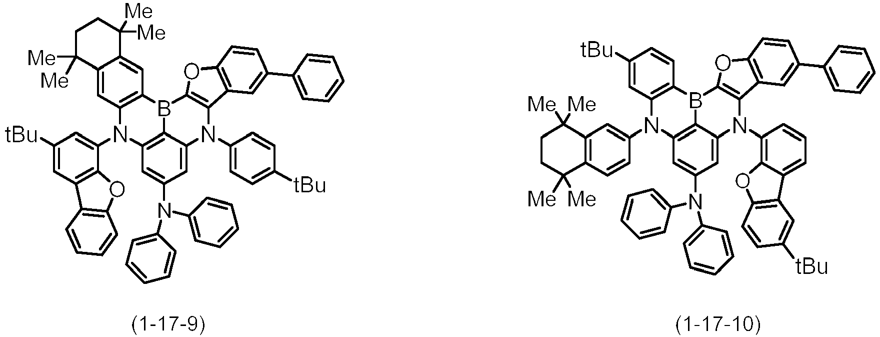 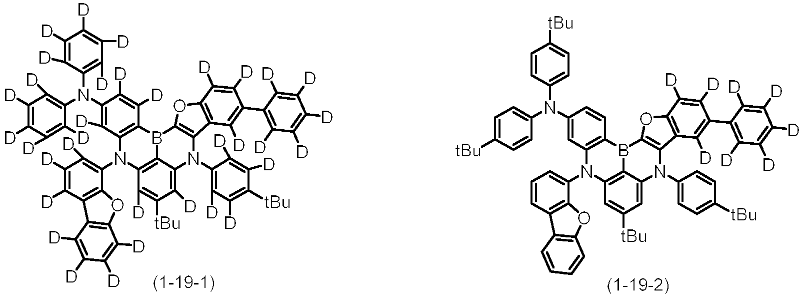 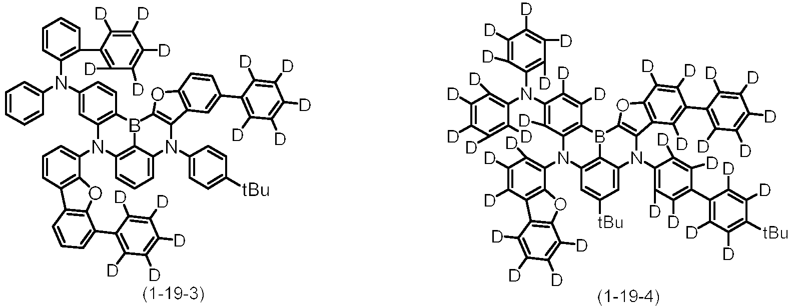 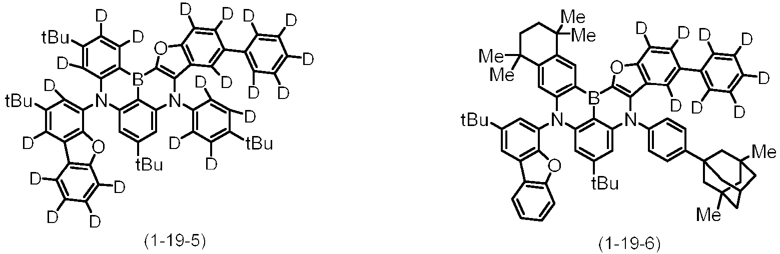 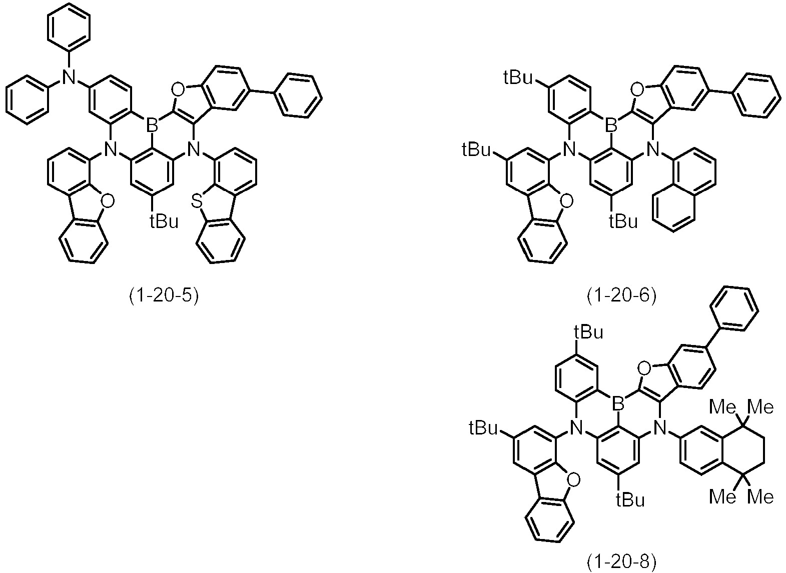 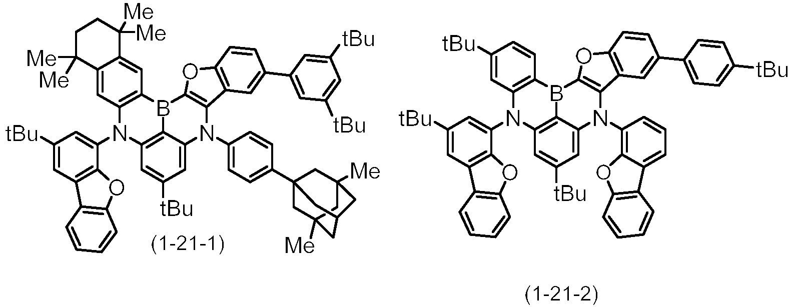 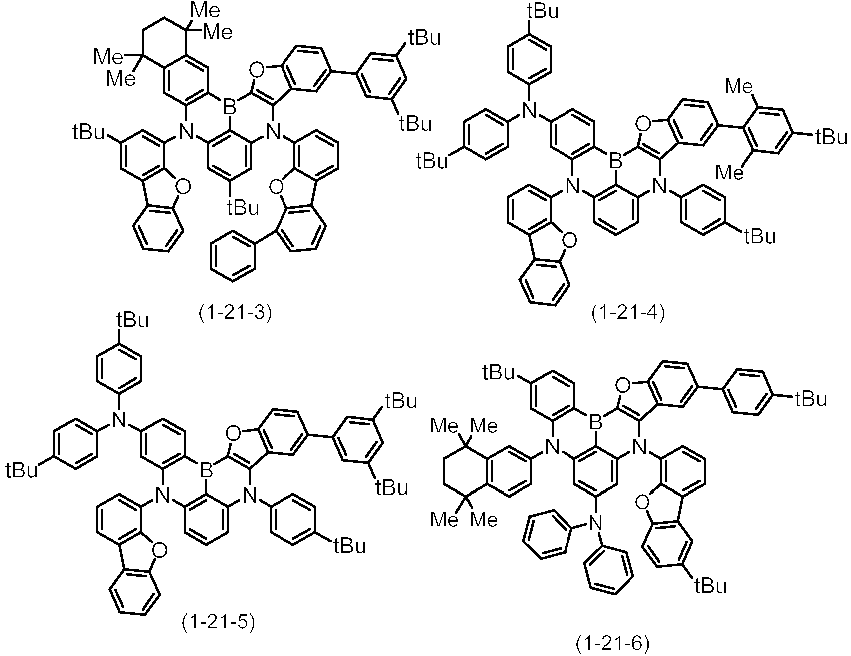 wherein Me is methyl, tBu is t-butyl, and D is deuterium.
<8> The polycyclic aromatic compound according to <7>, which is represented by Formula (1-9-2), Formula (1-9-5), Formula (1-9-9), Formula (1-11-8), Formula (1-17-10), Formula (1-19-1), Formula (1-19-3), Formula (1-21-1), or Formula (1-21-4).
<9> The polycyclic aromatic compound according to any one of <1> to <5>, wherein
   at least one selected from the group consisting of X¹ and X² is >N-R^{NX} having R^{NX} that is a group represented by Formula (G-2), and
   the structure does not contain >N-R^{NX} having R^{NX} that is a group represented by Formula (G-1) as X¹ or X².
<10> The polycyclic aromatic compound according to <9>, which is represented by any one of the following formulas; 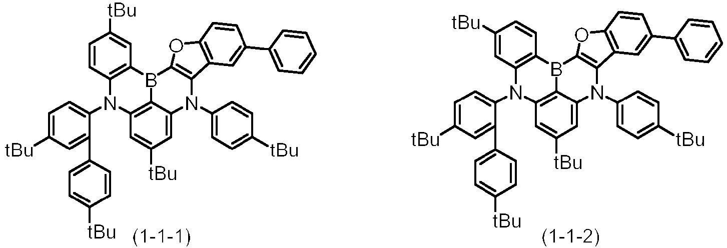 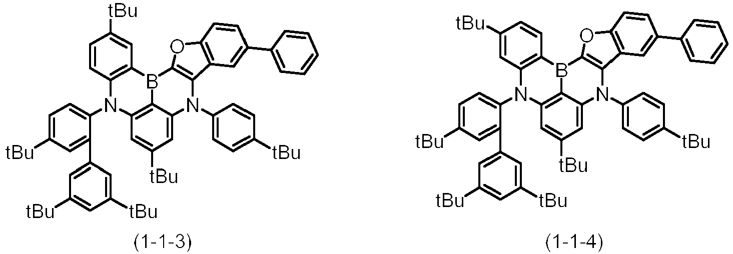 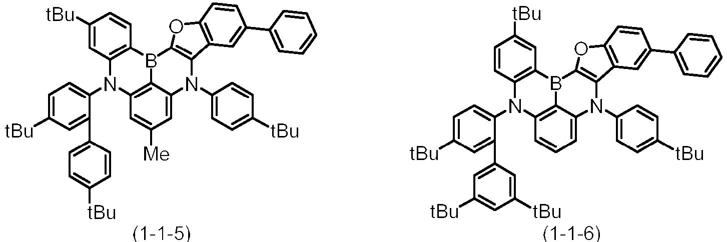 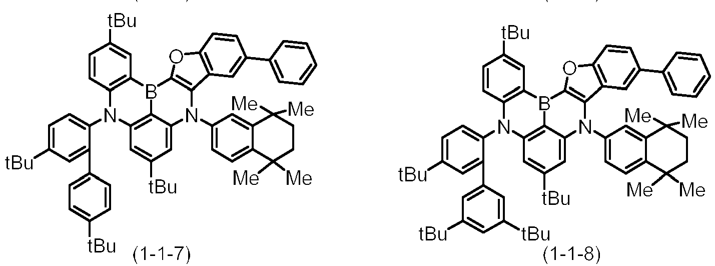 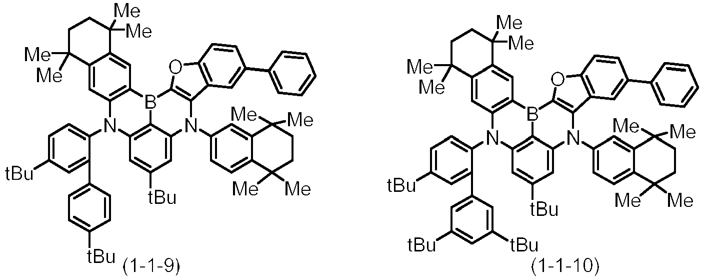 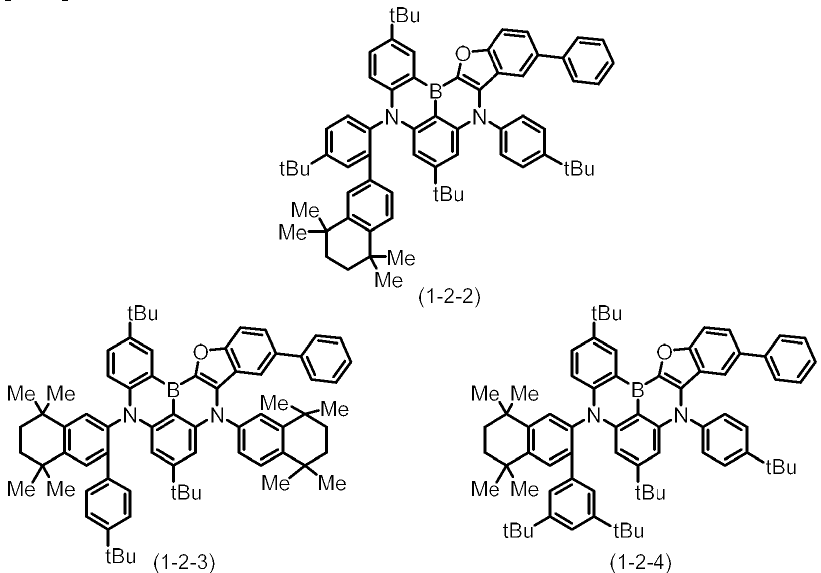 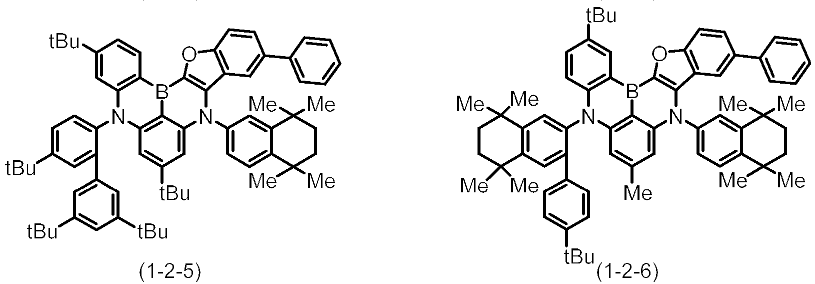 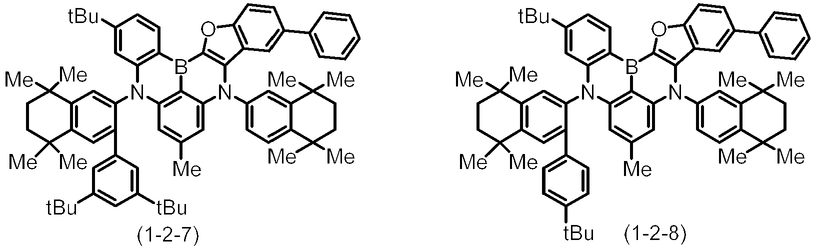 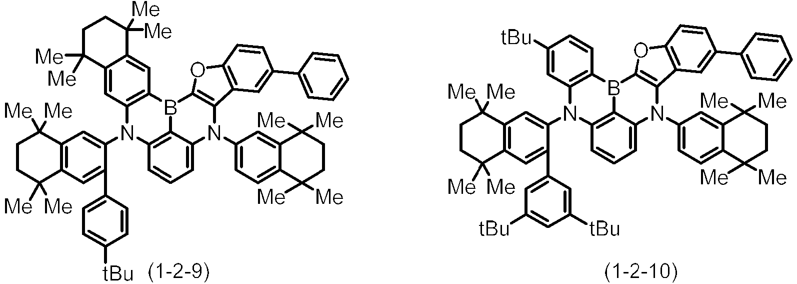 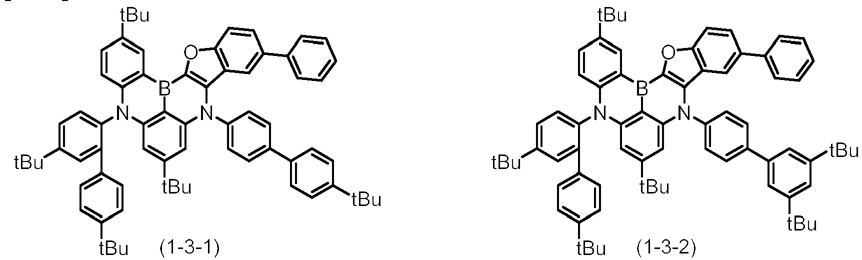 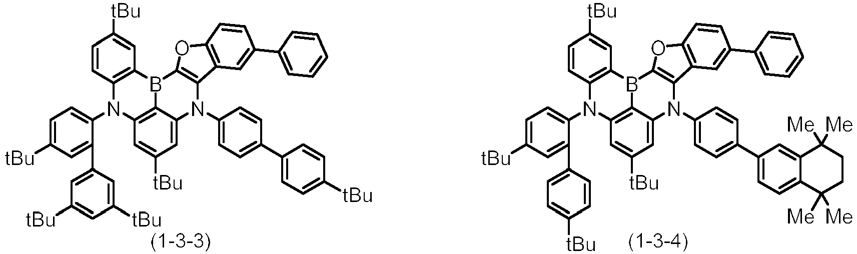 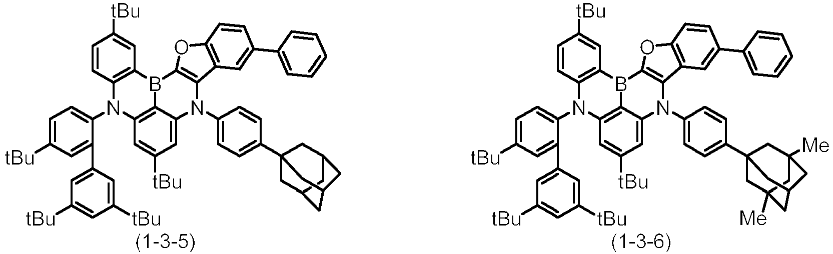 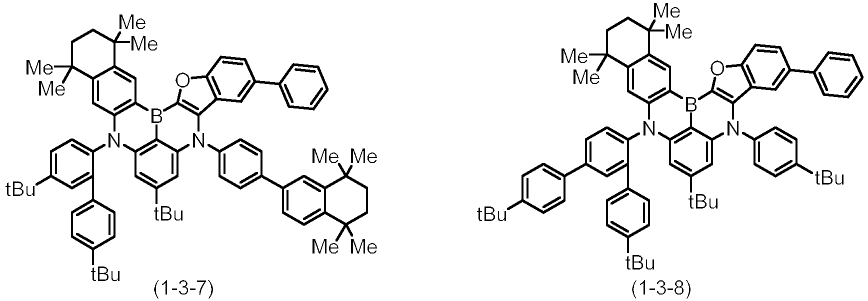 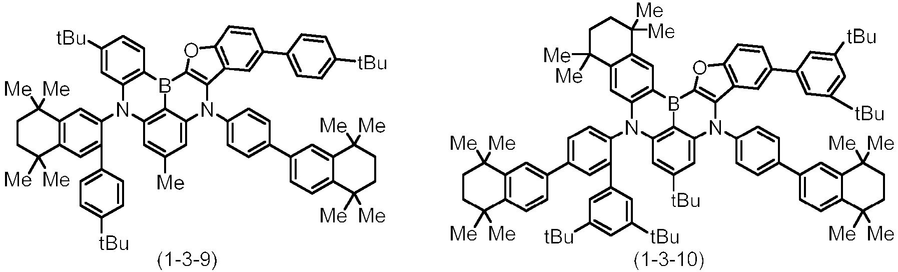 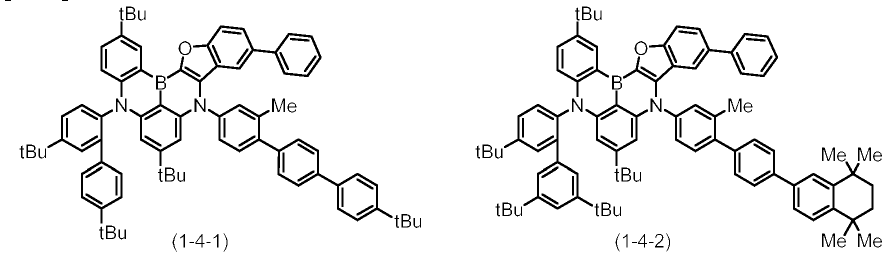 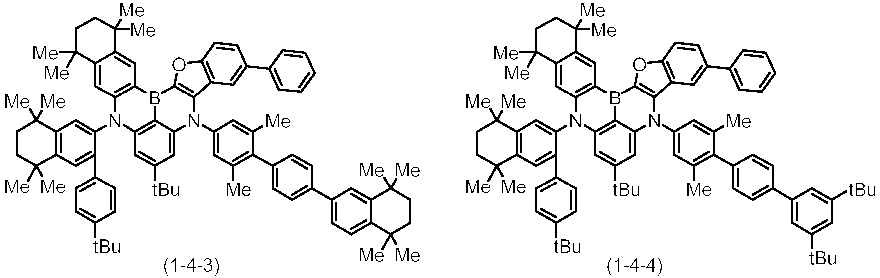 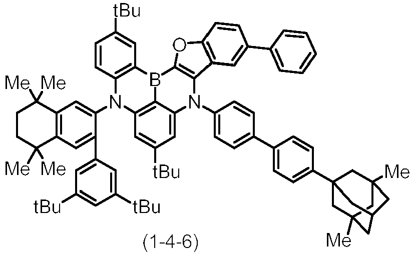 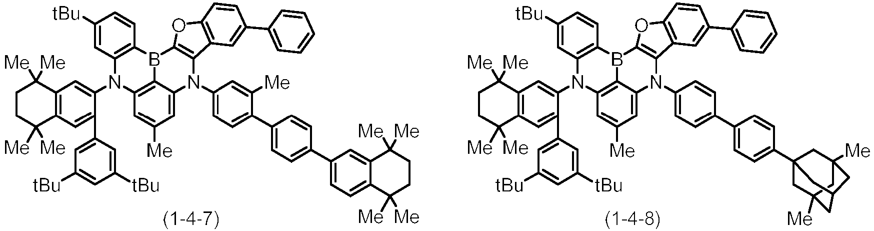 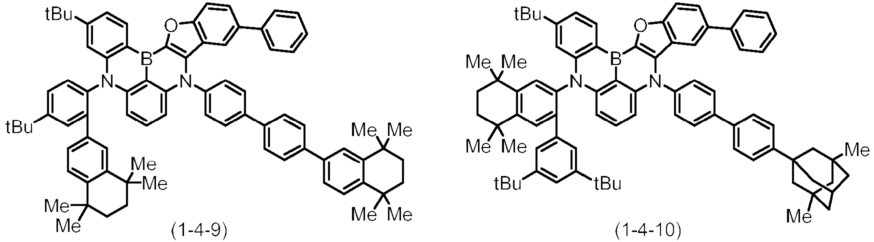 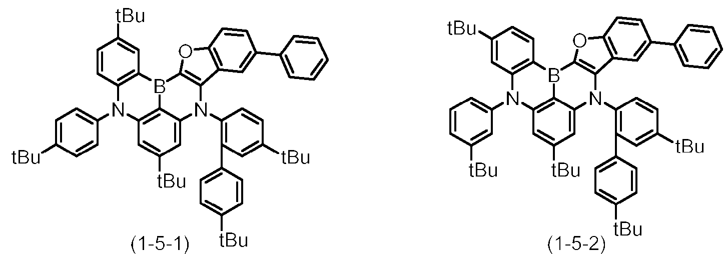 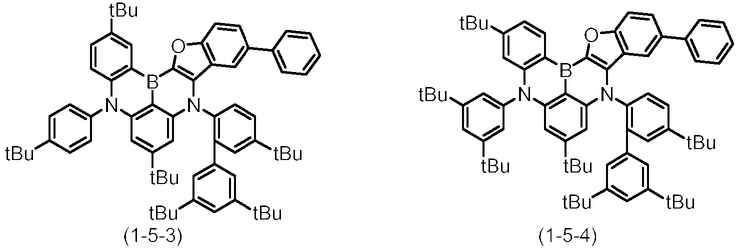 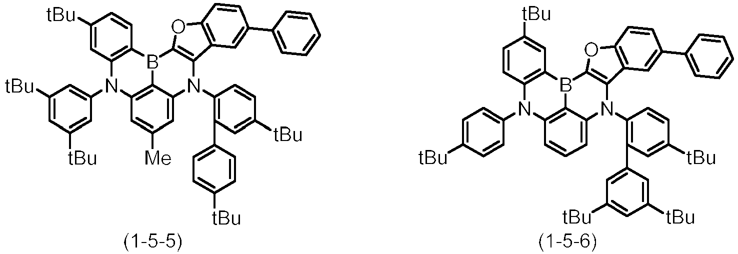 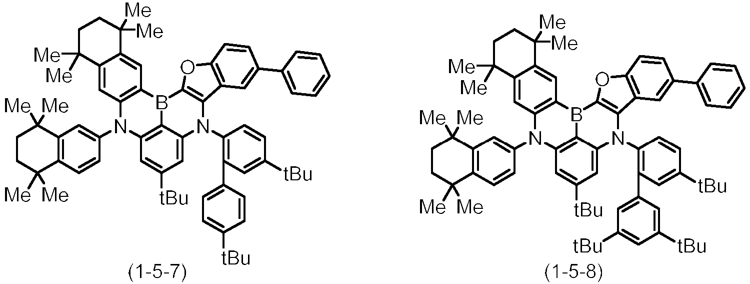 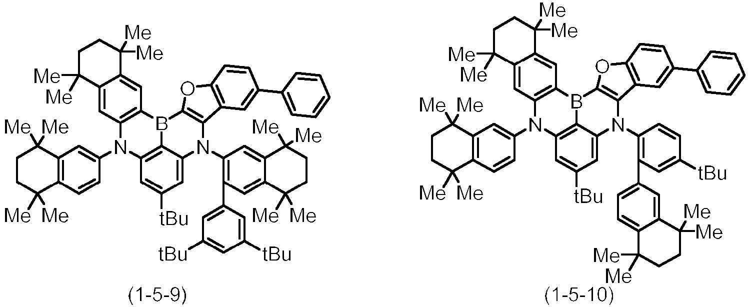 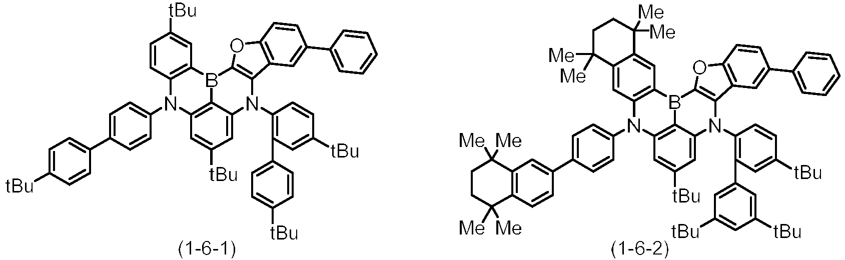 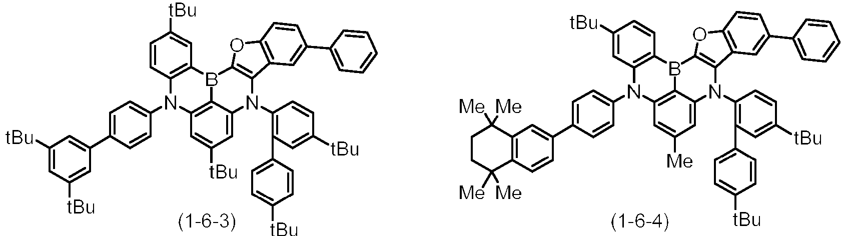 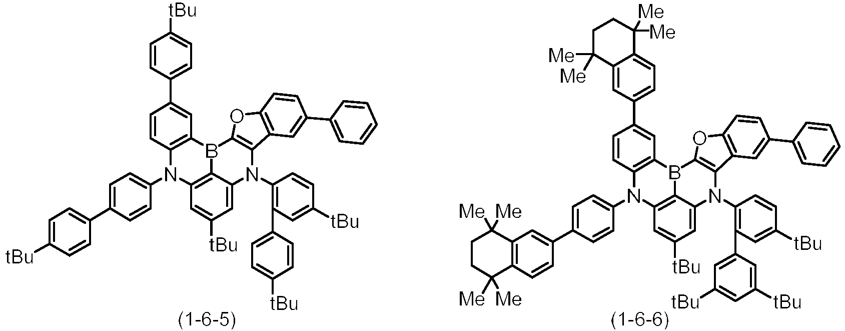 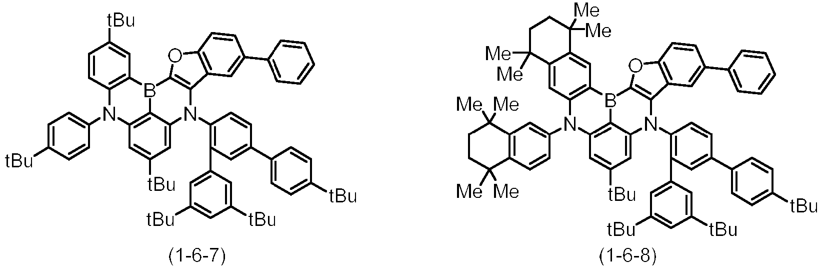 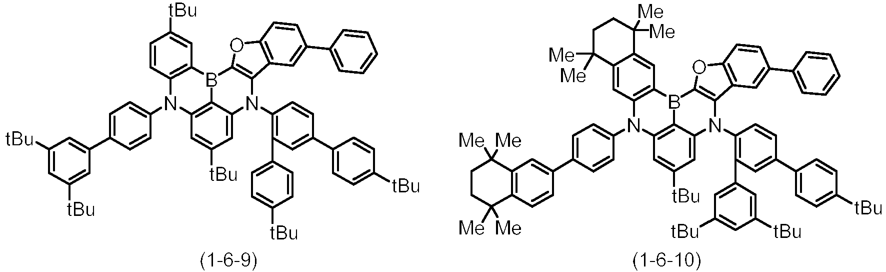 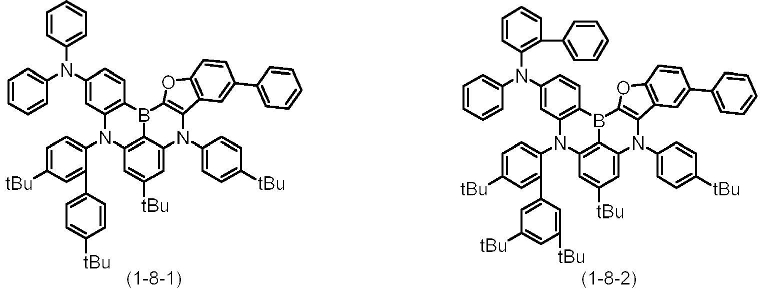 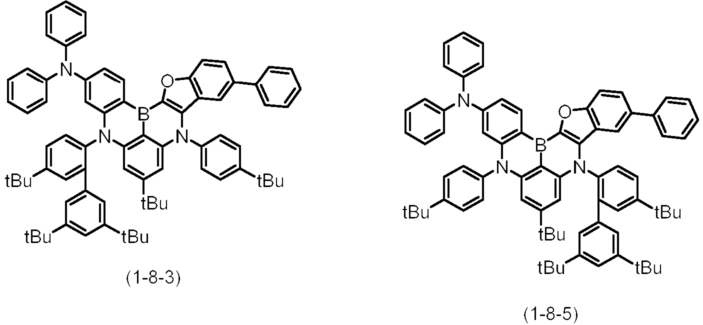 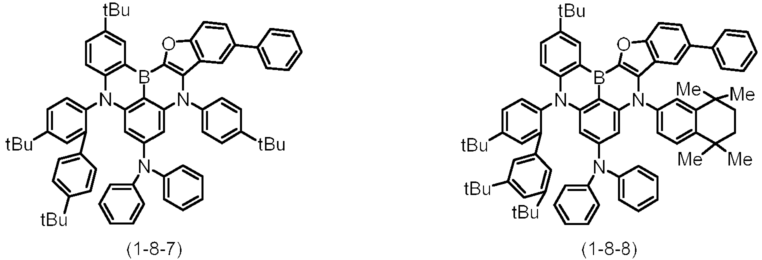 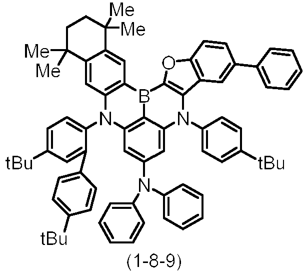 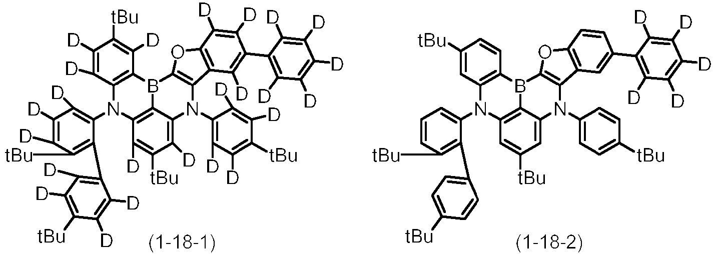 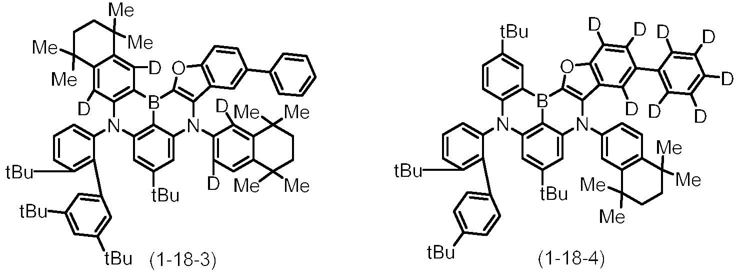 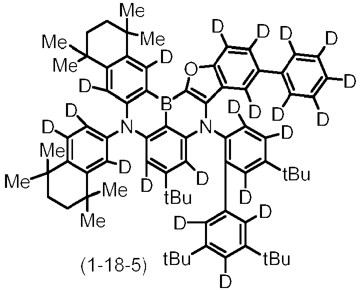 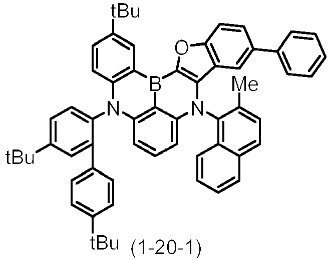 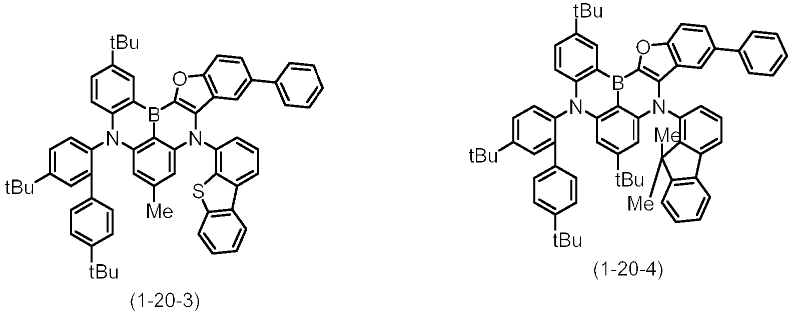 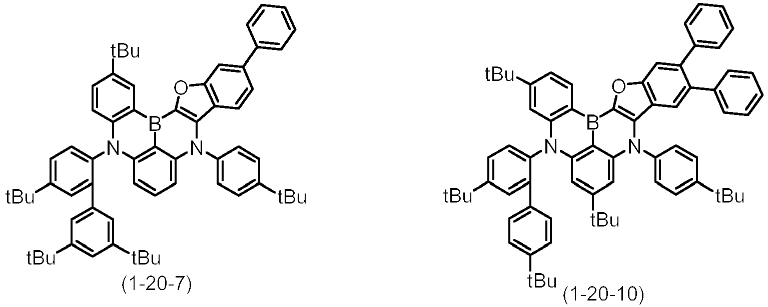 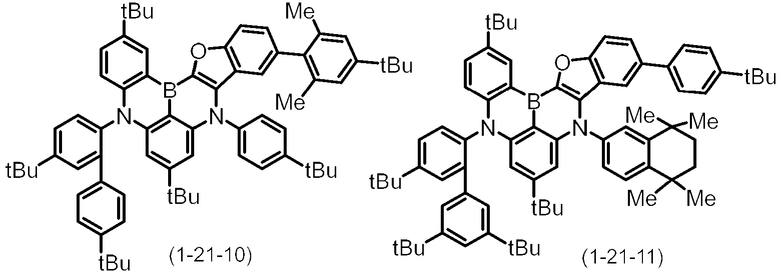 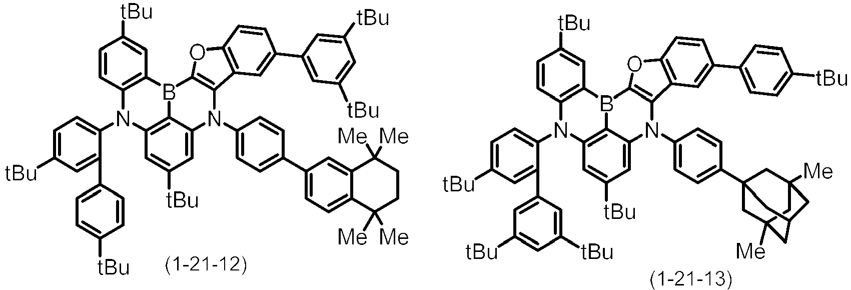 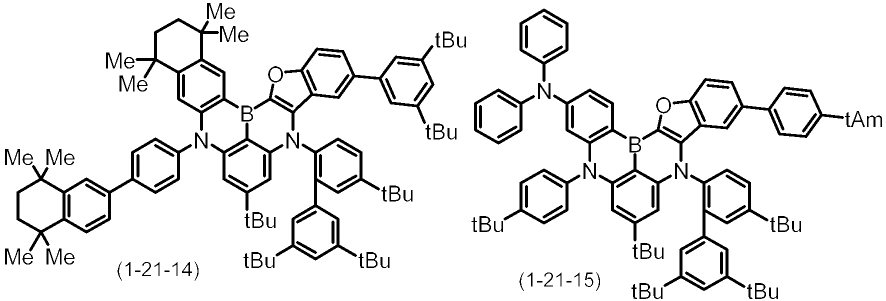 wherein Me is methyl, tBu is t-butyl, tAm is t-amyl, and D is deuterium.
<11> The polycyclic aromatic compound according to <11>, which is represented by Formula(1-1-1), Formula (1-1-3), Formula (1-1-5), Formula (1-1-10), Formula (1-2-7), Formula (1-3-4), Formula (1-3-6), Formula (1-3-9), Formula (1-3-10), Formula (1-4-2), Formula (1-5-8), Formula (1-6-2), Formula (1-6-6), Formula (1-6-10), Formula (1-8-2), Formula (1-16-6), Formula (1-20-1), Formula (1-20-3), Formula (1-20-4), Formula (1-20-7), Formula (1-20-10), Formula (1-21-12), or Formula(1-21-15).
<12> The polycyclic aromatic compound according to <1o>, which is represented by Formula (1-1-1) or Formula (1-20-10).
<13> The polycyclic aromatic compound according to any one of <1> to <5>, wherein one of X¹ and X² is >N-R^{NX} having R^{NX} that is a group represented by Formula (G-1), and the other is >N-R^{NX} having R^{NX} that is a group represented by Formula (G-2).
<14> The polycyclic aromatic compound according to <13>, which is represented by any one of the following formulas; 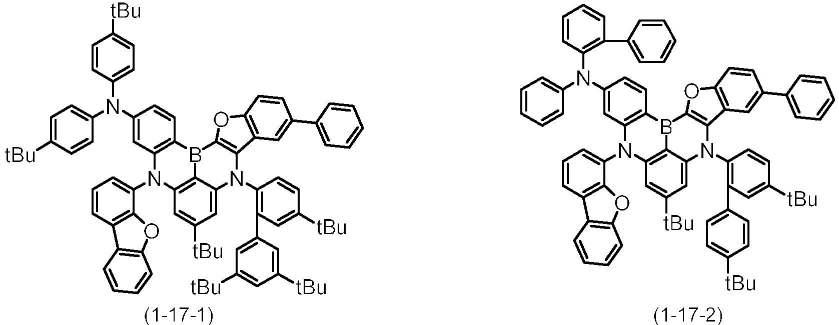 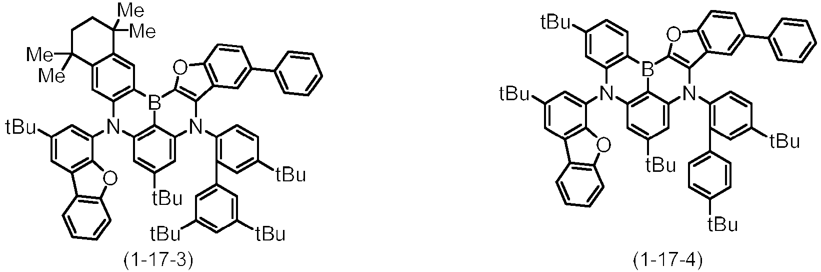 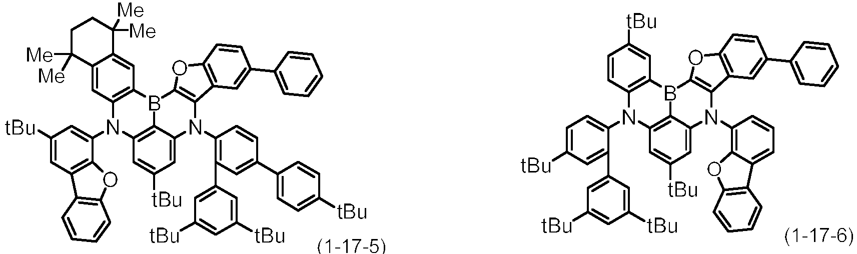 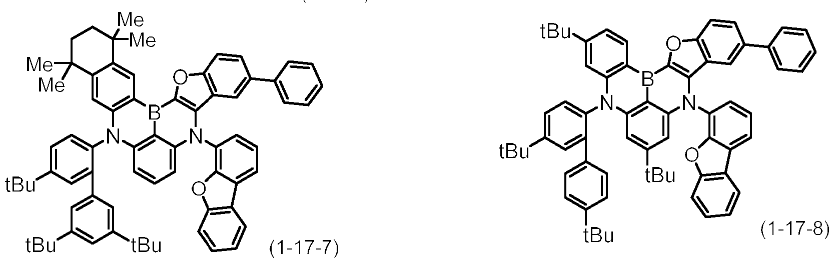 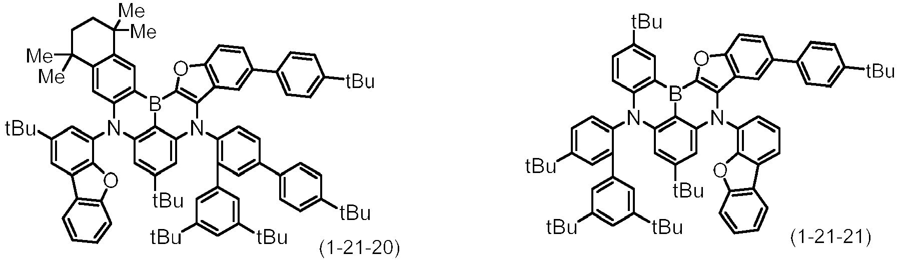 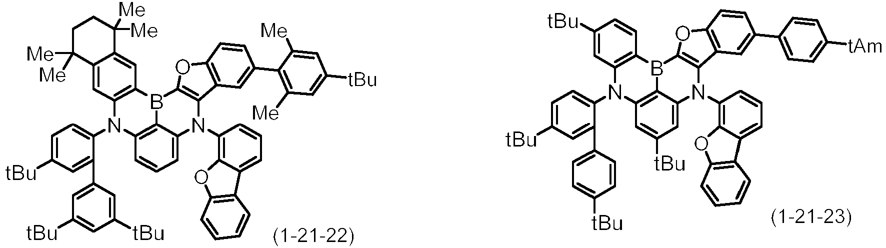 wherein Me is methyl, tBu is t-butyl, tAm is t-amyl, and D is deuterium.
<15> The polycyclic aromatic compound according to <14>, which is represented by Formula (1-17-1), Formula (1-17-3), Formula (1-17-5), or Formula (1-21-23).
<16> The polycyclic aromatic compound according to <6>, which is represented by any one of the following formulas; 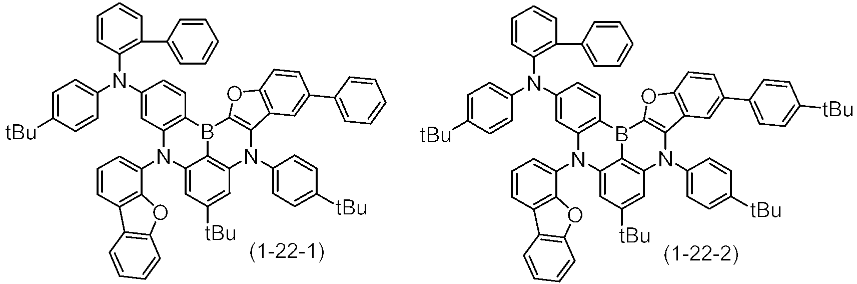 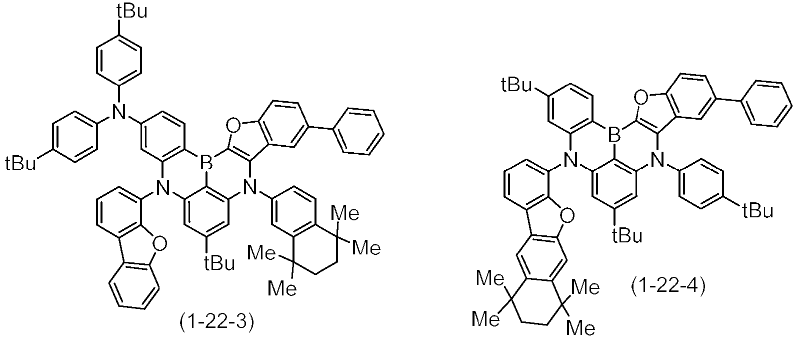 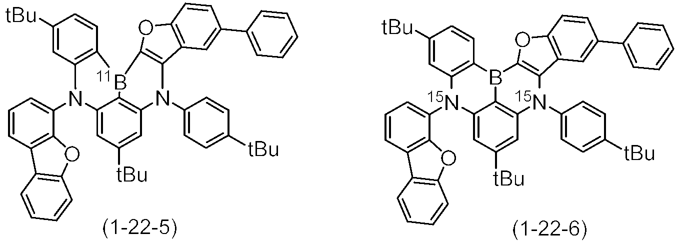 wherein Me is methyl, tBu is t-butyl.
<17> The polycyclic aromatic compound according to <1>, which is represented by any one of the following formulas; 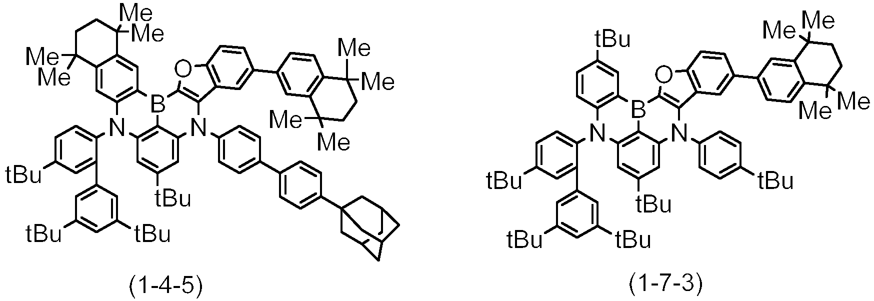 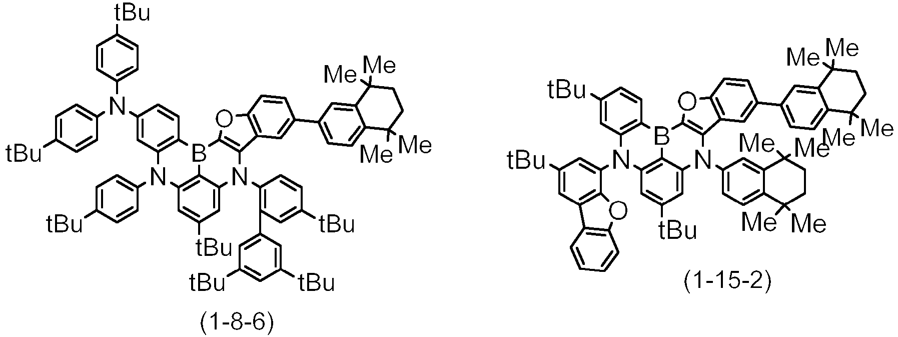 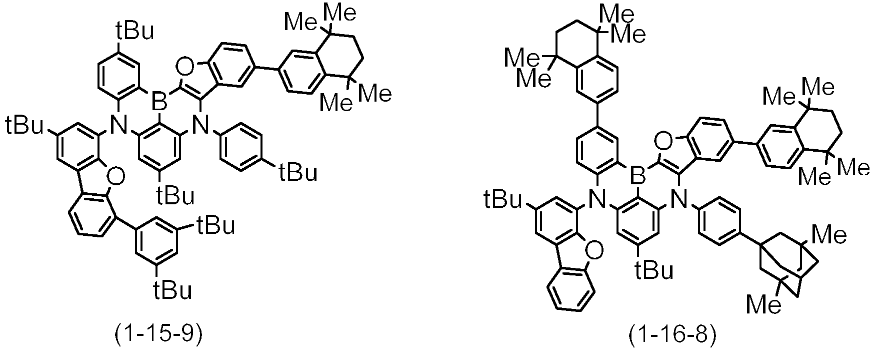 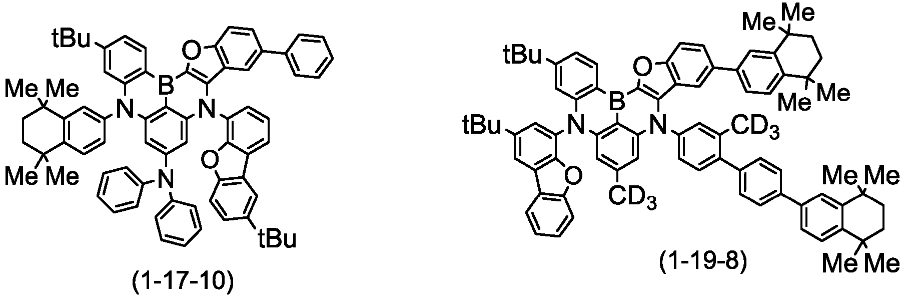 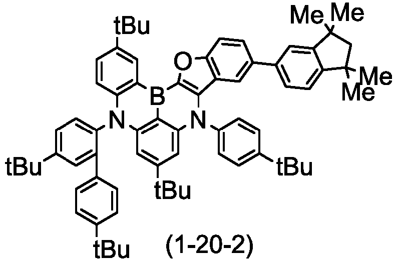 wherein Me is methyl, tBu is t-butyl, and D is deuterium.
<18> A material for an organic device, which comprises the polycyclic aromatic compound according to any one of <1> to <17>.
<19> An organic electroluminescent element, which comprises a pair of electrodes comprising an anode and a cathode, and a light-emitting layer disposed between the pair of electrodes,
   wherein the light-emitting layer comprises the polycyclic aromatic compound according to any one of <1> to <17>.
<20> The organic electroluminescent element according to <19>, wherein the light-emitting layer comprises a host and the polycyclic aromatic compound as a dopant.
<21> The organic electroluminescent element according to <20>, wherein the host is an anthracene-based compound, a fluorene-based compound, or a dibenzochrysene-based compound.
<22> A display device or a lighting device comprising an organic electroluminescent element according to any one of <19> to <21>.

### Effect of the Invention

The present invention provides a novel polycyclic aromatic compound useful as materials for organic devices such as an organic electroluminescent element. The polycyclic aromatic compound of the present invention can be used in the manufacture of organic devices such as an organic electroluminescent element.

### Brief Description of Drawing

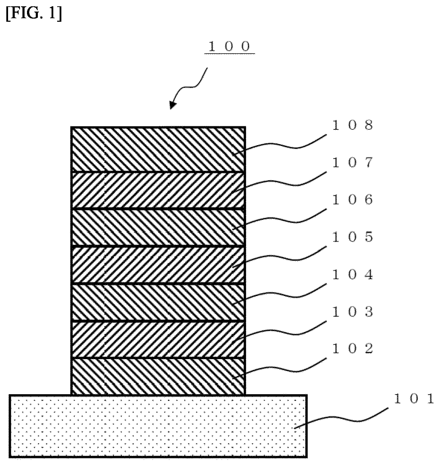

[FIG. 1] This is a schematic cross-sectional view showing an example of an organic electroluminescent element.

### Description of Embodiments

Hereinafter, the invention will be described in detail. Description of constituent features described below is made on the basis of typified embodiments or specific examples in several cases, but the invention is not limited to such embodiments. The numerical range represented by using "to" in the specification means a range including numerical values described before and after "to" as a lower limit and an upper limit. Moreover, "hydrogen" as used herein in description of a structural formula means a "hydrogen atom (H)." Similarly, "carbon atom (C)" is sometimes referred to as "carbon."

When used herein, "adjacent groups" means two groups attached to two adjacent atoms (two atoms directly bonded by covalent bonds) in the structural formula, respectively.

In the present specification, "Me" represents methyl, "Et" represents ethyl, "nBu" represents n-butyl(normalbutyl), "tBu" represents t-butyl(tertiarybutyl), "iBu" represents isobutyl, "secBu" represents secondarybutyl, "nPr" represents n-propyl(normalpropyl), "iPr" represents isopropyl, "tAm" represents t-amyl, "2EH" represents2-ethylhexyl, "tOct" represents t-octyl, "Ph" represents phenyl, "Mes" represents mesityl(2,4,6-trimethylphenyl), "Ad" represents 1-adamanthyl, "Tf" represents trifluoromethanesulfonyl, "TMS" represents trimethylsilyl, and "D" represents deuterium.

In the present specification, an organic electroluminescent element is sometimes referred to as an "organic EL element."

A chemical structure or a substituent is represented herein by using the number of carbon atoms in several cases. However, the number of carbon atoms when an atom of the chemical structure is replaced with the substituent in, when an atom of the substituent is further replaced with a substituent, or the like means the number of carbon atoms of each chemical structure or each substituent and does not mean the total number of carbon atoms of each chemical structure and the substituent thereof or the total number of carbon atoms of each substituent and the substituent thereof. For example, an expression "substituent B having Y carbons which is subjected to substitution for substituent A having X carbons" means that hydrogen of "substituent B having Y carbons" is replaced with "substituent A having X carbons," and the Y carbons do not represent the number of carbon atoms of a total of the substituent A and the substituent B. For example, an expression "substituent B having Y carbons which is subjected to substitution for substituent A" means that hydrogen of "substituent B having Y carbons" is replaced with "substituent A (in which the number of carbon atoms is not specified), and the Y carbons do not mean the number of carbon atoms of a total of the substituent A and the substituent B.

The chemical structural formulas described in the present specification (including general formulas depicted in Markush structural formulas as described below in Formula (1)) are planar structural formulas, and therefore, various isomeric structures such as enantiomers, diastereomers, and rotamers may actually exist. In the present specification, unless otherwise specified, the compounds described may be any of the isomeric structures that can be considered from the planar structural formulae, and may also be mixtures of any ratio of the possible isomers.

The present specification describes numerous structural formulas of aromatic compounds. Aromatic compounds are described by combining double bonds and single bonds, but in reality, due to resonance of π electrons, even a single substance may have multiple equivalent resonance structures in which double bonds and single bonds alternate. In the present specification, only one resonance structure is described for each substance, but unless otherwise specified, other resonance structures that are equivalent from an organic chemistry perspective are also included.

In the present specification, the expression "may be" is sometimes used, but it has the same meaning as ""is not" or "is.""

### < Explanation of rings and substituents>

First, details of the rings and substituents used in this specification are described below. As the "aryl ring" in the present specification, an aryl ring having 6-30 carbons can be exemplified, an aryl ring having 6-16 carbons is preferred, an aryl ring having 6-12 carbons is more preferred, and an aryl ring having 6-10 carbons is particularly preferred.

Specific examples of the "aryl ring" include benzene ring as a monocyclic ring, biphenyl ring as a bicyclic ring, naphthalene ring and indene ring as a fused bicyclic ring, terphenyl ring (m-terphenyl, o-terphenyl, p-terphenyl) as a tricyclic ring, acenaphthylene ring, fluorene ring, phenalene ring, phenanthrene ring and anthracene ring as a fused tricyclic ring, triphenylene ring, pyrene ring. naphthacene ring and chrysene ring as a fused tetracyclic ring, perylene ring and pentacene ring as a fused pentacyclic ring. Further, the fluorene ring, the benzofluorene ring, and the indene ring also include a structure in which another fluorene ring, benzofluorene ring, and cyclopentane ring, and the like are spiro-bonded, respectively. The fluorene ring, benzofluorene ring and indene ring also include a dimethylfluorene ring, a dimethylbenzofluorene ring and a dimethylindene ring, in which two of the two hydrogens of methylene in the fluorene ring, benzofluorene ring and indene ring are each replaced with an alkyl such as methyl as the first substituent described below.

As the "heteroaryl ring" in the present specification, a heteroaryl ring having 2 to 30 carbons is exemplified, a heteroaryl ring having 2 to 25 carbons is preferable, a heteroaryl ring having 2 to 20 carbons is more preferable, a heteroaryl ring having 2 to 15 carbons is further preferable, and a heteroaryl ring having 2 to 10 carbons is particularly preferable. Moreover, specific examples of the "heteroaryl ring" include a heterocyclic ring containing, in addition to carbons, 1 to 5 hetero atoms selected from oxygen, sulfur, nitrogen, boron, selenium, phosphorus, and tellurium as a ring-forming atom.

Specific examples of the "heteroaryl ring" include a pyrrole ring, an oxazole ring, an isoxazol ring, a thiazole ring, an isothiazole ring, an imidazole ring, an oxadiazole ring (a furazan ring, etc.), a thiadiazole ring, a triazole ring, a tetrazole ring, a pyrazole ring, a pyridine ring, a pyrimidine ring, a pyridazine ring, a pyrazine ring, a triazine ring, an indole ring, an isoindole ring, a 1H-indazole ring, a benzimidazole ring, a benzooxazole ring, a benzothiazole ring, a 1H-benzotriazol ring, a quinoline ring, an isoquinoline ring, a cinnoline ring, a quinazoline ring, a quinoxaline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, a phenazasiline ring, an indolizine ring, a furan ring, a benzofuran ring, an isobenzofuran ring, a dibenzofuran ring, a thiophene ring, a benzothiophene ring, a dibenzothiophene ring, a thianthrene ring, indolocarbazole ring, a benzoindolocarbazole ring, a dibenzoindolocarbazole ring, a naphthobenzofuran ring, a dioxine ring, a dihydroacridine ring, a xanthene ring, a thioxanthene ring, a dibenzodioxin ring, a dioxabora-naphtho-anthracene ring (5, 9-dioxa-13b-bora-13bH-naphtho[3,2,1-de]anthracene ring, etc.), a benzoselenophene ring, a dibenzoselenophene ring, an azacarbazol ring, an azadibenzothiophene ring, an azadibenzofuran ring, an azadibenzoselenophene ring, an azatriphenylene ring, an imidazoimidazole ring, an indoloindole ring, a benzofurocarbazole ring, a benzothienocarbazole ring, an indenocarbazole ring, and a selenophenocarbazole ring, a spiro[fluorene-9,9'-xanthene] ring, andspirobi[silafluorene] ring. Additionally, a dihydroacridine ring, a xanthen ring, and a thioxanthen ring, in which two of the two hydrogen atoms of the methylene group in their structures are each replaced by an alkyl group such as methyl as the first substituents described below, are also preferred. Further, bipyridine ring, phenylpyridine ring, and pyridylphenyl ring which are bicyclic, terpyridyl ring, bispyridylphenyl ring, and pyridylbiphenyl ring which are a tricyclic can be also exemplified as a "heteroaryl ring." Further, the "heteroaryl ring" shall also include pyran ring.

In the present specification, a substituent may be substituted with further substituents. For example, with respect to a specific substituent, it may be described as "substituted or unsubstituted." This means that the specific substituent is substituted with at least one further substituent or is not substituted. In the same sense, it may be described as "may be substituted." In the present specification, the above-mentioned specific substituent is referred to as "first substituent" and the above-mentioned further substituent is referred to as "second substituent."

In the present specification, Substituent Group Zα consists of substituents of Substituent Group Z and substituents represented by Formula (A30) described below.

In the present specification, Substituent Group Z consists of:
an aryl which may be substituted with at least one group selected from the group consisting of an aryl, a heteroaryl, an alkyl, a cycloalkyl, cyano, and a halogen,
a heteroaryl which may be substituted with at least one group selected from the group consisting of an aryl, a heteroaryl, an alkyl, a cycloalkyl, cyano, and a halogen,
a diarylamino (the two aryls may be bonded via a single bond or a linking group) which may be substituted with at least one group selected from the group consisting of an aryl, a heteroaryl, an alkyl, a cycloalkyl, cyano, and a halogen,
a diheteroarylamino (the two heteroaryls may be bonded via a single bond or a linking group) which may be substituted with at least one group selected from the group consisting of an aryl, a heteroaryl, an alkyl, a cycloalkyl, cyano, and a halogen,
an arylheteroarylamino (the aryl and the heteroaryl may be bonded via a single bond or a linking group) which may be substituted with at least one group selected from the group consisting of an aryl, a heteroaryl, an alkyl, a cycloalkyl, cyano, and a halogen,
a diarylboryl (the two aryls may be bonded via a single bond or a linking group) which may be substituted with at least one group selected from the group consisting of an aryl, a heteroaryl, an alkyl, a cycloalkyl, cyano, and a halogen,
an alkyl which may be substituted with at least one group selected from the group consisting of an aryl, a heteroaryl, a cycloalkyl, cyano, and a halogen,
a cycloalkyl which may be substituted with at least one group selected from the group consisting of an aryl, a heteroaryl, an alkyl, a cycloalkyl, cyano, and a halogen,
an alkoxy which may be substituted with at least one group selected from the group consisting of an aryl, a heteroaryl, a cycloalkyl, cyano, and a halogen,
an aryloxy which may be substituted with at least one group selected from the group consisting of an aryl, a heteroaryl, an alkyl, a cycloalkyl, cyano, and a halogen,
an arylthio which may be substituted with at least one group selected from the group consisting of an aryl, a heteroaryl, an alkyl, a cycloalkyl, cyano, and a halogen,
an alkenyl which may be substituted with at least one group selected from the group consisting of an aryl, a heteroaryl, an alkyl, a cycloalkyl, cyano, and a halogen,
a substituted silyl, cyano, and a halogen.

The aryl, which is the second substituent in each group of Substituent Group Z, may be further substituted with an aryl, a heteroaryl, an alkyl, a cycloalkyl, cyano, or a halogen. Similarly, the heteroaryl group, which is the second substituent, may be substituted an aryl, a heteroaryl, an alkyl, a cycloalkyl, cyano, or a halogen.

In the present specification, when the term "substituent" is used, the type of substituent is not particularly limited, but unless otherwise specified, it may be any substituent selected from Substituent Group Z. For example, when a group described as "substituted or unsubstituted" is substituted, the group may be substituted with at least one substituent selected from Substituent Group Z.

In the present specification, an "aryl" is for example an aryl having 6 to 30 carbons, and is preferably an aryl having 6 to 20 carbons, an aryl having 6 to 16 carbons, an aryl having 6 to 12 carbons, and an aryl having 6 to 10 carbons etc.

A specific example of aryl includes a monovalent group obtained by removing one hydrogen atom from the "aryl ring" described above, and for example, phenyl as monocyclic aryl, biphenylyl(2- biphenylyl, 3- biphenylyl, 4- biphenylyl) as bicyclic aryl, naphthyl (1-naphthyl, 2-naphthyl) as fused bicyclic aryl, terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, or p-terphenyl-4-yl) as tricyclic aryl, acenaphthylen-(1-,3-,4-, or 5-)yl, fluoren-(1-,2-,3-,4-,or 9-)yl, phenalen-(1-,2-)yl, phenanthr(1-,2-,3-,4-,9-)ylm or anthracene-(1-, 2-, or 9-)yl as fused tricyclic aryl, quaterphenylyl (5'-phenyl-m-terphenyl-2-yl, 5'-phenyl-m-terphenyl-3-yl, 5'-phenyl-m-terphenyl-4-yl, m-quaterphenylyl) as tetracyclic aryl, triphenylen-(1-,2-)yl, pyren-(1-,2-,4-)yl, naphthacen-(1-,2-,5-)yl as fused tetracyclic aryl, perylen-(1-,2-,3-)yl, pentacen-(1-,2-,5-,6-)yl as fused pentacyclic aryl. Other examples include monovalent groups of spirofluorene.

Examples of aryl as a second substituent include structures wherein the aryl is substituted with at least one substituent selected from the group consisting of an aryl such as phenyl (Specific examples are described above.), an alkyl such as methyl (Specific examples will be described later.), and a cycloalkyl such as cyclohexyl or adamanthyl (Specific examples will be described later.). An example is fluorenyl as the second substituent in which the 9th position is replaced by an aryl such as phenyl, an alkyl such as methyl, or a cycloalkyl such as cyclohexyl or adamantyl.

An "arylene" is, for example, an arylene having 6 to 30 carbon atoms, preferably an arylene having 6 to 20 carbon atoms, an arylene having 6 to 16 carbon atoms, an arylene having 6 to 12 carbon atoms, or an arylene having 6 to 10 carbon atoms.

A specific example of "arylene" is a divalent group obtained by removing one hydrogen from the above-described "aryl" (monovalent group).

A "heteroaryl" is a heteroaryl having 2 to 30 carbons and is preferably, a heteroaryl having 2 to 25 carbons, a heteroaryl having 2 to 20 carbons, a heteroaryl having 2 to 15 carbons, and a heteroaryl having 2 to 10 carbons etc. A "heteroaryl" contains in addition to carbon, one or more, preferably 1 to 5, hetero atoms selected from oxygen, sulfur and nitrogen as a ring-forming atom.

A specific example of "heteroaryl" includes a monovalent group obtained by removing one hydrogen atom from the "heteroaryl ring" described above. Specific examples of the heteroaryl include pyrrolyl, oxazolyl, isoxazolyl, thiazolyl, isothiazolyl, imidazolyl, oxadiazolyl, thiadiazolyl, triazoryl, tetrazolyl, pyrazolyl, pyridyl, pyrimidinyl, pyridazinyl, pyrazinyl, triazinyl, indolyl, isoindolyl, 1H-indazolyl, benzimidazolyl, benzoxazolyl, benzothiazolyl, 1H-benzotriazoryl, quinolyl, isoquinolyl, cinnolyl, quinazolyl, quinoxalinyl, phenanthrolinyl, phthalazinyl, naphthyridinyl, purinyl, pteridinyl, carbazolyl, acridinyl, phenoxathiinyl, phenoxazinyl, phenothiazinyl, phenazinyl, phenazasilinyl, indrizinyl, furanyl, benzofuranyl, isobenzofuranyl, dibenzofuranyl, naphthobenzofuranyl, thienyl, benzothienyl, isobenzothienyl, dibenzothienyl, naphthobenzothienyl, monovalent group of benzophosphole oxide ring, monovalent group of dibenzophosphole oxide ring, furazanyl, thianthrenyl, indolocarbazolyl, benzoindolocarbazolyl, dibenzoindolocarbazolyl, imidazolinyl, oxazolinyl, or the like. In addition, monovalent group of spiro[fluorene-9,9'-xanthene], monovalent group of spirobi[silafluorene], and monovalent group of benzoselenophene can be exemplified.

Examples of heteroaryl as a second substituent include structures wherein the heteroaryl is substituted with at least one substituent selected from the group consisting of an aryl such as phenyl (Specific examples are described above.), an alkyl such as methyl (Specific examples will be described later.) and a cycloalkyl such as cyclohexyl or adamanthyl (Specific examples will be described later.).

An example is carbazolyl as the second substituent in which the 9th position is replaced by an aryl such as phenyl, an alkyl such as methyl, or a cycloalkyl such as cyclohexyl or adamantyl. In addition, a nitrogen-containing heteroaryl group such as pyridyl, pyrimidinyl, triazinyl, or carbazolyl, which is further substituted with phenyl or biphenylyl is also included in a heteroaryl groups as the second substituent.

A "heteroarylene" is, for example, a heteroarylene having 2 to 30 carbon atoms, preferably a heteroarylene having 2 to 25 carbon atoms, a heteroarylene having 2 to 20 carbon atoms, a heteroarylene having 2 to 15 carbon atoms, or a heteroarylene having 2 to 10 carbon atoms. "Heteroarylene" is a divalent group of a heterocyclic ring containing 1 to 5 heteroatoms selected from oxygen, sulfur, and nitrogen other than carbon as ring-forming atoms.

A specific example of "heteroarylene" is a divalent group obtained by removing one hydrogen from the above-described "heteroaryl" (monovalent group).

A "diarylamino" is an amino substituted with two aryls. For details on the aryl, the explanation of "aryl" described above can be referred to.

A "diheteroarylamino" is an amino substituted with two heteroaryls. For details on the heteroaryl, the explanation of "heteroaryl" described above can be referred to.

An "arylheteroarylamino" is an amino substituted with an aryl and a heteroaryl. For details on the aryl and heteroaryl, the explanations of "aryl" and "heteroaryl" described above can be referred to.

As an aryl in "diarylamino," "diheteroarylamino," and "arylheteroarylamino," Phenyl, biphenylyl(o-biphenylyl is preferable), naphthyl, phenanthryl, fluorenyl, and terphenylyl are preferred. As a heteroaryl in "diarylamino," "diheteroarylamino," and "arylheteroarylamino," carbazolyl, dibenzofanyl, and dibenzothienyl are preferred. The two aryls in the diarylamino may be the same or different.

The two aryls in the diarylamino as the first substituent may be bonded to each other via a linking group, the two heteroaryls in the diheteroarylamino as the first substituent may be bonded to each other via a linking group, and the aryl and heteroaryl in the arylheteroarylamino as the first substituent may be bonded to each other via a linking group. Here, the phrase "bonded via a linking group" indicates, for example, that the two phenyls of diphenylamino are bonded by a linking group, as shown below. This explanation also applies to a diheteroarylamino and arylheteroarylamino formed by heteroaryls or an aryl and a heteroaryl. 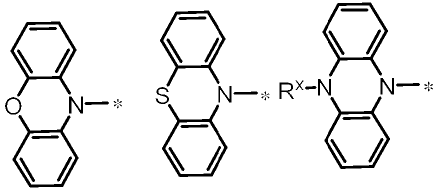 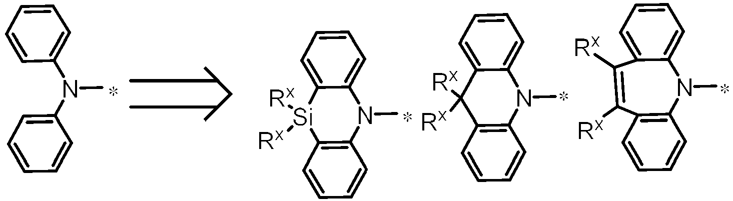 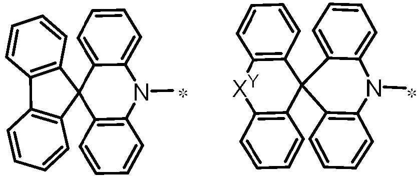 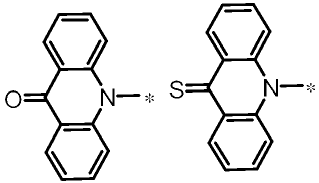 (* represents a bonding position.)

Specific examples of the linking group include >O, >N-R^{X}, >C(-R^{X})₂, -C(-R^{X})=C(-R^{X})-, >Si(-R^{X})₂, >S, >CO, >CS, >SO, >SO₂, >SeO, >SeO₂, >PO, >B(-R^{X}), and >Se. R^{X} are each independently an alkyl, a cycloalkyl, an aryl, or a heteroaryl, each of which may be substituted with an alkyl, a cycloalkyl, an aryl, or a heteroaryl. The two R^{X}s in each of >C(-R^{X})₂, -C(-R^{X})=C(-R^{X})-, >Si(-R^{X})₂ may form a ring by bonding to each other via single bonds or a linked group X^{Y}. As X^{Y}, >O, >N-R^{Y}, >C(-R^{Y})₂, >Si(-R^{Y})₂, >S, >CO, >CS, >SO, >SO₂, and >Se can be exemplified, and R^{Y} are each independently an alkyl, a cycloalkyl, an aryl, or a heteroaryl, each of which may be substituted with an alkyl, a cycloalkyl, an aryl, or a heteroaryl, but two R^{Y}s in each of >C(-R^{Y})₂ and >Si(-R^{Y})₂ do not further form a ring by bonding to each other. A further example includes an alkenylene. Any hydrogen in the alkenylene may be independently replaced with R^{2X}. R^{2X}are each independently an alkyl, a cycloalkyl, a substituted silyl, an aryl, or a heteroaryl, each of which may be substituted with an alkyl, a cycloalkyl, a substituted silyl, or an aryl. The two R^{X}s in-C(-R^{X})=C(-R^{X})- may form an aryl ring (such as benzene ring) or a heteroaryl ring by bonding to each other together with C=C where they are bonded. That is, -C(-R^{X})=C(-R^{X})- can be an arylene (1,2-phenylene, etc.) or a heteroarylene.

In the present specification, unless otherwise specified, the terms "diarylamino," "diheteroarylamino," and "arylheteroarylamino," include meaning that "the two aryls of the diarylamino may be bonded to each other via a linking group," "the two heteroaryls of the diheteroarylamino may be bonded to each other via a linking group," and "the aryl and heteroaryl of the arylheteroarylamino may be bonded to each other via a linking group," respectively.

A "diarylboryl" is a boryl substituted with two aryls. For details on the aryl, the explanation of 'aryl' above can be referred to. The two aryls may be bonded to each other via single bond or a linking group (for example, -CH=CH-, -CR=CR-, -C≡C-, >N-R, >O, >S, >CO, >C=S, >S=O, >S(=O)₂, >Se(=O), >Se(=O)₂, >P(=O), >B(-R), >C(-R)₂, >Si(-R)₂, or >Se). Here, R in the - CR=CR-, R in the>N-R, R in the >B(-R), R in the >C(-R)₂, and R in the >Si(-R)₂ are each an aryl, a heteroaryl, a diarylamino, an alkyl, an alkenyl, an alkynyl, a cycloalkyl, an alkoxy, or an aryloxy, and at least one hydrogen in the R may be further substituted with an aryl, a heteroaryl, an alkyl, an alkenyl, an alkynyl, or a cycloalkyl. Further, two adjacent Rs may form a cycloalkylene, an arylene, or a heteroarylene by bonding to each other. For details on the substituents listed here, the explanations of "aryl," "arylene," "heteroaryl," "heteroarylene," and "diarylamino," above, and the explanations of "alkyl," "alkenyl," "alkynyl," "cycloalkyl," "cycloalkylene," "alkoxy," and "aryloxy" below can be referred to. In addition, unless otherwise specified, the term "diarylboryl" as used in the present specification is to be understood to imply the meaning that "the two aryls of diarylboryl may be bonded to the other via a single bond or a linking group".

A "alkyl" may be any of a straight-chain alkyl and a branched-chain alkyl, and is for example a straight-chain alkyl having 1 to 24 carbons or a branched-chain alkyl having 3 to 24 carbons, and preferably an alkyl having 1 to 18 carbons (a branched-chain alkyl having 3 to 18 carbons), an alkyl having 1 to 12 carbons (a branched-chain alkyl having 3 to 12 carbons), an alkyl having 1 to 6 carbons (a branched-chain alkyl having 3 to 6 carbons), an alkyl having 1 to 4 carbons (a branched-chain alkyl having 3 to 4 carbons), and the like.

Examples of specific "alkyl" include methyl, ethyl, n-propyl, isopropyl, 1-ethyl-1-methylpropyl, 1,1-diethylpropyl, 1,1,2-trimethylpropyl, 1,1,2,2-tetramethylpropyl, 1-ethyl-1,2,2-trimethylpropyl, n-butyl, isobutyl, s-butyl, t-butyl,2-ethylbutyl, 1,1-dimethylbutyl, 3,3-dimethylbutyl, 1,1-diethylbutyl, 1-ethyl-1-methylbutyl, 1-propyl-1-methylbutyl, 1,1,3-trimethylbutyl, 1-ethyl-1,3-dimethylbutyl, n-pentyl, isopentyl, neopentyl, t-pentyl (t-amyl), 1-methylpentyl, 2-propylpentyl, 1,1-dimethylpentyl, 1-ethyl-1-methylpentyl, 1-propyl-1-methylpentyl, 1-butyl-1-methylpentyl, 1,1,4-trimethylpentyl, n-hexyl,1-methylhexyl, 2-ethylhexyl, 1,1-dimethylhexyl, 1-ethyl-1-methylhexyl, 1,1,5-trimethylhexyl, 3,5,5-trimethylhexyl, n-heptyl, 1-methylheptyl, 1-hexylheptyl, 1,1-dimethylheptyl, 2,2-dimethylheptyl, 2,6-dimethyl-4-heptyl, n-octyl, t-octyl (1,1,3,3-tetramethylbutyl), 1,1-dimethyloctyl, n-nonyl, n-decyl, 1-methyldecyl, n-undecyl, n-dodecyl, n-tridecyl, n-tetradecyl, n-pentadecyl, n-hexadecyl, n-heptadecyl, n-octadecyl and n-eicosyl.

An "alkylene" is a divalent group obtained by removing a hydrogen from an alkyl, such as methylene, ethylene, and propylene.

Regarding "alkenyl," reference can be made to the explanation of "alkyl" mentioned above. It is a group in which a C-C single bond in the alkyl structure is replaced by a C=C double bond, and includes groups in which not just one but two or more single bonds are replaced by double bonds (also called alkadien-yl or alkatrien-yl).

An "alkenyl" specifically refers to an alkenyl with 2 to 30 carbons, with those having 2 to 20 carbons being preferred, those having 2 to 10 carbons being more preferred, those having 2 to 6 carbons being even more preferred, and those having 2 to 4 carbon atoms being particularly preferred. Preferred alkenyl groups include vinyl, 1-propenyl, 2-propenyl, 1-butenyl, 2-butenyl, 3-butenyl, 1-pentenyl, 2-pentenyl, 3-pentenyl, 4-pentenyl, 1-hexenyl, 2-hexenyl, 3-hexenyl,4-hexenyl, or 5-hexenyl.

An "alkenylene" is a divalent group obtained by removing one of the hydrogens from 'alkenyl,' and vinylene is an example.

Regarding "alkynyl," reference can be made to the explanation of "alkyl" mentioned above. It is a group in which the C-C single bond in an alkyl structure is replaced with a C≡C triple bond, and includes groups in which not only one but two or more single bonds are replaced with triple bonds (also called alkadiyn-yl or alkatriyn-yl).

A "cycloalkyl" is, for example, a cycloalkyl having 3 to 24 carbons, preferably a cycloalkyl having 3 to 20 carbons, a cycloalkyl having 3 to 16 carbons, a cycloalkyl having 3 to 14 carbons, a cycloalkyl having 3 to 12 carbons, a cycloalkyl having 5 to 10 carbons, a cycloalkyl having 5 to 8 carbons, a cycloalkyl having 5 to 6 carbons, a cycloalkyl having 5 carbons, and the like.

Specific "cycloalkyl" is, for example, cyclopropyl, cyclobutyl, cyclopentyl, cyclohexyl, cycloheptyl, cyclooctyl, cyclononyl, cyclodecyl, or an alkyl (especially methyl) substituents thereof having 1 to 5 carbons or 1 to 4 carbons, bicyclo[1.1.0]butyl, bicyclo[1.1.1]pentyl, bicyclo[2.1.0]pentyl, bicyclo[2.1.1]hexyl, bicyclo[3.1.0]hexyl, bicyclo[2.2.1]heptyl(norbornyl), bicyclo[2.2.2]octyl, adamanthyl, diamantyl, decahydronaphthalenyl, and decahydroazulenyl.

A "cycloalkylene" is, for example, a cycloalkylene having 3 to 24 carbon, preferably a cycloalkylene having 3 to 20 carbons, a cycloalkylene having 3 to 16 carbons, a cycloalkylene having 3 to 14 carbons, a cycloalkylene having 3 to 12 carbons, a cycloalkylene having 5 to 10 carbons, a cycloalkylene having 5 to 8 carbons, a cycloalkylene having 5 to 6 carbons, or cycloalkylene having 5 carbons, and the like.

Specific examples of "cycloalkylene" include structures obtained by removing one hydrogen from the above described "cycloalkyl" (monovalent group) to form a divalent group.

A "cycloalkenyl" refers to a group having a structure in which at least one pair of single bonds between two carbons in the above described "cycloalkyl" is replaced by a double bond (e.g., a group in which -CH₂-CH₂- is replaced by -CH=CH-), excluding groups that correspond to an aryl. Specific examples include 1-cyclohexenyl and 1-cyclopentenyl.

An "alkoxy" is a group represented by "Alk-O- (Alk is an alkyl)," and for details on the alkyl, the explanation of 'alkyl' above can be referred to.

An "aryloxy" is a group represented by "Ar-O-(Ar is an aryl)," and for details on the aryl, the explanation of 'aryl' above can be referred to.

An "arylthio" is a group represented by "Ar-S-(Ar is an aryl)," and for details on the alkyl, the explanation of 'alkyl' above can be referred to.

Examples of the "substituted silyl" include a silyl substituted with at least one of an aryl, an alkyl, and a cycloalkyl, and preferablys thereof include a triarylsilyl, a trialkylsilyl, a tricycloalkylsilyl, a dialkylcycloalkylsilyl, and an alkyldicycloalkylsilyl.

A "triarylsily" is a silyl group substituted with three aryls, and for details of the aryls the explanation of "aryl" above can be referred to.
Specific "triarylsilyl" is, for example, triphenylsilyl, diphenylmononaphthyl silyl, monophenyldinaphthylsilyl, or trinaphthylsilyl or the like.

A "trialkylsilyl" is a silyl group substituted with three alkyls, and details of these alkyl group can be found in the explanation of "alkyl" above.

Specific "trialkylsilyl" is, for example, trimethylsilyl, triethylsilyl, trin-propylsilyl, triisopropylsilyl, trin-butylsilyl, triisobutylsilyl, tris-butylsilyl, trit-butylsilyl, ethyldimethylsilyl, n-propyldimethylsilyl, isopropyldimethylsilyl, n-butyldimethylsilyl, isobutyldimethylsilyl, s-butyldimethylsilyl, t-butyldimethylsilyl, methyldiethylsilyl, n-propyldiethylsilyl, isopropyldiethylsilyl, n-butyldiethylsilyl, s-butyldiethylsilyl, t-butyldiethylsilyl, methyldin-propylsilyl, ethyldin-propylsilyl, n-butyldin-propylsilyl, s-butyldin-propylsilyl, t-butyldin-propylsilyl, methyldiisopropylsilyl, ethyldiisopropylsilyl, n-butyldiisopropylsilyl, s-butyldiisopropylsilyl, t-butyldiisopropylsilyl or the like.

A "tricycloalkylsilyl" is a silyl group substituted with three cycloalkyls, and details of these alkyl group can be found in the explanation of "cycloalkyl" above.

Specific "tricycloalkylsilyl" is, for example, tricyclopentylsilyl , tricyclohexylsilyl or the like.

A "dialkylcycloalkylsilyl" is a silyl group substituted with two alkyls and one cycloalkyl, and details of the alkyl and cycloalkyl can be found in the explanation of "alkyl" and "cycloalkyl"above.

A "alkyldicycloalkylsilyl" is a silyl group substituted with one alkyl and two cycloalkyls, and details of the alkyl and cycloalkyl can be found in the explanation of "alkyl" and "cycloalkyl" above.

A "halogen" means fluorine, chlorine, bromine, or iodine, preferably fluorine, chlorine, or bromine, more preferably fluorine or chlorine, and fluorine is most preferred.

Furthermore, when substituted with cyano or halogen, it is also preferable that all or part of the hydrogens in the aryl or heteroaryl in the structure be replaced with cyano or halogen.

The substituent represented by Formula (A30) has the following structure.

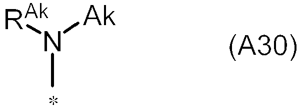

In Formula (A30),
Ak is hydrogen, a substituted or unsubstituted alkyl, a substituted or unsubstituted alkenyl, a substituted or unsubstituted cycloalkyl, or a substituted or unsubstituted cycloalkenyl, in the alkyl, the cycloalkyl, and the cycloalkenyl, at least one -CH₂- may be replaced with -O- or -S-.
R^{Ak} is a substituted or unsubstituted aryl, a substituted or unsubstituted heteroaryl, a substituted or unsubstituted alkyl, or a substituted or unsubstituted cycloalkyl, and R^{Ak} may be bonded to Ak via a linking group or a single bond, and * indicates a bond position.

In Formula (A30), since Ak is the above substituent, it does not conjugate with the lone pair of electrons on N, allowing the lone pair of electrons to conjugate with the π electrons at the bonding site. This enables a greater wavelength shift compared to structures with aryl groups at the same position. The same applies to the influence on multiple resonance effects, enabling greater improvement in thermally activated delayed fluorescence (TADF) properties.

R^{Ak} is an aryl group which may be substituted with an alkyl or cycloalkyl, a heteroaryl group which may be substituted with an alkyl or cycloalkyl, preferably an alkyl or cycloalkyl, more preferably an aryl which may be substituted with an alkyl, a heteroaryl group which may be substituted with an alkyl, an alkyl, or a cycloalkyl, further preferably an aryl group which may be substituted with an alkyl, and particularly preferably phenyl which may be substituted with methyl.

In Formula (A30), Ak is preferably an alkyl having 1 to 6 carbons or a cycloalkyl having 3 to 14 carbons, preferably an alkyl having 1 to 4 carbons or a cycloalkyl having 3 to 8 carbons, more preferably an alkyl having 1 to 4 carbons, and further preferably methyl.

R^{Ak} and Ak can be the same or different, and preferably different.

R^{Ak} may be bonded to Ak via a linking group or a single bond. As the linking group, >O, >S, >Si(-R)₂ or the like can be exemplified. R in >Si(-R)₂ is hydrogen, an aryl having 6 to 12 carbons, an alkyl having 1 to 6 carbons or a cycloalkyl having 3 to 14 carbons. Examples of structures in which R^{Ak} is bonded to Ak via a linking group or a single bond include the following.

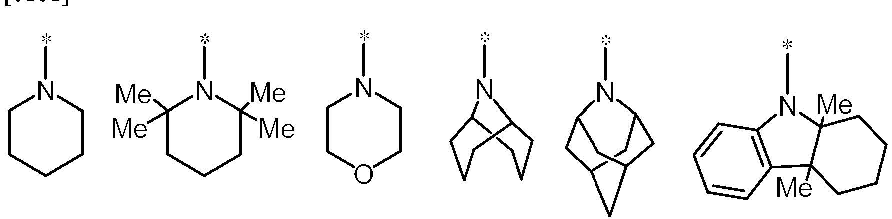

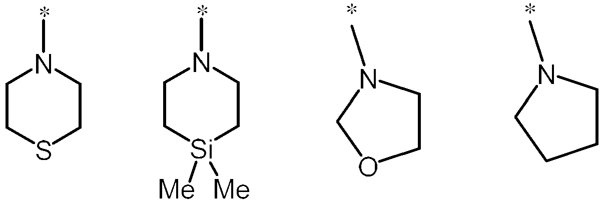

In the above formulas, * indicates the bonding position.

### [When two groups bonded to the same atom bond to each other]

When two groups bonded to the same atom are described in the present specification, as "they may form a ring by bonding to each other", they may be bonded by a single bond or a linking group (collectively referred to as a bonding group). Examples of the linking group include -CH₂-CH₂-, - CHR-CHR-, -CR₂-CR₂-, -CH=CH-, -CR=CR-, -C=C-, -N(-R)-, -O-, -S-, -C(-R)₂-, -C(=O)-, -C(=S)-, -S(=O)-, -S(=O)₂-, -Se(=O)-, -Se(=O)₂-, -P(=O)-, -B(-R)-, -Si(-R)₂-, and -Se-, and the following structures can be exemplified. R in -CHR-CHR-, R in -CR₂-CR₂-, R in -CR=CR-, R in-N(-R)-, R in-C(-R)₂-, R in-B(-R)-, and R in-Si(-R)₂- are each independently, hydrogen, an aryl group which may be substituted with an alkyl or cycloalkyl, a heteroaryl group which may be substituted with an alkyl or cycloalkyl, an alkyl which may be substituted with a cycloalkyl, an alkenyl which may be substituted with an alkyl or cycloalkyl, an alkynyl which may be substituted with an alkyl or cycloalkyl, or a cycloalkyl may be substituted with an alkyl or cycloalkyl. In addition, any two adjacent Rs may be bonded to form a ring, forming a cycloalkylene, arylene, or heteroarylene.

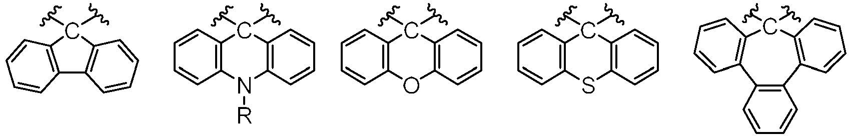

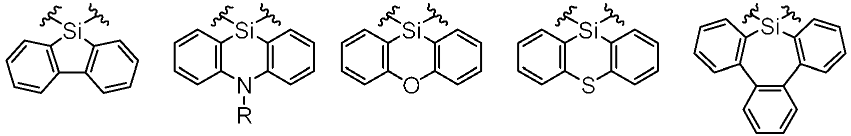

The bonding group is preferably a single bond or as linking group, -CR=CR-, -N(-R)-, -O-, - S-, -C(-R)₂-, -Si(-R)₂-, and -Se-, more preferably a single bond or as linking group,-CR=CR-, -N(-R)-, -O-, -S-, and-C(-R)₂-, still more preferably a single bond or as linking group,-CR=CR-, -N(-R)-, -O-, and -S-, and most preferably a single bond.

The position at which the two R groups are bonded by the linking group is not particularly limited as long as it is a bondable position, but it is preferable that they are bonded at the most adjacent positions. For example, when the two groups are phenyl, it is preferable that they are bonded at the ortho (2-position) positions relative to the "C" or "Si" bond positions (1-position) in the phenyl group (see the above structural formulas).

### <Stereoisomers>

The polycyclic aromatic compounds of the present invention may exist as enantiomers or diastereomers depending on the type of substituents, etc., but regardless of the structural formulae described, any pure form of any stereoisomer, any mixture of stereoisomers, racemic mixtures, etc., are all included within the scope of the present invention.

### <Explanation of Replacement with Isotopes>

Each element in a polycyclic aromatic compound having a structure consisting of one or more structural units represented by Formula (1) contains multiple isotopes that exist naturally in the same proportions as they occur in nature, unless otherwise specified. However, at least one atom of each element in each structural formula may contain heavy stable isotopes in excess of their natural abundance (e.g., 90 atom % or more). In the present specification, this is simply referred to as "replacing" with "heavy stable isotopes." More specifically, at least one hydrogen atom can be replaced with deuterium, at least one nitrogen atom can be replaced with nitrogen-15 (¹⁵N), at least one sulfur atom can be replaced with sulfur-33 (³³S), sulfur-34 (³⁴S), or sulfur-36 (³⁶S), and at least one oxygen atom can be replaced with oxygen-17 (¹⁷O) or oxygen-18 (¹⁸O), at least one carbon can be replaced with carbon-13 (¹³C), and at least one boron can be replaced with boron-11 (¹¹B). By replacing at least some elements with heavier stable isotopes, particularly by replacing at least one boron with boron-11 (¹¹B), it is possible to improve the performance of organic electroluminescent elements using polycyclic aromatic compounds having a structure consisting of one or more structural units represented by Formula (1) as dopants.

Polycyclic aromatic compounds having a structure composed of one or more structural units represented by Formula (1) may have replacement with one or more of the following: deuterium, nitrogen-15 (¹⁵N), sulfur-33 (³³S), sulfur-34 (³⁴S), sulfur-36 (³⁶S), oxygen-17 (¹⁷O), oxygen-18 (¹⁸O), carbon-13 (¹³C), and boron-11 (¹¹B), and preferably at least one is replaced with at least one selected from the group consisting of deuterium, nitrogen-15 (¹⁵N), and boron-11 (¹¹B), and more preferably at least one is substituted with deuterium. In the present specification, replacing hydrogen with deuterium is sometimes referred to as "replacement of hydrogen with deuterium" or "deuteration". In other words, in one embodiment, at least one hydrogen in a polycyclic aromatic compound having a structure consisting of one or more structural units represented by Formula (1) may be replaced with deuterium.

In the description of polycyclic aromatic compounds having a structure consisting of one or more structural units represented by Formula (1), when boron is indicated only as "B" or "boron," it means that the compound was synthesized using raw materials with isotope ratios corresponding to those found in nature, unless otherwise specified. In contrast, when the mass number of an element is specified, as in "¹¹B," it means that the compound was synthesized using raw materials with artificially elevated proportions of the element in question. This also applies to other elements, such as hydrogen, nitrogen, sulfur, oxygen, or carbon. Furthermore, the polycyclic aromatic compounds of the present invention in which the isotope ratio of at least one atom is any ratio different from the natural ratio are encompassed by the present invention.

When the specific mass number of the element is not specified in the polycyclic aromatic compounds of the present invention, the polycyclic aromatic compounds having the isotope ratio of at least one atom in the molecule of any ratio different from the natural ratio are still encompassed by the present invention.

### <1. Polycyclic aromatic compound>

### <Overall structure>

A polycyclic aromatic compound in which aromatic rings are linked by heteroatoms such as boron, nitrogen, oxygen, and sulfur has already been found to have large HOMO-LUMO gaps (band gaps Eg in thin films). This is because a six-membered ring containing a heteroatom has low aromaticity, and the reduction in the HOMO-LUMO gap associated with the expansion of the conjugated system is suppressed. In addition, it was found that the HOMO-LUMO gap can be arbitrarily changed depending on the type of hetero elements and their linking types. This may be attributed to the fact that the energies of HOMO and LUMO can be arbitrarily shifted depending on the spatial extent and energy of the empty orbitals or lone pairs of heteroatoms.

These polycyclic aromatic compounds exhibit narrow half-widths of their fluorescent emission peaks due to the localization of excited-state SOMO1 and SOMO2 on each atom, resulting from electronic perturbations caused by heteroatoms, and thus can produce emissions with high color purity when used as dopants in organic EL elements. For the same reason, ΔE_{S1T1} becomes smaller, and these polycyclic aromatic compounds exhibit thermally activated delayed fluorescence, enabling them to provide high efficiency when used as emitting dopants in organic EL elements.

Furthermore, by introducing substituents to the polycyclic aromatic compounds, the energies of HOMO and LUMO can be arbitrarily shifted, enabling optimization of ionization potentials and electron affinities according to the surrounding materials.

It has been found in the present invention, that in particular, a polycyclic aromatic compound comprising one or more structural units represented by Formula (1) having specific groups, wherein the aromatic rings such as benzene rings and a benzofuran ring are linked by heteroatoms such as boron and nitrogen, enable a manufacture of an organic electroluminescent element with a longer lifetimes and a higher luminous efficiency than a polycyclic aromatic compound with a similar structure.

The polycyclic aromatic compound of the present invention is a polycyclic aromatic compound having a structure consisting of one or two or more structural units represented by Formula (1).

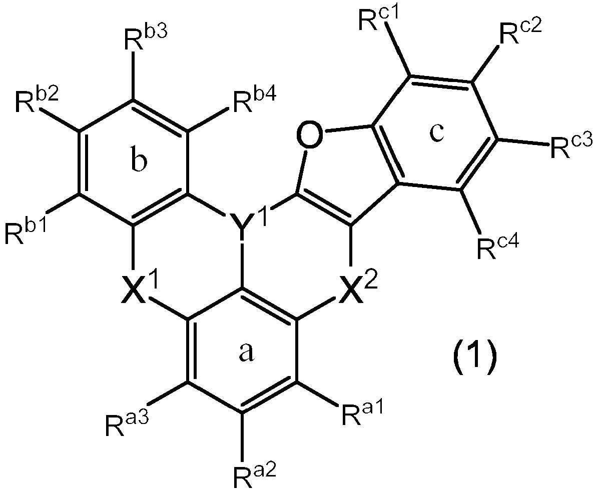

In Formula (1), at least one selected from the group consisting of X¹ and X² is >N-R^{NX} having R^{NX} that is a group represented by Formula (G-1) or Formula (G-2), and at least one of R^{c1} to R^{c4} is a substituted or unsubstituted aryl, or a substituted or unsubstituted heteroaryl.

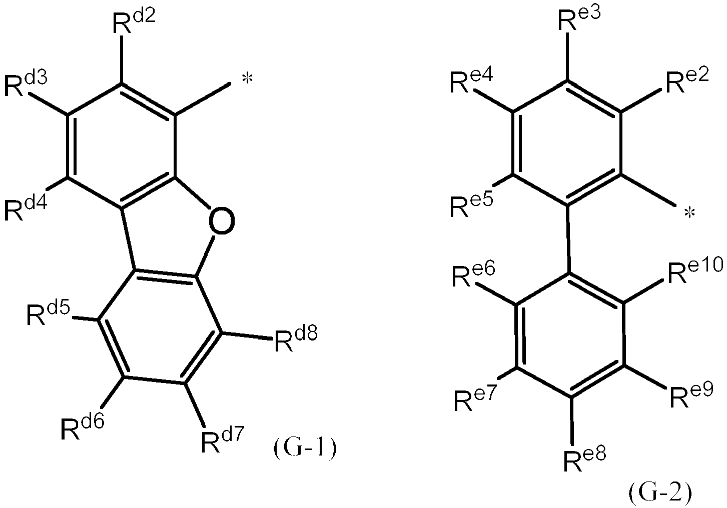

The symbols used in Formula (1) are explained below.

### <Y¹>

In Formula (1), Y¹ is B, P, P=O, P=S, Al, Ga, As, Si-R, or Ge-R, and R in the Si-R and the Ge-R is a substituted or unsubstituted aryl, a substituted or unsubstituted heteroaryl, a substituted or unsubstituted alkyl, or a substituted or unsubstituted cycloalkyl. As R, an aryl having 6 to 10 carbons(for example, phenyl, naphthyl etc.), an alkyl having 1 to 5 carbons(for example, methyl, ethyl etc.), or a cycloalkyl having 5 to 10 carbons(preferably cyclohexyl or adamanthyl) is particularly preferable.

Y¹ is preferably B, P=O, or P=S, and more preferably B.

### <X¹ and X²>

X¹ and X² in Formula (1) are each independently >O, >N-R^{NX}, >C(-R^{CX})₂, >Si(-R^{IX})₂, >S, or >Se. Preferably, X¹ and X² are each independently >N-R^{NX}.

R^{NX} is hydrogen, a substituted or unsubstituted aryl, a substituted or unsubstituted heteroaryl, a substituted or unsubstituted alkyl, or a substituted or unsubstituted cycloalkyl. As described below, Formula (1) has at least one >N-R^{NX} in which R^{NX} is a group represented by Formula (G-1) or Formula (G-2), as X¹ or X².

As R^{NX} other than the group represented by Formula (G-1) or Formula (G-2), another substituted or unsubstituted aryl, or a substituted or unsubstituted heteroaryl other than is preferable, a substituted or unsubstituted phenyl, a substituted or unsubstituted naphthyl, a substituted or unsubstituted dibenzothienyl, a substituted or unsubstituted fluorenyl, or a substituted or unsubstituted carbazolyl is preferable, a substituted or unsubstituted phenyl, a substituted or unsubstituted naphthyl, or a substituted or unsubstituted carbazolyl is more is preferable, phenyl which may be substituted with an alkyl or a cycloalkyl that may be substituted with an alkyl, a fluorenyl which may be substituted with an alkyl or a cycloalkyl that may be substituted with an alkyl, a dibenzothienyl which may be substituted with an alkyl or a cycloalkyl that may be substituted with an alkyl, or a carbazolyl which may be substituted with an alkyl or a cycloalkyl that may be substituted with an alkyl is further is preferable.

As R^{NX} other than the group represented by Formula (G-1) or Formula (G-2), a preferable example includes a group which is phenyl, fluorenyl, carbazolyl, or dibenzothienyl, each of which may be substituted with methyl, t-butyl, t-amyl, or adamanthyl that may be substituted with methyl. Among them, a phenyl which may be substituted with an alkyl or a cycloalkyl that may be substituted with methyl is most preferable.

R^{CX} are each independently hydrogen, a substituted or unsubstituted aryl, a substituted or unsubstituted heteroaryl, a substituted or unsubstituted alkyl, or a substituted or unsubstituted cycloalkyl, the two R^{CX} may form a ring by bonding to each other. R^{CX} is preferably methyl or phenyl. R^{IX} are each independently hydrogen, a substituted or unsubstituted aryl, a substituted or unsubstituted heteroaryl, a substituted or unsubstituted alkyl, or a substituted or unsubstituted cycloalkyl, the two R^{IX} may form a ring by bonding to each other. R^{IX} is preferably methyl or phenyl. Further, as described below, R^{NX} and/or R^{CX} may be bonded to R^{a3} and/or R^{b1}, or R^{a1} and/or R^{c4} via a linking group or single bond,

At least one selected from the group consisting of X¹ and X² is >N-R^{NX} having R^{NX} that is a group represented by Formula (G-1) or Formula (G-2). Hereinafter, >N-R^{NX} having R^{NX} that is a group represented by Formula (G-1) may be referred to as ">N-(G-1)," and >N-R^{NX} having R^{NX} that is a group represented by Formula (G-2) as ">N-(G-2)." That is, one of X¹ and X² may be >N-(G-1) or >N-(G-2), or each may be >N-(G-1) or >N-(G-2). X¹ and X² may each be >N-(G-1), where the two >N-(G-1) may be the same or different. X¹ and X² may each be >N-(G-2), where the two >N-(G-2) may be the same or different. One of X¹ and X² may be >N-(G-1), and the other may be >N-(G-2).

Preferably, one of X¹ and X² is >N-(G-1) or >N-(G-2) and the other is >N-R^{NX} (R^{NX} may be a group represented by Formula (G-1) or Formula (G-2) or another group.), >C(-R^{CX})₂, or >O, and more preferably one of X¹ and X² is >N-(G-1) or >N-(G-2) and the other is>N-R^{NX}(R^{NX} may be a group represented by Formula (G-1) or Formula (G-2) or another group.

### Group represented by Formula (G-1)

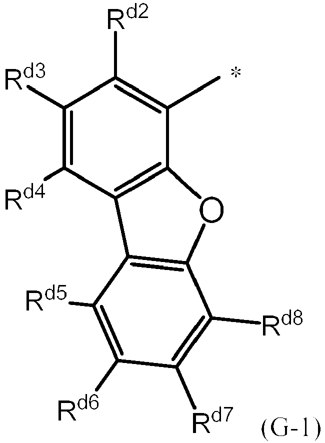

In Formula (G-1), R^{d2} to R^{d8} are each independently hydrogen or a substituent, any two adjacent groups of R^{d2} to R^{d8} may be bonded to each other to form a substituted or unsubstituted aryl ring or a substituted or unsubstituted heteroaryl ring together with the two carbon atoms to which they are bonded.

As each of R^{d2} to R^{d8} when it is a substituent and as a substituent to the ring formed as above, at least one substituent selected from Substituent Group Zα can be exemplified, and at least one substituent selected from Substituent Group Z is preferable, a substituted or unsubstituted alkyl, a substituted or unsubstituted cycloalkyl, a substituted or unsubstituted aryl, a substituted or unsubstituted heteroaryl, or a substituted or unsubstituted diarylamino is preferable, an unsubstituted alkyl, a cycloalkyl which may be substituted with methyl, an aryl which may be substituted with an alkyl or a cycloalkyl that may be substituted with methyl, or a heteroaryl which may be substituted with an alkyl or a cycloalkyl that may be substituted with methyl is more preferable, and an adamanthyl (which may be substituted with methyl, t-butyl, t-amyl, or methyl)or a phenyl(which may be substituted with methyl, t-butyl, t-amyl, or an adamanthyl that may be substituted with methyl) is further preferable. The examples of preferred substituents described below can also be referred to. When two or more of R^{d2} to R^{d8} are substituents, the substituents may be the same or different.

It is preferable that R^{d2} to R^{d8} are all hydrogens, or at least one selected from the group consisting of R^{d3}, R^{d6}, and R^{d8} is an aryl which may be substituted with an alkyl (preferably t-butyl) or an alkyl (preferably t-butyl) and the rest are hydrogens.

Examples of the ring formed of the two adjacent groups of R^{d2} to R^{d8} being bonded to each other, together with the two carbon atoms to which they are bonded are not particularly limited but include benzene ring, naphthalene ring, indene ring, fluorene ring, pyridine ring, furan ring, thiophene ring, pyrrole ring, benzofuran ring, benzothiophene ring, indole ring, selenophene ring, benzoselenophene ring and the like. Benzene ring is more preferable. The above formed ring may independently have a substituent. An example of the substituent includes at least one substituent selected from Substituent Group Zα. At least one substituent selected from Substituent Group Z is preferable, a substituted or unsubstituted alkyl, a substituted or unsubstituted cycloalkyl, a substituted or unsubstituted aryl, a substituted or unsubstituted heteroaryl, or a substituted or unsubstituted diarylamino is more preferable, an unsubstituted alkyl, a cycloalkyl which may be substituted with methyl, an aryl which may be substituted with an alkyl or a cycloalkyl that may be substituted with methyl, or a heteroaryl which may be substituted with an alkyl or a cycloalkyl that may be substituted with methyl is further preferable, and adamanthyl (which may be substituted with methyl, t-butyl, t-amyl, or methyl) or phenyl (which may be substituted with methyl, t-butyl, t-amyl, or adamanthyl that may be substituted with methyl) is particularly preferable.

A structure in which at least one of the aryl rings or heteroaryl rings in Formula (G-1) is condensed with cycloalkane as described below is also preferable. Especially, the formation of a structure in which a partial structure represented by Formula (B-1) or Formula (B-2) as described below is bonded to the ring is preferable.

In Formula (G-1), * indicates the bonding position with the nitrogen atom (N in >N-R^{NX}).

Examples of the groups represented by Formula (G-1) are as follows. In the following formulas, * indicates the bonding position with the nitrogen atom.

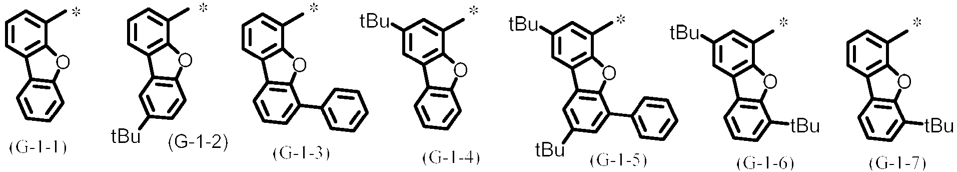

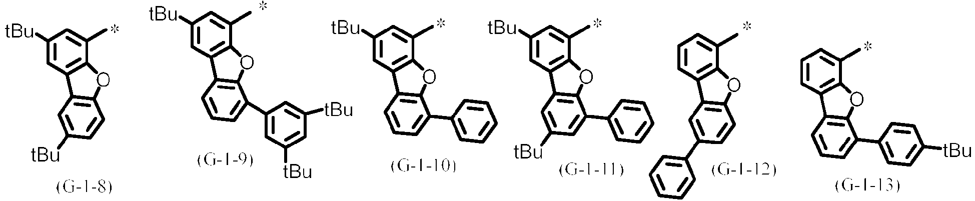

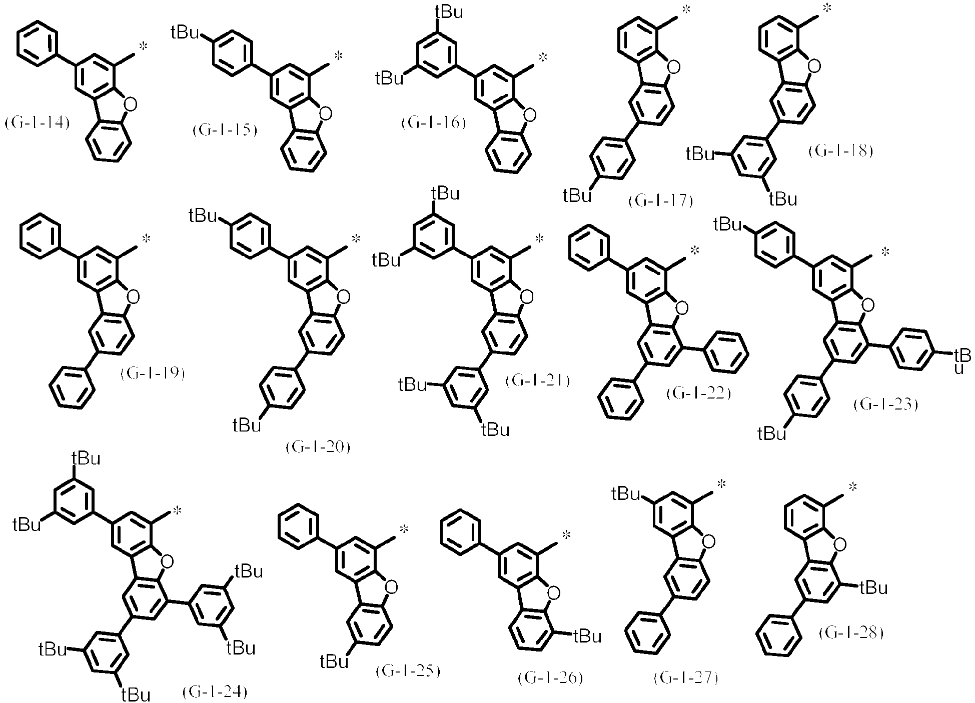

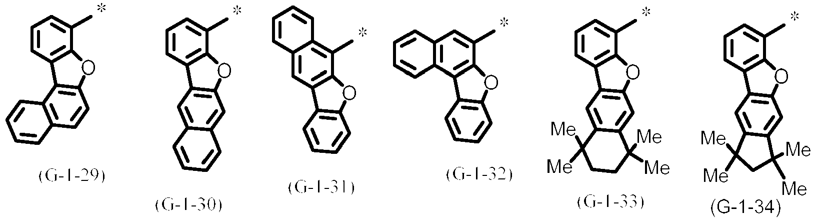

Among the groups represented by Formula (G-1-1) to Formula (G-1-34), the group represented by Formula (G-1-1), Formula (G-1-2), Formula (G-1-3), Formula (G-1-4), Formula (G-1-7), Formula (G-1-8), Formula (G-1-9), Formula (G-1-10), Formula (G-1-11), Formula (G-1-12), Formula (G-1-13), Formula (G-1-14), Formula (G-1-15), Formula (G-1-16), Formula (G-1-17), Formula (G-1-18), Formula (G-1-19), Formula (G-1-20), Formula (G-1-21), Formula (G-1-25), Formula (G-1-26), Formula (G-1-27), Formula (G-1-28), Formula (G-1-33), or Formula (G-1-34) is preferable, the group represented by Formula (G-1-1), Formula (G-1-2), Formula (G-1-3), Formula (G-1-4), Formula (G-1-5), Formula (G-1-7), Formula (G-1-8), Formula (G-1-11), Formula (G-1-12), Formula (G-1-13), Formula (G-1-14), Formula (G-1-15), Formula (G-1-16), Formula (G-1-17), Formula (G-1-18), Formula (G-1-19), Formula (G-1-20), Formula (G-1-21), Formula (G-1-33), or Formula (G-1-34) is more preferable, , the group represented by Formula (G-1-1), Formula (G-1-2), Formula (G-1-3), Formula (G-1-4), Formula (G-1-7), or Formula (G-1-8) is further preferable, and the group represented by Formula (G-1-1), Formula (G-1-2), Formula (G-1-3), Formula (G-1-4), or Formula (G-1-8) is most preferable.

### Group represented by Formula (G-2)

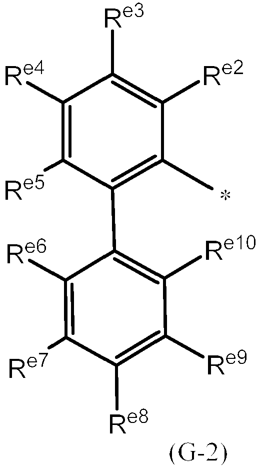

In Formula (G-2), * indicates the bonding position with the nitrogen atom (N in >N-R^{NX}), R^{e2} to R^{e10} are each independently hydrogen or a substituent, provide that at least one selected from the group consisting of R^{e6} to R^{e10} is Substituent e, or at least one of the aryl rings or heteroaryl rings in Formula (G-2) is condensed with at least one cycloalkane, at least one hydrogen in the cycloalkane may be replaced with a substituent, and at least one -CH₂- in the cycloalkane may be replaced with - O-. When the benzene ring to which R^{e2} to R^{e5} are bonded is condensed with cycloalkane as described above, and the benzene ring to which R^{e6} to R^{e10} are bonded is not condensed with cycloalkane as described above, at least one selected from the group consisting of R^{e6} to R^{e10} is preferably Substituent e. Substituent e is a substituent selected from the group consisting of an alkyl, a cycloalkyl that may be substituted with at least one alkyl, and an aryl which may be substituted with at least one of an alkyl or a cycloalkyl that may be substituted with an alkyl.

As Substituent e, an unsubstituted alkyl, a cycloalkyl which may be substituted with methyl, or an aryl which may be substituted with an alkyl or a cycloalkyl that may be substituted with methyl is more preferable, methyl, t-butyl, t-amyl, adamanthyl that may be substituted with methyl, or phenyl(which may be substituted with methyl, t-butyl, t-amyl, or adamanthyl that may be substituted with methyl)is further preferable.

Furthermore, even when Formula (G-2) has a condensed cycloalkane structure as described above, the structure which corresponds to a structure in which any two adjacent groups among R^{e2} to R^{e5} are bonded to each other preferably has at least one selected from the group consisting of R^{e6} to R^{e10} as Substituent e.

As each of R^{e2} to R^{e10}, when it is a substituent, at least one substituent selected from Substituent Group Zα can be exemplified, and at least one substituent selected from Substituent Group Z is preferable, a substituted or unsubstituted alkyl, a substituted or unsubstituted cycloalkyl, a substituted or unsubstituted aryl, a substituted or unsubstituted heteroaryl, or a substituted or unsubstituted diarylamino is preferable, an unsubstituted alkyl, a substituted or unsubstituted cycloalkyl, or an aryl which may be substituted with an alkyl is more preferable, methyl, t-butyl, t-amyl, adamanthyl that may be substituted with methyl, or phenyl(which may be substituted with methyl, t-butyl, t-amyl, or adamanthyl that may be substituted with methyl)is further preferable, and methyl, t-butyl, or phenyl that may be substituted with t-butyl is particularly preferable. The examples of preferred substituents described below can also be referred to. When two or more of R^{e2} to R^{e10} are substituents, the substituents may be the same or different.

It is preferable that one to four of R^{e2} to R^{e10} are substituents and the rest are hydrogens, and it is more preferable that one to three of R^{e2} to R^{e10} are substituents and the rest are hydrogens. For example, a structure in which R^{e9} is substituent, a structure in which R^{e8} is substituent, a structure in which R^{e7} and R^{e9} are substituents, or the like is preferable. Particularly, R^{e8} is preferably a substituent.

A structure in which the aryl ring or heteroaryl ring in Formula (G-2) is condensed with cycloalkane is also preferable. At least one hydrogen in the cycloalkane may be replaced with a substituent, and at least one -CH₂- in the cycloalkane may be replaced with -O-. The structure condensed with cycloalkane corresponds to a structure in which any two adjacent groups from R^{e2} to R^{e10} are bonded to each other to form a cycloalkene (cyclohexene, cyclopentene, etc.) together with the two carbon atoms to which they are bonded. This structure is preferably a partial structure represented by Formula (B-1) or Formula (B-2) described below.

An example of a group represented by Formula (G-2) is, more specifically, a group represented by one of the following formulas. In the following formulas, * indicates the bonding position with the nitrogen atom. In addition, at least one hydrogen of the benzene ring in the group represented by any of the following formulas may be replaced with methyl.

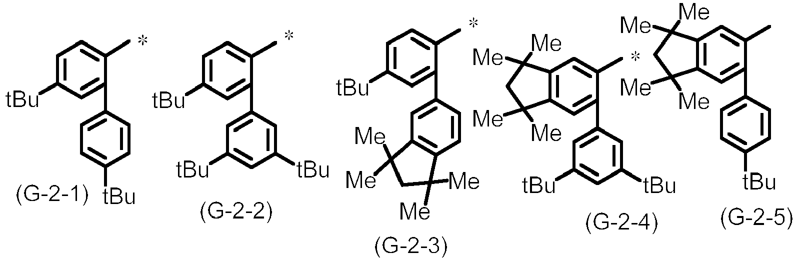

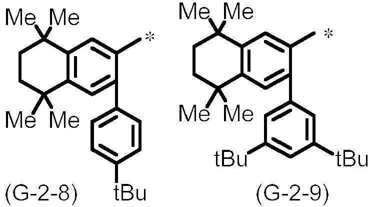

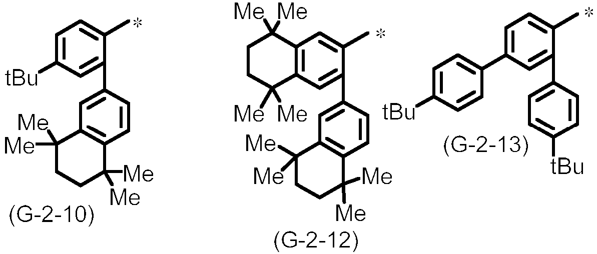

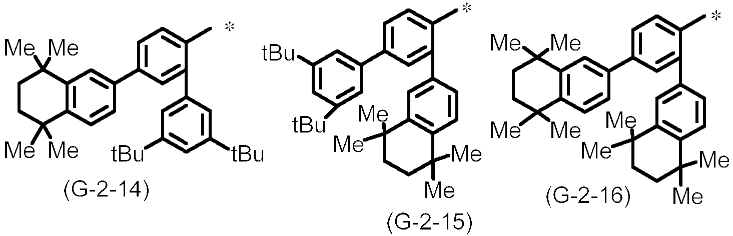

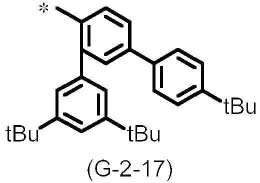

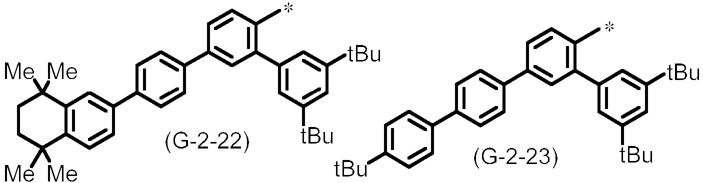

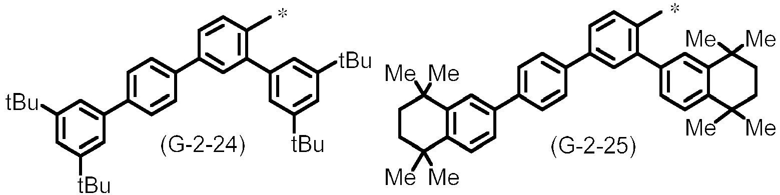

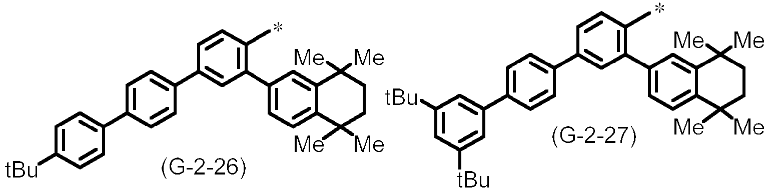

Among the groups above, the group represented by Formula (G-2-1), Formula (G-2-2), Formula (G-2-3), Formula (G-2-4), Formula (G-2-5), Formula (G-2-8), Formula (G-2-9), Formula (G-2-10), Formula (G-2-12), Formula (G-2-13), Formula (G-2-14), Formula (G-2-15), Formula (G-2-16), or Formula (G-2-17) is preferable, the group represented by Formula (G-2-1), Formula (G-2-2), Formula (G-2-8), Formula (G-2-9), Formula (G-2-10) or Formula (G-2-12) is more preferable.

### When R^{NX} is bonded to R^{a3} and/or R^{b1}, or R^{a1} and/or R^{c4}

In Formula (1), R^{NX} and R^{CX} in >N-R^{NX} and >C(-R^{CX})₂ as X¹ or X² may each be bonded to R^{a3} and/or R^{b1}, or R^{a1} and/or R^{c4} via a linking group or single bond. That is, R^{NX} and R^{CX} in X¹ may each be bonded to R^{a3} and/or R^{b1} via a linking group or single bond, and R^{NX} and R^{CX} in X² may each be bonded to R^{a1} and/or R^{c4} via a linking group or single bond. As the linking group, -O-, -S-, - C(=O)-, or -C(-R¹³)₂- is preferable. For example, carbazole ring, phenoxazine ring, phenothiazine ring, or acridone ring can be formed by incorporating one of X¹ or X² to a-ring as benzene ring, for example.

Further, an embodiment in which R^{NX} in >N-R^{NX} is a substituted or unsubstituted cycloalkyl and is bonded to R^{a3}, R^{a1}, R^{b1}, or R^{c4} via single bond is also preferable. As the cycloalkyl, a substituted or unsubstituted cyclopentyl or a substituted or unsubstituted cyclohexyl is preferable.

A particularly preferable example of the condensed ring formed as described above includes the structure represented by Formula (A11). In Formula (A11), * corresponds to an embodiment in which the bonding is via single bond in the definition as "R^{NX} and R^{CX} in >N-R^{NX} and >C(-R^{CX})₂ as X¹ or X² may each be bonded to R^{a3} and/or R^{b1}, or R^{a1} and/or R^{c4} via a linking group or single bond." In this case, the two carbons each substituted by methyl are chiral carbons, and as the compound represented by Formula (1) diastereomers and enantiomers may exist as described above. The compounds represented by Formula (1) may be any of those isomers, and may also be in a form in which possible isomers are mixed in any ratio.

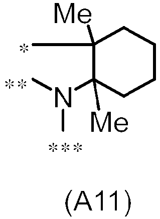

The structure represented by Formula (A11) is bonded to one of the two rings to which X¹ or X² are bonded at positions * and **, and to the other ring at position ***.

An embodiment in which R^{NX} in >N-R^{NX} is a phenyl and is bonded to a ring, b ring, or c ring via single bond can also be exemplified.

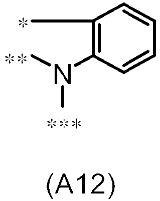

The structure represented by Formula (A12) is bonded to one of the two rings to which X¹ or X² are bonded at positions * and **, and to the other ring at position ***.

### <R^{a1} to R^{a3}, R^{b1} to R^{b4}, and R^{c1} to R^{c4}>

In Formula (1), R^{a1} to R^{a3}, R^{b1} to R^{b4}, and R^{c1}to R^{c4} are each independently hydrogen or a substituent, and the any adjacent groups of R^{a1} to R^{a3}, R^{b1} to R^{b4}, and R^{c1} to R^{c4} may be bonded to each other to form a substituted or unsubstituted aryl ring or a substituted or unsubstituted heteroaryl ring together with the two carbon atoms to which they are bonded, provided that at least one of R^{c1} to R^{c4} is a substituted or unsubstituted aryl or a substituted or unsubstituted heteroaryl.

As each of R^{a1} to R^{a3}, R^{b1} to R^{b4}, and R^{c1} to R^{c4} when it is a substituent and as a substituent to the ring formed as above, at least one substituent selected from Substituent Group Zα can be exemplified, and at least one substituent selected from Substituent Group Z is preferable, a substituted or unsubstituted alkyl, a substituted or unsubstituted cycloalkyl, a substituted or unsubstituted aryl, a substituted or unsubstituted heteroaryl, a substituted or unsubstituted arylheteroarylamino, or a substituted or unsubstituted diarylamino is more preferable, an unsubstituted alkyl, a cycloalkyl which may be substituted with methyl, an aryl which may be substituted with an alkyl or a cycloalkyl that may be substituted with methyl, a heteroaryl which may be substituted with an alkyl or a cycloalkyl that may be substituted with methyl, a diarylamino which may be substituted with an alkyl or a cycloalkyl that may be substituted with methyl, an arylheteroarylamino which may be substituted with an alkyl or a cycloalkyl that may be substituted with methyl, or a carbazolyl which may be substituted with an alkyl or a cycloalkyl that may be substituted with methyl is further preferable, and methyl, t-butyl, t-amyl, adamanthyl that may be substituted with methyl, or any of the following groups each of which may be substituted with methyl, t-butyl, t-amyl, or adamanthyl that may be substituted with methyl is particularly preferable: phenyl, phenyldibenzofuranylamino, biphenylyldibenzofuranylamino, naphthyldibenzofuranylamino, diphenylamino, phenylnaphthylamino, phenylbiphenylylamino, or carbazolyl.

A structure in which any two adjacent carbon atoms in any aryl ring or heteroaryl ring in the aryl, the heteroaryl, the diarylamino, the arylheteroarylamino, the phenyl, the carbazolyl, the phenyldibenzofuranylamino, the biphenylyldibenzofuranylamino, the naphthyldibenzofuranylamino, the diphenylamino, the phenylnaphthylamino, the phenylbiphenylylamino, or the carbazolyl are bonded to a partial structure represented by Formula (B-1) or Formula (B-2) as described below can also be exemplified. For the substituent, preferred substituents described below can also be referred tom and t-butyl is particularly preferable.

At least one of R^{c1} to R^{c4} is a substituted or unsubstituted aryl, or a substituted or unsubstituted heteroaryl. Here, the substituent to the aryl and heteroaryl is preferably selected from the group consisting of an alkyl and a substituted or unsubstituted cycloalkyl (a cycloalkyl which may be substituted with methyl is preferable, and adamanthyl which may be substituted with methyl is more preferable.)

At least one of R^{c1} to R^{c4} is preferably an aryl which may be substituted with an alkyl, more preferably phenyl which may be substituted with an alkyl, and further preferably unsubstituted phenyl.

Preferably one or two, further preferably one of R^{c1} to R^{c4} is a substituted or unsubstituted aryl, or a substituted or unsubstituted heteroaryl. The group which is a substituted or unsubstituted aryl or a substituted or unsubstituted heteroaryl is preferably one or two of R^{c2} and R^{c3}, more preferably either one of R^{c2} and R^{c3}, and further preferably R^{c3}. Particularly, it is preferable that R^{c3} is a substituted or unsubstituted aryl or a substituted or unsubstituted heteroaryl(preferably phenyl that may be substituted with t-butyl), and R^{c1}, R^{c2}, and R^{c4} are all hydrogens.

It is preferable that, among R^{a1} to R^{a3}, R^{a2} is hydrogen or a substituent, and R^{a1}and R^{a3} are each hydrogen. As R^{a2}, when R^{a2} is a substituent, a substituted or unsubstituted alkyl, a substituted or unsubstituted cycloalkyl, a substituted or unsubstituted aryl, a substituted or unsubstituted heteroaryl, a substituted or unsubstituted arylheteroarylamino, or a substituted or unsubstituted diarylamino is preferable, an unsubstituted alkyl, a cycloalkyl which may be substituted with methyl, an aryl which may be substituted with an alkyl or a cycloalkyl that may be substituted with methyl, a heteroaryl which may be substituted with an alkyl or a cycloalkyl that may be substituted with methyl, a diarylamino which may be substituted with an alkyl or a cycloalkyl that may be substituted with methyl, an arylheteroarylamino which may be substituted with an alkyl or a cycloalkyl that may be substituted with methyl, a carbazolyl which may be substituted with an alkyl or a cycloalkyl that may be substituted with methyl is more preferable, and methyl, t-butyl, t-amyl, adamanthyl that may be substituted with methyl, or any of the following groups each of which may be substituted with methyl, t-butyl, t-amyl, or adamanthyl that may be substituted with methyl is further preferable: phenyl, phenyldibenzofuranylamino, biphenylyldibenzofuranylamino, naphthyldibenzofuranylamino, diphenylamino, phenylnaphthylamino, phenylbiphenylylamino, carbazolyl.

A structure in which any two adjacent carbon atoms in any aryl ring or heteroaryl ring in the aryl, the heteroaryl, the diarylamino, the arylheteroarylamino, the phenyl, the phenyldibenzofuranylamino, the biphenylyldibenzofuranylamino, the naphthyldibenzofuranylamino, the diphenylamino, the phenylnaphthylamino, the phenylbiphenylylamino, or the carbazolyl are bonded to a partial structure represented by Formula (B-1) or Formula (B-2) as described below is also preferable.

R^{a2} as a substituent is more preferably t-butyl, diphenylamino, or carbazolyl, and further preferably t-butyl.

Among R^{b1} to R^{b4}, preferably R^{b2} or R^{b3} is hydrogen or a substituent and the rest are hydrogens, more preferably R^{b2} or R^{b3} is a substituent and the rest are hydrogens, further preferably R^{b2} is a substituent and the rest are hydrogens.

As each of R^{b1} to R^{b4} (particularly R^{b2} or R^{b3}), when it is a substituent, a substituted or unsubstituted alkyl, a substituted or unsubstituted cycloalkyl, a substituted or unsubstituted aryl, a substituted or unsubstituted heteroaryl, a substituted or unsubstituted diarylamino, a substituted or unsubstituted arylheteroarylamino, or a substituted or unsubstituted carbazolyl is preferable, an unsubstituted alkyl, a cycloalkyl which may be substituted with methyl, an aryl which may be substituted with an alkyl or a cycloalkyl that may be substituted with methyl, a heteroaryl which may be substituted with an alkyl or a cycloalkyl that may be substituted with methyl, a diarylamino which may be substituted with an alkyl or a cycloalkyl that may be substituted with methyl, an arylheteroarylamino which may be substituted with an alkyl or a cycloalkyl that may be substituted with methyl, or a carbazolyl which may be substituted with an alkyl or a cycloalkyl that may be substituted with methyl is more preferable, and methyl, t-butyl, t-amyl, adamanthyl that may be substituted with methyl, or any of the following groups each of which may be substituted with methyl, t-butyl, t-amyl, or adamanthyl that may be substituted with methyl is further preferable: phenyl, phenyldibenzofuranylamino, biphenylyldibenzofuranylamino, naphthyldibenzofuranylamino, diphenylamino, phenylnaphthylamino, phenylbiphenylylamino, carbazolyl.

A structure in which any two adjacent carbon atoms in any aryl ring or heteroaryl ring in the aryl, the heteroaryl, the diarylamino, the arylheteroarylamino, the phenyl, the carbazolyl, the phenyldibenzofuranylamino, the biphenylyldibenzofuranylamino, the naphthyldibenzofuranylamino, the diphenylamino, the phenylnaphthylamino, or the phenylbiphenylylamino are bonded to a partial structure represented by Formula (B-1) or Formula (B-2) as described below is also preferable.

As a substituent as any of R^{b1} to R^{b4}, a substituted or unsubstituted diarylamino, a substituted or unsubstituted arylheteroarylamino, or a substituted or unsubstituted carbazolyl is preferable, t-butyl, a diphenylamino that may be substituted with t-butyl or phenyl, or carbazolyl that may be substituted with t-butyl or phenyl is more preferable, t-butyl or a diphenylamino that may be substituted with t-butyl or phenyl is further preferable.

Examples of the ring formed of any two adjacent groups of R^{a1} to R^{a3}, R^{b1} to R^{b4}, and R^{c1} to R^{c4} being bonded to each other, together with the two carbon atoms to which they are bonded are not particularly limited but include benzene ring, naphthalene ring, indene ring, fluorene ring, pyridine ring, furan ring, thiophene ring, pyrrole ring, benzofuran ring, benzothiophene ring, indole ring, selenophene ring, benzoselenophene ring, and carbazole ring, and benzene ring, naphthalene ring, naphthalene ring, benzofuran ring, benzothiophene ring, indole ring, or carbazole ring is preferable. It is also preferable that any two adjacent groups in R^{c1} to R^{c4} are not bonded to each other to form a ring.

A more preferable embodiment of the polycyclic aromatic compound represented by Formula (1) includes a polycyclic aromatic compound represented by Formula (1-A) below.

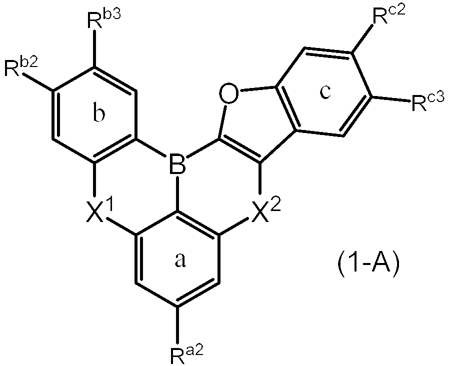

In Formula (1-A), for definitions of symbols in the formula or the like and their preferred ranges, the descriptions in the present specification can be referred to.

### <Structure consisting of one or two or more structural units>

The polycyclic aromatic compound of the present invention is a polycyclic aromatic compound having a structure consisting of one or two or more structural units represented by Formula (1). An example of the polycyclic aromatic compound having a structure consisting of one structural unit above includes a polycyclic aromatic compound represented by Formula (1). An example of the polycyclic aromatic compound having a structure consisting of two or more structural units represented by Formula (1) includes a compound corresponding to a multimer form of polycyclic aromatic compound represented by the formula described above as the structural unit represented by Formula (1). The multimer is preferably dimer to hexamer, more preferably dimer to trimer, and particularly preferably dimer. The multimer only needs have a form having a plurality of unit structures in one compound, and for example, the multimer may have a form in which arbitrary rings (a ring, b ring or c ring) contained in the unit structure are bonded so as to be shared in the plurality of unit structures, or a form in which arbitrary rings (a ring, b ring or c ring) contained in the unit structure are bonded so as to be fused to each other. In addition, the multimer may have a form in which a plurality of unit structures are bonded by a single bond or a linking group such as an alkylene group having 1 to 3 carbons, phenylene, or naphthylene. Among them, a form in which arbitrary rings are bonded so as to be shared in a plurality of unit structures is preferable.

### <Preferred substituents>

In polycyclic aromatic compounds used as emitting dopants (and other compounds used as dopants), a tertiary alkyl substituent represented by the following Formula (tR) as the substituent containing "alkyl" is particularly preferred. This is because the emission quantum yield (PLQY) is improved as the intermolecular distance is increased by such a bulky substituent. Also preferred is a substituent in which a tertiary-alkyl represented by Formula (tR) is substituted to another substituent as a second substituent. Specific examples thereof include a diarylamino substituted with a tertiary-alkyl represented by (tR), a carbazolyl substituted with a tertiary-alkyl represented by (tR) (preferably, N-carbazolyl) or a benzocarbazolyl substituted with a tertiary-alkyl represented by (tR) (preferably, N-benzocarbazolyl). Substituted forms of groups of Formula (tR) to diarylamino, carbazolyl and benzocarbazolyl include examples in which some or all hydrogens of the aryl ring or the benzene ring in these groups are replaced with groups of Formula (tR).

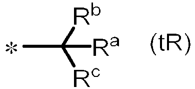

In Formula (tR), R^{a}, R^{b} and R^{c} are each independently an alkyl having 1 to 24 carbons, any-CH₂-in the alkyl may be replaced with -O-, and the group represented by Formula (tR) has bonding position at *.

"Alkyl having 1 to 24 carbons" as R^{a}, R^{b}, and R^{c} may be either a straight chain or a branched chain, for example, a straight chain alkyl having 1-24 carbons or a branch chain alkyl having 3 to 24 carbons. Examples include an alkyl having 1 to 18 carbons (a branch chain alkyl having of 3-18 carbons), an alkyl having 1 to 12 carbons (a branch chain alkyl having 3-12 carbons), an alkyl having 1 to 6 carbons (a branch chain alkyl having 3 to 6 carbons), or an alkyl having 1 to 4 carbons (a branch chain alkyl having 3 to 4 carbons).

The sum of the number of carbons in R^{a}, R^{b}, and R^{c} in Formula (tR) is preferably from 3 to 20, and particularly preferably from 3 to 10.

Specific alkyls of R^{a}, R^{b} and R^{c} include methyl, ethyl, n-propyl, isopropyl, n-butyl, isobutyl, s-butyl, t-butyl, n-pentyl, isopentyl, neopentyl, t-pentyl, n-hexyl, 1-methylpentyl, 4-methyl-2-pentyl, 3,3-dimethylbutyl, 2-ethylbutyl, n-heptyl, 1-methylhexyl, n-octyl, t-octyl, 1-methylheptyl, 2-ethylhexyl, 2-propylpentyl, n-nonyl, 2,2-dimethylheptyl, 2,6-dimethyl-4-heptyl, 3,5,5-trimethylhexyl, n-decyl, n-undecyl, 1-methyldecyl, n-dodecyl, n-tridecyl, 1-hexylheptyl, n-tetradecyl, n-pentadecyl, n-hexadecyl, n-heptadecyl, n-octadecyl and n-eicosyl.

Examples of a group represented by Formula (tR) include t-butyl, t-amyl, 1-ethyl-1-methylpropyl, 1,1-diethylpropyl, 1,1-diethylbutyl, 1-ethyl-1-methylbutyl, 1,1,3,3-tetramethylbutyl, 1,1,4-trimethylpentyl, 1,1,2-trimethylpropyl, 1,1-dimethyloctyl, 1,1-dimethylpentyl, 1,1-dimethylheptyl, 1,1,5-trimethylhexyl, 1-ethyl-1-methylhexyl, 1-ethyl-1,3-dimethylbutyl, 1,1,2,2-tetramethylpropyl, 1-butyl-1-methylpentyl, 1,1-diethylbutyl, 1-ethyl-1-methylpentyl, 1,1,3-trimethylbutyl, 1-propyl-1-methylpentyl, 1,1,2-trimethylpropyl, 1-ethyl-1,2,2-trimethylpropyl, 1-propyl-1-methylbutyl, 1,1-dimethylhexyl, and the like. Of these, t-butyl and t-amyl are preferred.

The substituents represented by Formula (A30) are also preferred as the substituent.

The emission wavelength can be tuned by the steric hindrance, electron-donating and electron-withdrawing nature of the structure of the substituents in a compound used as a dopant (an assisting dopant or an emitting dopant). Preferable examples are the groups represented by the following structural formulas. Among them, methyl, t-butyl, t-amyl, t-octyl, neopentyl, adamantyl, phenyl, o-tolyl, p-tolyl, 2,4-xylyl, 2,6-xylyl, diphenylamino, di-p-tolylamino, bis(p-(t-butyl)phenyl)amino, carbazolyl, 3,6-dimethylcarbazolyl, 3,6-di-t-butylcarbazolyl and phenoxy are more preferred, and methyl, t-butyl, t-amyl, t-octyl, neopentyl, adamantyl, phenyl, o-tolyl, 2,6-xylyl, 2,4,6-mesityl, diphenylamino, di-p-tolylami no, bis(p-(t-butyl)pheny)amino, carbazolyl, 3,6-dimethylcarbazolyl and 3,6-di-t-butylcarbazolyl are further preferred. From the viewpoint of ease of synthesis, a larger steric hindrance is preferred for selective synthesis, and specifically, t-butyl, t-amyl, t-octyl, adamanthyl, o-tolyl, 2,4-xylyl, 2,5-xylyl, 2,6-xylyl, 2,4,6-mesityl, di-p-tolylamino, bis(p-(t-butyl)phenyl)amino, 3,6-dimethylcarbazolyl and 3,6-di-t-butylcarbazolyl are preferred.

In the structural formula below, * indicates the bonding position.

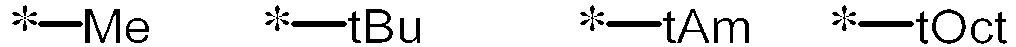

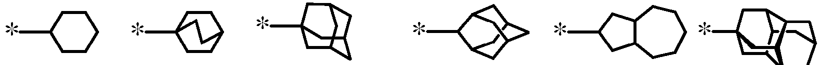

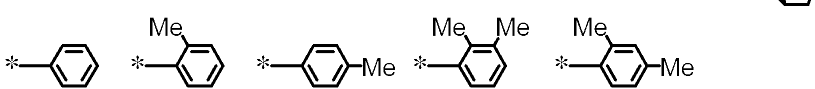

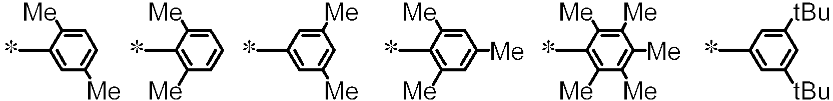

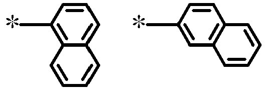

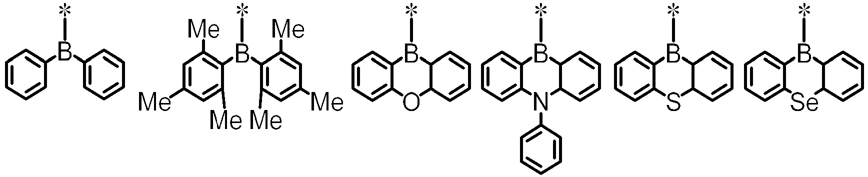

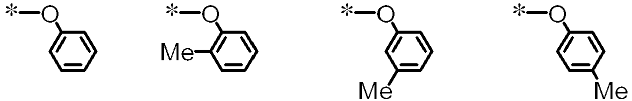

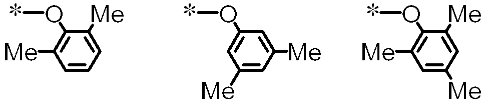

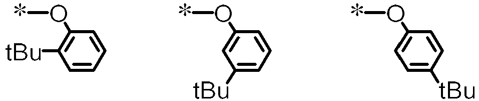

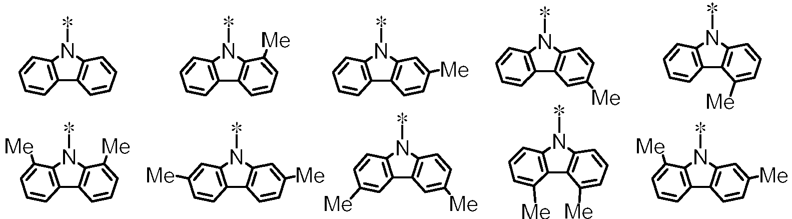

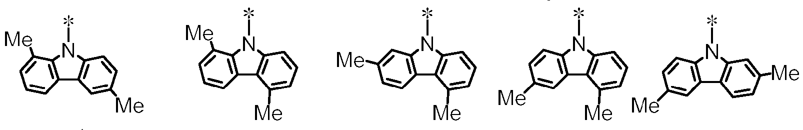

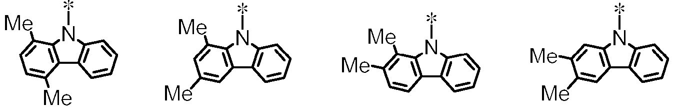

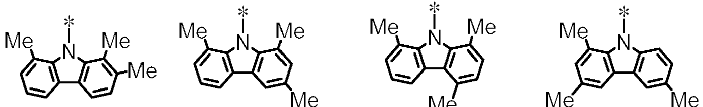

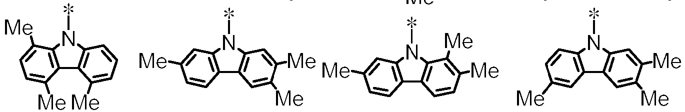

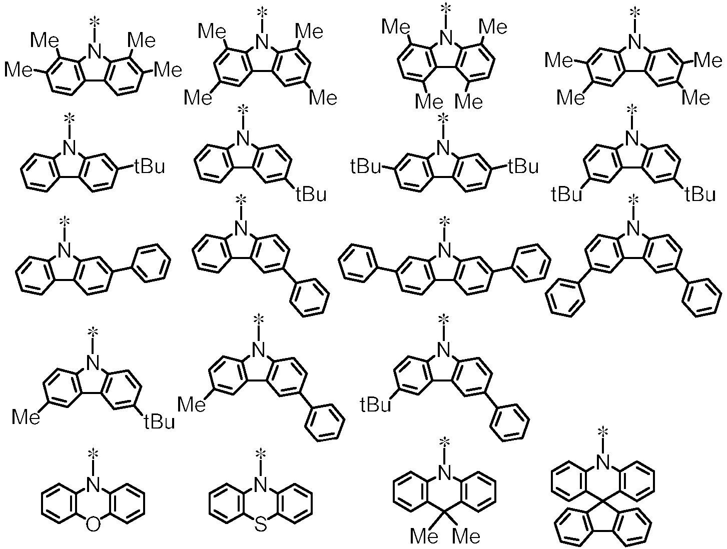

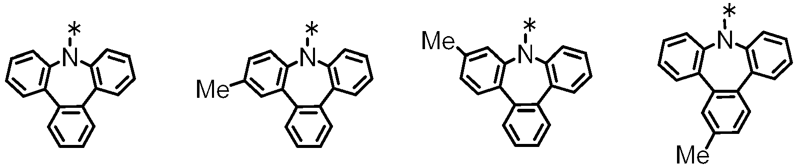

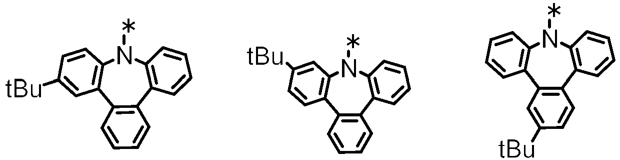

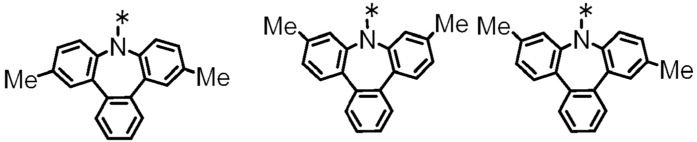

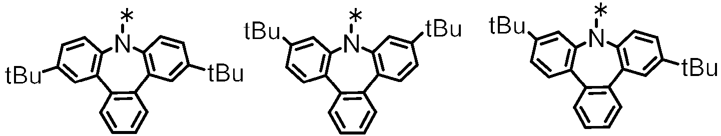

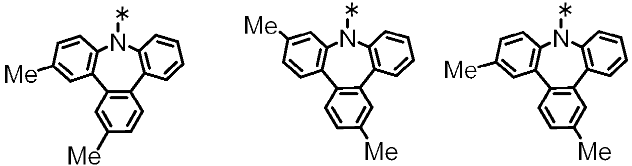

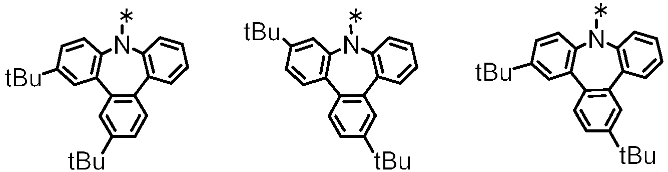

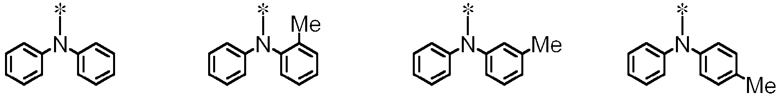

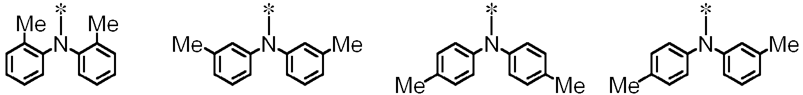

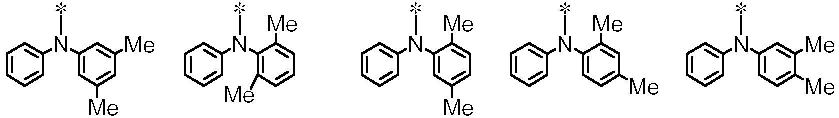

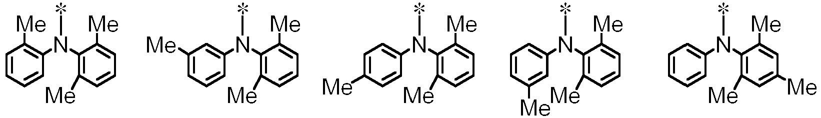

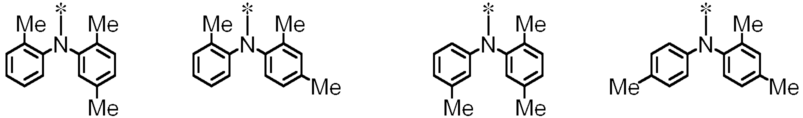

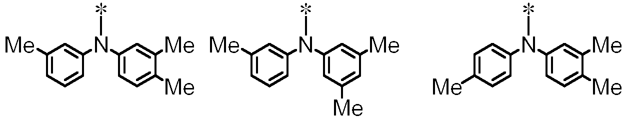

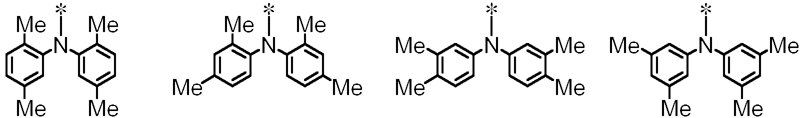

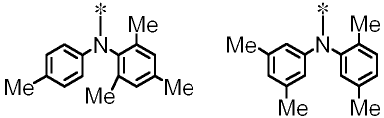

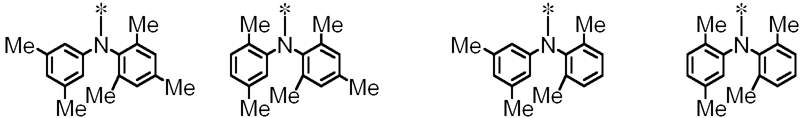

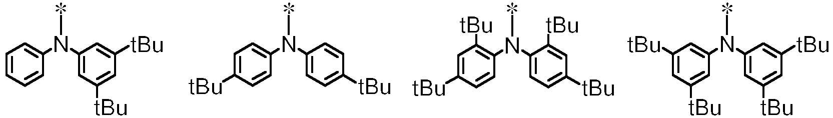

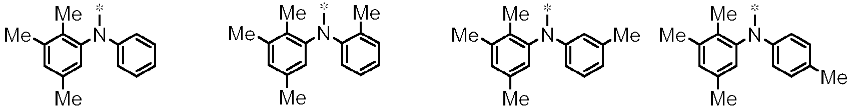

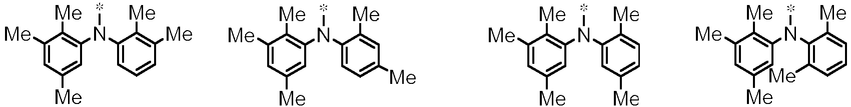

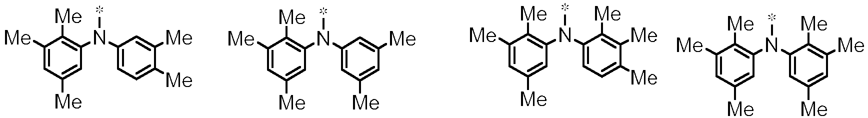

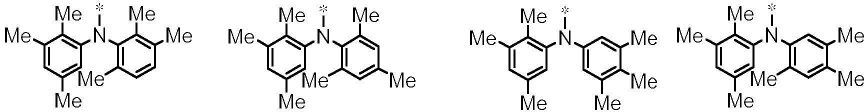

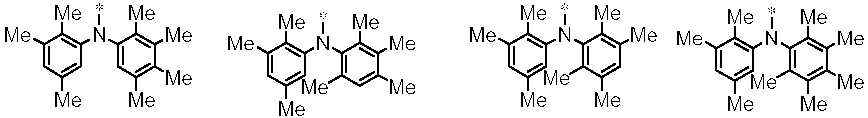

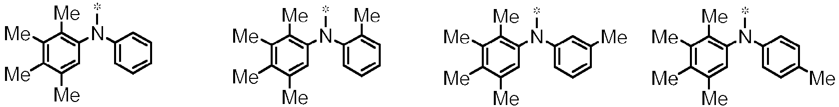

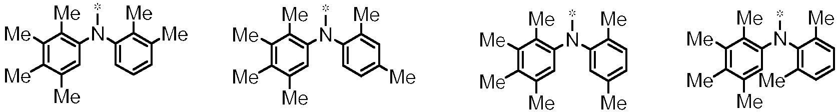

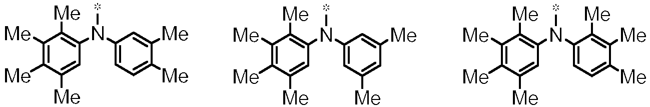

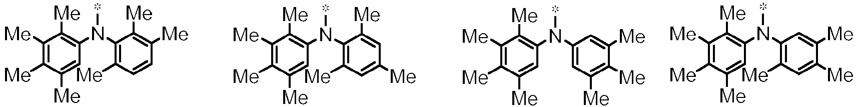

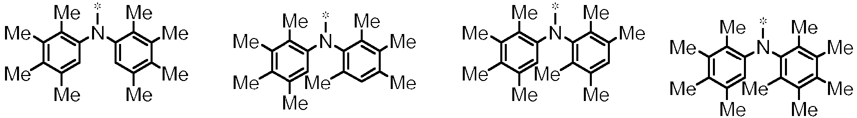

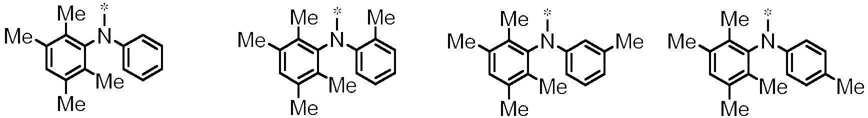

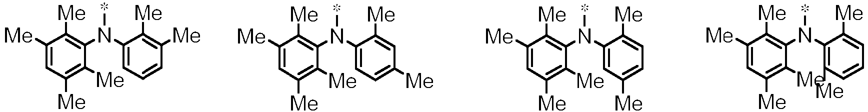

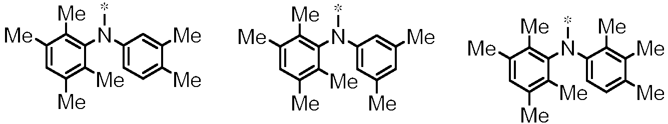

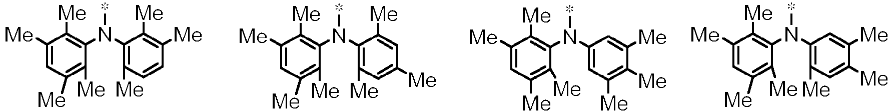

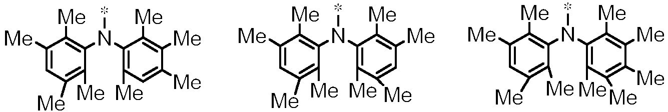

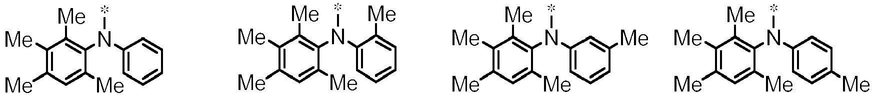

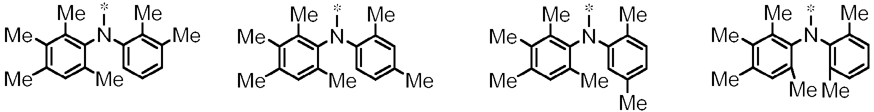

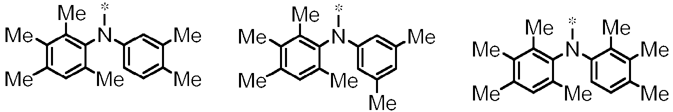

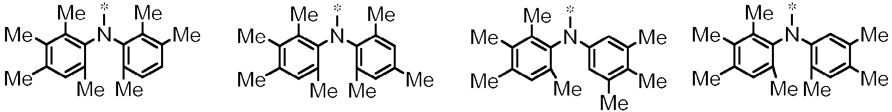

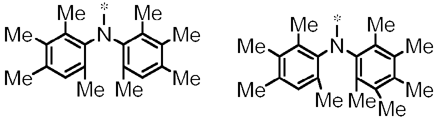

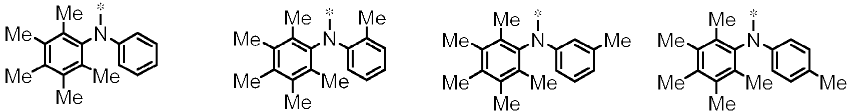

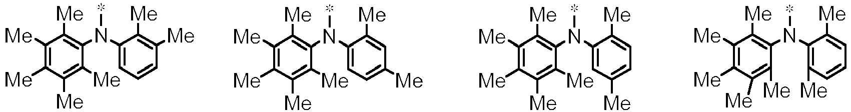

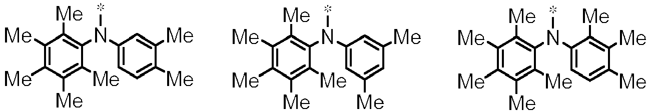

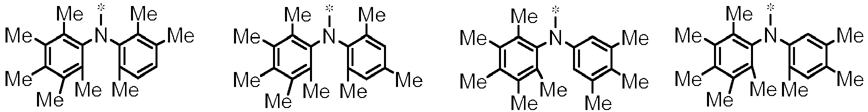

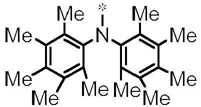

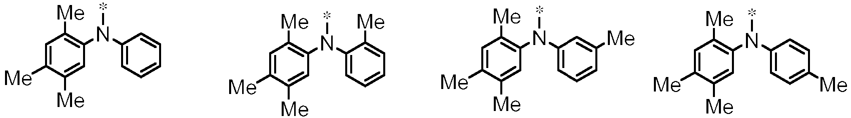

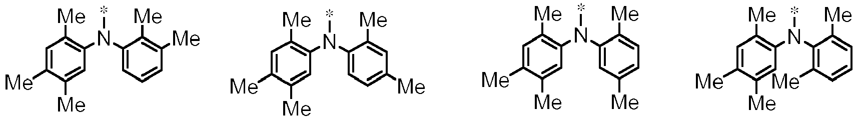

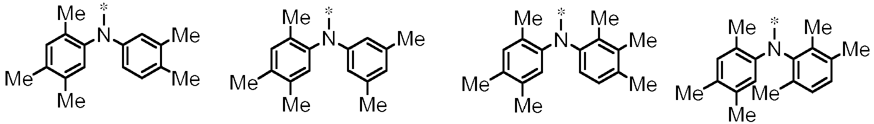

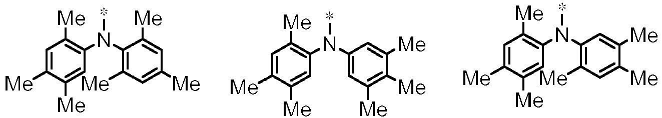

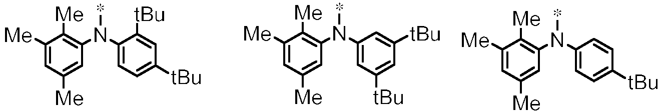

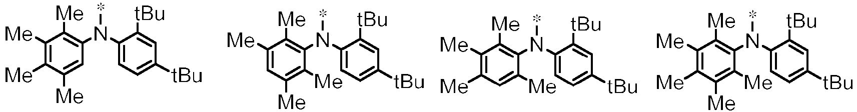

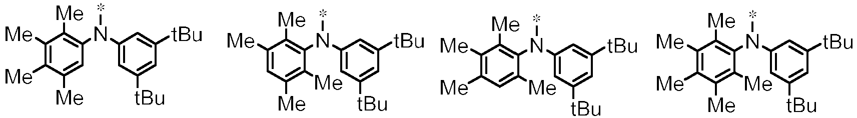

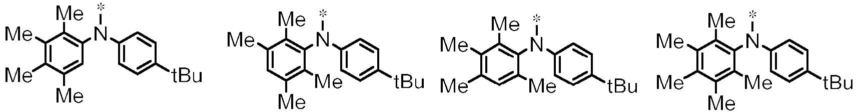

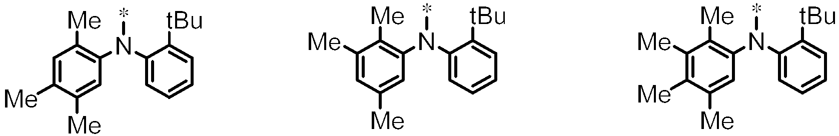

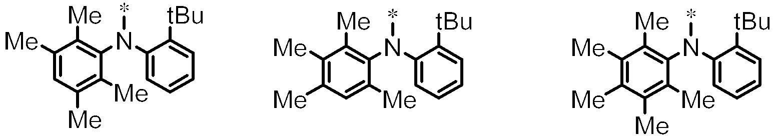

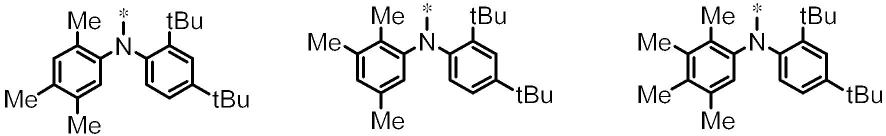

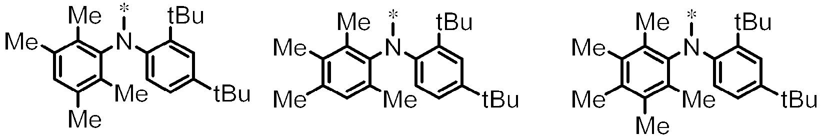

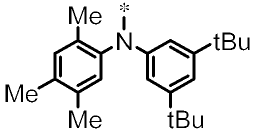

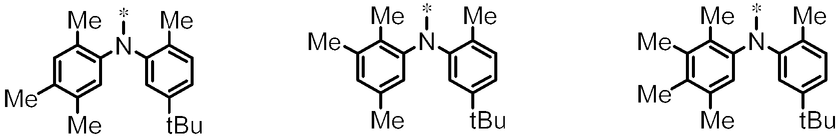

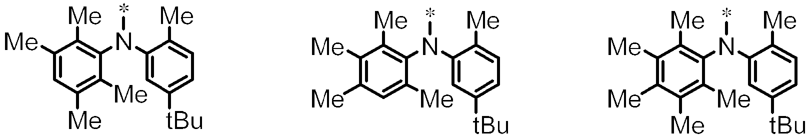

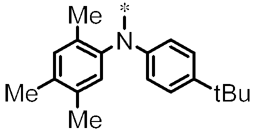

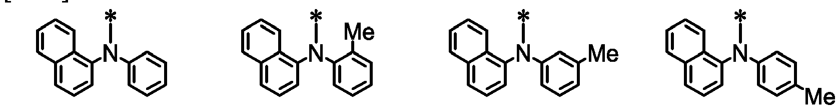

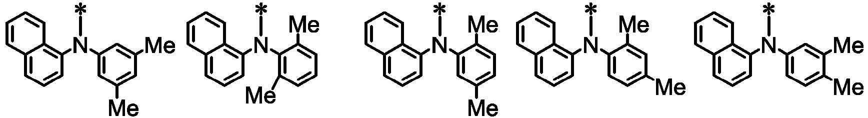

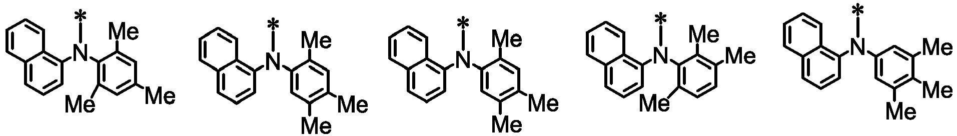

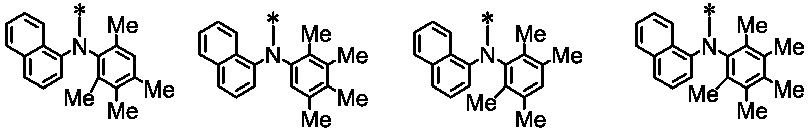

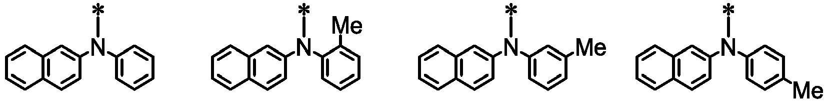

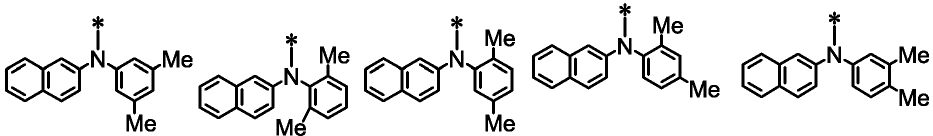

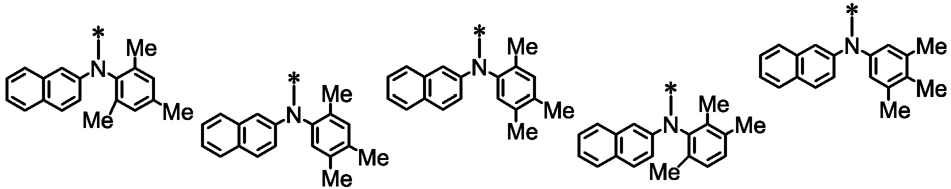

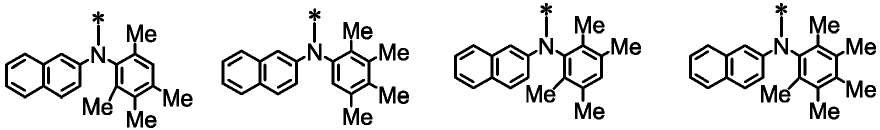

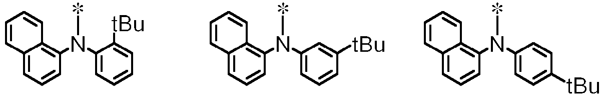

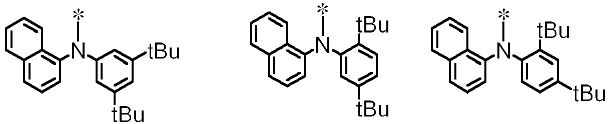

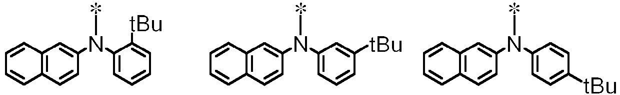

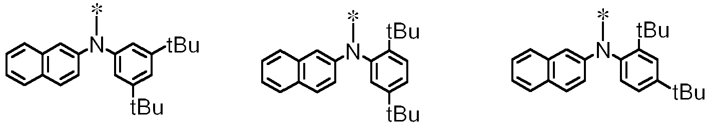

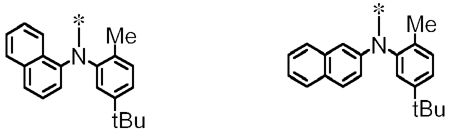

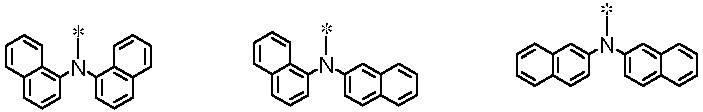

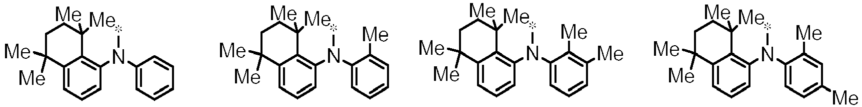

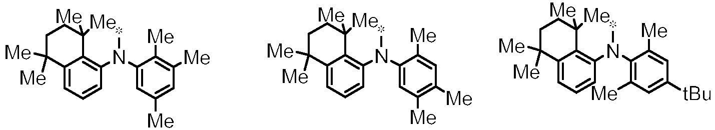

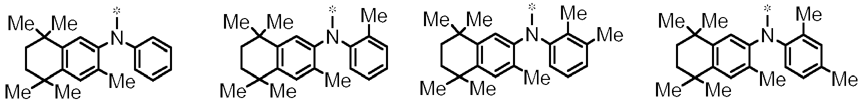

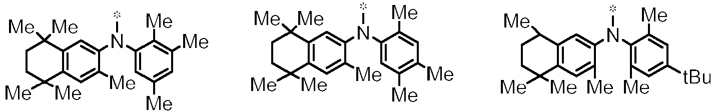

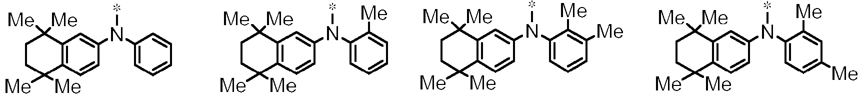

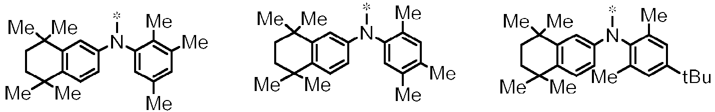

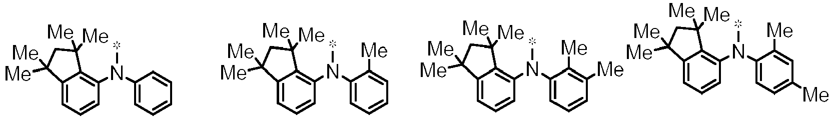

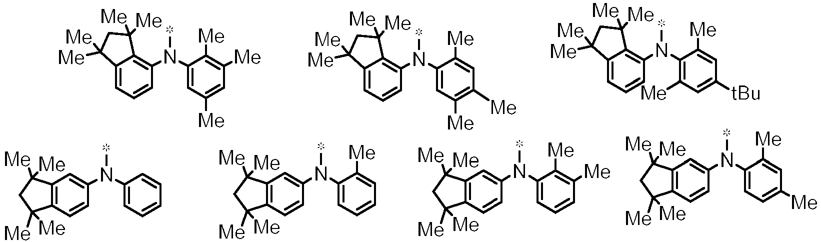

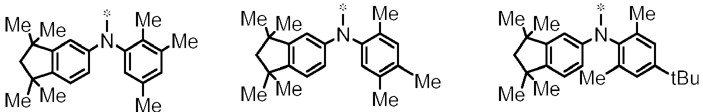

The polycyclic aromatic compound having a structure consisting of one or two or more of the structural units represented by Formula (1) is preferably a structure containing at least one tertiary-alkyl (t-butyl or t-amyl or the like) represented by Formula (tR) described above, neopentyl or adamanthyl, and preferably contains a tertiary-alkyl (t-butyl or t-amyl or the like) represented by Formula (tR) The emission quantum yield (PLQY) is improved because the intermolecular distance is increased by such a bulky substituent. A diarylamino is also preferred as the substituent. Further, a diarylamino substituted with a group of Formula (tR), a carbazolyl substituted with a group of Formula (tR) (preferably N-carbazolyl) or a benzocarbazolyl substituted with a group of Formula (tR) (preferably N-benzocarbazolyl) are also preferred. Substituted forms of groups of Formula (tR) to diarylamino, carbazolyl and benzocarbazolyl include examples in which some or all hydrogens of an aryl ring or a benzene ring in these groups are replaced with groups of Formula (tR).

In the structure consisting of one or two or more of the structural units represented by Formula (1), a substituent to the aryl ring or heteroaryl ring may be a substituent represented by the following Formula (A20).

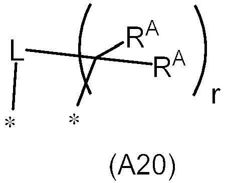

A substituent represented by Formula (A20) is bonded to any two atoms adjacent to each other on a ring of an aryl ring or a heteroaryl ring with two *, respectively, in Formula (A20). In Formula (A20), L is >N-R, >O, >Si(-R)₂ or >S, wherein R of >N-R is a substituted or unsubstituted aryl, a substituted or unsubstituted heteroaryl, a substituted or unsubstituted alkyl, or a substituted or unsubstituted cycloalkyl, R of >Si(-R)₂ is hydrogen, an aryl which may be substituted, an alkyl which may be substituted, or a cycloalkyl which may be substituted, and may be bonded to each other by a linking group, and wherein at least one of Rs in >N-R and >Si(-R)₂ may be bonded to the aryl ring or the heteroaryl ring,
r is an integer between 1 and 4,
each R^{A} is independently hydrogen, a substituted or unsubstituted alkyl or a substituted or unsubstituted cycloalkyl, and any R^{A} may be bonded to any other R ^{A} by a linking group or a single bond.

An Example of the above substituent includes a substituent represented by any one of the following formulas.

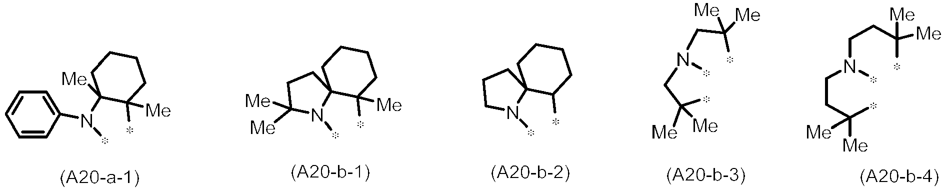

Each substituent may be bonded to two or three atoms that are consecutive (adjacent) on any aryl ring or heteroaryl ring, at *.

### <Cycloalkane Condensation>

At least one selected from the group consisting of aryl rings and heteroaryl rings in a polycyclic aromatic compound having a structure consisting of one or two or more of the structural units represented by Formula (1) may be fused with at least one cycloalkane. However, it is one of preferable embodiment that the aryl rings and heteroaryl rings located in the R^{c1} to R^{c4} positions are not fused with cycloalkanes.

As the cycloalkane, any cycloalkane having 3 to 24 carbons may be used. At least one hydrogen in the cycloalkane may be replaced with an aryl having 6 to 30 carbons, a heteroaryl having 2 to 30 carbons, an alkyl having 1 to 24 carbons or a cycloalkyl having 3 to 24 carbons, and at least one -CH ₂- in the cycloalkane may be replaced with -O-.

The cycloalkane is preferably a cycloalkane having 3 to 20 carbons, wherein at least one hydrogen in the cycloalkane may be replaced with an aryl having 6 to 16 carbons, a heteroaryl having 2 to 22 carbons, an alkyl having I to 12 carbons or a cycloalkyl having 3 to 16 carbons.

"Cycloalkanes" include cycloalkanes having 3 to 24 carbons, cycloalkanes having 3 to 20 carbons, cycloalkanes having 3 to 16 carbons, cycloalkanes having 3 to 14 carbons, cycloalkanes having 5 to 10 carbons, cycloalkanes having 5 to 8 carbons, cycloalkanes having 5 to 6 carbons, and cycloalkanes having 5 carbons.

Specific examples of cycloalkanes include cyclopropane, cyclobutane, cyclopentane, cyclohexane, cycloheptane, cyclooctane, cyclononane, cyclodecane, norbonrane (bicyclo[2.2.1]heptane), bicyclo[1.1.0]butane, bicyclo[1.1.1]pentane, bicyclo[2.1.0]pentane, bicyclo[2.1.1]hexane, bicyclo[3.1.0]hexane, bicyclo[2.2.2]octane, adamantane, diamantine, decahydronaphthalene and decahydroazulene, and a C1-5 alkyl (particularly methyl) substituent thereof, a halogen (especially fluorine) substituent thereof, and a deuterium substituent thereof.

Among these, a structure in which at least one hydrogen is substituted at a carbon at the α-position of a cycloalkane (in a cycloalkyl which is fused to an aryl ring or a heteroaryl ring, a carbon at the position adjacent to a carbon at the fused site) is preferred, and a structure in which two hydrogens at a carbon at an α-position are substituted is more preferred, and a structure in which a total of four hydrogens at a carbon at two α-positions are substituted, as shown in the following structural formulas, is further preferred. Examples of the substituent include an alkyl having 1 to 5 carbons (particularly methyl), a halogen (particularly fluorine), and deuterium. In particular, it is preferable to have a structure in which a partial structure represented by the following Formula (B-1) or (B-2) is bonded to carbon atoms adjacent to each other on an aryl ring or a heteroaryl ring.

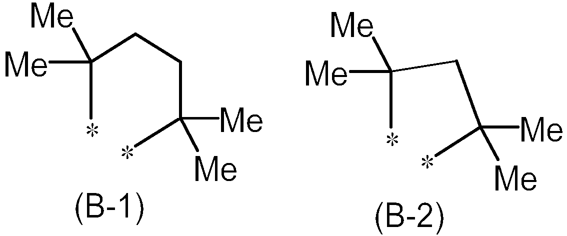

In Formulas (B-1) or (B-2), Me represents methyl and * represents a bonding position.

The number of cycloalkanes to be fused to one aryl ring or heteroaryl ring is preferably 1 to 3, more preferably 1 or 2, and still more preferably 1. Examples of the structures in which one or more cycloalkanes are fused to one benzene ring (phenyl) are shown below * represents a bonding position, and the position may be any of the carbons constituting the benzene ring and not constituting the cycloalkane. Cycloalkanes fused may be further fused to each other as shown in Formula (Cy-1-4) and Formula. (Cy-2-4). The same applies, when the ring (group) to be fused is an aryl ring other than the benzene ring (phenyl) or a heteroaryl ring, and when the cycloalkane to be fused is a cycloalkane other than cyclopentane or cyclohexane.

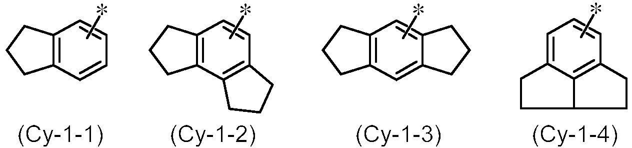

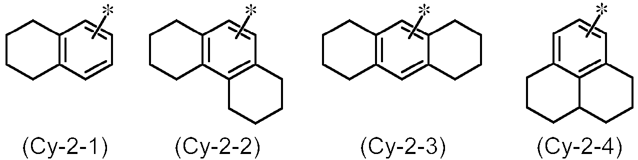

At least one -CH₂- in the cycloalkane may be replaced with -O-. Examples of the structures in which one or more -CH₂-(s) in a cycloalkane fused to a benzene ring (phenyl) are replaced with -O-are shown below. The same applies, when the ring (group) to be fused is an aryl ring other than the benzene ring (phenyl) or a heteroaryl ring, and when the cycloalkane to be fused is a cycloalkane other than cyclopentane or cyclohexane.

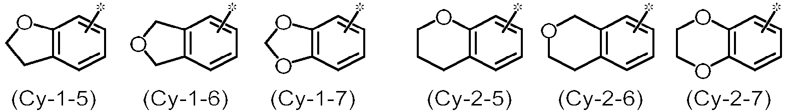

At least one hydrogen in the cycloalkane may be substituted. The examples of the substituent include groups selected from Substituent Group Z. Among these substituents, an alkyl (e.g., an alkyl having 1 to 6 carbons), a cycloalkyl (e.g., a cycloalkyl having 3 to 14 carbons) are preferred. It is also preferred that one or more of the hydrogen is replaced with a halogen (e.g., fluorine) or deuterium. In addition, when cycloalkyl is substituted, it may form a spiro structure. For example, the following shows an example of a spiro structure formed in a cycloalkane fused to a single benzene ring (phenyl). In each structural formula, * indicates that the benzene ring is part of the skeletal structure of the compound when it is a benzene ring, and indicates a substituent bond when it is a phenyl group.

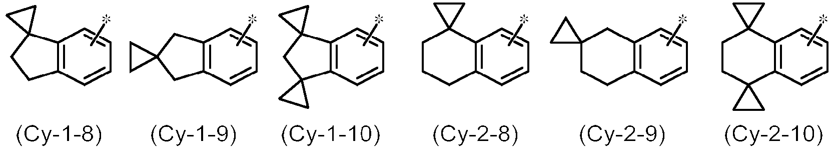

The forms of cycloalkane condensation include those in which the a-ring, b-ring, and c-ring of a polycyclic aromatic compound having a structure consisting of one or more structural units represented by Formula (1) are fused with cycloalkane, and those in which the aryl ring or heteroaryl ring in R^{a1} to R^{a3}, and R^{b1} to R^{b4} are fused with cycloalkane. In the polycyclic aromatic compounds of the present invention, it is one of the preferable enbodiments that the aryl rings or heteroaryl rings in R^{c1} to R^{c4} are not fused with cycloalkanes.

Another embodiment of cycloalkane condensation is such a structure that a polycyclic aromatic compounds haying a structure consisting of one or two or more of the structural units represented by Formula (1) has >N-R^{NX}, in which R is an aryl fused with a cycloalkane, a diaiylamino fused with a cycloalkane (a cycloalkane is fused to this aryl moiety), a carbazolyl fused with a cycloalkane cycloalkane is fused to this benzene moiety), or a benzocarbazolyl fused with a cycloalkane (a cycloalkane is fused to this benzene ring moiety).

By introducing a cycloalkane structure into the polycyclic aromatic compoun having a structure consisting of one or more structural units represented by Formula (1), a decrease in melting point and sublimation temperature can be expected. This means that, in sublimation purification, which is almost essential as a method for purifying a material for an organic device such as an organic EL element for which high purity of materials is required, thermal decomposition of a material or the like can be avoided because it can be purified at a relatively low temperature. This also applies to the vacuum deposition process, which is an effective means for manufacturing an organic device such as an organic EL element, and since the process can be performed at a relatively low temperature, thermal decomposition of the material can be avoided, and as a result, a high-performance organic device can be obtained. Further, since solubility in an organic solvent is improved by introduction of a cycloalkane structure, it is also possible to apply it to fabrication of an element utilizing a coating process. However, the present invention is not particularly limited to these principles.

### <Deuterium replacement>

All or a part of hydrogens in a structure consisting of one or two or more of the structural units represented by Formula (1) may be deuterium.

For example, any hydrogen in the aryl rings or heteroaryl rings in a ring, b ring, and c ring and their substituents in the polycyclic aromatic compound having a structure consisting of one or more structural units represented by Formula (1) may be replaced with deuterium. Among these, an embodiment in which all or part of the hydrogens in the aryls and heteroaryls are replaced by deuteriums can be exemplified. In addition, from the viewpoint of durability, it is also preferable that all or a part of hydrogens in the polycyclic aromatic compound having a structure consisting of one or two or more structural units represented by Formula (1) are deuterated.

### <Specific Examples of Polycyclic Aromatic Compounds>

Specific examples of the polycyclic aromatic compounds having a structure consisting of one or two or more structural units represented by Formula (1) include the following compounds.

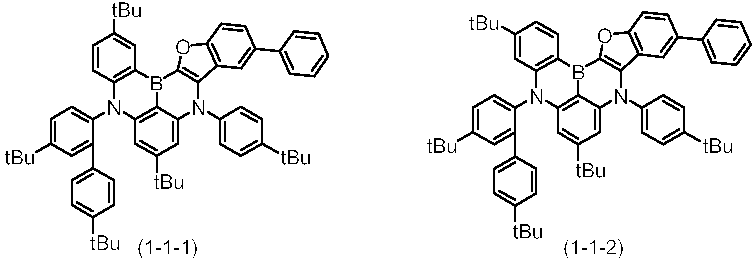

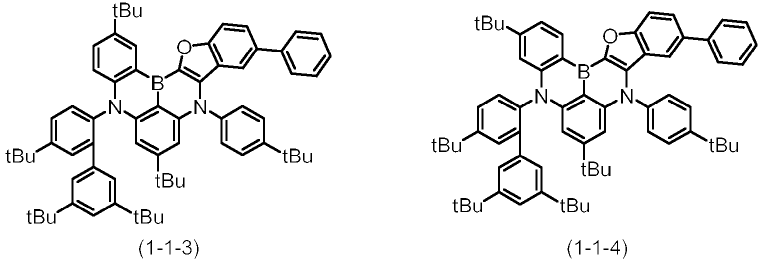

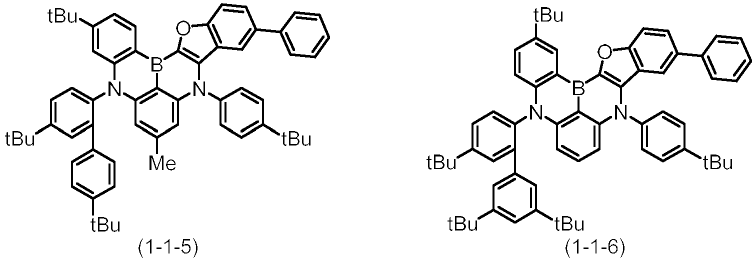

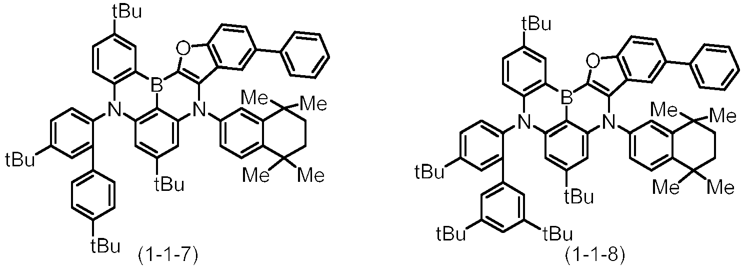

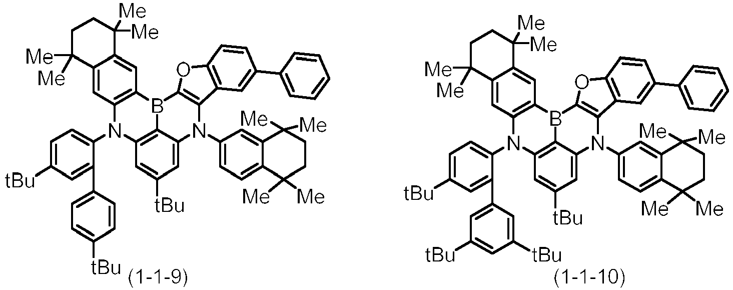

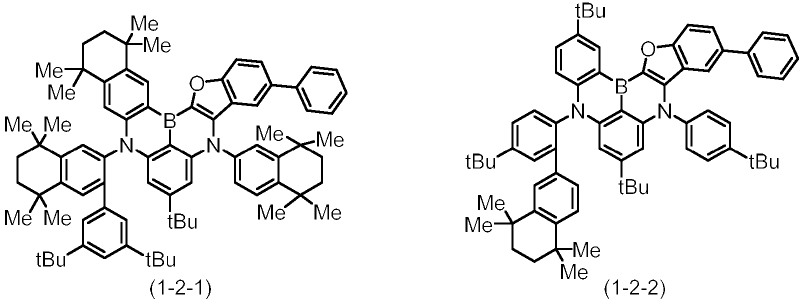

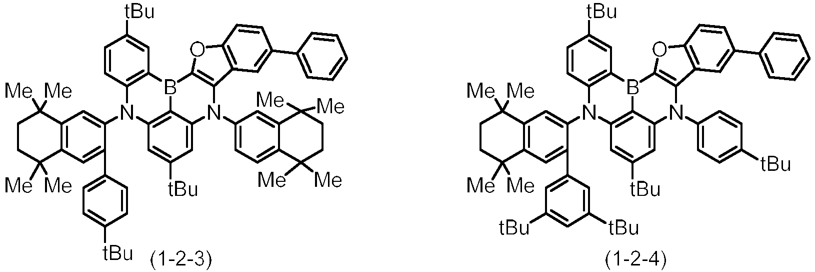

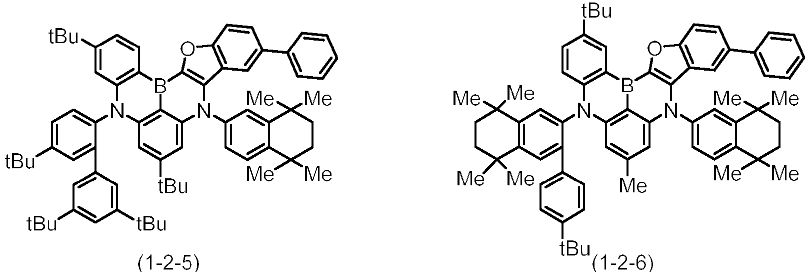

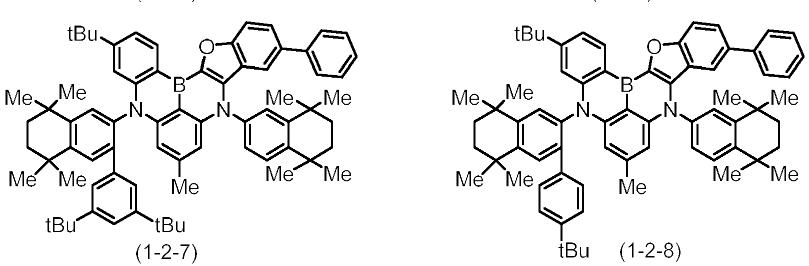

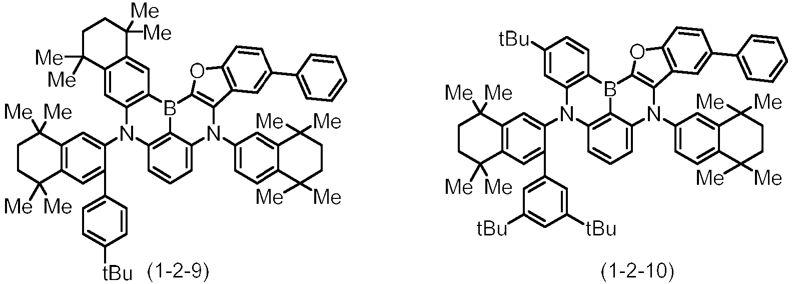

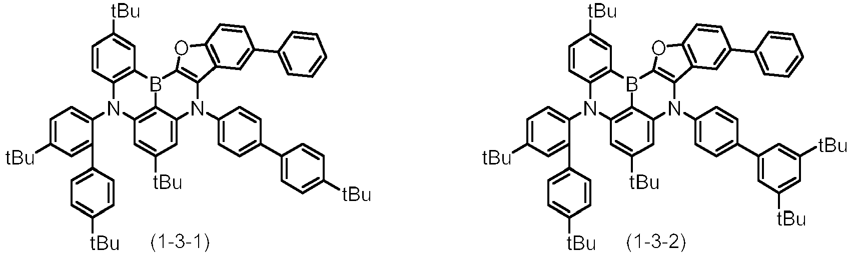

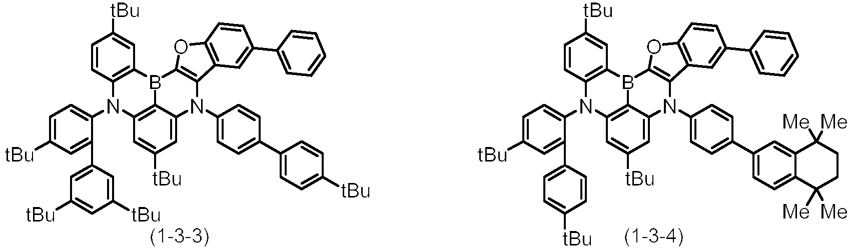

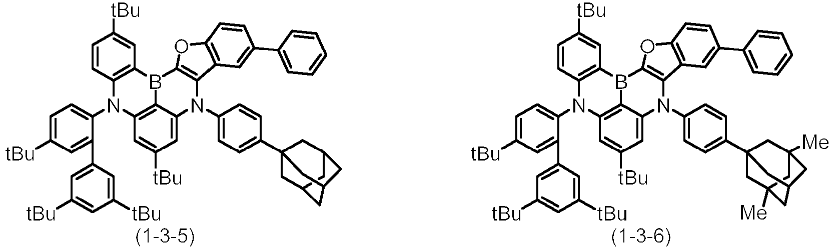

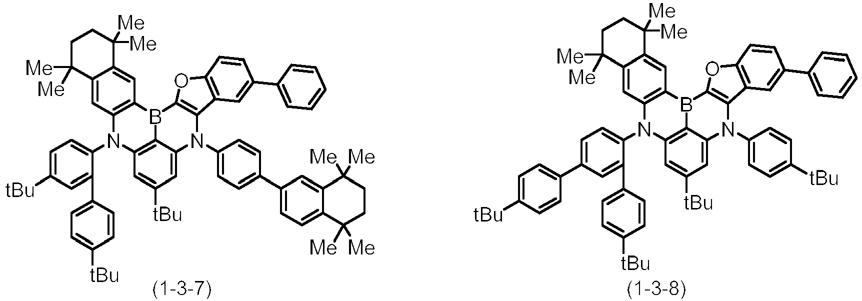

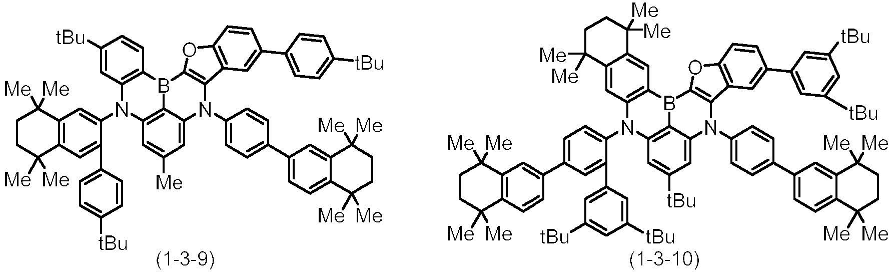

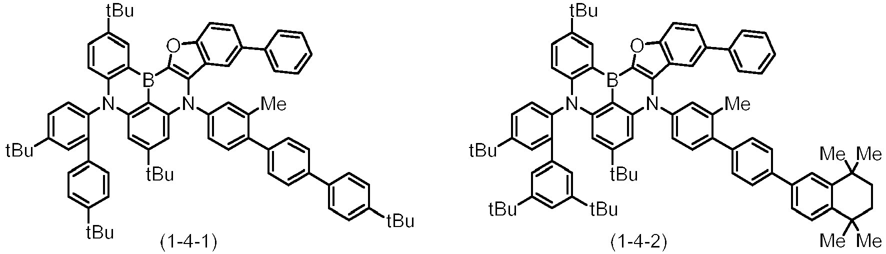

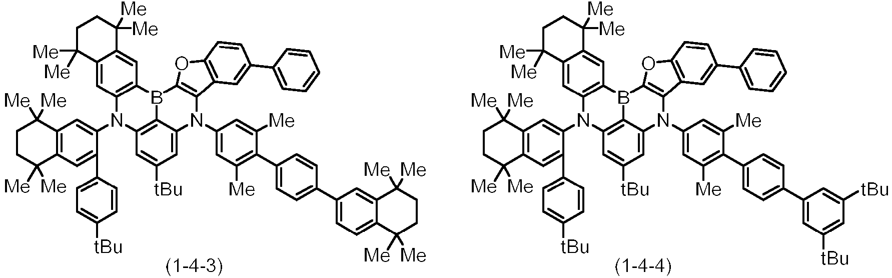

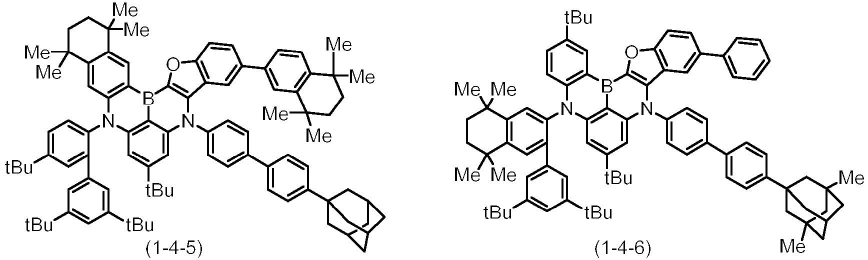

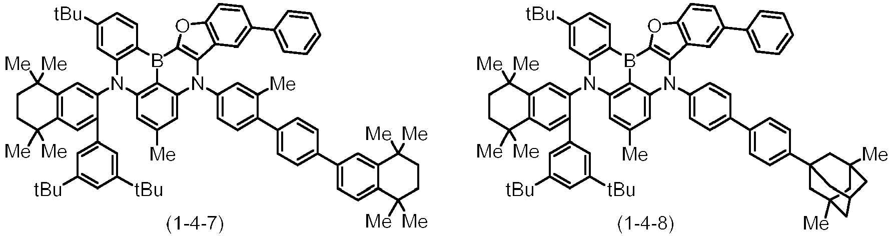

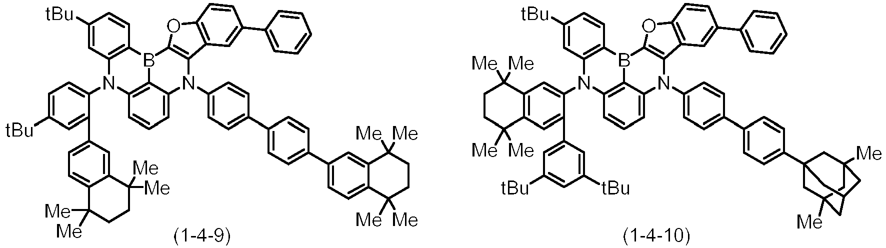

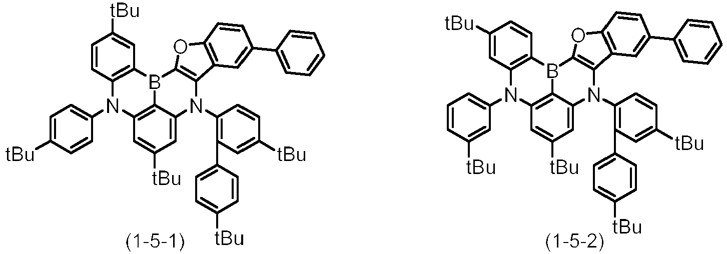

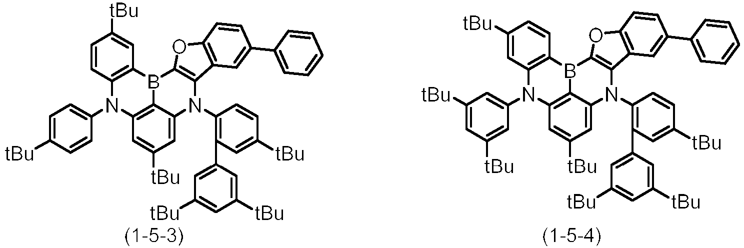

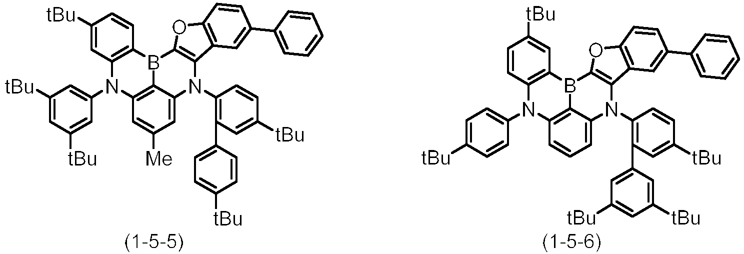

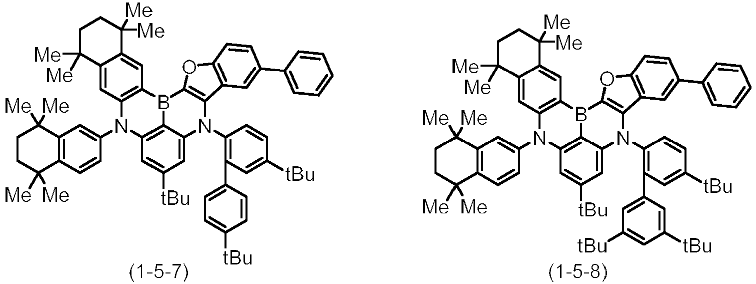

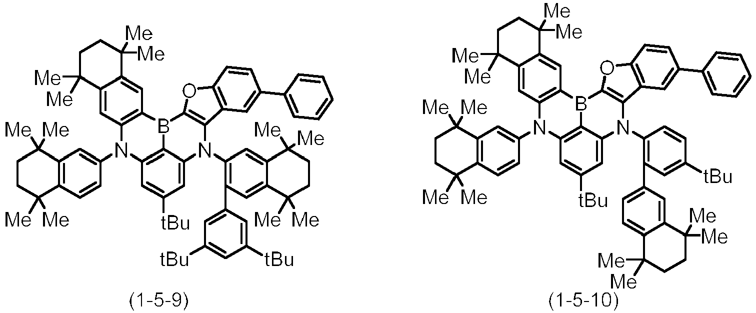

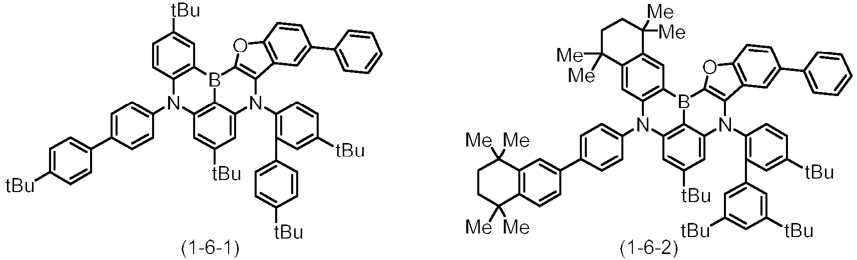

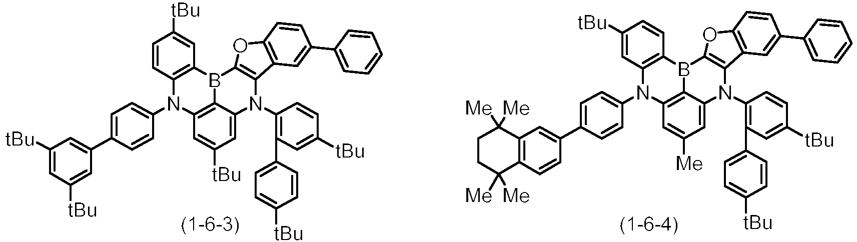

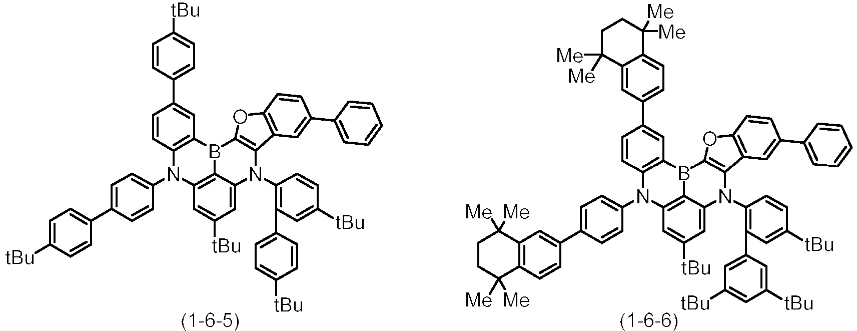

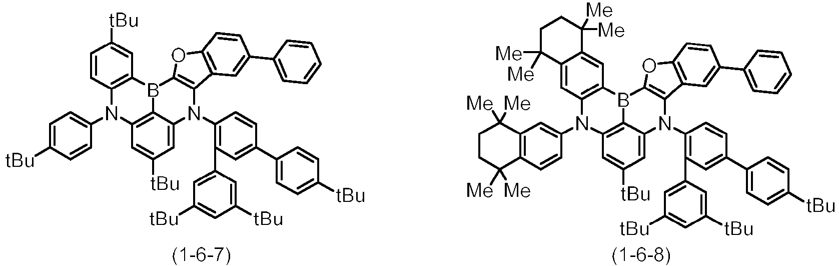

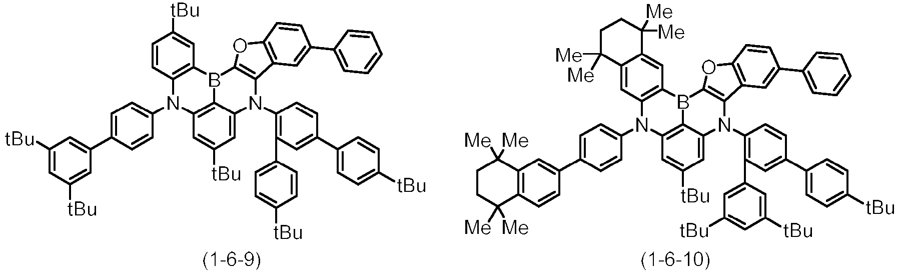

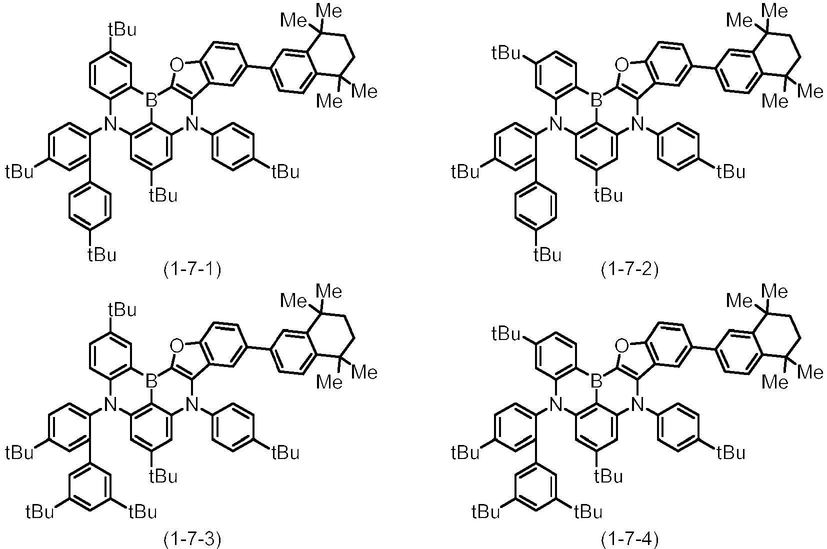

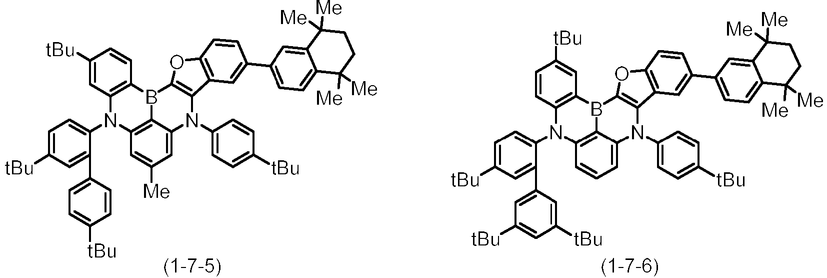

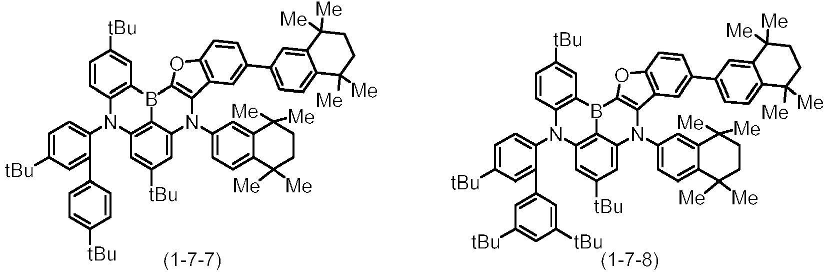

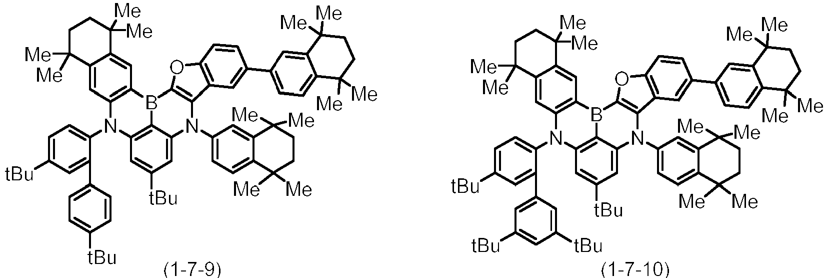

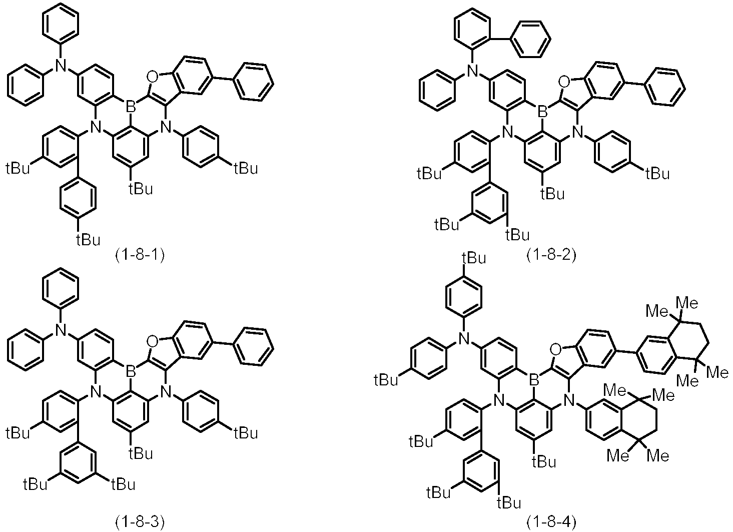

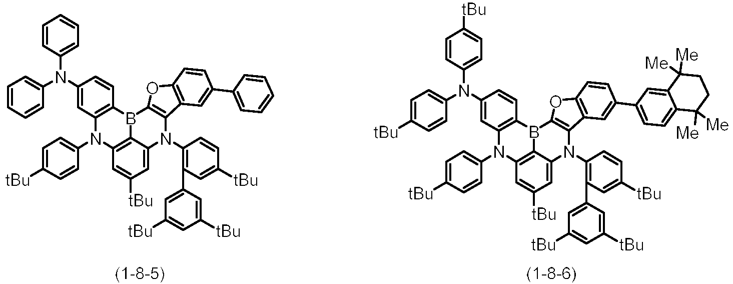

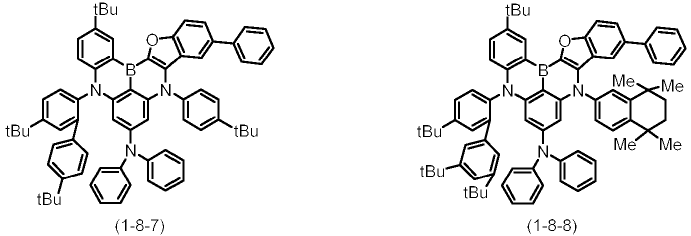

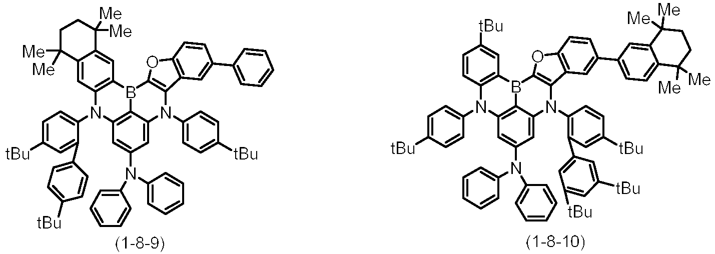

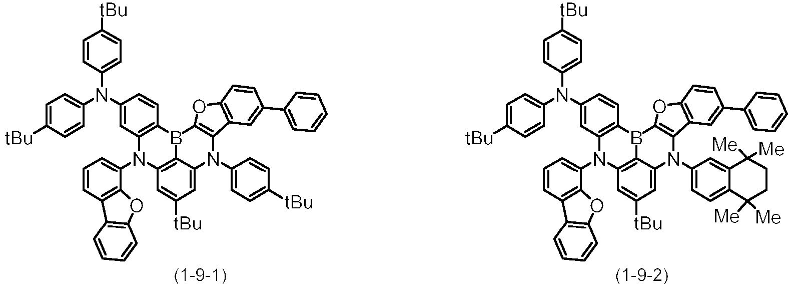

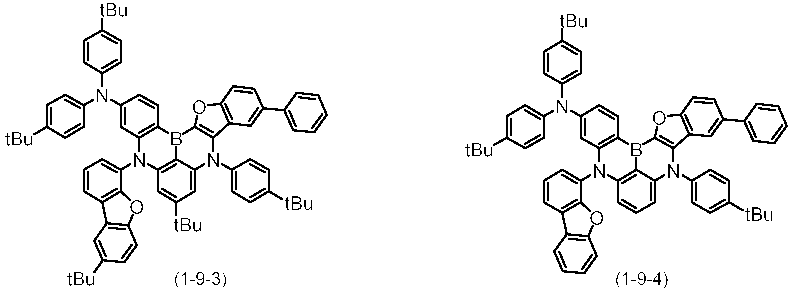

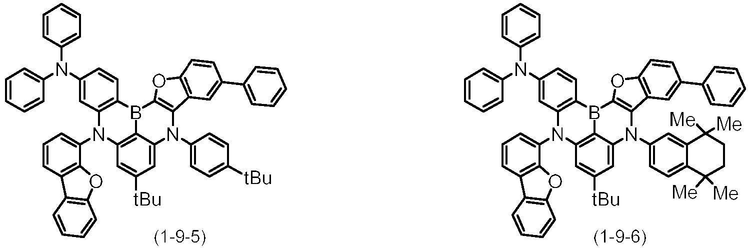

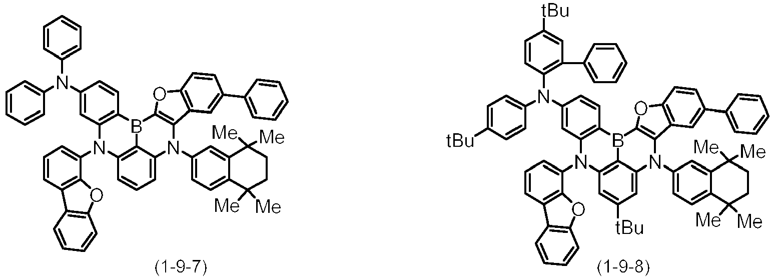

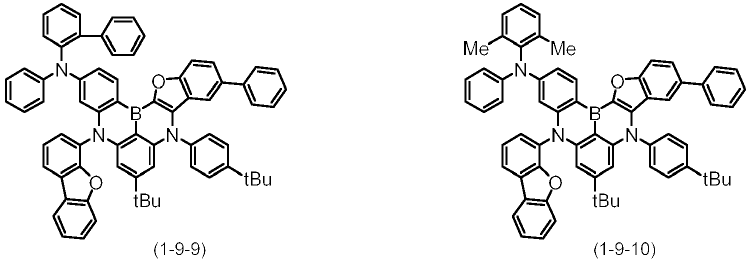

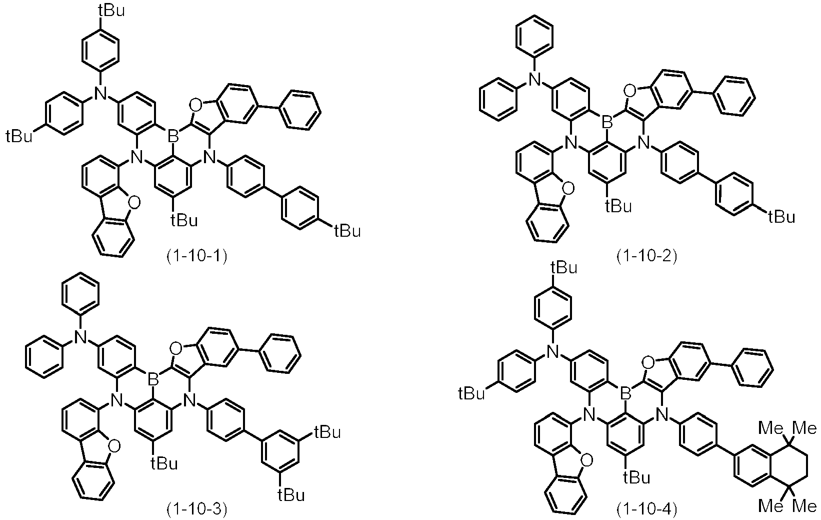

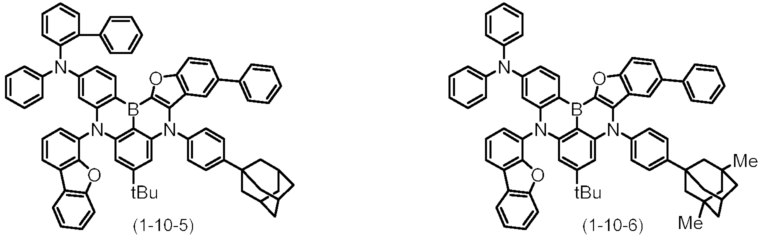

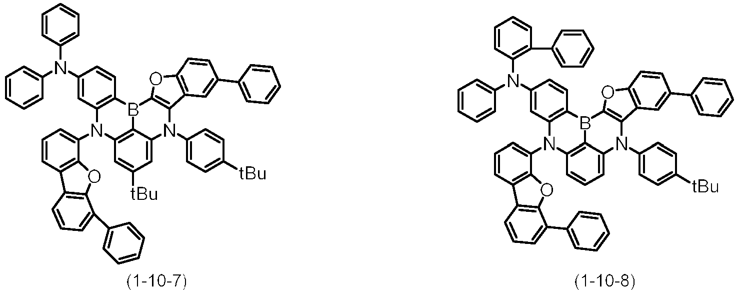

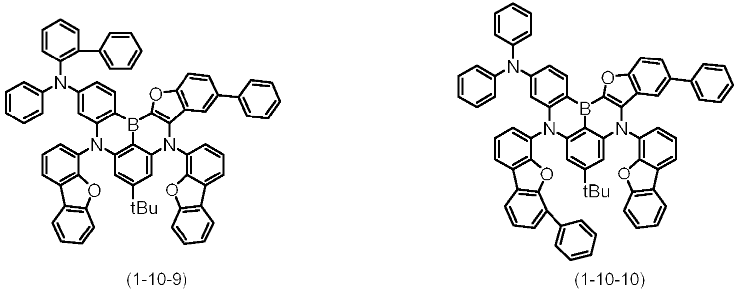

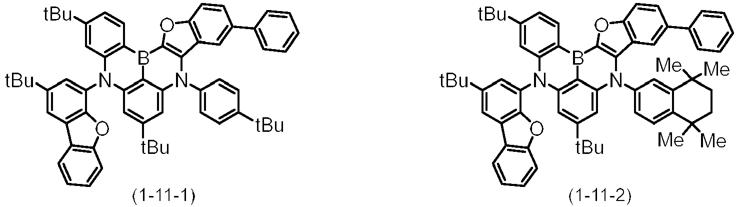

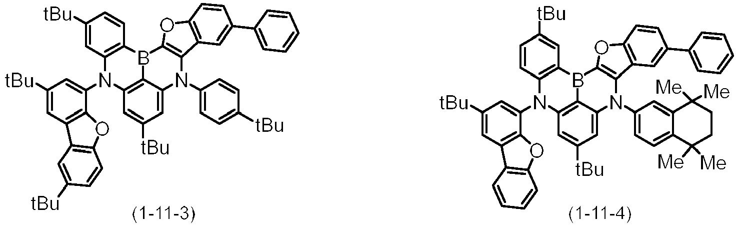

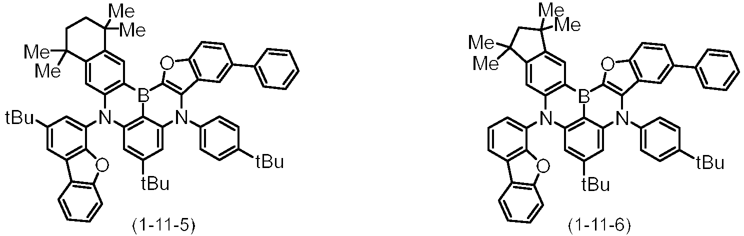

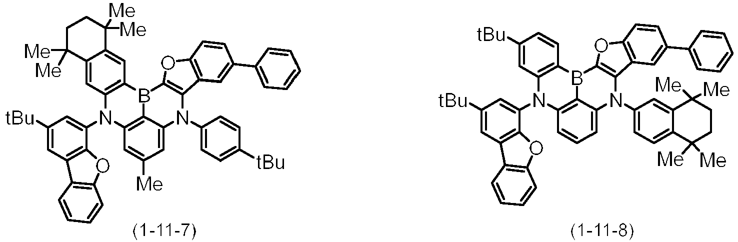

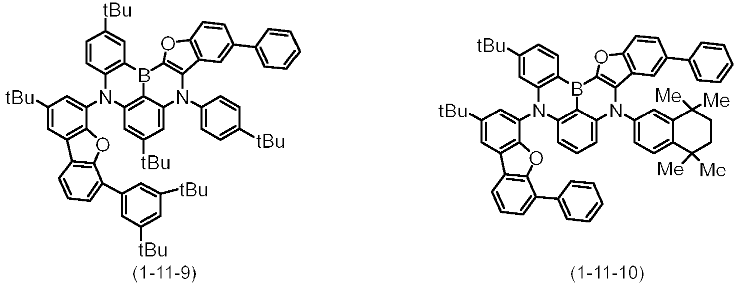

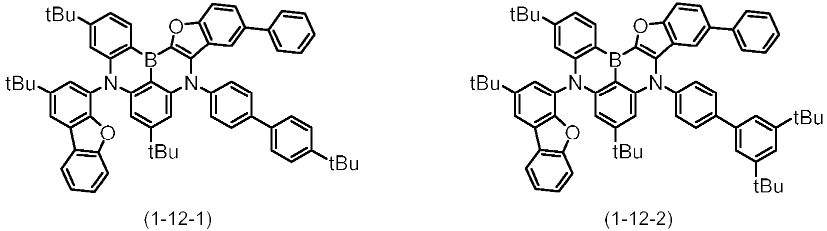

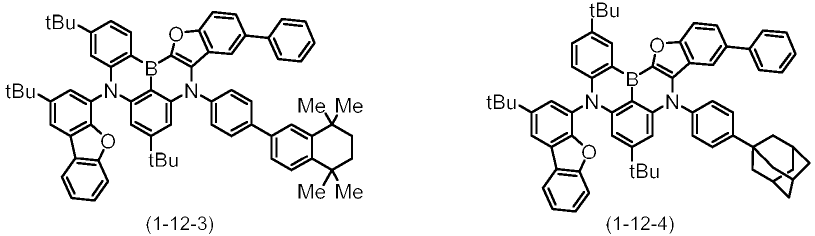

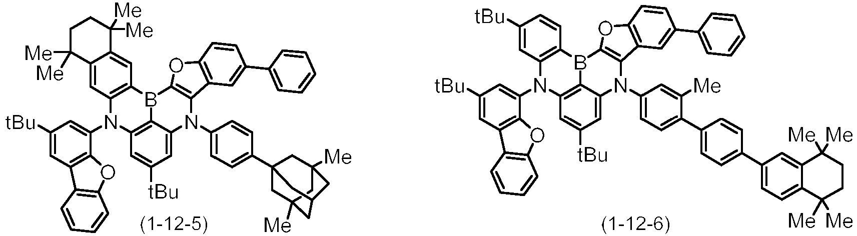

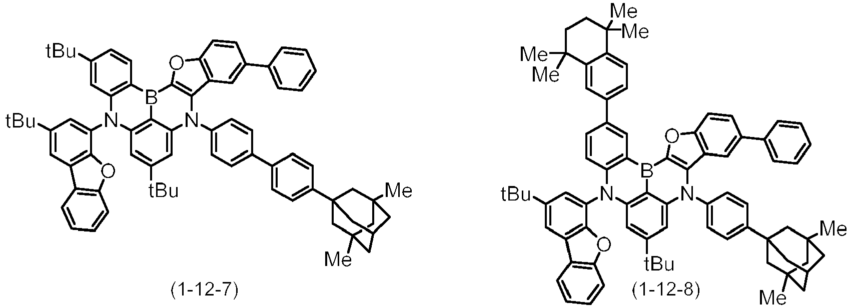

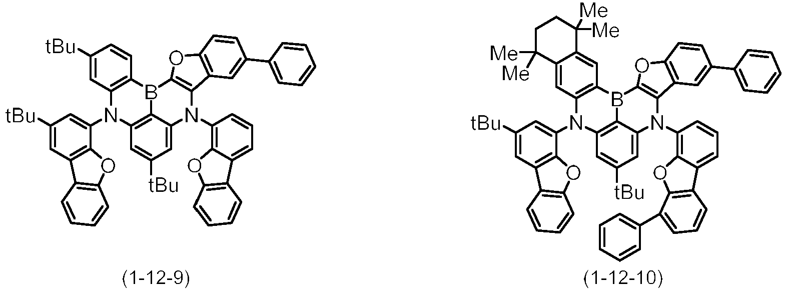

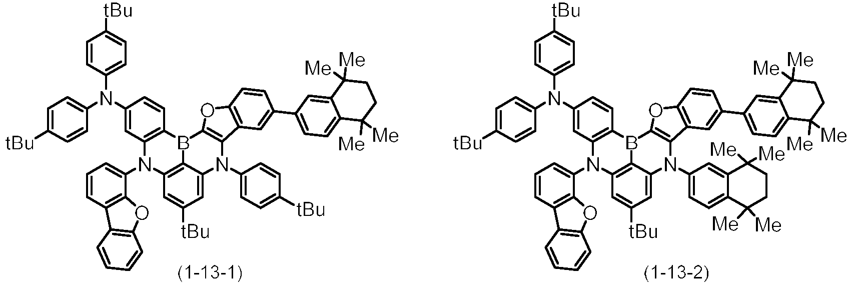

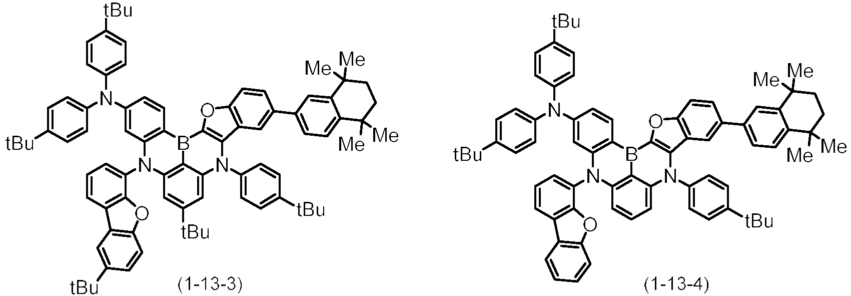

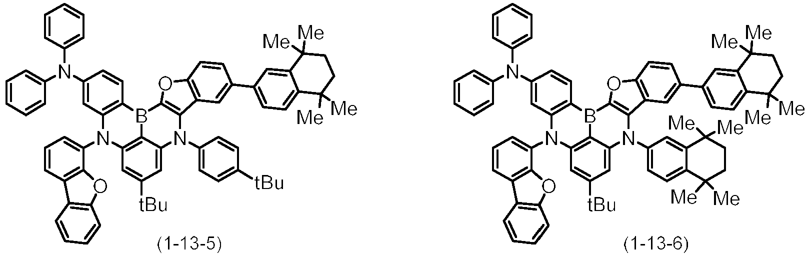

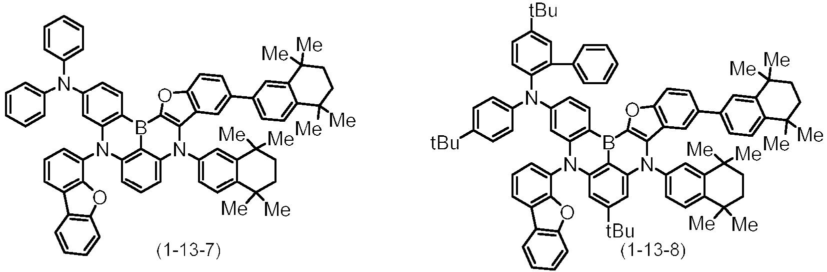

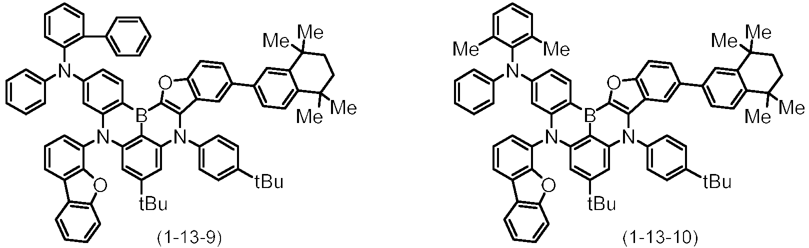

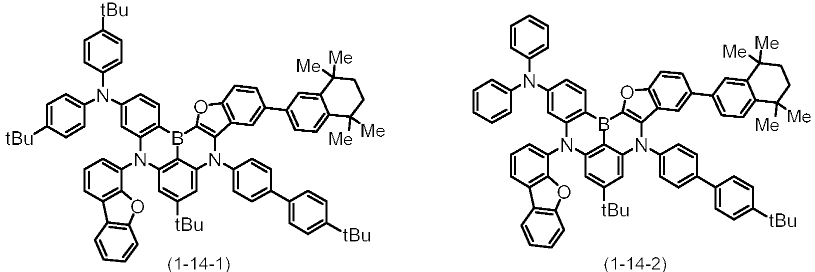

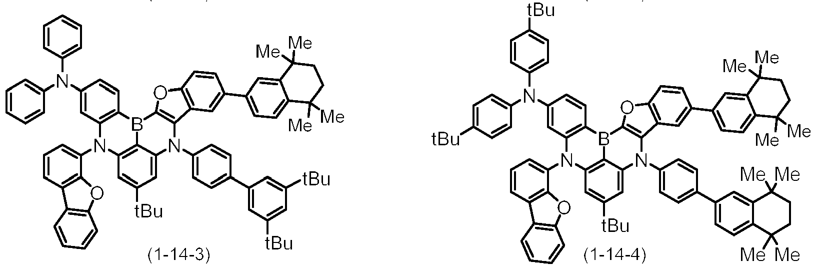

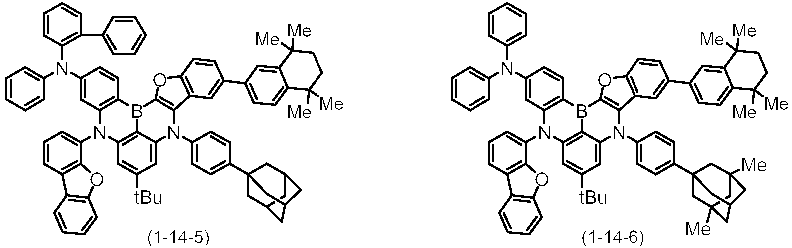

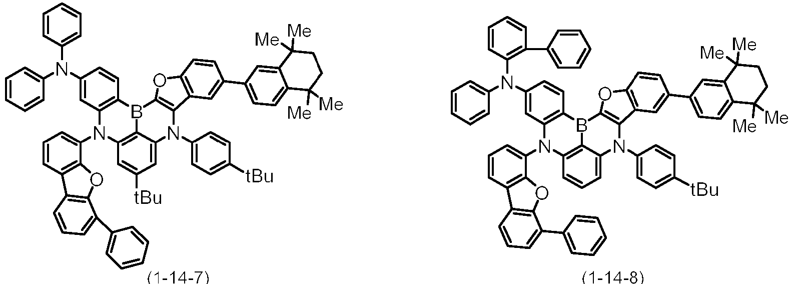

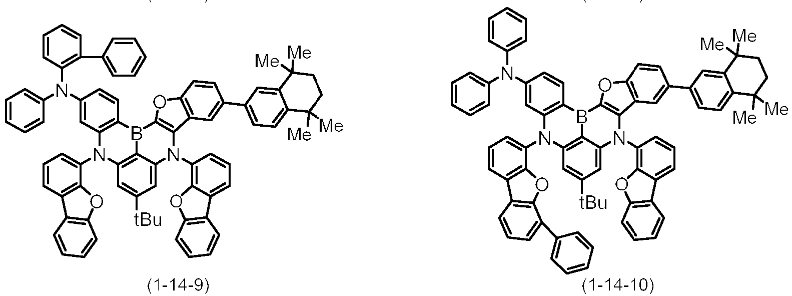

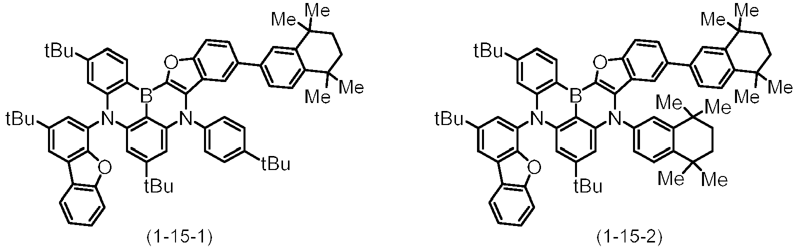

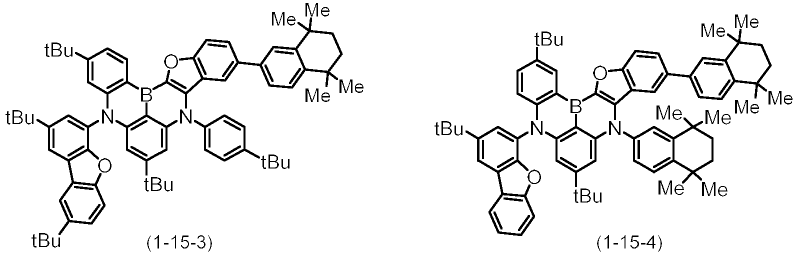

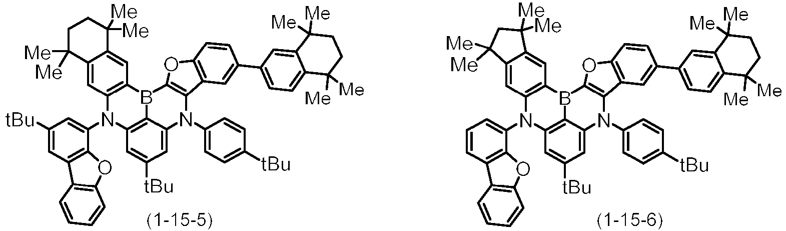

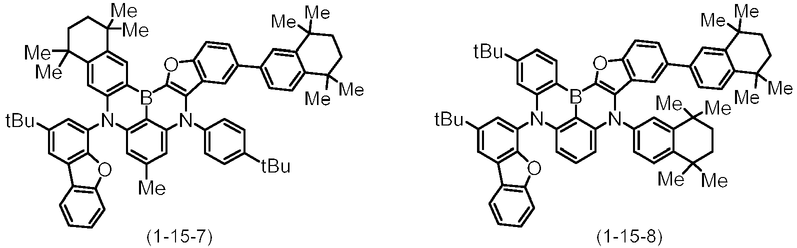

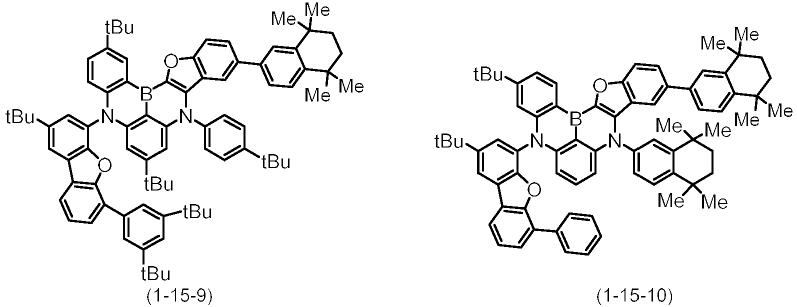

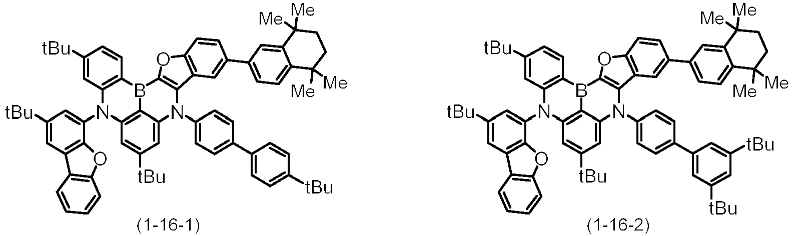

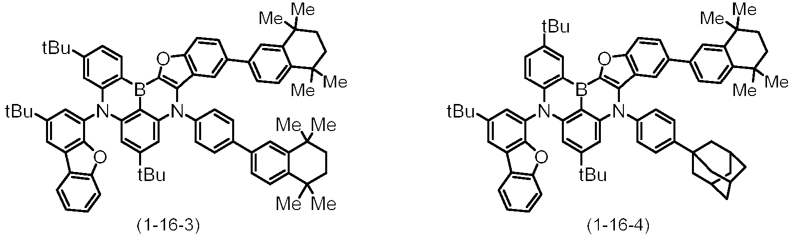

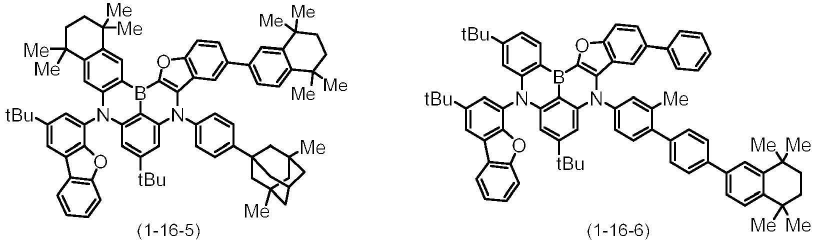

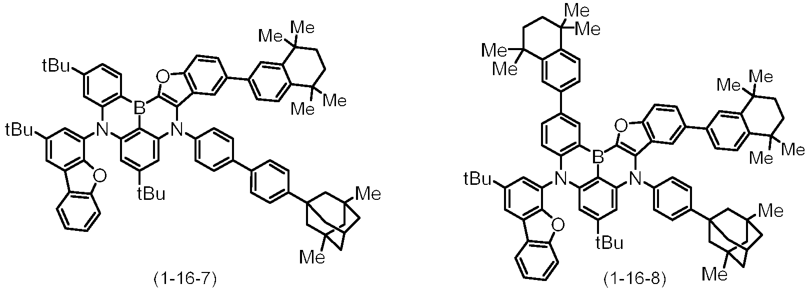

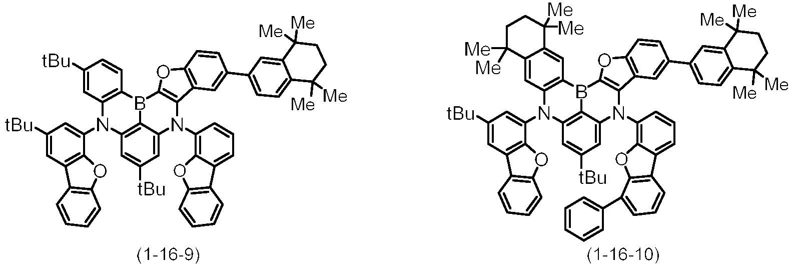

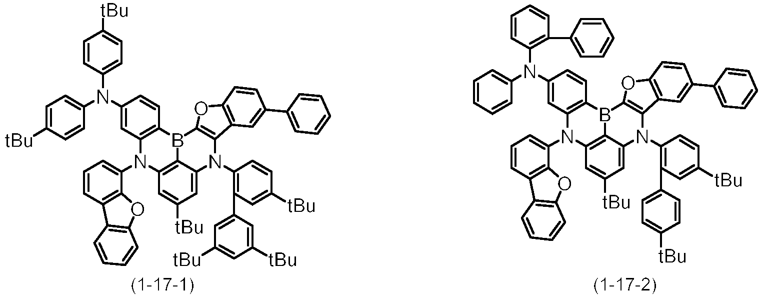

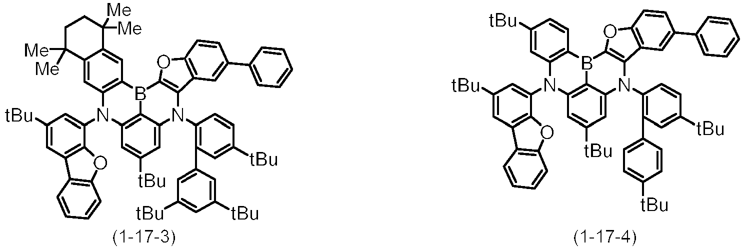

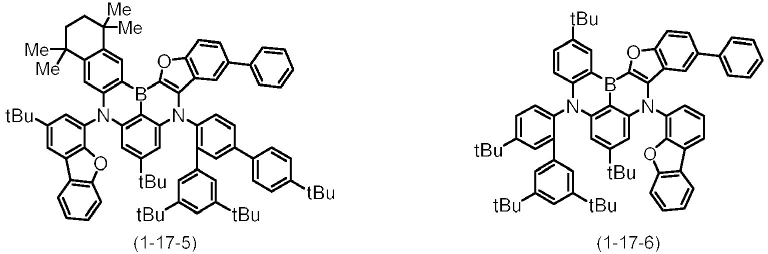

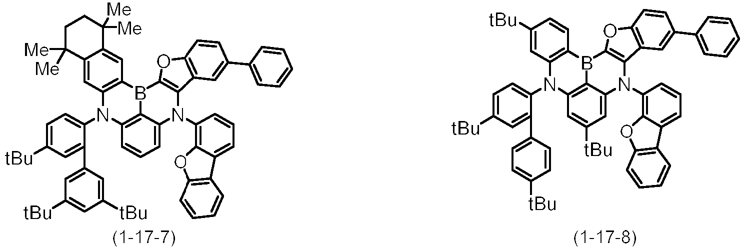

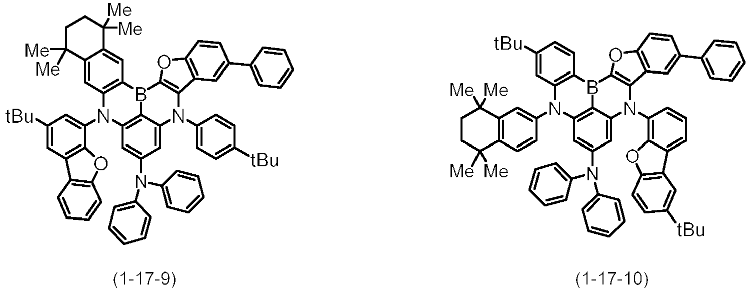

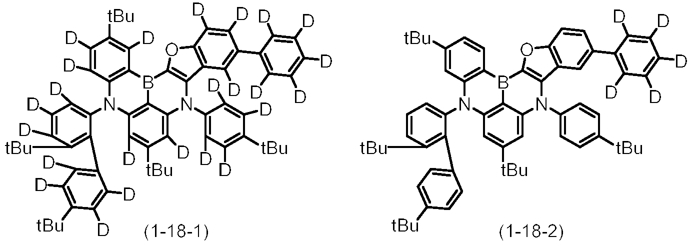

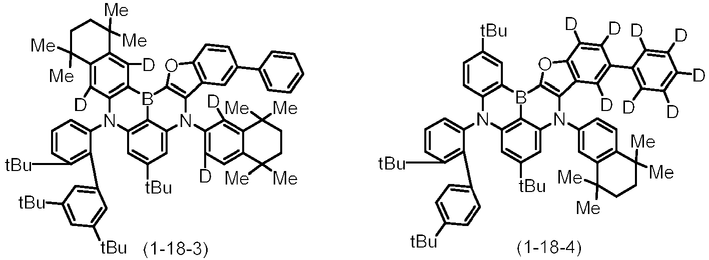

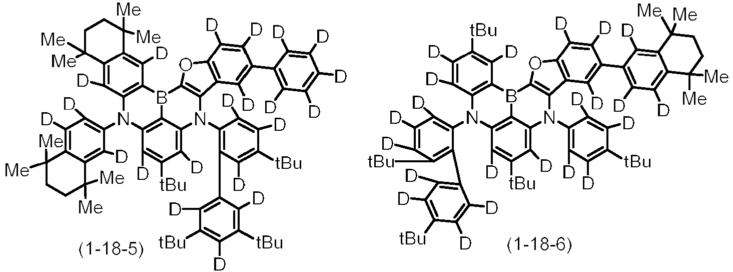

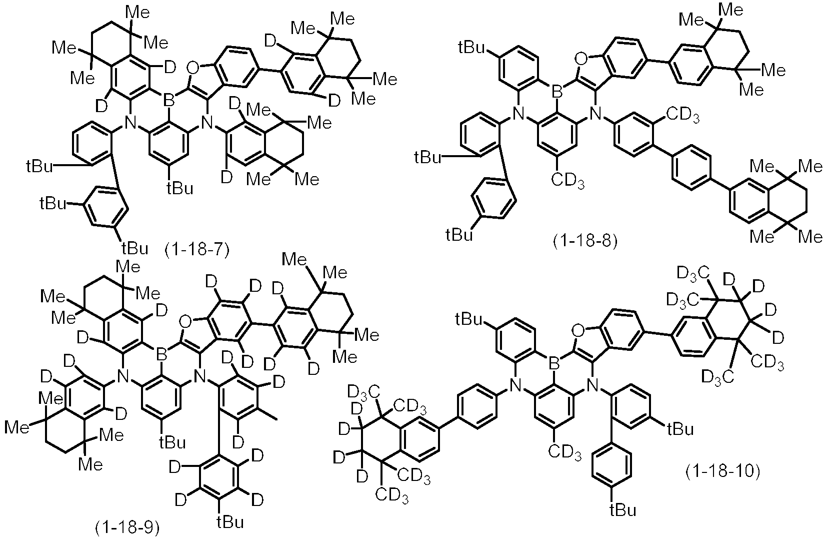

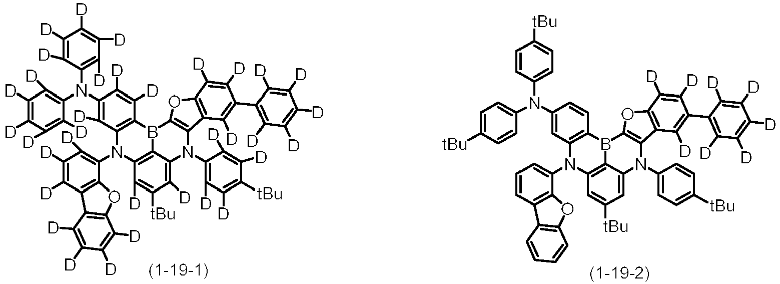

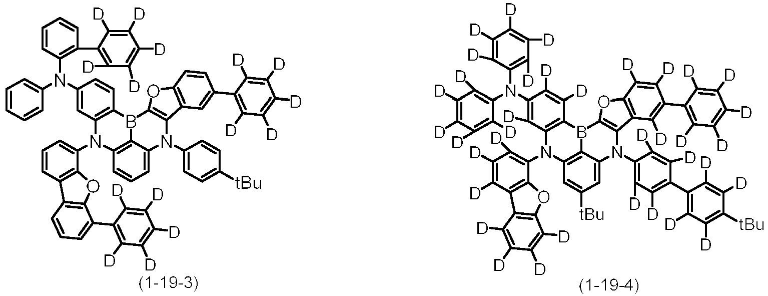

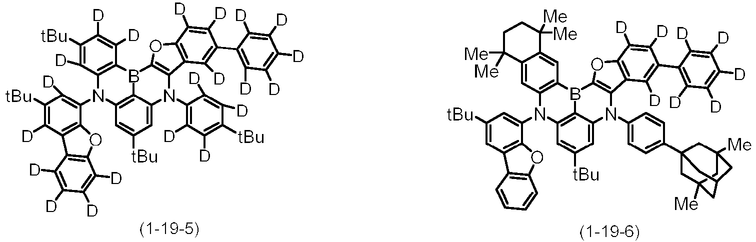

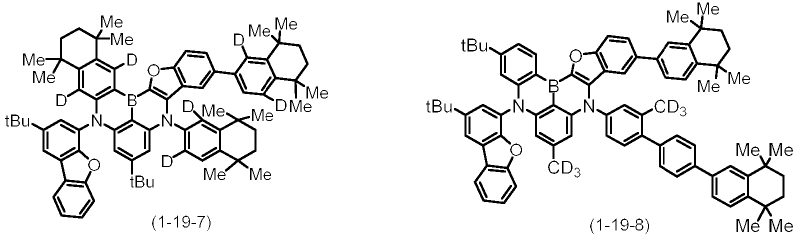

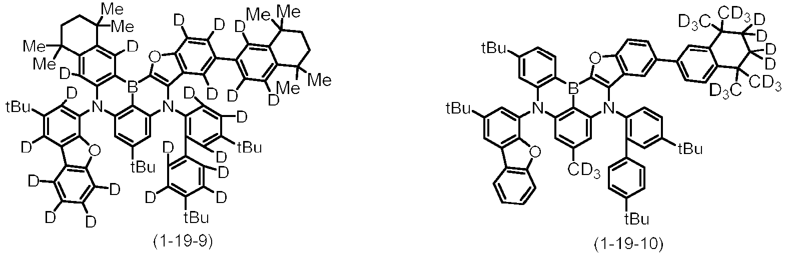

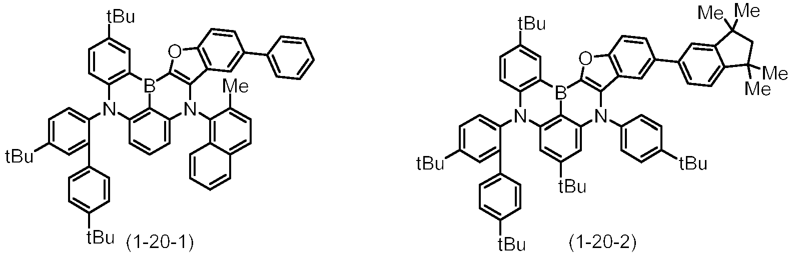

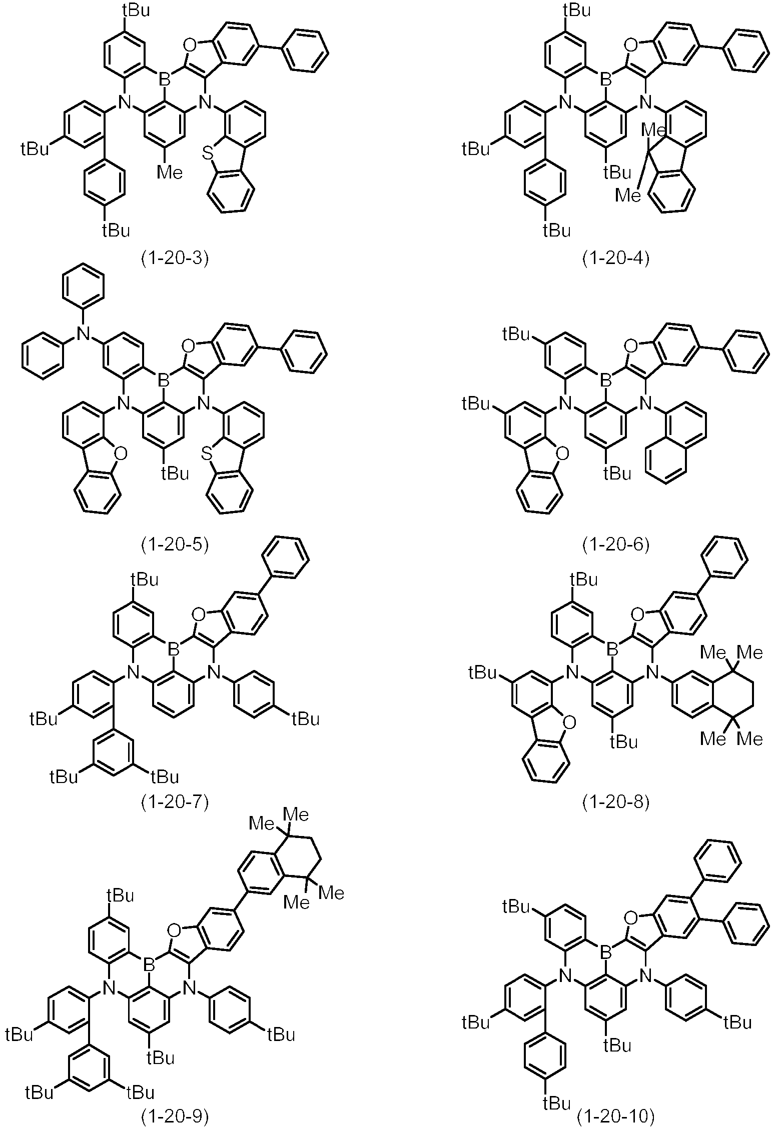

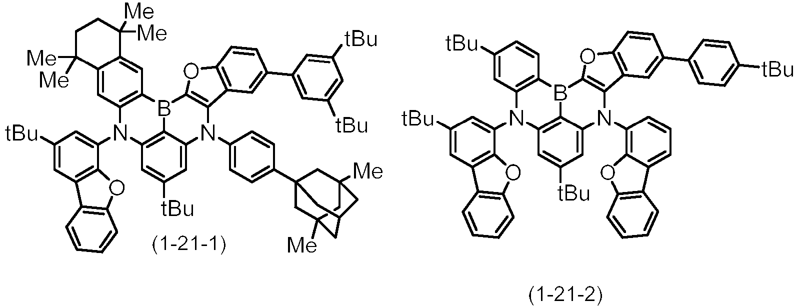

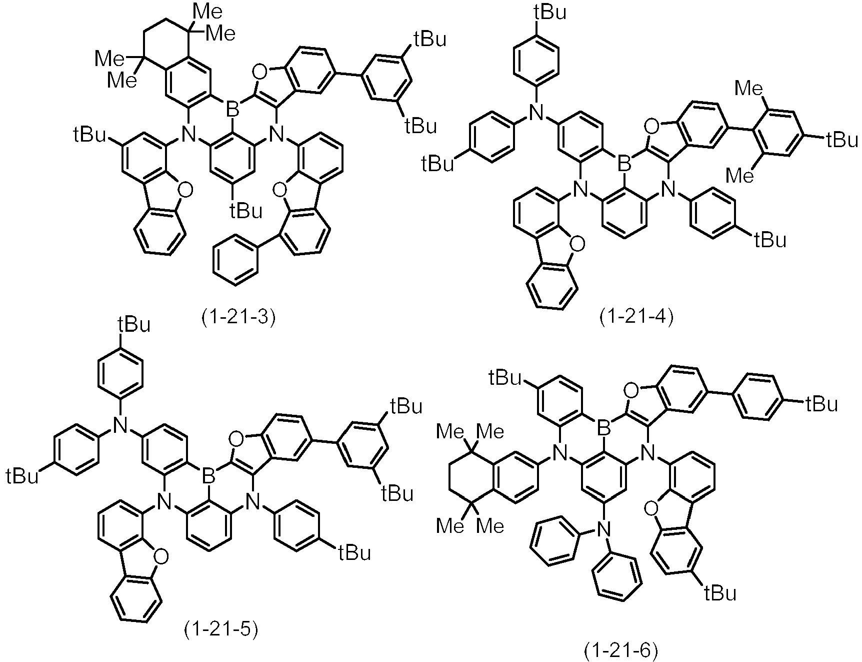

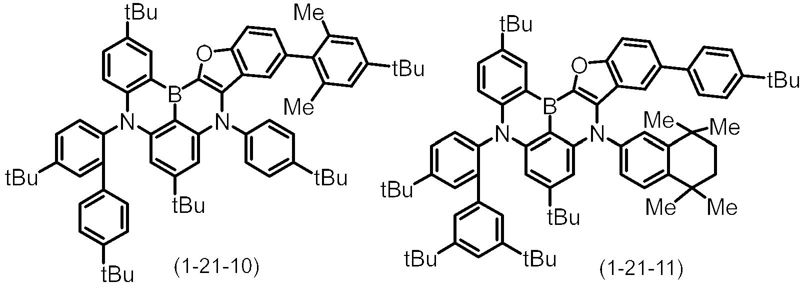

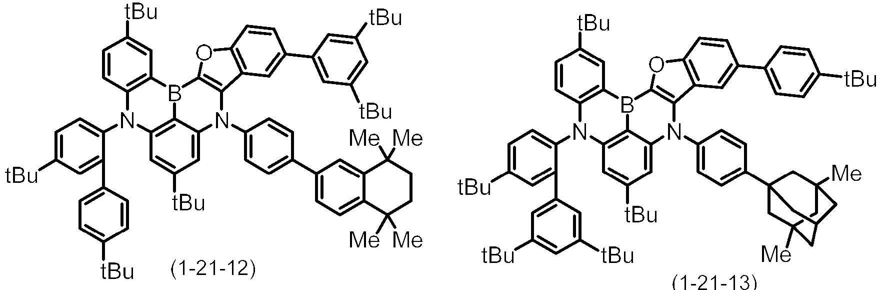

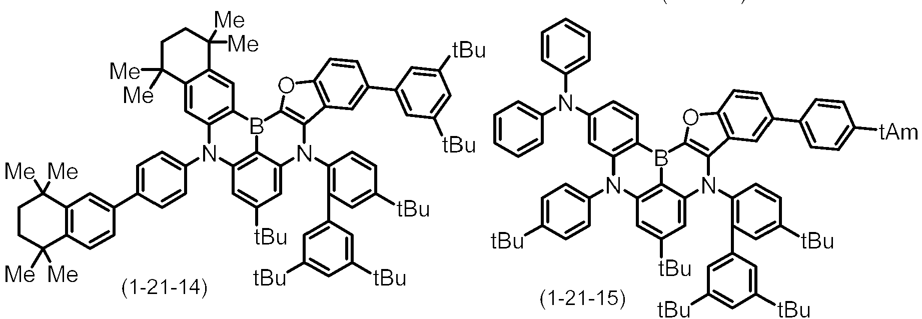

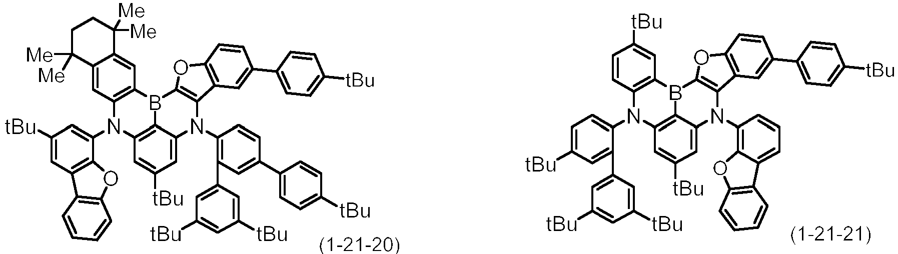

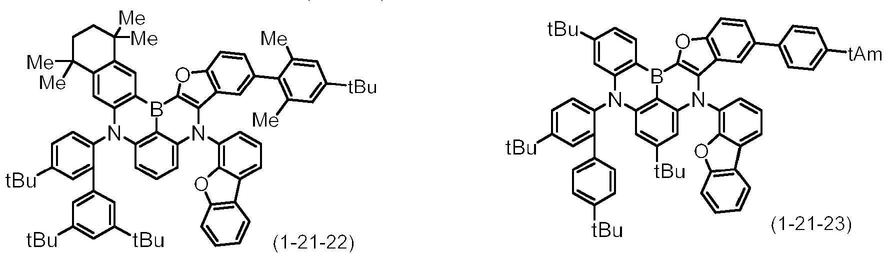

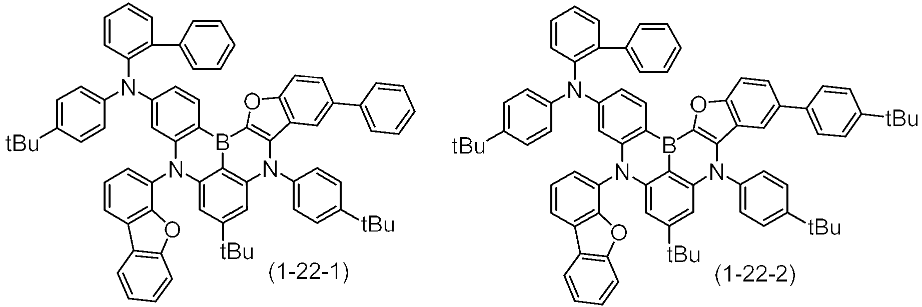

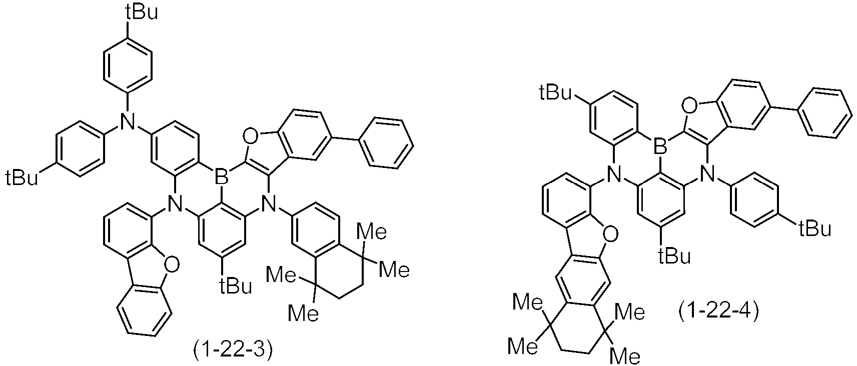

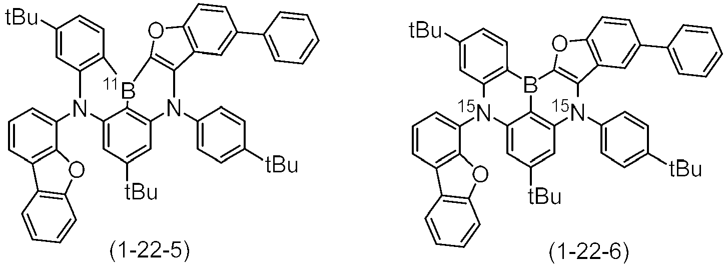

The compound represented by Formula (1-2-1) and the compound represented by Formula (1-5-9) are structural isomers in which X¹ and X² are reversed, and the compound represented by Formula (1-5-9) is preferable.

### <Production Method of Polycyclic Aromatic Compounds>

The polycyclic aromatic compound having a structure consisting of one or two or more structural units represented by Formula (1) can basically be produced by first producing an intermediate by combining a condensed ring containing a ring, b ring, and c ring with a linking group (a group containing X¹ and X²) (first reaction), and then combining the condensed ring containing rings a, b, and c with a linking group (a group containing Y¹) to obtain the final product (second reaction). In the first reaction, for example, in the case of etherification reactions, general reactions such as nucleophilic substitution reactions and Ullmann reactions can be used, and in the case of amination reactions, general reactions such as Buchwald-Hartwig reactions, nucleophilic substitution reactions, and Goldberg amination can be used. In the second reaction, a tandem hetero-Friedel-Crafts reaction (a series of aromatic electrophilic substitution reactions, the same applies hereinafter) can be used. The desired compound can be produced by using a raw material having the desired condensed ring at some point in the reaction process or by adding a ring condensation step.

### [Production Method via Intermediate 1]

The polycyclic aromatic compound of the present invention can be produced by a production method comprising the following steps. For each step below, reference may be made to the description of WO 2015/102118.

Shown below is a method comprising: a method step of metallizing a halogen atom (Hal) between X¹ and X² in Intermediate 1 below using an organic alkaline compound; a. reaction step of exchanging the metal and Y¹ using a reagent selected from the group consisting of a halide of Y¹, an amino halide of Y¹, an alkoxide of Y¹ and an aryloxy oxide of Y¹; and a reaction step of joining b ring and c ring at Y¹ by a consecutive electrophilic aromatic substitution reaction using a Bronsted base. The halogen atom (Hal) in the formula may be any of F, Cl, Br, or I, and may be selected appropriately in consideration of the reactivity of the substrate.

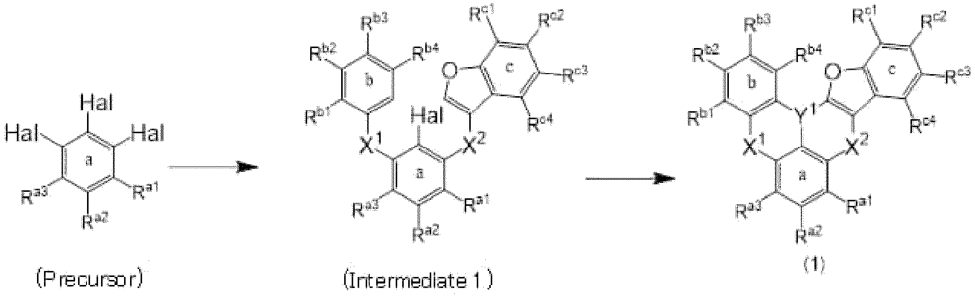

Examples of the metalating reagents used in the halogen-metal exchange reactions in the schemes described above include alkyllithium such as methyllithium, n-butyllithium, sec-butyllithium, t-butyllithium, and the like, isopropylmagnesium chloride, isopropylmagnesium bromide, phenylmagnesium chloride, phenylmagnesium bromide, a lithium chloride complex of isopropylmagnesiwn chloride, known as a turbo Grignard reagent, and the like.

In addition, as the metalating reagent used in the ortho-meal exchange reaction in the scheme described above, in addition to the above-described reagents, examples thereof include organic alkali compounds such as lithium diisopropylamide, lithium tetramethylpiperidide, lithiumhexamethyldisilazide, potassium hexamethyldisilazide, lithium tetramethylpiperidinylmagnesium chloride lithium complex, and tri-n-butyllithium magnesate.

Further, examples of the additive which promotes the reaction when an alkyllithium is used as the metalating reagent include N,N,N',N'-tetramethylethylenediamine, 1,4-diazabicyclo[2.2.2]octane, and N,N-dimethylpropyleneurea.

In addition, examples of the Lewis acid used in the scheme described above include AlCl₃, AlBr₃, AlF₃, BF₃·OEt₂, BCl₃, BBr₃, BI₃, GaCl₃, GaBr₃, InCl₃, InBr₃, In(OTf)₃, SnCl₄, SnBr₄, AgOTf, ScCl₃, Sc(OTf)₃, ZnCl₂, ZnBr₂, Zn(OTf)₂, MgCl₂, MgBr₂, Mg(OTf)₂, LiOTf, NaOTf, KOTf, Me₃SiOTf, Cu(OTf)₂, CuCl₂, YCl₃, Y(OTf)₃, TiCl₄, TiBr₄, ZrCl₄, ZrBr₄, FeCl₃, FeBr₃, CoCl₃, CoBr₃and others. Also, those in which these Lewis acids are supported on a solid can be used in the same manner.

Examples of the bronsted acids used in the schemes described above include p-toluenesulfonic acid, methanesulfonic acid, trifluoromethanesulfonic acid, fluorosulfonic acid, carbolanic acid, trifluoroacetic acid, (trifluoromethanesulfonyl)imide, tris(trifluoromethanesulfonyl)methane, hydrogen chloride, hydrogen bromide, hydrogen fluoride, and the like. Solid Bronsted acids include Amberlist (trade name: Dow Chemical), Nafion (trade name: DuPont), zeolite, TAYCACURE (trade name: Tayca Corporation), and the like.

Further, examples of amines which may be added in the scheme described above include diisopropylethylamine, triethylamine, tributylamine, 1,4-diazabicyclo[2.2.2]octane, N,N-dimethyl-p-toluidine, N,N-dimethylaniline, pyridine, 2,6-lutidine, and 2,6-di-t-butylamine.

Also, solvents used in the schemes described above include o-dichlorobenzene, chlorobenzene, toluene, benzene, methylene chloride, chloroform, dichloroethylene, benzotrifluoride, decalin, cyclohexane, hexane, heptane, 1,2,4-trimethylbenzene, xylene, diphenyl ether, anisole, cyclopentylmethyl ether, tetrahydrofuran, dioxane, methyl-t-butyl ether, and the like.

Here, although an example in which Y¹ is B has been described, it is possible to synthesize a compound in which Y¹ is P, P=O, P=S, Ga, As, Si-R or Ge-R by changing the raw material as appropriate.

In the above scheme, a Bronsted base or a Lewis acid may be used for promotion of the tandem hetero Friedel Crafts reaction. However, when Y¹ halides such as Y¹ trifluoride, Y¹ trichloride, Y¹ tribromide, and Y¹ triiodide are used, acids such as hydrogen fluoride, hydrogen chloride, hydrogen bromide, and hydrogen iodide are produced along with the progress of the electrophilic aromatic substitution reactions, and therefore the use of a Bronsted base for capturing acids is effective. On the other hand, when Y¹ amino halide or Y¹ alkoxylide is used, it is not required to use a Bronsted base in many cases because of the formation of amines and alcohols as the electrophilic aromatic substitutions proceed, but the use of a Lewis acid to promote the elimination of amino and alkoxy is effective because of their low elimination ability.

Further, the polycyclic aromatic compound of the present invention also includes a compound in which at least a part of hydrogens are replaced with deuterium or a various substituent. Such a compound or the like can be synthesized in the same manner as described above by using a raw material in which a desired position is deuterated or made to a derivative.

### <2. Organic devices>

The polycyclic aromatic compound according to the present invention can be used as a material for an organic device. Examples of the organic element include an organic electroluminescent element, an organic field effect transistor, and an organic thin film solar cell.

The polycyclic aromatic compound according to the present invention can be used as a material for an organic device. Examples of the organic element include an organic electroluminescent element, an organic field effect transistor, and an organic thin film solar cell, and is preferably an organic electroluminescent element. The polycyclic aromatic compounds according to the present invention are preferably organic electroluminescent device materials, more preferably materials for light-emitting layers (light-emitting materials), and most preferably dopant materials for light-emitting layers.

### <2-1.Organic electroluminescent element>

### <2-1-1.Structure of Organic electroluminescent element>

FIG. 1 shows a schematic cross-sectional view of an organic EL element of the present embodiment.

Organic EL element 100 shown in FIG. 1 has substrate 101, anode 102 provided on substrate 101, hole injection layer 103 provided on anode 102, hole transport layer 104 provided on hole injection layer 103, light-emitting layer 105 provided on hole transport layer 104, electron transport layer 106 provided on light-emitting layer 105, electron injection layer 107 provided on electron transport layer 106 and cathode 108 provided on electron injection layer 107.

In addition, with reversing preparation order, organic EL element 100 may be formed into a configuration having substrate 101, cathode 108 provided on substrate 101, electron injection layer 107 provided on cathode 108, electron transport layer 106 provided on electron injection layer 107, light-emitting layer 105 provided on electron transport layer 106, hole transport layer 104 provided on light-emitting layer 105, hole injection layer 103 provided on hole transport layer 104 and anode 102 provided on hole injection layer 103, for example.

All the respective layers are not necessarily required, and a minimum constitutional unit may be formed into a configuration formed of anode 102, light-emitting layer 105 and cathode 108, and hole injection layer 103, hole transport layer 104, electron transport layer 106 and electron injection layer 107 are an arbitrarily provided layer. Moreover, each layer described above may be formed of a single layer or may be formed of a plurality of layers.

A form of the layers constituting the organic EL element may be, in addition to the constitutional form of "substrate/anode/hole injection layer/hole transport layer/light-emitting layer/electron transport layer/electron injection layer/cathode" described above, in a constitutional form such as "substrate/anode/hole transport layer/light-emitting layer/electron transport layer/electron injection layer/cathode," "substrate/anode/hole injection layer/light-emitting layer/electron transport layer/electron injection layer/cathode," "substrate/anode/hole injection layer/hole transport layer/light-emitting layer/electron injection layer/cathode," "substrate/anode/hole injection layer/hole transport layer/light-emitting layer/electron transport layer/cathode," "substrate/anode/light-emitting layer/electron transport layer/electron injection layer/cathode," "substrate/anode/hole transport layer/light-emitting layer/electron injection layer/cathode," "substrate/anode/hole transport layer/light-emitting layer/electron transport layer/cathode," "substrate/anode/hole injection layer/light-emitting layer/electron injection layer/cathode," "substrate/anode/hole injection layer/light-emitting layer/electron transport layer/cathode," "substrate/anode/light-emitting layer/electron transport layer/cathode" and "substrate/anode/light-emitting layer/electron injection layer/cathode."

### <2-1-2. Light-Emitting Layer in Organic Electroluminescent Element>

The polycyclic aromatic compound of the present invention is preferably used as a material for forming any one or more organic layers in an organic electroluminescent element, and more preferably used as a material for forming a light-emitting layer.

Light-emitting layer 105 is a layer which produces luminescence by allowing holes injected from anode 102 to recombine with electrons injected from cathode 108, between electrodes to which an electric field is applied. A material forming light-emitting layer 105 only needs be a compound (luminescent compound) which produces luminescence by being excited by recombination between the holes and the electrons, and is preferably a compound that can form a stable thin film shape, and exhibits strong luminescence (fluorescence) efficiency in a solid state. The polycyclic aromatic compound of the present invention can be used as a material for a light emitting layer, and may be used as a dopant material or as a host material, but is preferably used as a material for a light emitting layer, and more preferably used as a dopant material.

As the dopant, there is an example in which an assisting dopant and an emitting dopant are used in combination. In the present specification, when simply described as "dopant", it refers to a light emitting dopant used alone.

The light-emitting layer may be formed of a single layer or a plurality of layers, and each layer is formed of a light-emitting layer material (the host material and the dopant material). The host material and the dopant material may be in one kind, or in combination of a plurality of kinds, respectively. The dopant material may be wholly contained in the host material, or may be partly contained therein. As a. doping method, the layer can be formed by vapor codeposition with the host material, or the dopant material is previously mixed with the host material, and then the resulting mixture may be simultaneously deposited. The following are specific examples of dopants to be combined with the compounds of the present invention when dopants are a combination of a plurality of kind.

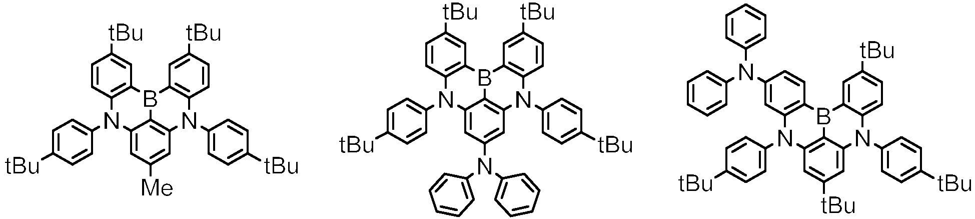

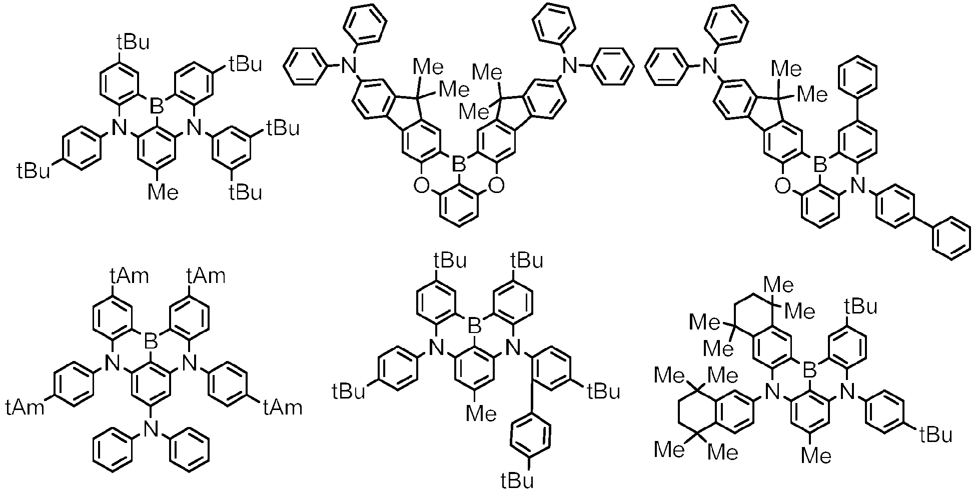

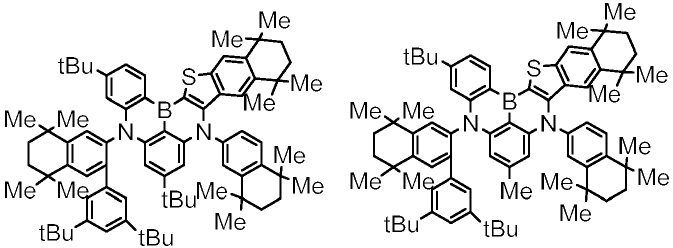

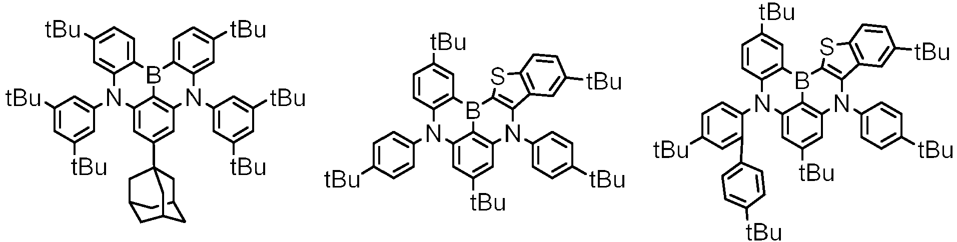

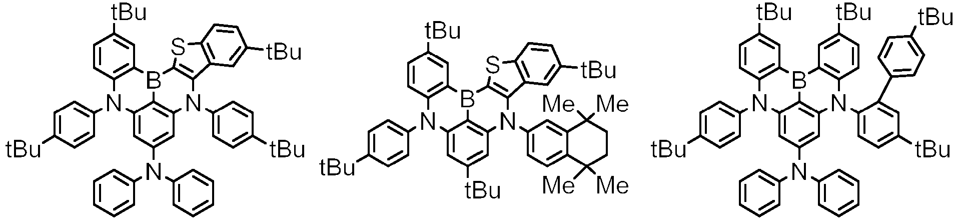

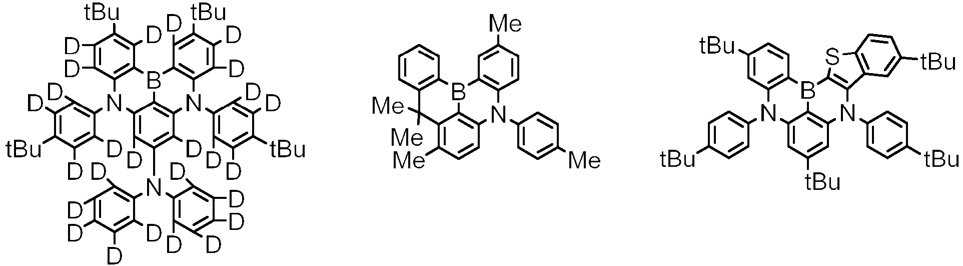

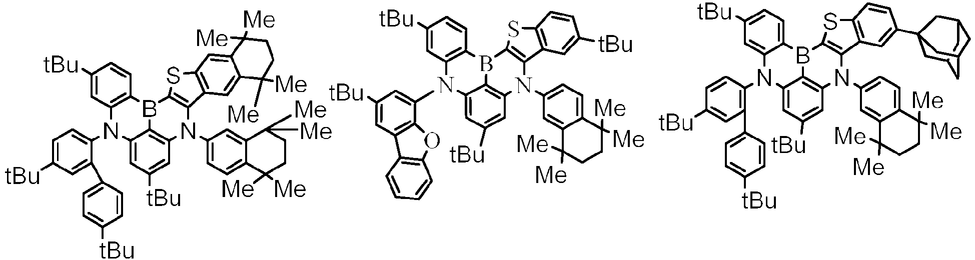

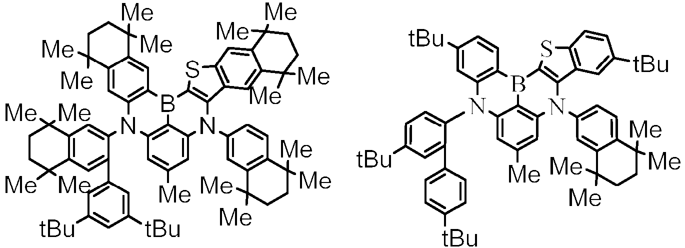

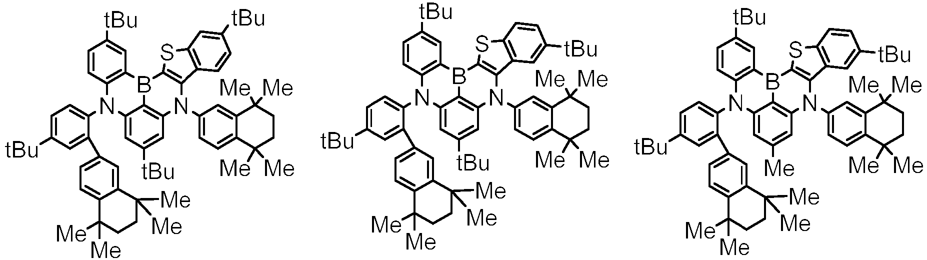

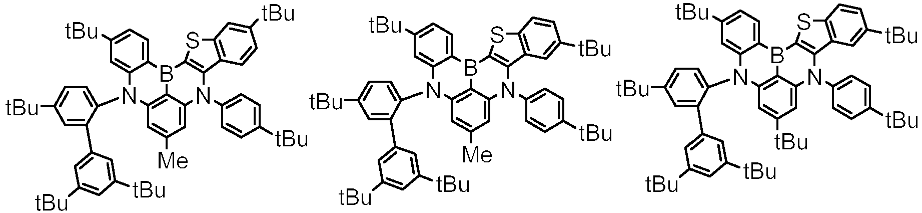

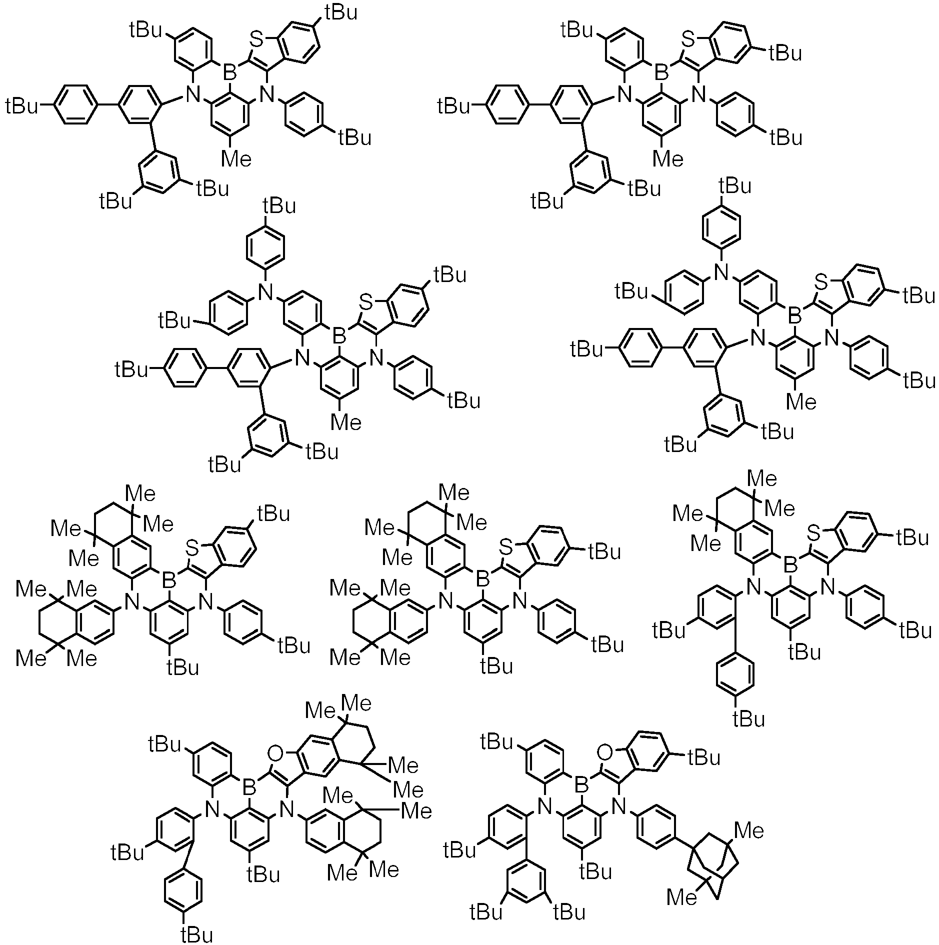

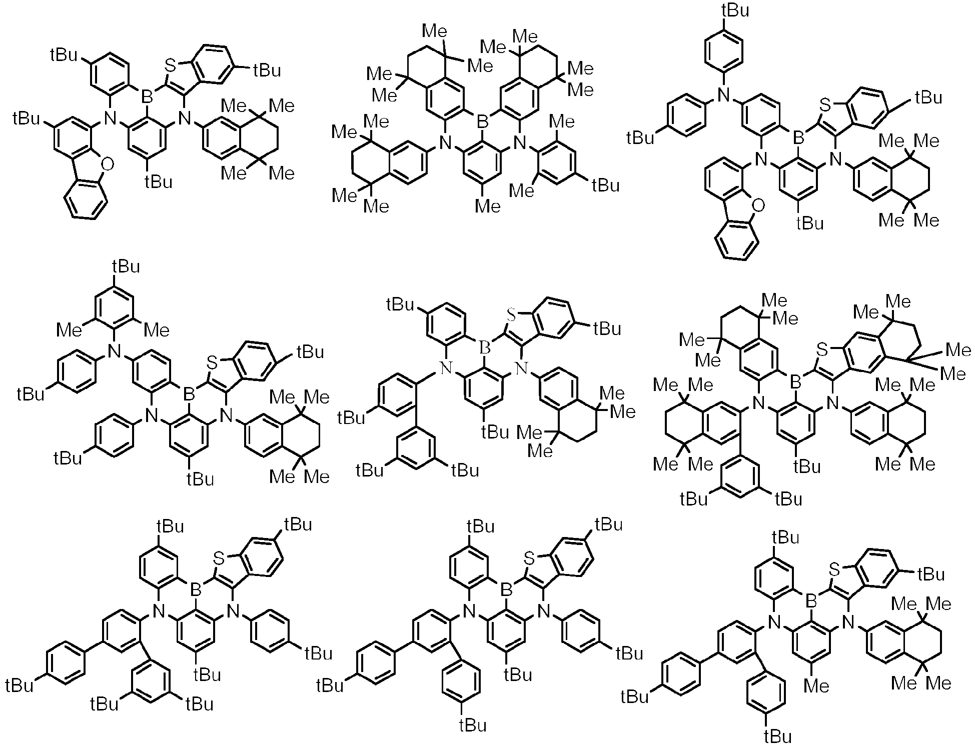

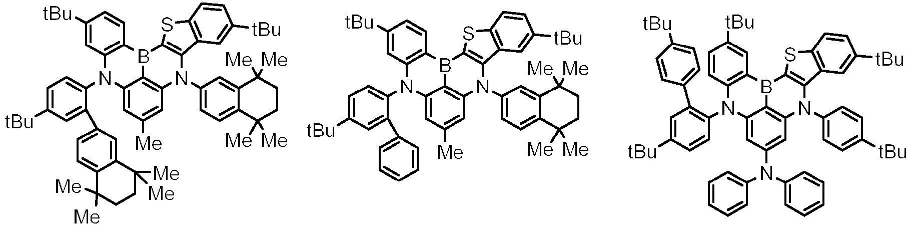

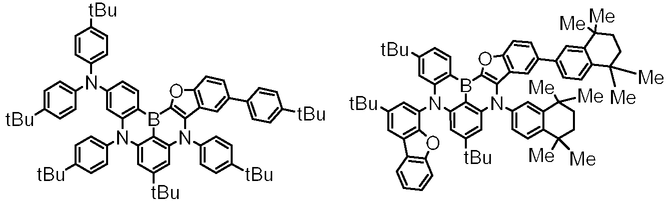

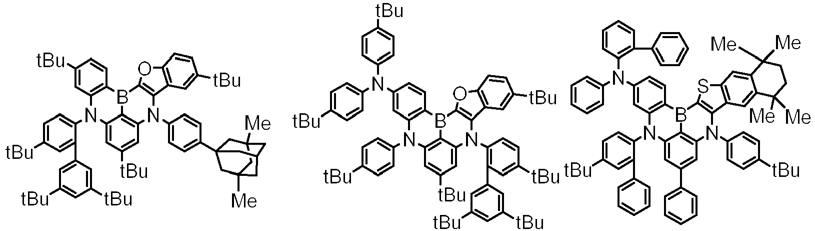

The amount of the host material used varies depending on the type of the host material, and may be determined in accordance with the characteristics of the host material. The amount of the host material to be used is preferably 50 to 99.999% by mass, more preferably 80 to 99.95% by mass, and still more preferably 90 to 99.9% by mass, with respect to the total mass of the light-emitting layer.

The amount of the dopant material used varies depending on the type of the dopant material and may be determined according to characteristics of the dopant material. The amount of the dopant to be used is preferably 0.001 to 50% by mass, more preferably 0.05 to 20% by mass, and still more preferably 0.1 to 10% by mass, with respect to the total mass of the light-emitting layer. The amount within the above-described range is preferred in view of capability of preventing a concentration quenching phenomenon, for example.

### <Host Material>

Host materials include fused ring derivatives such as anthracene, pyrene, dibenzochrysene or fluorene, previously known as luminescents, bisstyryl derivatives such as bisstyryl anthracene and distyrylbenzene derivatives, tetraphenylbutadiene derivatives, cyclopentadiene derivatives, fluorene derivatives, and benzofluorene derivatives.

As the host material, for example, a compound represented by any one of Formulas (H1), (H2) and (H3) below may be used.

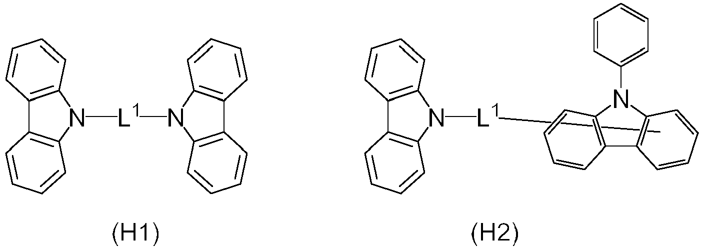

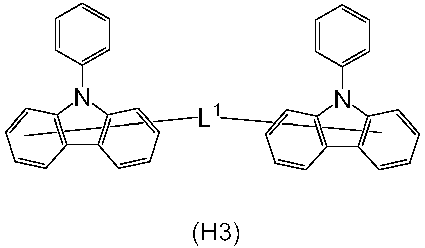

In Formulas (H1), (H2) and (H3), L¹ is a divalent group that is either a single bond or contains at least one arylene or heteroarylene group. L¹ is a single bond or an arylene having 6 to 24 carbons, a heteroarylene having 2 to 24 carbons, a heteroarylenearylene having 6 to 24 carbons and an aryleneheteroarylenearylene having 6 to 24 carbons, or any two of these linked by -O-, -S-, -CH2-, -Si(-Arx)₂- (Arx is aryl), or cycloalkylene to form a divalent group. An arylene in L¹ is preferably an arylene having 6 to 16 carbons, more preferably an arylene having 6 to 12 carbons, and particularly preferably an arylene having 6 to 10 carbons, and specifically a divalent group of benzene ring, biphenyl ring, terphenyl ring, fluorene ring or the like. As heteroarylene in L¹, a heteroarylene having 2-24 carbons is preferable, a heteroarylene having 2-15 carbons is still more preferable, and a heteroarylene having 2-10 carbons is particulay preferable. Specifically, a divalent group of pyrrole ring, oxazole ring, isoxazole ring, thiazole ring, isothiazole ring, imidazole ring, oxadiazole ring, thiadiazole ring, triazole ring, tetrazole ring, pyrazole ring, pyridine ring, a pyrimidine ring, pyndazine ring, pyrazine ring, triazine ring, indole ring, isoindole ring, 1H-indazole ring, benzoimidazole ring. benzoxazole ring, benzothiazole ring, 1H-benzotriazole ring, quinoline ring, isoquinoline ring, cinnoline ring, quinazoline ring, quinoxaline ring, ph thalazine ring, naphthyridine ring, purine ring, pteridine ring, carbazole ring, acridine ring, phenoxathiin ring, phenoxazine ring, phenothiazine ring, phenazine ring, indolizine ring, furan ring, benzofuran ring, isobenzofuran ring, dibenzofuran ring, thiophene ring, benzothiophene ring, dibenzothiophene ring. furazane ring. oxadiazole ring or thianthrene ring can be exemplified. At least one hydrogen in the compound represented by each of the above formulas may be replaced with at least one group selected from Substituent Group Z or with deuterium, specifically with an alkyl having 1 to 6 carbons, cyano, a halogen or deuterium, for example.

Preferred specific examples include compounds represented by any of the structural formulas listed below. In the structural formula listed below, at least one hydrogen may be substituted with a halogen, cyano, an alkyl having 1 to 4 carbons (e.g., methyl or t-butyl), phenyl naphthyl, or the like.

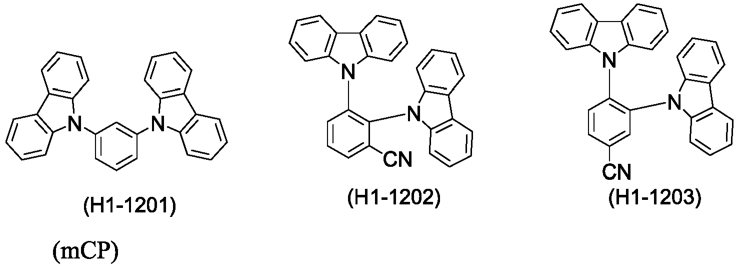

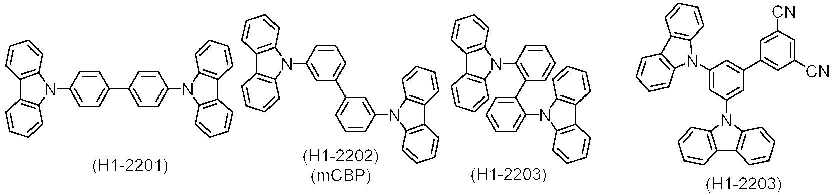

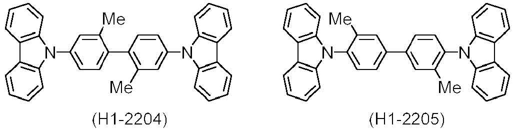

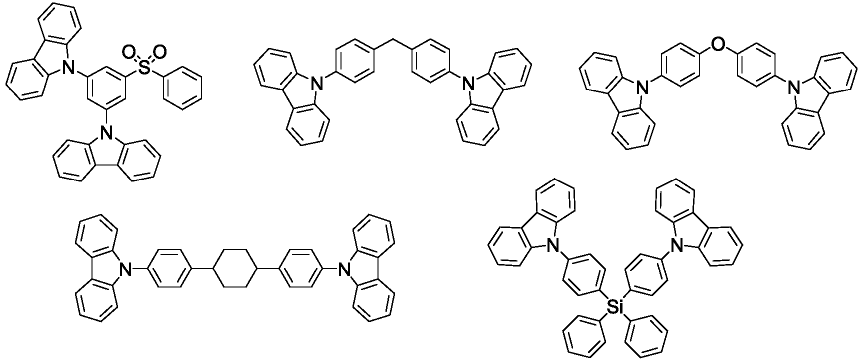

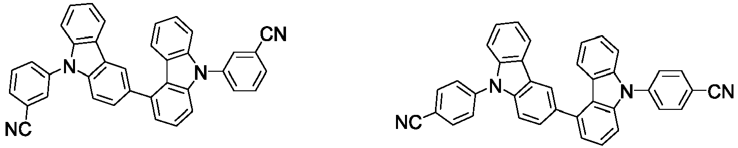

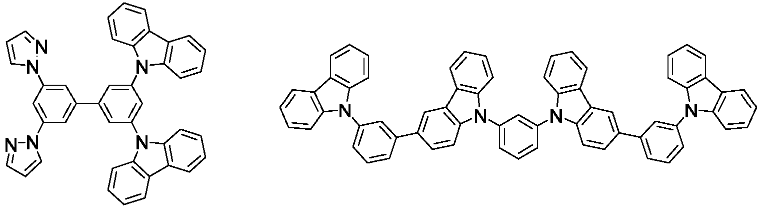

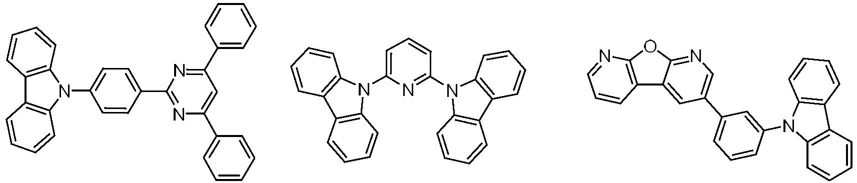

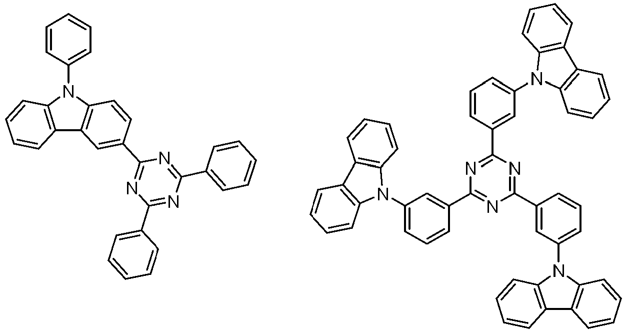

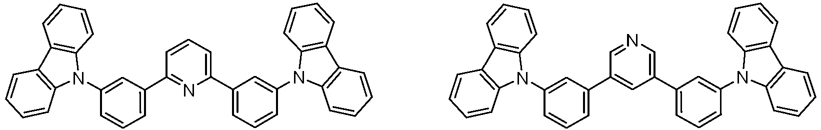

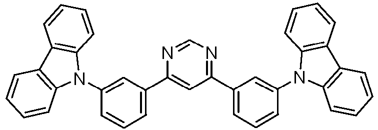

### <Anthracene-Based Compound>

Examples of anthracene-bed compound as a host include a compound represented by Formula (3-H) and a compound represented by Formula (3-H2).

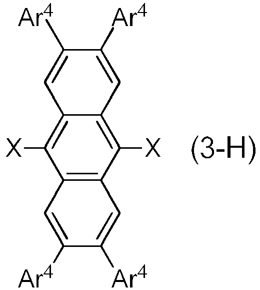

In Formula (3-H):
X and Ar⁴ is each independently hydrogen, a substituted or unsubstituted aryl, a substituted or unsubstituted heteroaryl, a substituted or unsubstituted diarylamino, a substituted or unsubstituted diheteroarylamino, an substituted or unsubstituted arylheteroarylamino which may be subjected to substitution, a substituted or unsubstituted alkyl , a substituted or unsubstituted cycloalkyl, a substituted or unsubstituted alkenyl, a substituted or unsubstituted alkoxy , a substituted or unsubstituted aryloxy, a substituted or unsubstituted arylthio, or a substituted silyl, and a case where all of X and Ar⁴ simultaneously become hydrogen is excluded.

At least one hydrogen in the compound represented by Formula (3-H) may be replaced with a halogen, cyano, deuterium or a heteroaryl which may be substituted.

Further, a multimer (preferably a dimer) may be formed using a structure represented by Formula (3-H) as a unit structure. In this case, for example, an embodiment in which a plural of the unit structure represented by Formula(3-H) is bonded via X can be exemplified. Examples of X include single bond, an arylene (phenylene, biphenylene and naphthylene, etc.), a heteroarylene (a divalent group of pyridine ring, dibenzofuran ring, dibenzothiophene ring, carbazole ring, benzocarbazole ring and phenyl-substituted carbazole ring, etc.) and the like.

Preferred embodiments of the above anthracene-based compound will be described below. The definitions of the symbols in the following structures are the same as those described above.

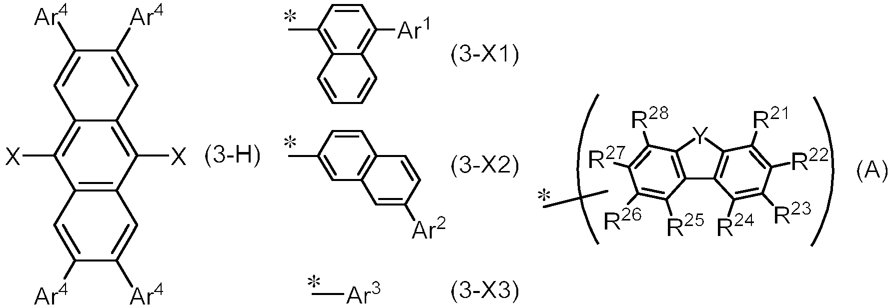

In Formula (3-H), X is each independently a group represented by Formula (3-X1), Formula (3-X2) or Formula (3-X3). The group represented by Formula (3-X1), Formula (3-X2) or Formula (3-X3) is bonded to the anthracene ring in Formula (3-H) at *. Preferably, two X are not the group represented by Formula (3-X3) at the same time. More preferably, two X are not the group represented by Formula (3-X2) at the same time.

Further, a multimer (preferably a dimer) may be formed using a structure represented by Formula (3-H) as a unit structure. In this case, for example, an embodiment in which a plural of the unit structures represented by Formula (3-H) is bonded via X can be exemplified. Examples of X include single bond, an arylene (phenylene, biphenylene and naphthylene, etc.) and a heteroarylene (a divalent group of pyridine ring, dibenzofuran ring, dibenzothiophene ring, carbazole ring, benzocarbazole ring or phenyl-substituted carbazole ring, etc) and the like.

A naphthylene site in f Formula (3-X1) and Formula (3-X2) may be fused by one benzene ring. A structure thus fused is as described below.

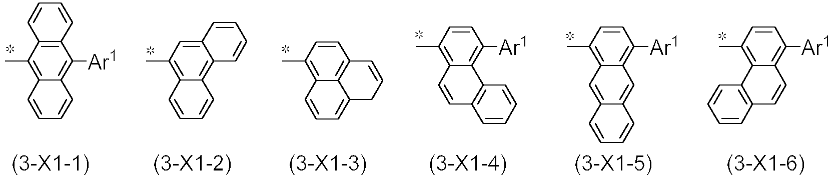

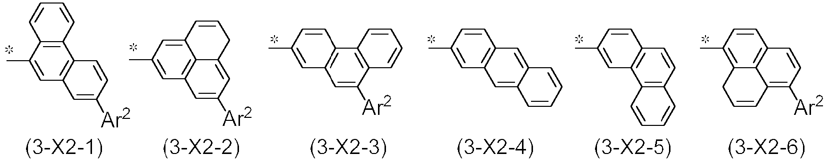

Ar¹ and Ar² are each independently hydrogen, phenyl, biphenylyl, terphenylyl, quaterphenylyl, naphthyl, phenanthryl, fluorenyl, benzofluorenyl, chrysenyl, triphenylenyl, pyrenyl, or a group represented by Formula (A) (also including carbazolyl, benzocarbazolyl and a phenyl-substituted carbazolyl). In addition, when Ar¹ or Ar² is a group represented by Formula (A), the group represented by Formula (A) s bonded to a naphthalene ring in Formula (3-X1) or Formula (3-X2) at a position "*."

Ar³ is phenyl, biphenylyl, terphenylyl, quaterphenylyl, naphthyl, phenanthryl, fluorenyl, benzofluorenyl, chrysenyl, triphenylenyl, pyrenyl, or a group represented by Formula (A) (also including carbazolyl, benzocarbazolyl and a phenyl-substituted carbazolyl). In addition, when Ar³ is a group represented by Formula (A), the group represented by Formula (A) is bonded to a single bond represented by a straight line in Formula (3-X3) at a position *. More specifically, the anthracene ring in Formula (3-H) is directly bonded to the group represented by Formula (A).

Moreover, Ar³ may have a substituent, and at least one hydrogen in Ar³ may be replaced with an alkyl having 1 to 4 carbons, a cycloalkyl having 5 to 10 carbons, phenyl, biphenylyl, terphenylyl, naphthyl, phenanthryl, fluorenyl, chrysenyl, triphenylenyl, pyrenyl, or a group represented by Formula (A) (also including carbazolyl and a phenyl-substituted carbazolyl). In addition, when the substituent of Ar³ is the group represented by Formula (A), the group represented by Formula (A) is bonded to Ar³ in Formula (3-X3) at a position *.

Ar⁴ is each independently hydrogen, phenyl, biphenylyl, terphenylyl, naphthyl, or silyl which has as substituents an alkyl having 1 to 4 carbons (metyl, ethyl, t-butyl, or the like) and/or a cycloalkyl having 5 to 10 carbons.

Moreover, hydrogen in a chemical structure of the anthracene-based compound represented by Formula (3-H) may be replaced with the group represented by Formula (A). When the hydrogen is replaced by the group represented by Formula (A), at least one hydrogen in the compound represented by Formula (3-H) is replaced with the group represented by Formula (A) at a position *.

The group represented by Formula (A) is one of the substituents that the anthracene-based compound represented by Formula (3-H) can have.

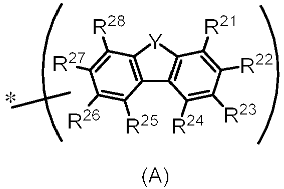

In Formula (A), Y is -O-, -S- or >N-R²⁹, R²¹ to R²⁸ are each independently hydrogen, an alkyl which may be substituted, a cycloalkyl which may be substituted, an aryl which may be substituted, a heteroaryl which may be substituted, an alkoxy which may be substituted, an aryloxy which may be substituted, an arylthio which may be substituted, a trialkylsilyl, a tricycloalkylsilyl, a dialkylcycloalkylsilyl, an alkyldicycloalkylsilyl, an amino which may be substituted, a halogen, hydroxy or cyano, and adjacent groups of R²¹ to R²⁸ may be bonded to each other to form a hydrocarbon ring, an aryl ring or a heteroaryl ring, and R²⁹ is hydrogen or an aryl which may be substituted.

Y in Formula (A) is preferably -O-.

Examples of the "substituted amino" of the "amino which may be substituted" in R²¹ to R²⁸ include a diarylamino, a diheteroarylamino, an arylheteroarylamino, etc.

R²⁹ in ">N-R²⁹" as Y is hydrogen or an aryl which may be substituted.

Any adjacent groups in R²¹ to R²⁸ may be bonded to each other to form a hydrocarbon ring, an aryl ring or a heteroaryl ring. Specific examples thereof include a group represented by Formula (A-1) in the case where the ring is not formed, and groups represented by Formulas (A-2) to (A-14) in the case where the ring is formed. In addition, at least one hydrogen in the group represented by any one of Formulas (A-1) to (A-14) may be replaced with an alkyl, a cycloalkyl, an aryl, a heteroaryl, an alkoxy, an aryloxy, an arylthio, a trialkylsilyl, a tricycloalkylsilyl, a dialkylcycloalkylsilyl, an alkyldicycloalkylsilyl, a diaryl-substituted amino(the two aryls may be liked to each other via a linking group.), a diheteroaryl-substituted amino, an arylheteroaryl-substituted amino, a halogen and hydroxy or cyano.

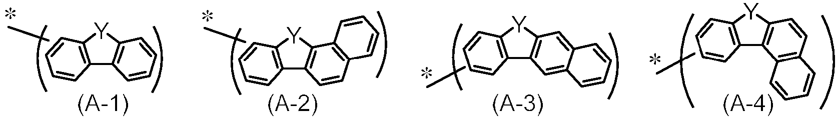

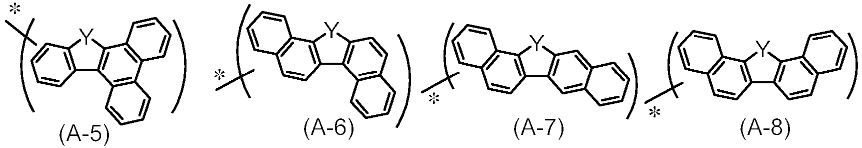

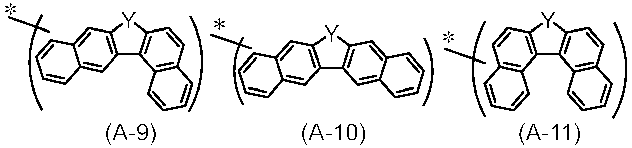

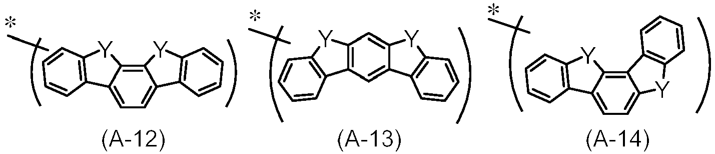

Specific examples of the ring formed by bonding adjacent groups to each other include a cyclohexane ring, if the ring is a hydrocarbon ring, and the ring structure described in the "aryl" or the "heteroaryl" in R²¹ to R²⁸, if the ring is the aryl ring or the heteroaryl ring, in which the above rings are formed so as to be fused to one or two benzene rings in Formula (A-1).

The group represented by Formula (A) is a group obtained by removing one hydrogen at any position of Formula (A), and * indicates the position at which the hydrogen is removed. In other words, the group represented by Formula (A) may have the bonding position at any position. For example, it can be any carbon atom on two benzene rings in the structure of Formula (A), an atom on any ring formed by bonding adjacent groups of R²¹ to R²⁸ in the structure of Formula (A) to each other, any position in R²⁹ in ">N-R²⁹" as Y in the structure of Formula (A), or N in ">N-R²⁹" (R²⁹ is a bonding hand). The same applies to the group represented by any of Formulas (A-1) to (A-14).

The group represented by Formula (A) includes, for example, a group represented by any of Formulas (A-1) to (A-14), a group represented by any of Formulas (A-1) to (A-5) and Formulas (A-12) to (A-14) is preferable, a group represented by any of Formulas (A-1) to (A-4) is more preferable, a group represented by any of Formulas (A-1), (A-3) and (A-4) is more preferable, and a group represented by Formula (A-1) is particularly preferable.

Examples of the group represented by Formula (A) include the following groups. Y and a position * in the formulas have the same definition as described above.

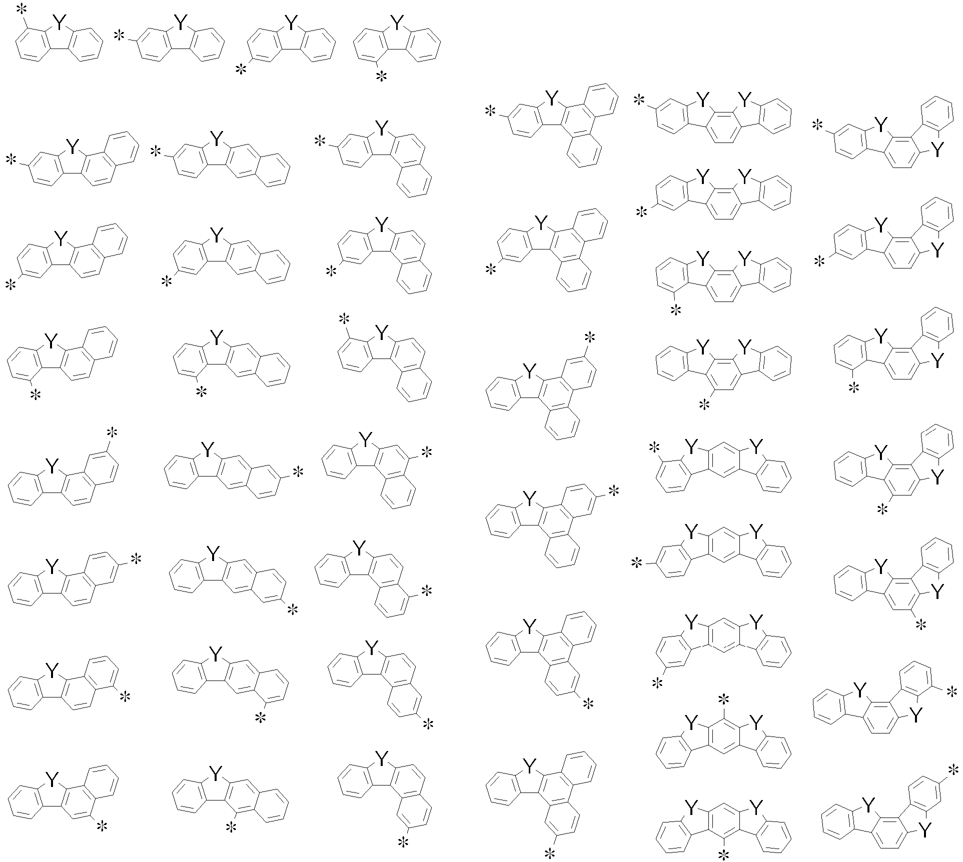

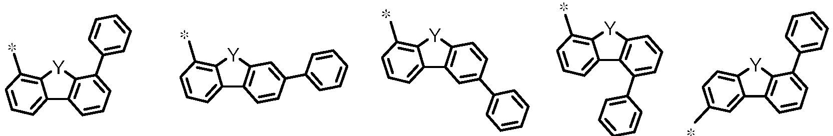

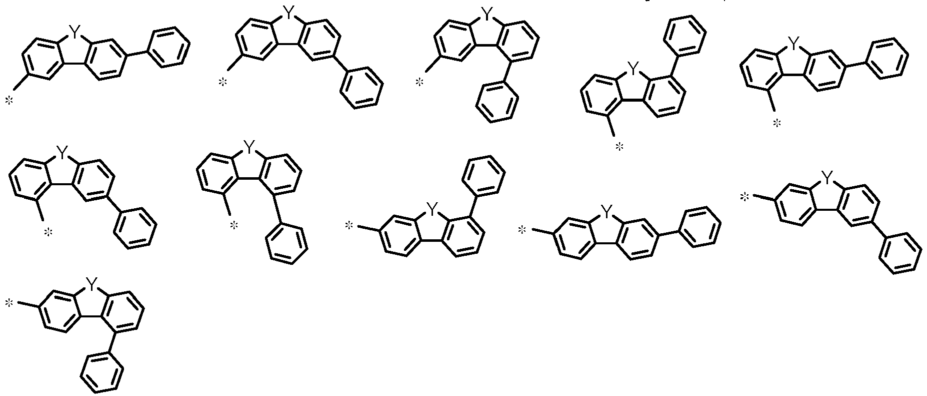

In the compound represented by Formula (3-H), the group represented by Formula (A) preferably binds to a naphthalene ring in Formula (3-X1) or Formula (3-X2), a single bond in Formula (3-X3) and/or Ar³ in Formula (3-X3).

Moreover, all or a part of hydrogens in the chemical structure of the anthracene-based compound represented by Formula (3-H) may be deuterium.

The anthracene-based compound as a host may be, for example, a compound represented by Formula (3-H2) below.

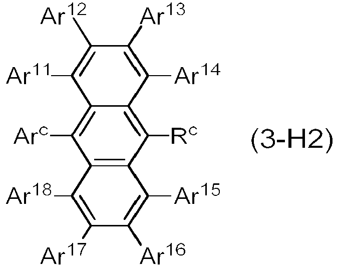

In Formula (3-H2), Ar^{c} is an optionally substituted aryl or an optionally substituted heteroaryl, R^{c} is hydrogen, an alkyl, or a cycloalkyl, and Ar¹¹, Ar¹², Ar¹³, Ar¹⁴, Ar¹⁵, Ar¹⁶, Ar¹⁷, and Ar¹⁸ are each independently hydrogen, an optionally substituted aryl, an optionally substituted heteroaryl, an optionally substituted diarylamino (the two aryls may be bonded via a linking group), an optionally substituted diheteroarylamino (the two heteroaryls may be bonded via a linking group), an optionally substituted arylheteroalylamino (the aryl and the heteroaryl may be bonded via a single bond or a linking group), an optionally substituted alkyl, an optionally substituted cycloalkyl, an optionally substituted alkenyl, an optionally substituted alkoxy, an optionally substituted aryloxy, an optionally substituted arylthio, or an optionally substituted silyl, and at least one hydrogen in a compound represented by Formula (3-H2) may be replaced with a halogen, cyano, or deuterium.

As the "optionally substituted aryl", a group represented by any one of Formulas (3-H2-X1) to (3-H2-X8) below is also preferred.

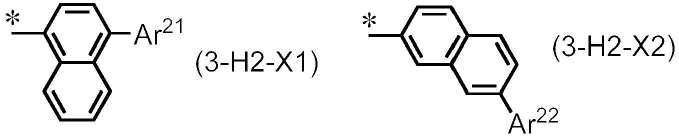

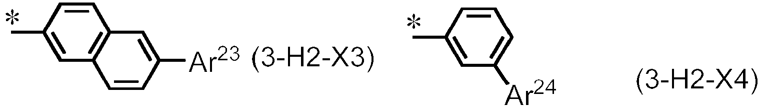

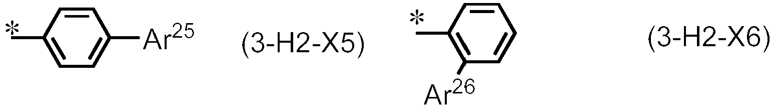

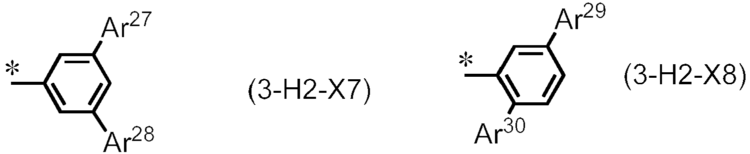

In the Formulas (3-H2-X1) to (3-H2-X8), * denotes a bonding position. In Formulas (3-H2-X1) to (3-H2-X8), Ar²¹, Ar²², and Ar²³ are each independently hydrogen, phenyl, biphenylyl, terphenylyl, quaterphenylyl, naphthyl, phenanthryl, fluorenyl, benzofluorenyl, chrysenyl, triphenylenyl, pyrenyl, anthracenyl, or a group represented by Formula (A). In the description of Formula (3-H2), the group represented by Formula (A) is the same as that described in the anthracene-based compound represented by Formula (3-H).

In Formulas (3-H2-X4) to (3-H2-X8), Ar²⁴, Ar²⁵, Ar²⁶, Ar²⁷, Ar²⁸, Ar²⁹, and Ar³⁰ are each independently hydrogen, phenyl, biphenylyl, terphenylyl, naphthyl, phenanthryl, fluorenyl, chrysenyl, triphenylenyl, pyrenyl, or a group represented by Formula (A). In addition, any one or two or more hydrogens in each of the groups represented by Formula (3-H2-X1) to Formula (3-H2-X8) may be replaced with an alkyl having 1 to 6 carbons (preferably methyl or t-butyl).

Further, preferred examples of "optionally substituted aryl" include terphenylyl (particularly m-terphenyl-5'-yl), which may be substituted with one or more substituents selected from the group consisting of phenyl, biphenylyl, terphenylyl, naphthyl, phenanthryl, fluorenyl, chrysenyl, triphenylenyl, pyrenyl, and a group represented by Formula (A).

Examples of the "optionally substituted heteroaryl" also include a group represented by Formula (A). In addition, specific examples of "optionally substituted aryl" and "optionally substituted heteroaryl" include dibenzofuryl, naphthobenzofuryl, a phenyl-substituted dibenzofuryl, and the like.

At least one hydrogen in the compound represented by Formula (3-H2) may be replaced with a halogen, cyano, or deuterium. The "halogen" includes fluorine, chlorine, bromine, and iodine. In particular, a compound in which all hydrogens in the compound represented by Formula (3-H2) are replaced with deuterium is preferred.

In Formula(3-H2), R^{c} is hydrogen, an alkyl, or a cycloalkyl, preferably hydrogen, methyl, or t-butyl, more preferably hydrogen.

In Formula (3-H2), it is preferable that at least two of Ar¹¹ to Ar¹⁸ are an optionally substituted aryl or an optionally substituted heteroaryl. In other words, it is preferable that the anthracene-based compound represented by Formula (3-H2) has a structure in which at least 3 substituents selected from the group consisting of an optionally substituted aryl and an optionally substituted heteroaryl are bonded to an anthracene ring.

It is more preferable that in the anthracene-based compound represented by Formula (3-H2) two of Ar¹¹ to Ar¹⁸ are each independently an optionally substituted aryl or an optionally substituted heteroaryl, and that the other six are hydrogen, an optionally substituted alkyl, an optionally substituted cycloalkyl, an optionally substituted alkenyl, or an optionally substituted alkoxy. In other words, it is more preferable that the anthracene-based compound represented by Formula (3-H2) has a structure in which three substituents selected from the group consisting of an optionally substituted aryl and an optionally substituted heteroaryl are bonded to an anthracene ring.

More preferably, in the anthracene-based compound represented by Formula. (3-H2) any two of Ar¹¹ to Ar¹⁸ are each independently an optionally substituted aryl or an optionally substituted heteroaryl, and that the other six are each independently hydrogen, methyl, or t-butyl.

Further, in Formula(3-H2), it is preferable that R^{c} is hydrogen and any six of Ar¹¹ to Ar¹⁸ are hydrogen.

The anthracene-based compound represented by Formula (3-H2) is preferably an anthracene-based compound represented by Formula (3-H2-A), (3-H2-B), (3-H2-C), (3-H2-D), or (3-H2-E) below.

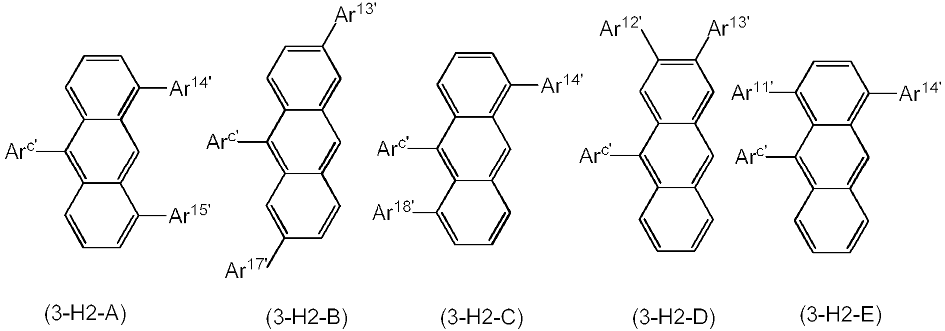

In Formulas (3-H2-A), (3-H2-B), (3-H2-C), (3-H2-D), or (3-H2-E), Ar^{c}', Ar¹¹', Ar¹²', Ar¹³', Ar¹⁴', Ar¹⁵', Ar¹⁷', and Ar¹⁸' are each independently phenyl, biphenylyl, terphenylyl, quaterphenylyl, naphthyl, phenanthtyl, fluorenyl, benzofluorenyl, chrysenyl, triphenylenyl, pyrenyl, or a group represented by Formula (A), and at least one hydrogen in each of the above groups may be replaced with phenyl, biphenylyl, terphenylyl, quaterphenylyl, naphthyl, phenanthryl, fluorenyl, benzofluorenyl, chrysenyl, triphenylenyl, pyrenyl, or a group represented by Formula (A). Here, when the hydrogens of methylene in fluorenyl and benzofluorenyl are both replaced with phenyls, these phenyls may be bonded to each other via a single bond. The carbons of the anthracene ring to which any of Ar^{c}', Ar¹¹', Ar¹²', Ar¹³', Ar¹⁴', Ar¹⁵', Ar¹⁷', and Ar¹⁸' is not bonded may be bonded with methyl or t-butyl instead of hydrogen.

A substituted or unsubstituted phenyl or a substituted or unsubstituted naphthyl as Ar^{c}', Ar¹¹', Ar¹²', Ar¹³', Ar¹⁴', Ar¹⁵', Ar¹⁷', and Ar¹⁸' is preferably a group represented by any of Formulas (3-H2-X1) to (3-H2-X8) above.

Preferably, Ar^{c}', Ar¹¹', Ar¹²', Ar¹³', Ar¹⁴', Ar¹⁵', Ar¹⁷', and Ar¹⁸' is each independently phenyl, biphenyl (particularly biphenyl-2-yl or biphenyl-4-yl), terphenyl (particularly m-terphenyl-5'-yl), naphthyl, phenanthryl, fluorenyl, or any of the above Formulas (A-1) to (A-4), wherein at least one of the hydrogens in these groups may be replaced with phenyl, biphenyl, naphthyl, phenanthryl, fluorenyl, or a group represented by any of Formulas (A-1) to (A-4).

In addition, at least one hydrogen in the compound represented by Formula (3-H2-A), (3-H2-B), (3-H2-C), (3-H2-D), or (3-H2-E) may be replaced with a halogen, cyano, or deuterium. A deuterated form is also preferred, and the form in which all anthracene rings are deuterated or all hydrogen atoms are deuterated is preferred.

Particularly preferred examples of the anthracene-based compound represented by Formula (3-H2) include an anthracene-based compound represented by Formula (3-H2-Aa) below.

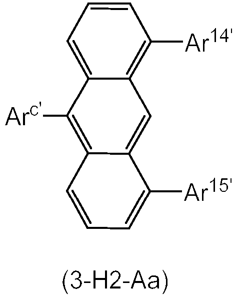

In Formula (3-H2-Aa), Ar^{c}', Ar¹⁴', and Ar¹⁵' are each independently phenyl, biphenylyl, terphenylyl, naphthyl, phenanthryl, fluorenyl, benzofluorenyl, cricenyl, triphenylyl, pyrenyl, or a group represented by any of Formulas (A-1) to (A-11) above, and at least one of the hydrogens in these groups may be replaced with a group represented by phenyl, biphenyl, terphenyl, naphthyl, phenanthryl, fluorenyl, benzofluorenyl, chrysenyl, triphenylenyl, pyrenyl, or a group represented by any of Formula (A-1) to Formula (A-11). When the hydrogens of methylene in fluorenyl and benzofluorenyl are both replaced with phenyls, these phenyls may be bonded to each other via a single bond. The carbons on the anthracene ring to which Ar^{c}', Ar¹⁴', and Ar¹⁵' are not bonded may be substituted with methyl or t-butyl instead of hydrogens. At least one hydrogen in the compound represented by Formula (3-H2-Aa) may be replaced with a halogen or cyano, and at least one hydrogen in the compound represented by Formula (3-H2-Aa) is replaced with deuterium.

In Formula (3-H2-Aa), Ar^{c}', Ar¹⁴', and Ar¹⁵' are preferably each independently phenyl, biphenylyl, terphenylyl, naphthyl, phenanthryl, fluorenyl, or a group represented by any of Formulas (A-1) to (A-4) above, and at least one of the hydrogens in these groups may be replaced with phenyl, naphthyl, phenanthryl, fluorenyl, or a group represented by any of Formulas (A-1) to (A-4).

In the compound represented by Formula (3-H2-Aa), it is preferable that at least a hydrogen bonded to a carbon at position 10 of an anthracene ring (when a carbon to which Ar^{c}' is bonded is set at position 9) is replaced with deuterium. In other words, the compound represented by Formula (3-H2-Aa) is preferably a compound represented by the following Formula (3-H2-Ab). In Formula (3-H2-Ab), D is deuterium, and Ar^{c}', Ar¹⁴', and Ar¹⁵' are the same as defined in Formula (3-H2-Aa). D in Formula (3-H2-Ab) indicates that at least this position is deuterium, and any one or more other hydrogens in Formula (3-H2-Ab) may be deuterium at the same time, and it is also preferred that every hydrogen in Formula (3-H2-Aa) is deuterium.

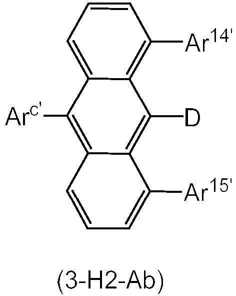

Specific examples of the anthracene-based compound include, for example, compounds represented by Formula(3-131-Y) to Formula(3-182-Y), compounds represented by Formula(3-183-N), Formula(3-184-Y)to Formula(3-284-Y), and Formula(3-500) to Formula(3-557), and Formula(3-600) to Formula(3-605), and Formula(3-606-Y) to Formula(3-626-Y). Hydrogens may be partially or entirely replaced with deuterium. Particularly desirable forms of deuterium substitution are listed individually. Y in the formula may be any of -O-, -S-, >N-R²⁹ (R²⁹ as defined above), or >C(-R³⁰)₂ (R³⁰ may be an optionally bonded aryl or an alkyl), and R²⁹ is phenyl, for example, R³⁰ is methyl, for example. For example, when Y is O, Formula (3-131-Y) is Formula (3-131-0), and when Y is -S- or >N-R²⁹ Formula (3-131-Y) is Formula (3-131-S) or Formula (3-131-N), respectively.

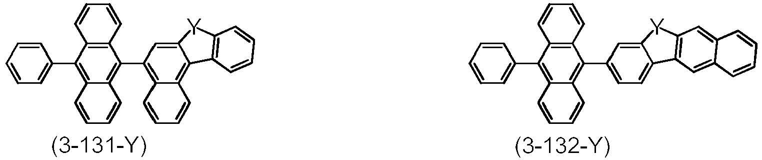

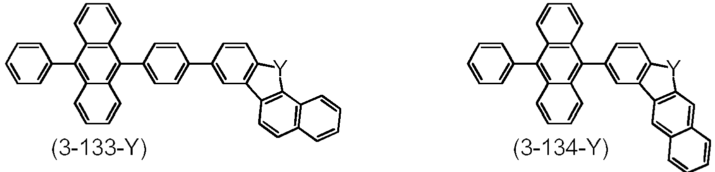

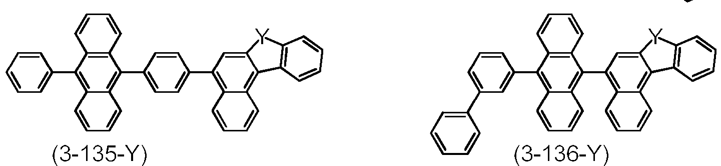

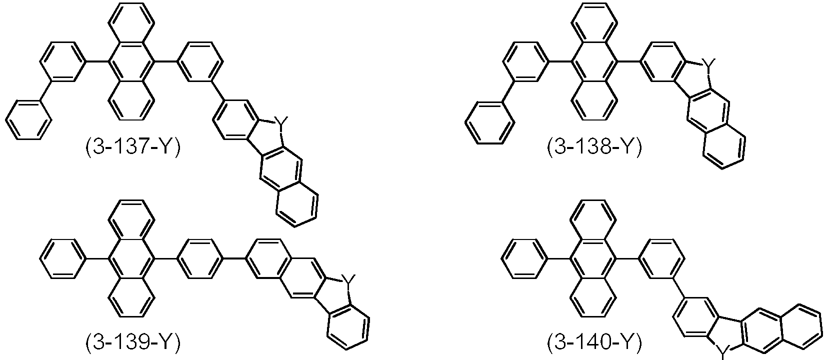

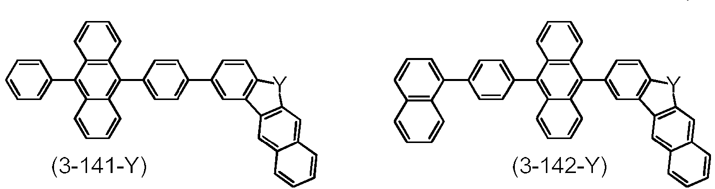

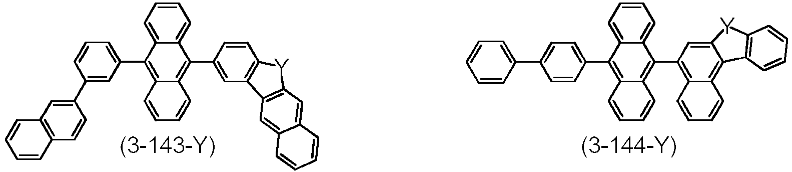

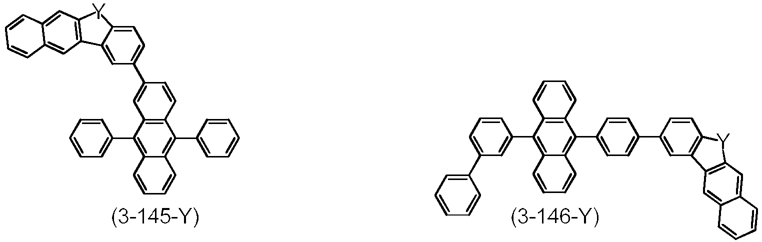

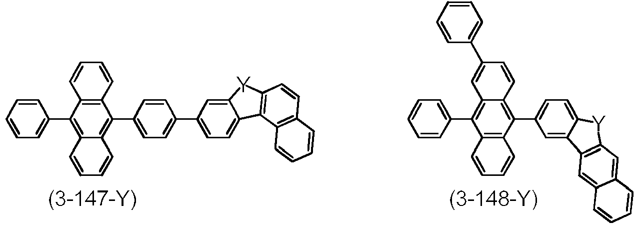

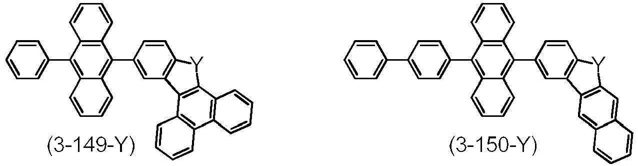

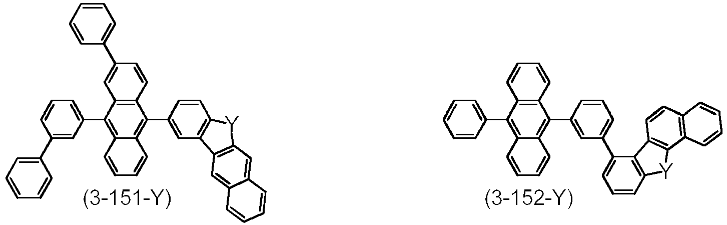

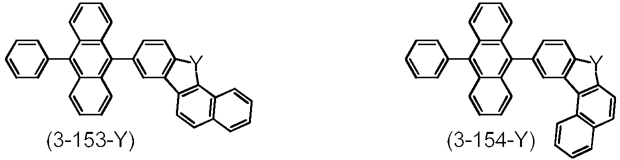

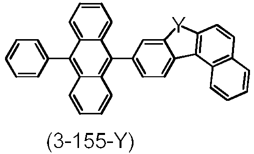

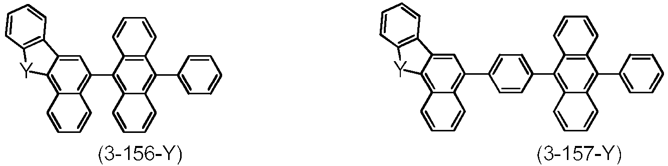

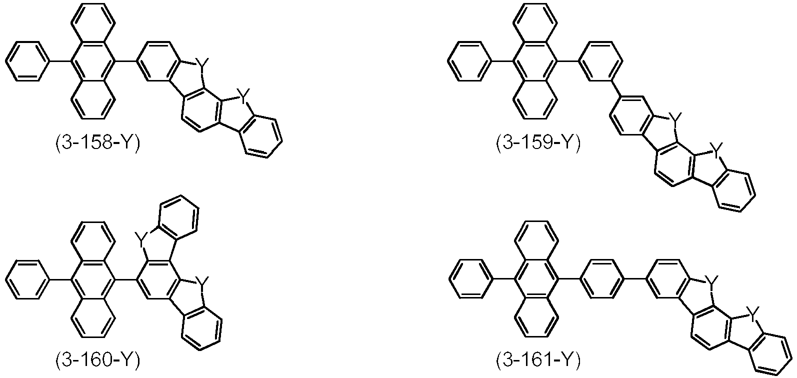

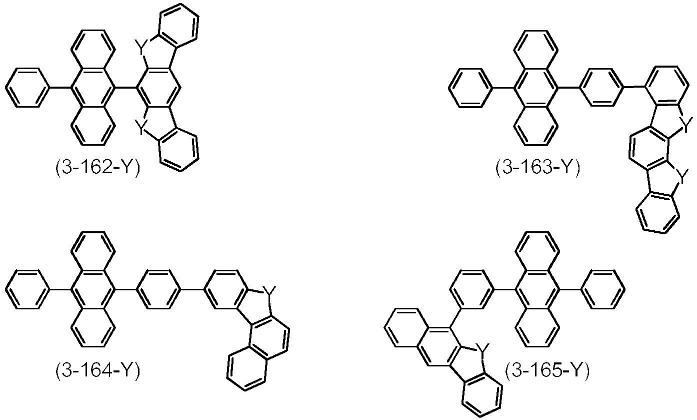

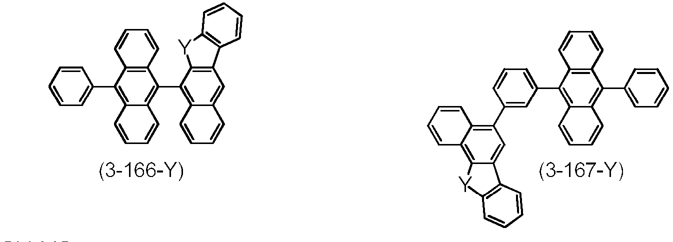

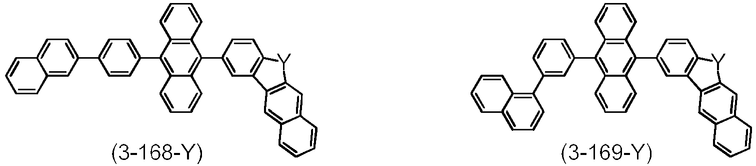

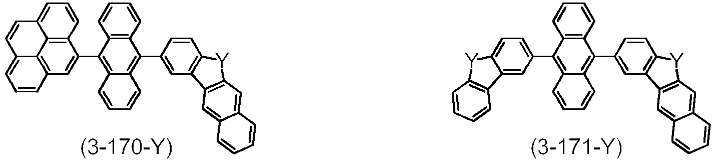

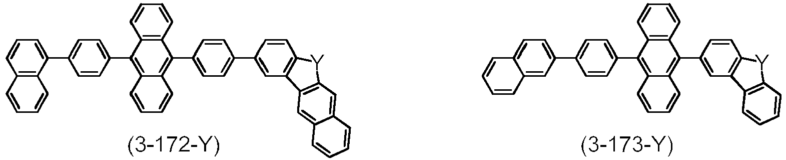

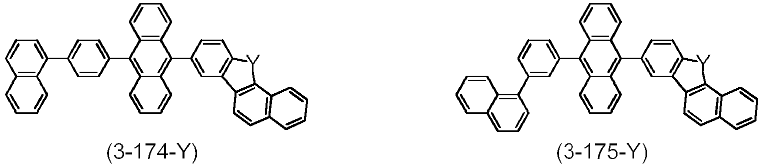

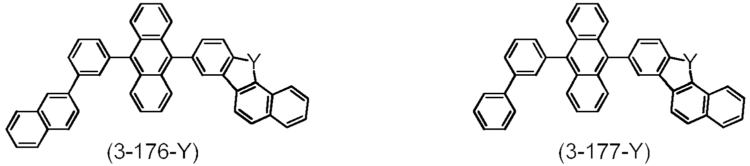

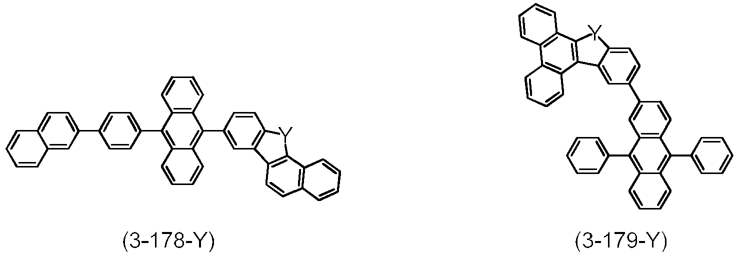

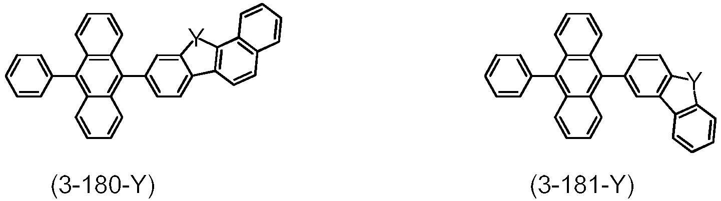

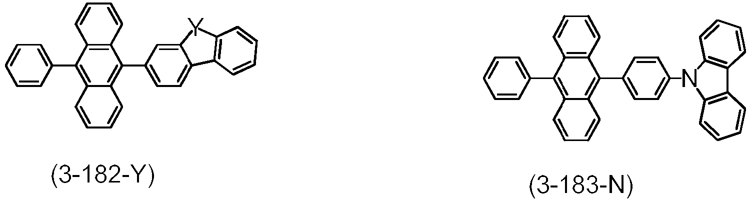

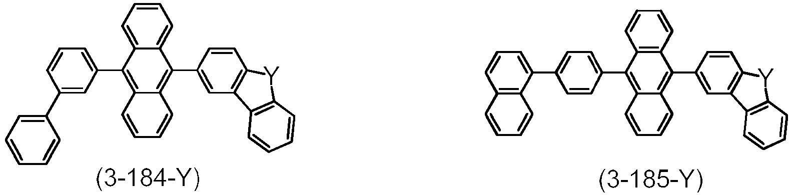

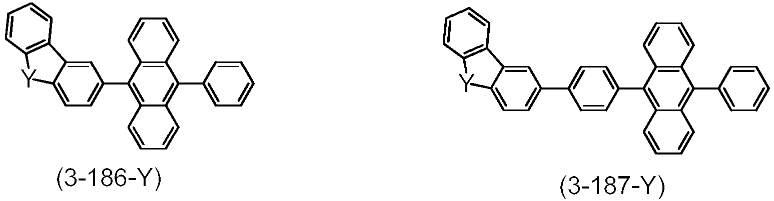

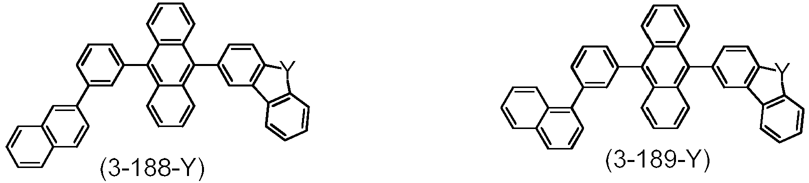

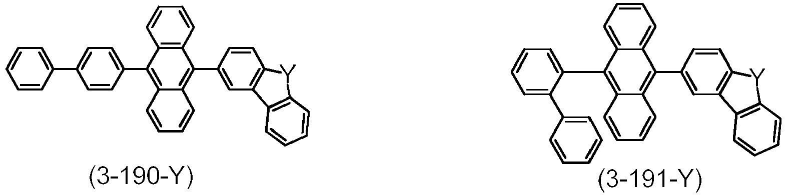

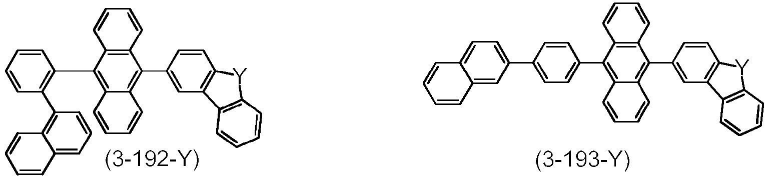

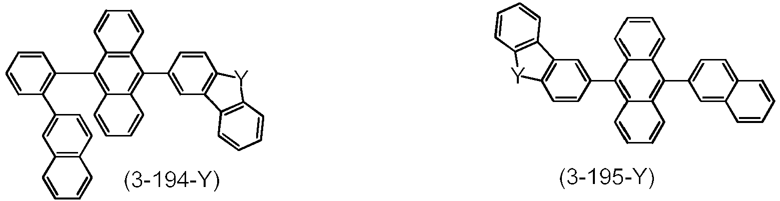

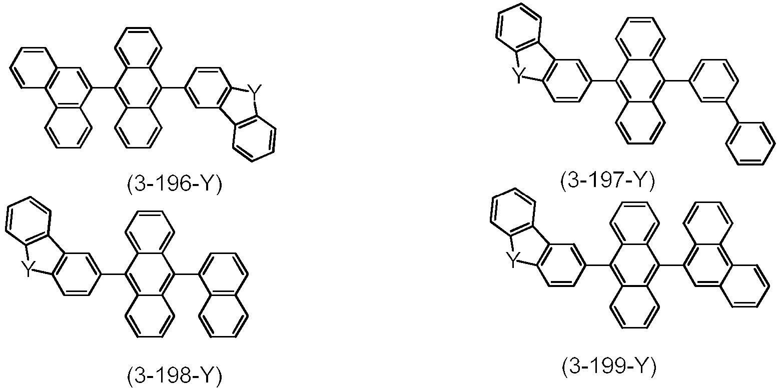

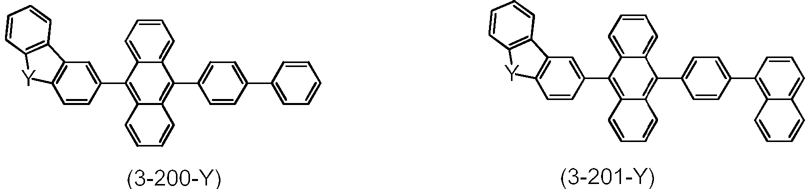

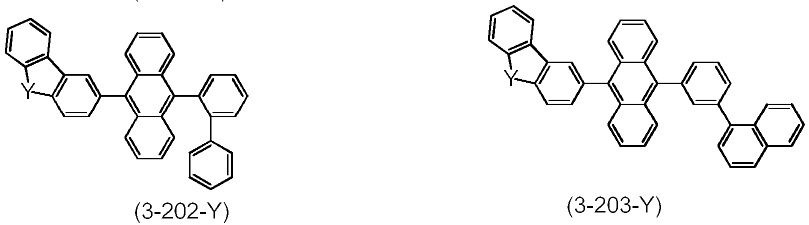

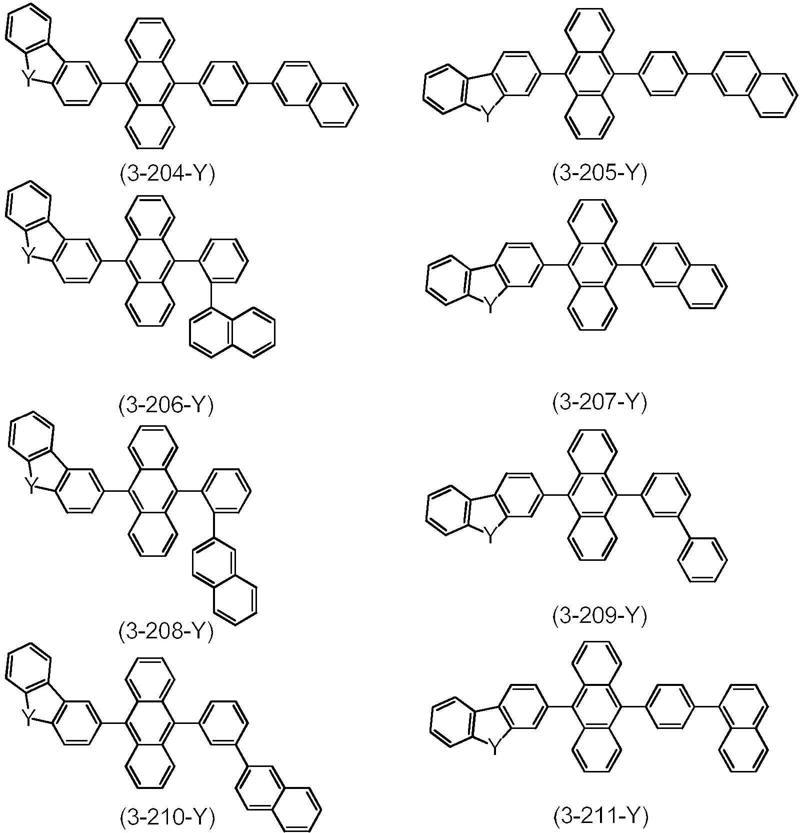

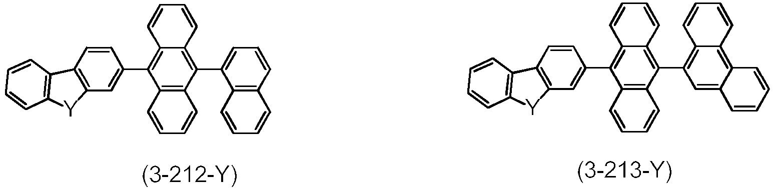

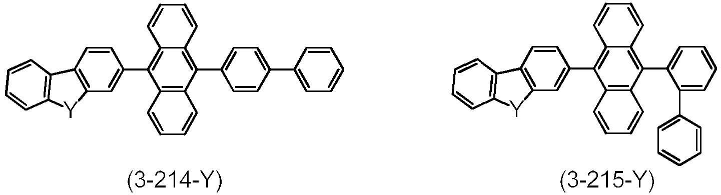

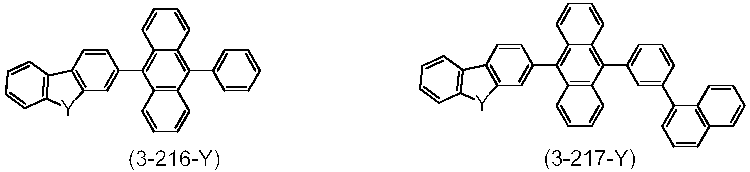

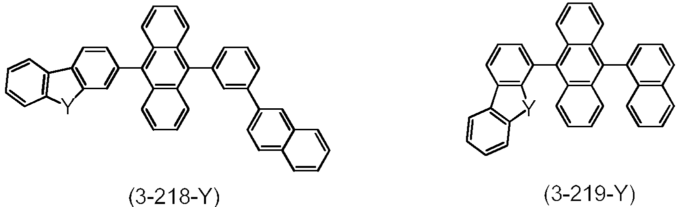

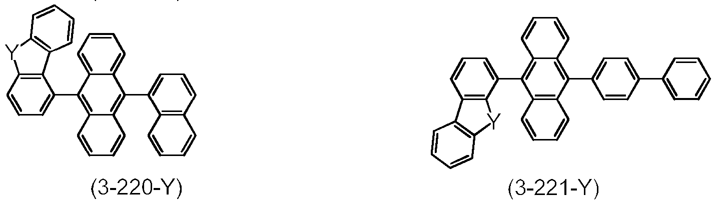

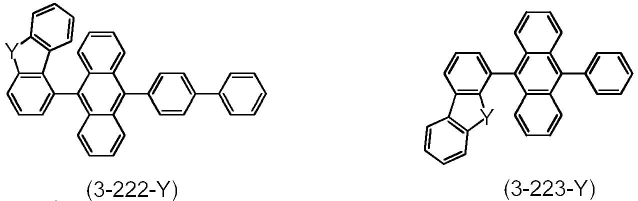

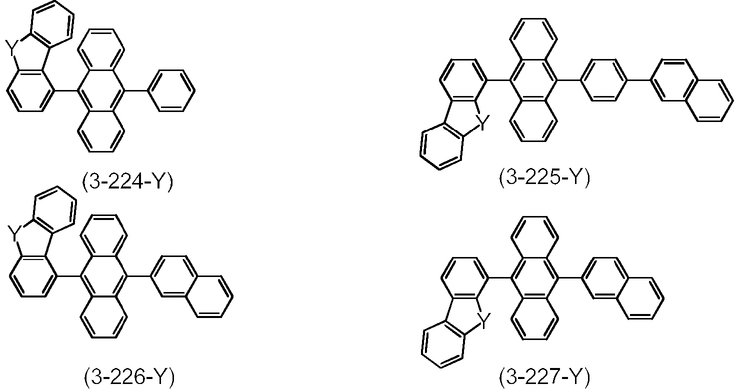

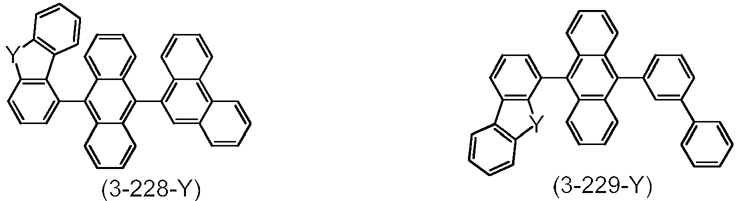

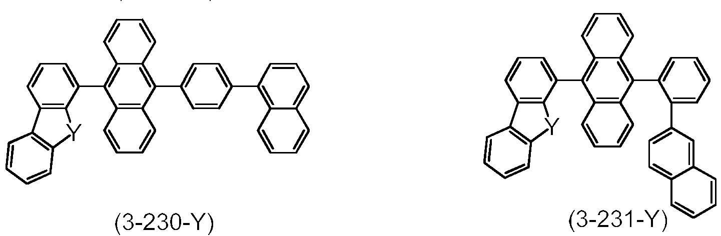

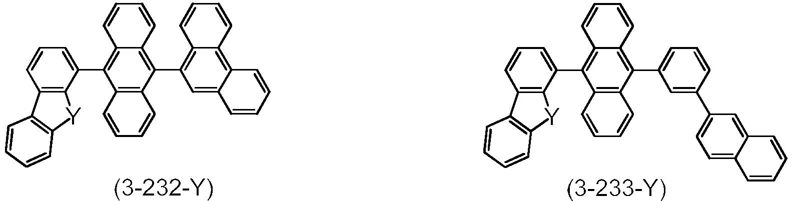

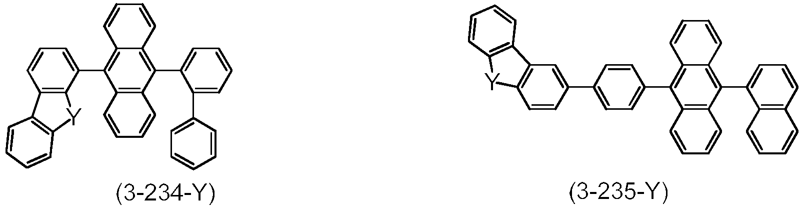

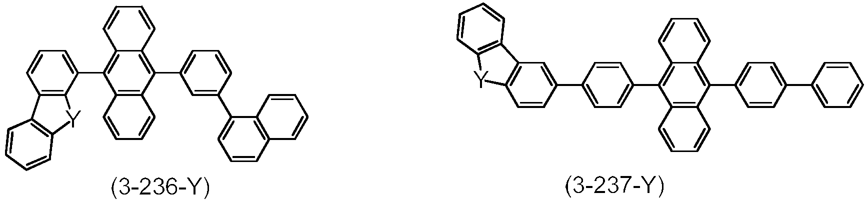

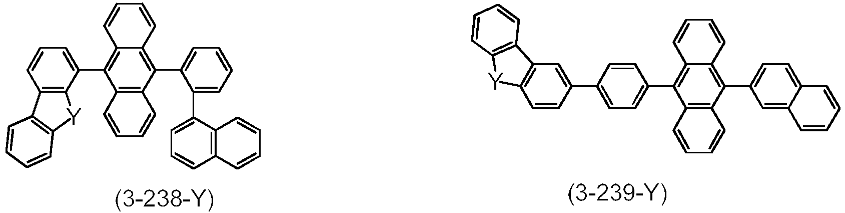

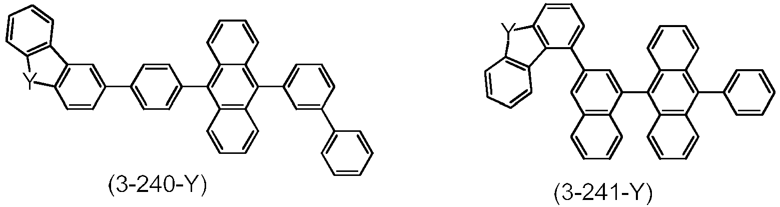

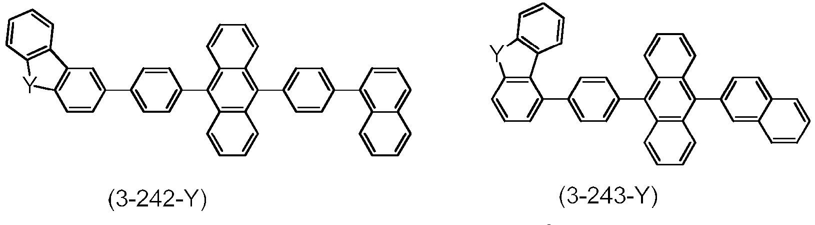

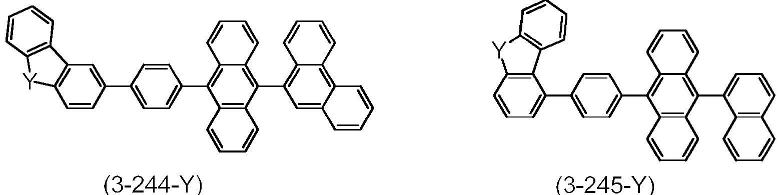

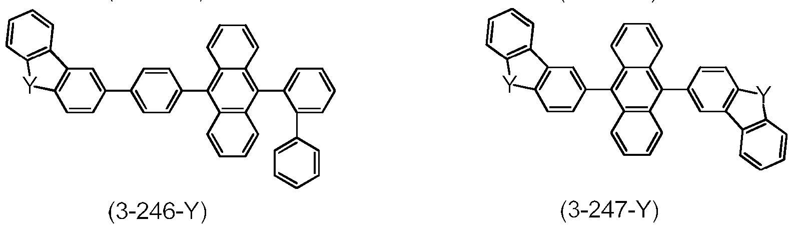

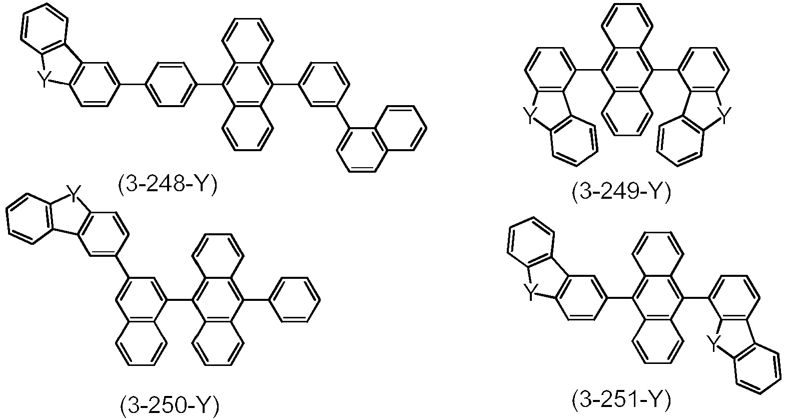

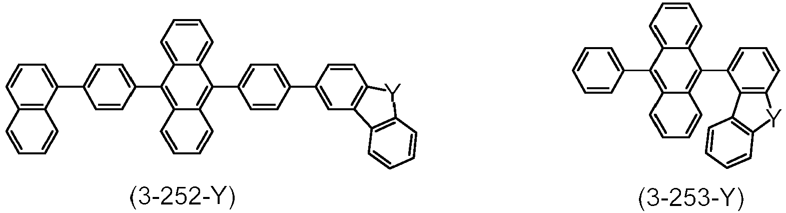

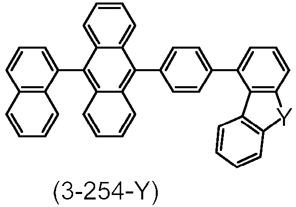

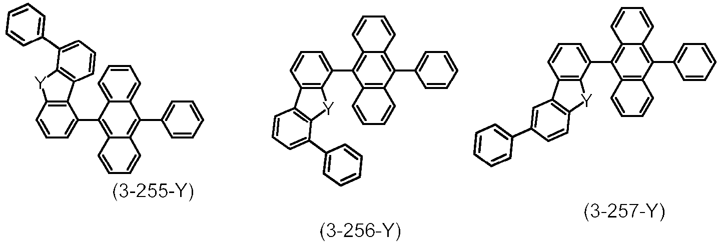

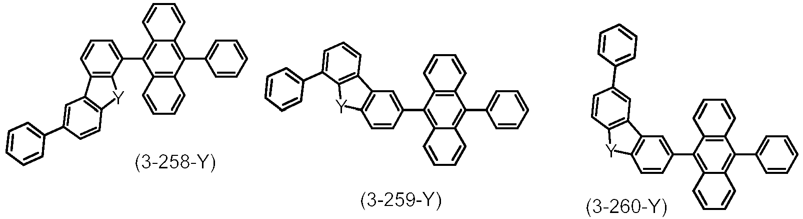

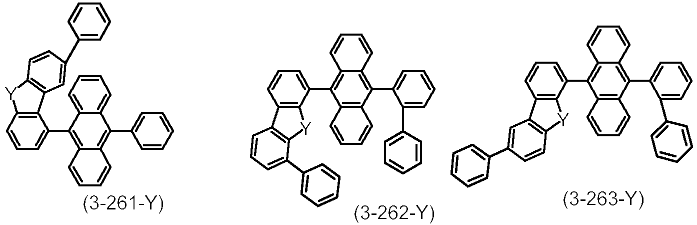

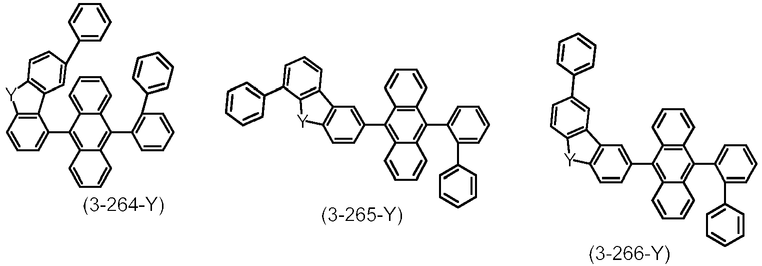

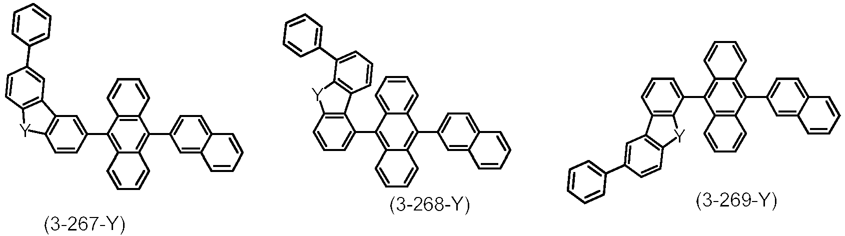

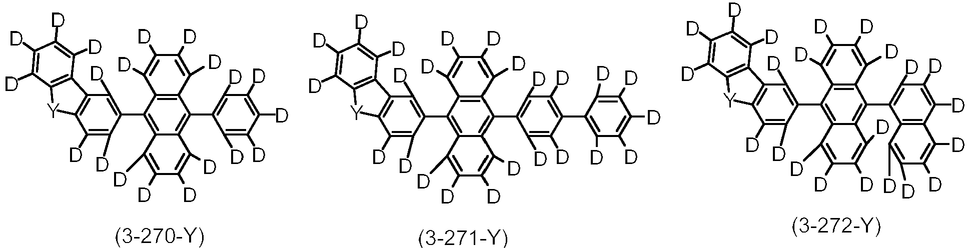

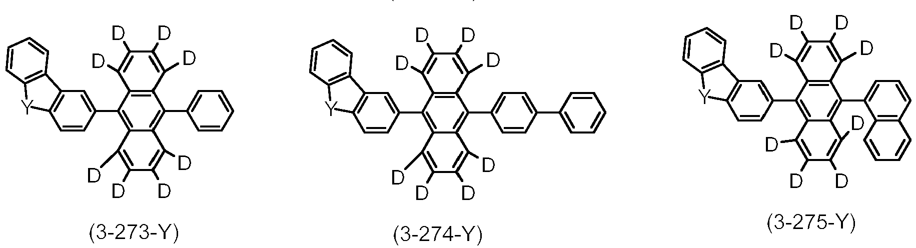

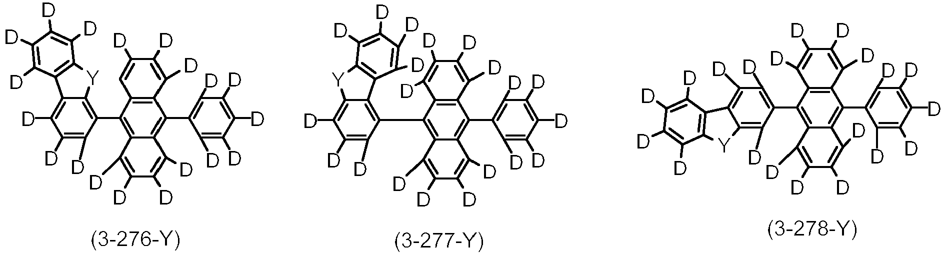

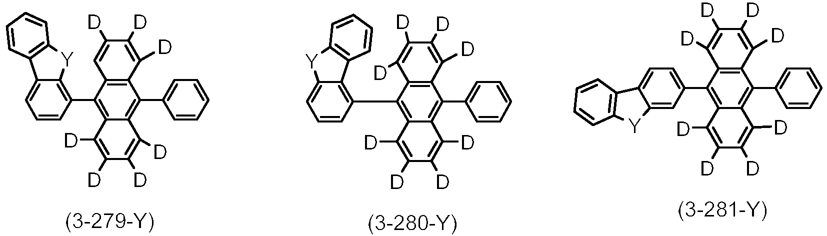

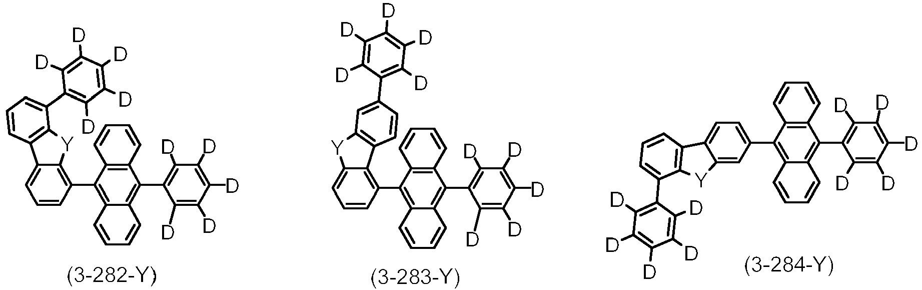

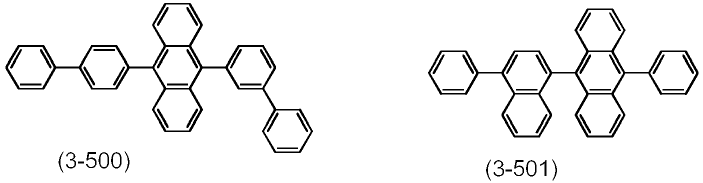

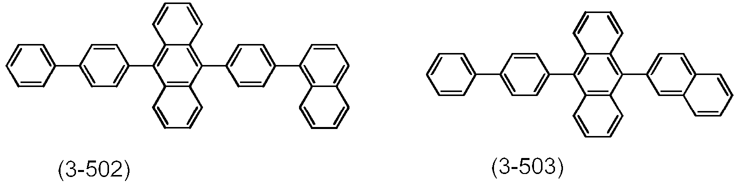

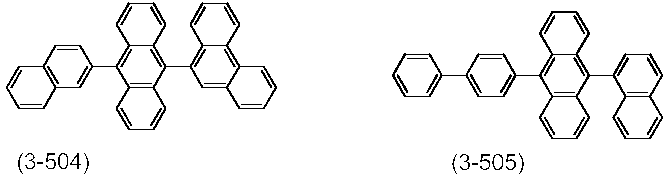

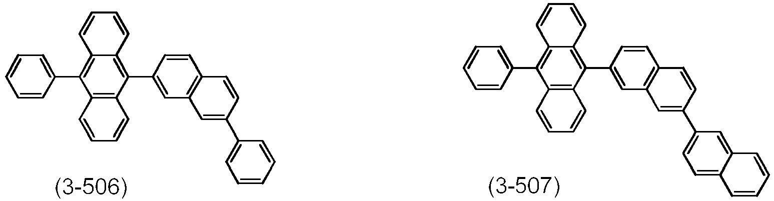

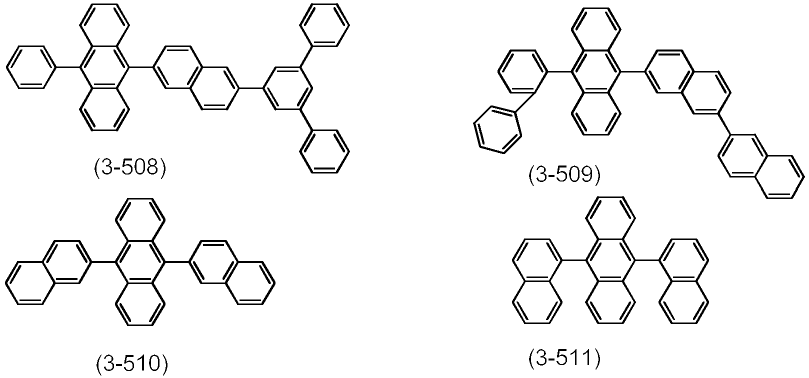

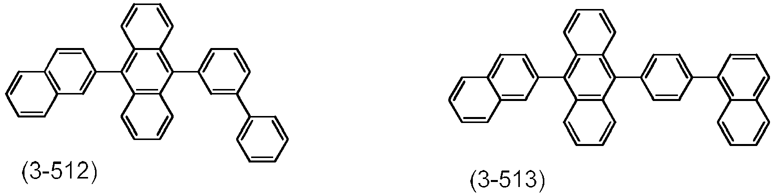

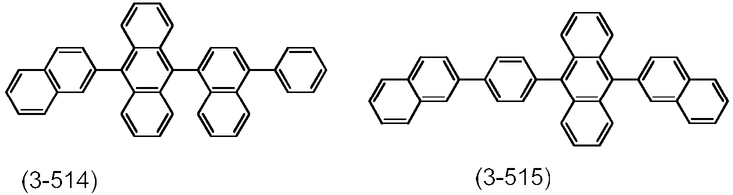

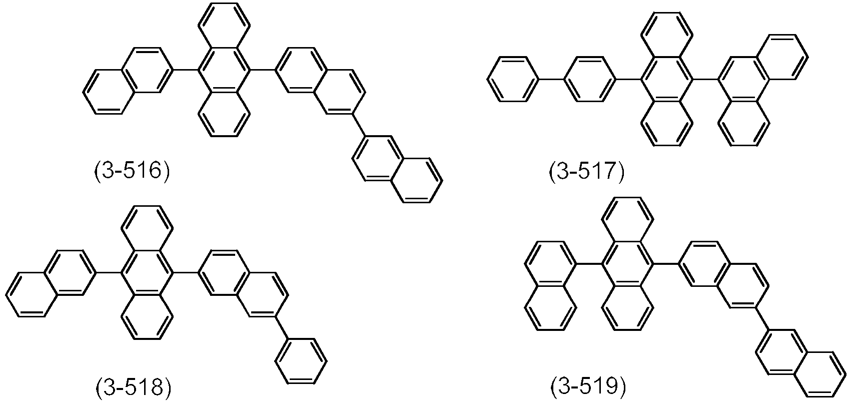

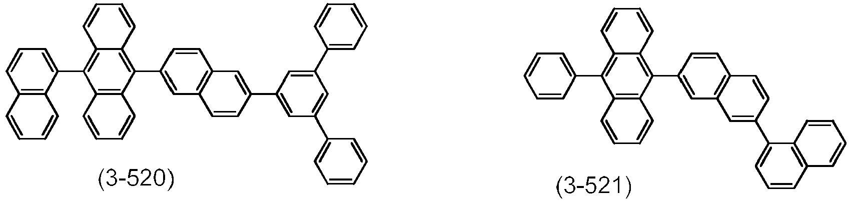

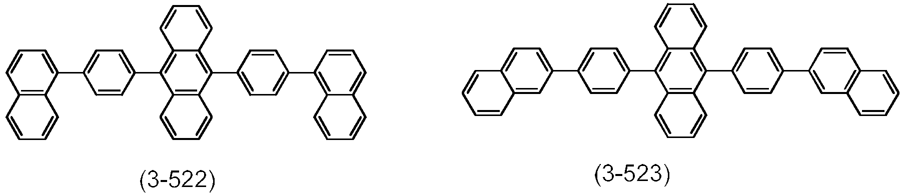

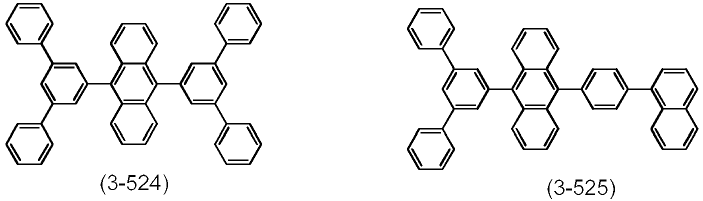

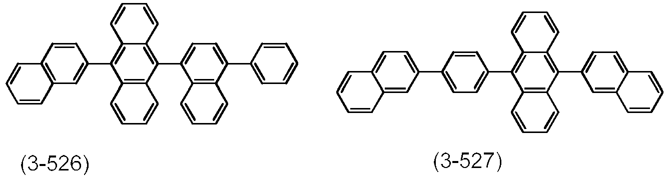

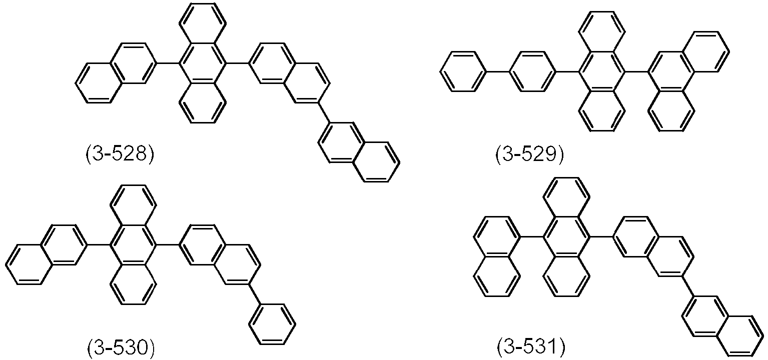

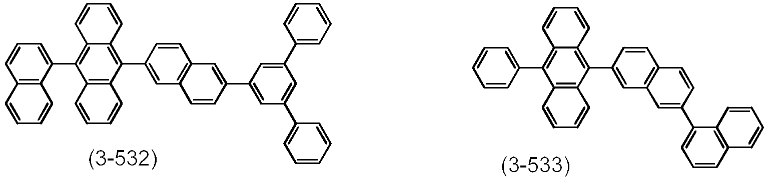

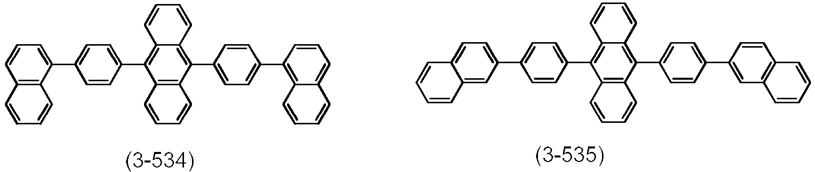

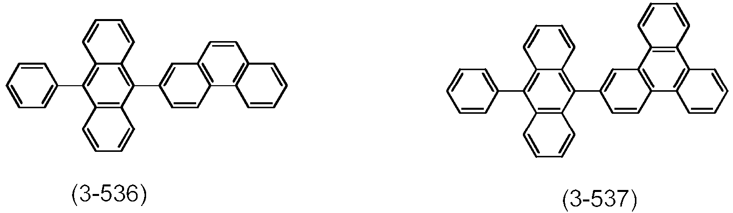

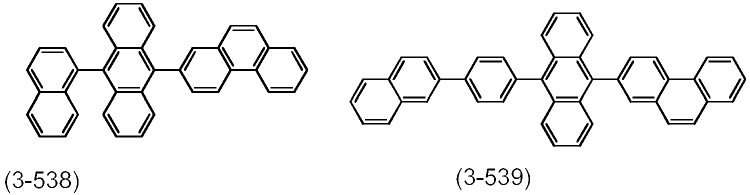

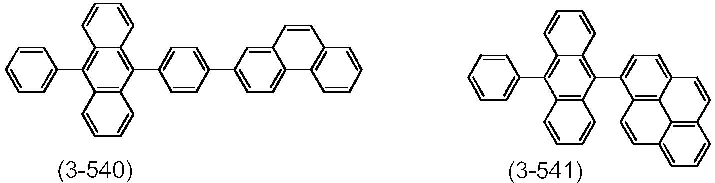

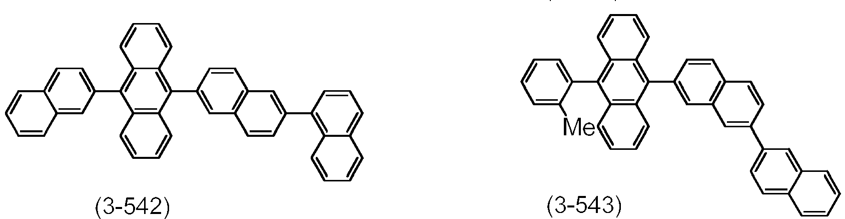

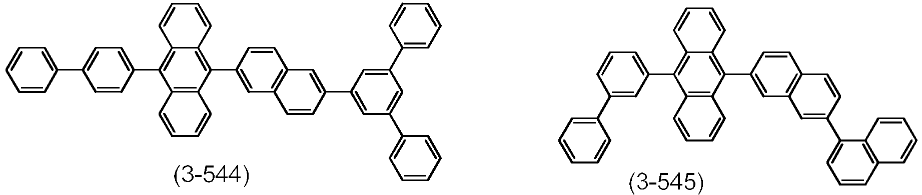

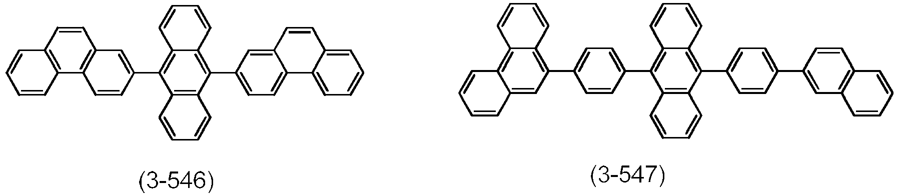

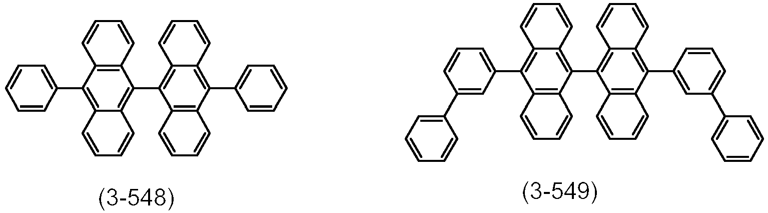

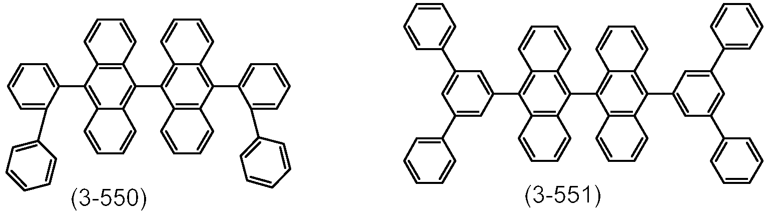

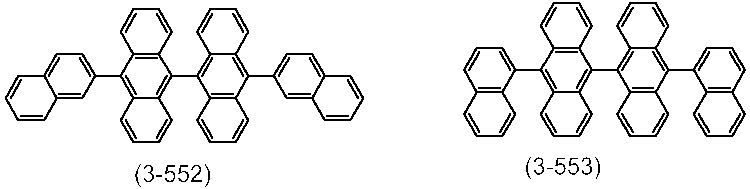

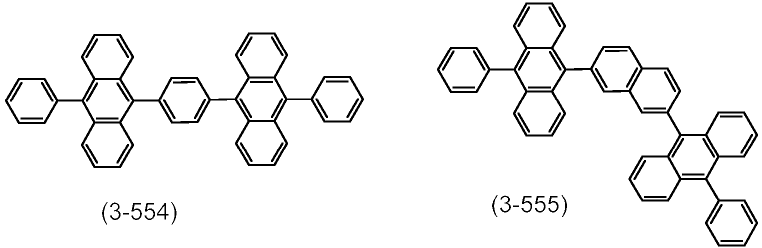

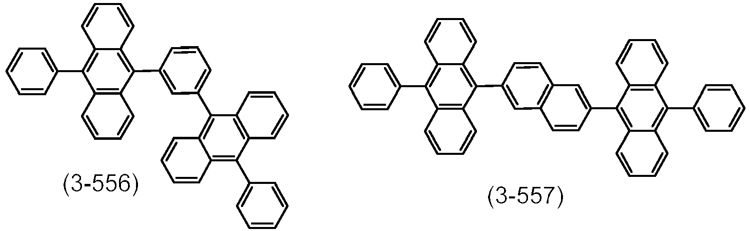

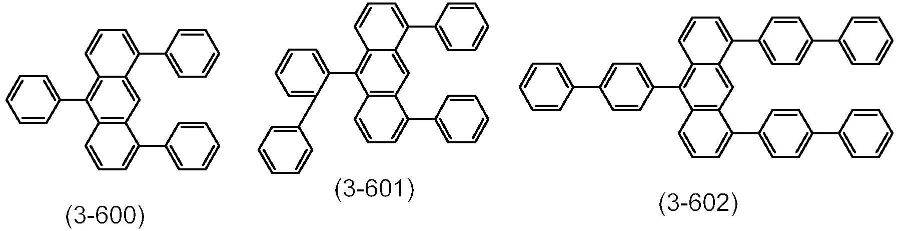

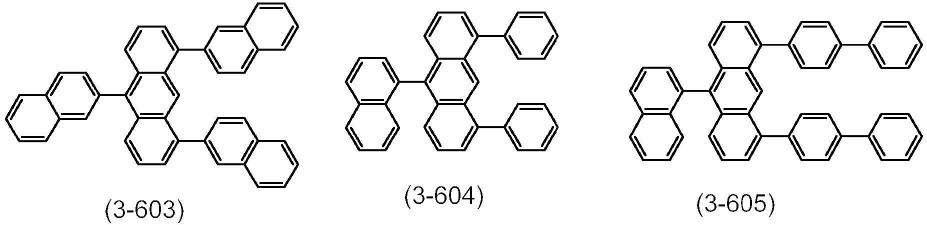

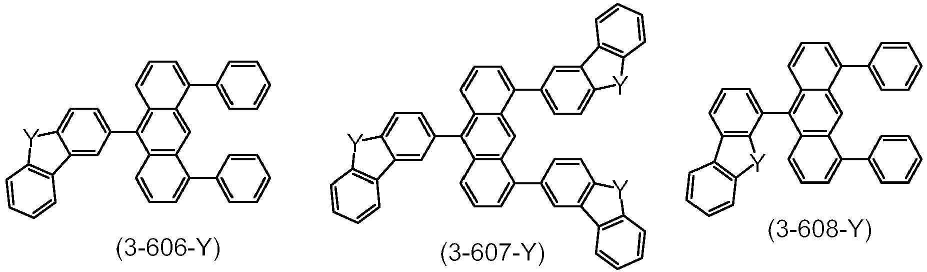

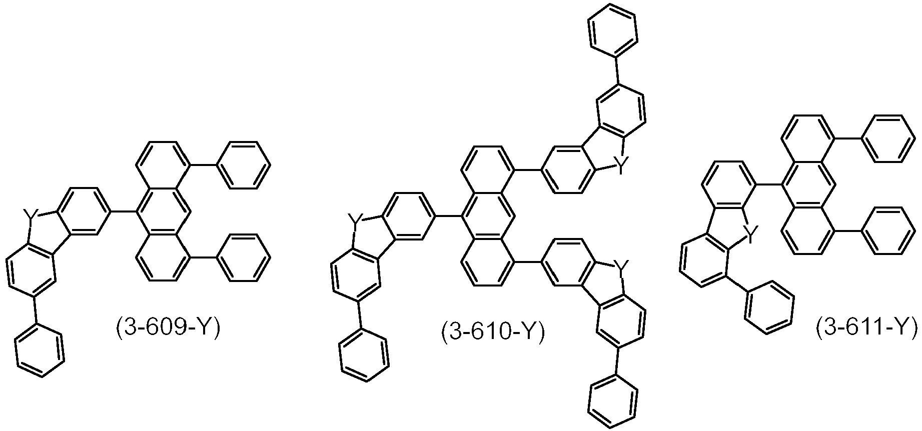

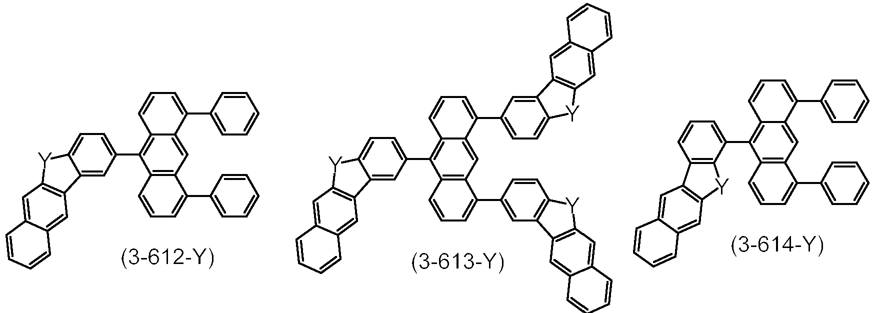

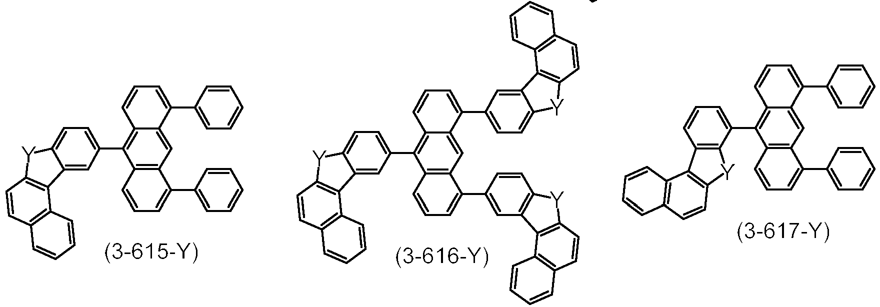

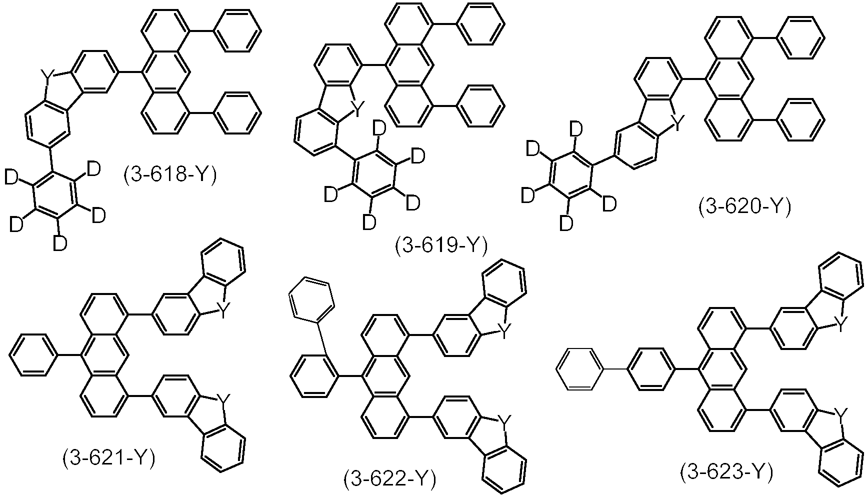

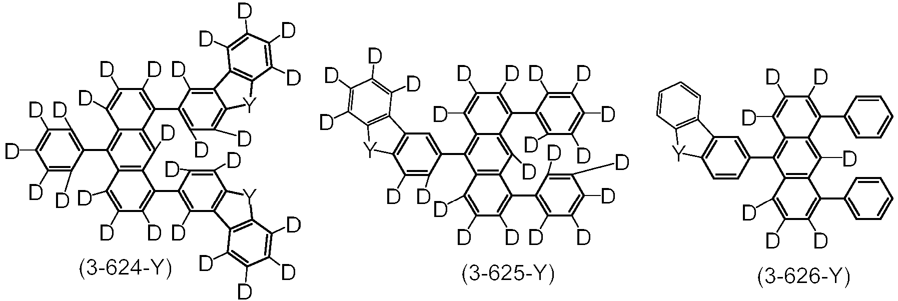

In the above structural formulas, "D" represents deuterium.

Among these compounds, a compound represented by any of Formula(3-131-Y) to Formula(3-134-Y), Formula(3-138-Y), Formula(3-140-Y) to Formula(3-143-Y), Formula(3-150-Y), Formula(3-153-Y) to Formula(3-156-Y), Formula(3-166-Y), Formula(3-168-Y), Formula(3-173-Y), Formula(3-177-Y), Formula(3-180-Y)to Formula(3-183-N), Formula(3-185-Y), Formula(3-190-Y), Formula(3-223-Y), Formula(3-241-Y), Formula(3-250-Y), Formula(3-252-Y) to Formula(3-254-Y), Formula(3-270-Y) to Formula(3-284-Y), Formula(3-501), Formula(3-507), Formula(3-508), Formula(3-509), Formula(3-513), Formula(3-514), Formula(3-519), Formula(3-521), Formula(3-538)to Formula(3-547), Formula(3-600) to Formula(3-605), and Formula(3-606-Y) to Formula(3-626-Y). In addition, Y is preferably -O- or >N-R²⁹, and -O- is more preferred. A form of deuterium substitution is also preferred.

The above anthracene-based compound can be produced by applying Suzuki coupling. Negishi coupling, or other known coupling reactions using a compound having a reactive group at a desired position of an anthracene skeleton and a compound having a reactive group in a partial structure such as X. Ar⁴, and a structure of Formula (A) as a starting material when the compound is an anthracene-based compound represented by Formula (3-H). Examples of the reactive group of these reactive compounds include a halogen and boronic acid. As a specific production method, for example, a synthesis method in paragraphs [0089] to [175] of WO 2014/141725 can be referred to.

### <Fluorene Compounds>

A compound represented by Formula (4-H) basically functions as a host.

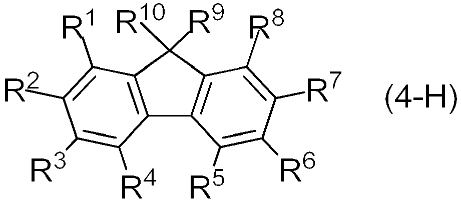

In Formula. (4-H), each of R¹ to R¹⁰is independently hydrogen, an aryl, a heteroaryl (the heteroaryl may be linked to the fluorene skelton in Formula (4-H) via a linking group), a diarylamino(the two heteroaryls may be bonded via a linking group), a diheteroarylamino (the two heteroaryls may be bonded via a linking group), an arylheteroarylamino(the aryl and the heteroaryl may be bonded via a single bond or a linking group), an alkyl, a cycloalkyl, an alkenyl, an alkoxy or an aryloxy, and at least one hydrogen in these may be replaced with an aryl, a heteroaryl, an alkyl, or a cycloalkyl, R¹ and R², R² and R³, R³ and R⁴, R⁵ and R⁶, R⁶ and R⁷, R⁷ and R⁸, or R⁹ and R¹⁰ may be independently bonded to form a fused ring or a spiro ring, and at least one hydrogen in the formed ring may be replaced with an aryl, a heteroaryl (the heteroaryl may be bonded to the formed ring via a linking group), a diarylamino(the two heteroaryls may be bonded via a linking group), a diheteroarylamino (the two heteroaryls may be bonded via a linking group), an arylheteroarylamino(the aryl and the heteroaryl may be bonded via a single bond or a linking group), an alkyl, a cycloalkyl, an alkenyl, an alkoxy, or an aryloxy, and at least one hydrogen in these may be replaced with an aryl, a heteroaryl, an alkyl, an alkyl, or a cycloalkyl. At least one hydrogen in the compound represented by Formula. (4-H) may be replaced with a halogen, cyano or deuterium.

Specific examples of the heteroaryl include a monovalent group obtained by removing any one hydrogen atom from the compound represented by Formula (4-Ar1), (4-Ar2), (4-Ar3), (4-Ar4) or (4-Ar5) shown below.

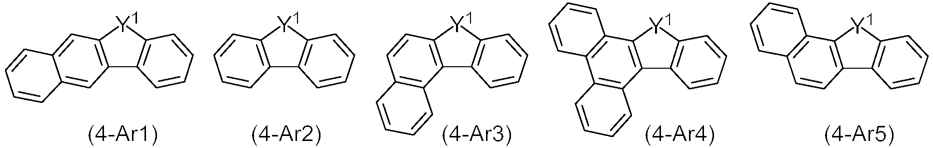

In Formulas (4-Ar1) to (4-Ar5), Y¹ is independently O, S or N-R, and. R is phenyl, biphenylyl, naphthyl, anthracenyl or hydrogens, at least one hydrogen in the structure of Formula (4-Ar1) to Formula (4-Ar5) may be replaced with phenyl, biphenylyl, naphthyl, anthracenyl, phenanthrenyl, methyl, ethyl, propyl, or butyl.

These heteroaryls may be bonded to the fluorene skeleton in Formula (4-H) via a linking group. In other words, not only the fluorene skeleton and the above-mentioned heteroaryl in Formula (4-H) are directly bonded to each other but also they may be bonded to each other via a linking group. These linking groups include phenylene, biphenylene, naphthylene, anthracenylene, methylene, ethylene, -OCH₂CH₂-, -CH₂CH₂O- and -OCH₂CH₂O-.

In Formula (4-H), and R¹ and R², R² and R³, R³ and R⁴, R⁵ and R⁶, R⁶ and R⁷ or R⁷ and R⁸ may be bonded to form a fused ring, and R⁹ and R¹⁰ may be bonded to form a spiro ring. The fused ring formed by R¹ to R⁸ is a ring fused to the benzene ring in Formula (4-H) and is an aliphatic ring or an aromatic ring. The fused ring formed is preferably an aromatic ring, and examples of the structure including a benzene ring in Formula (4-H) include naphthalene ring and phenanthrene ring. The spiro ring formed by R⁹ and R¹⁰ is a ring that is spiro-bonded to the five-membered ring in Formula (4-H) and is an aliphatic ring or an aromatic ring. The spiro ring formed is preferably an aromatic ring, and examples thereof include a fluorene ring and the like.

The compound represented by Formula (4-H) is preferably a compound represented by Formula (4-H-1), Formula (4-H-2) or Formula (4-H-3) below, which are a compound in which a benzene formed by bonding R¹ and R² in Formula (4-H) is fused, a compound in which a benzene ring formed by bonding R³ and R⁴ in Formula (4-H) is fused, and a compound in which none of R¹ to R⁸ is bonded in Formula (4-H), respectively.

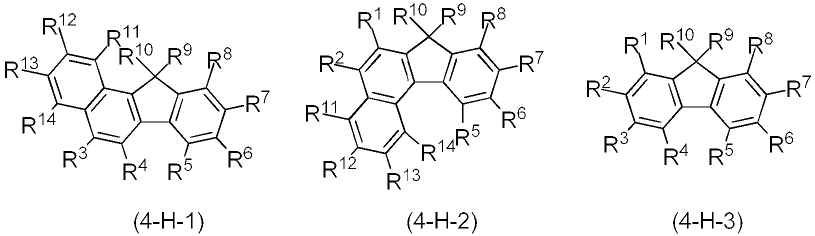

The definitions of R¹ to R¹⁰ in Formulas (4-H-1), (4-H-2) and (4-H-3) are the same as the definitions of the corresponding R¹ to R¹⁰ in Formula (4-H), and the definitions of R¹¹ to R¹⁴ in Formulas (4-H-1) and (4-H-2) are the same as the definitions of R¹ to R¹⁰ in Formula (4-H).

The compound represented by Formula (4-H) is more preferably a compound represented by Formula (4-H-1A), Formula (4-H-2A) or Formula (4-H-3A), which is a compound in which R⁹ and R¹⁰ are bonded to each other in Formula (4-H-1), Formula (4-H-1) or Formula (4-H-3), respectively, to form a spiro-fluorene ring.

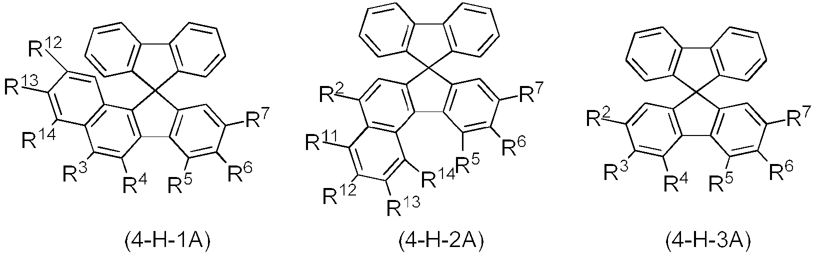

The definition of R² to R⁷ in Formulas(4- H-1 A), (4- H-2A) and (4- H-3A) is the same as the definition of the corresponding R² to R⁷ in Formulas (4- H-1), (4- H-2), and (4- H-3), and the definition of R¹¹ to R¹⁴ in Formulas (4- H-1A) and (4- H-2A) is the same as R¹¹ to R¹⁴ in Formulas (4-H-1) and (4- H-2), respectively.

In addition, all or a part of hydrogens in the compound represented by Formula (4-H) may be replaced with a halogen, cyano or deuterium.

A further specific example of the fluorene compound as a host of the present invention includes a compound represented by any of the following structural formula.

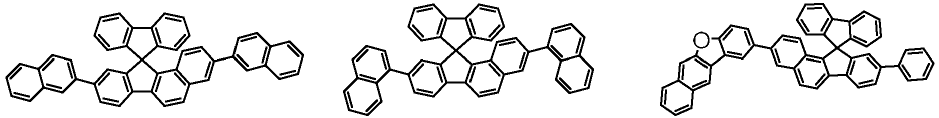

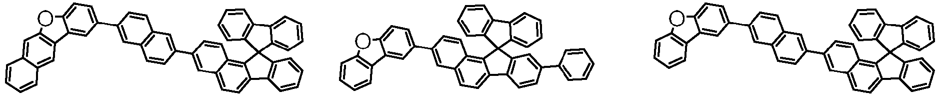

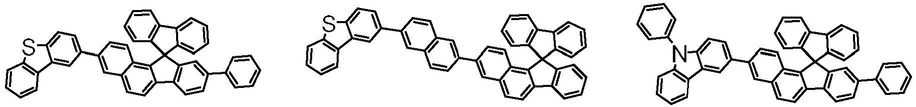

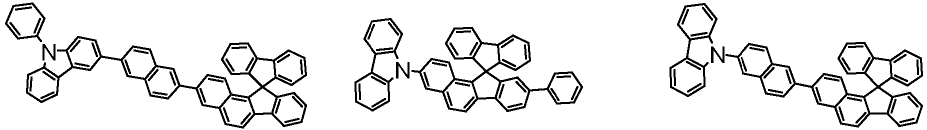

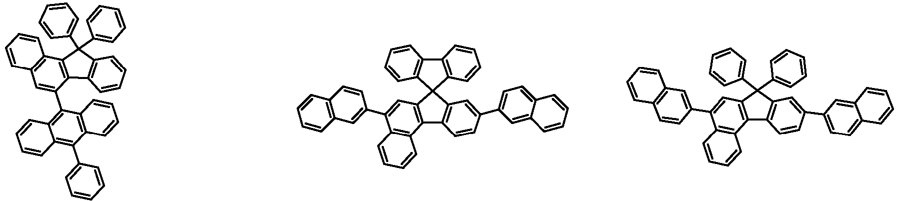

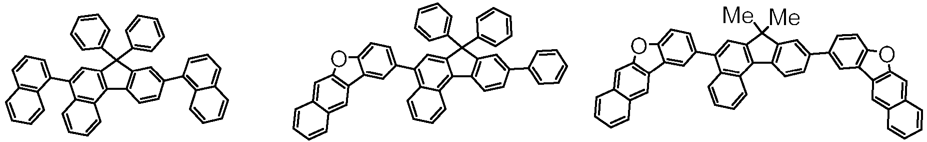

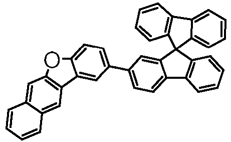

### <Dibenzochrysene-Based Compounds>

The dibenzocrvsene-based compound as a host is, for example, a compound represented by the following Formula (5-H).

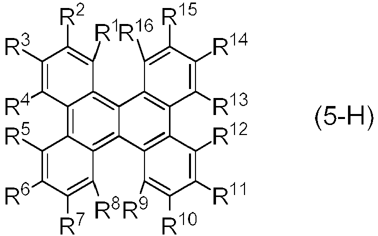

R¹ to R¹⁶ are each independently hydrogen, an aryl, a heteroaryl (the heteroaryl may be bonded to the dibenzochrysene skelton in Formula (5-H) via a linking group), a diarylamino, diheteroarylamino, an arylheteroarylamino, an alkyl, a cycloalkyl, an alkenyl, an alkoxy or an aryloxy, and at least one hydrogen in the above substituents may be substituted with an aryl, a heteroaryl, an alkyl, or a cycloalkyl, any adjacent groups among R¹ to R¹⁶ may be bonded to each other to form a fused ring, and at least one hydrogen in the formed ring may be replaced with an aryl, a heteroaryl (the heteroaryl may be bonded via a linking group to form a ring), a diarylamino, a diheteroarylamino, an arylheteroarylamino, an alkyl, a cycloalkyl, an alkenyl, an alkoxy, or an aryloxy, wherein at least one hydrogen in these may be replaced with an aryl, a heteroaryl, an alkyl, or a cycloalkyl, at least one hydrogen in the compound represented by Formula (5-H) may be replaced with a halogen, cyano or deuterium.

Examples of the alkeny as defined in Formula (5-H) include an alkenyl having 2 to 30 carbons, and an alkenyl having 2 to 20 carbons is preferred, an alkenyl having 2 to 10 carbons is more preferred, an alkenyl having 2 to 6 carbons is further preferred, and an alkenyl having 2 to 4 carbons is particularly preferred, Preferred alkenyls are vinyl, 1-propenyl, 2-propenyl, 1-butenyl, 2-butenyl, 3-butenyl, 1-pentenyl, 2-pentenyl, 3-pentenyl, 4-pentenyl, 1-hexenyl, 2-hexenyl, 3-hexenyl, 4-hexenyl, or 5-hexenyl.

A specific example of the heteroaryl includes a monovalent group obtained by deleting any one hydrogen atom from a compound represented by Formula (5-Ar1), Formula (5-Ar2), Formula (5-Ar3), Formula (5-Ar4) or Formula (5-Ar5).

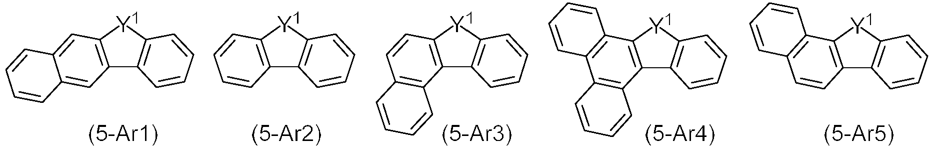

In Formulas (5-Ar1) to (5-Ar5), Y¹ is independently O, S or N-R, and R is phenyl, biphenylyl, naphthyl, anthracenyl or hydrogen, at least one hydrogen in the structure of Formula (5-Ar1) to Formula (5-Ar5) may be replaced with phenyl, biphenylyl, naphthyl, anthracenyl, phenanthrenyl, methyl, ethyl, propyl, or butyl.

These heteroaryls may be bonded to the dibenzocrysene skelton Formula (5-H) via a linking group. In other words, not only the dibenzochrysene skelton and the above heteroaryl in Formula (5-H) may be directly bonded to each other but also they may be bonded to each other via a linking group. These linking groups include phenylene, biphenylene, naphthylene, anthracenylene, methylene, ethylene, -OCH₂CH₂-, -CH₂CH₂O- or -OCH₂CH₂O-.

In Formula (5-H), R¹, R⁴, R⁵, R⁸, R⁹, R¹², R¹³ and R¹⁶ are preferably hydrogen. In this case, R², R³, R⁶, R⁷, R¹⁰, R¹¹, R¹⁴ and R¹⁵ in Formula (5-H) are preferred to be each independently hydrogen, phenyl, biphenylyl, naphthyl, anthracenyl, phenanthrenyl, a monovalent group having the structure of Formula (5-Ar1), Formula (5-Ar2), Formula (5-Ar3), Formula (5-Ar4), or Formula (5-Ar5) (the monovalent group having the structure may be bonded to the dibenzochrysene skeleton in Formula (5-H) via phenylene, biphenylene, naphthalne, anthracenylene, methylene, ethylene, - OCH₂CH₂-, -CH₂CH₂O-, or -OCH₂CH₂O-), methyl, ethyl, propyl, or butyl.

In the compound represented by Formula (5-H), R¹, R², R⁴, R⁵, R⁷, R⁸, R⁹, R¹⁰, R¹_{Z} R¹³, R¹⁵ and R¹⁶ are hydrogens. In this case, at least one (preferably one or two, more preferably one) of R³, R⁶, R¹¹ and R¹⁴ in Formula (5-H) is a monovalent group having the structures of Formula (5-Ar1), (5-Ar2), (5-Ar3), (5-Ar4) or (5-Ar5) via a single bond, phenylene, biphenylene, naphthylene, anthracenylene, methylene, ethylene, -OCH₂CH₂-, -CH₂CH₂O or -OCH₂CH₂O-; and other than the above at least one (i.e., other than the positions at which the monovalent group having the above structure is substituted) is hydrogen, phenyl, biphenylyl, naphthyl, anthracenyl, methyl, ethyl, propyl, or butyl, and at least one hydrogen in these may be replaced with phenyl, biphenylyl, naphthyl, anthracenyl, methyl, ethyl, propyl, or butyl.

In addition, when a monovalent group having a structure represented by Formula (5-Ar1) to Formula (5-Ar5) is selected as R², R³, R⁶, R⁷, R¹⁰, R¹¹, R¹⁴ as R¹⁵ in the Formula (5-H), at least one of the hydrogens in the structure may be instead single bond to be bonded to any of R¹ to R¹⁶ in the Formula (5-H).

Further specific examples of the dibenzochrysene-based compound as a host of the present invention include a compound represented by the following structural formula.

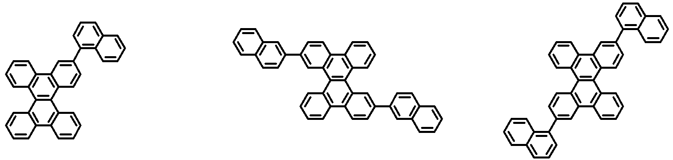

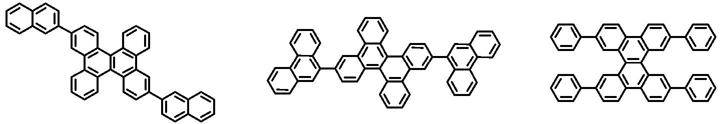

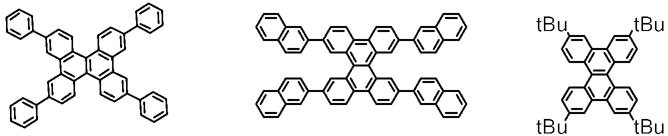

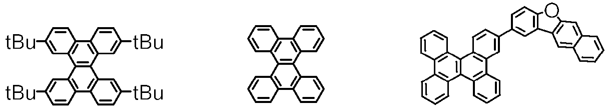

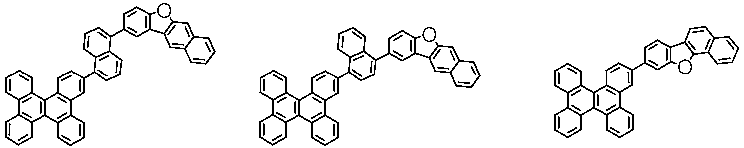

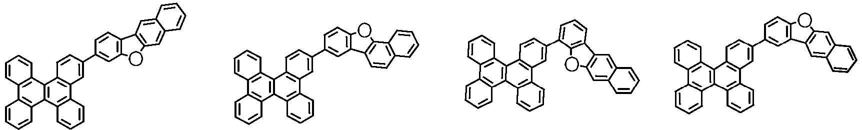

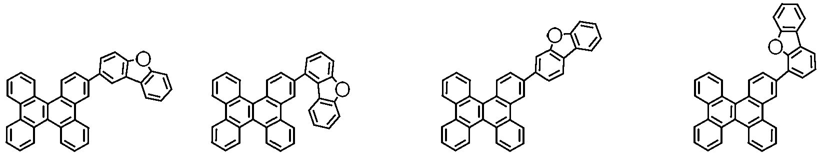

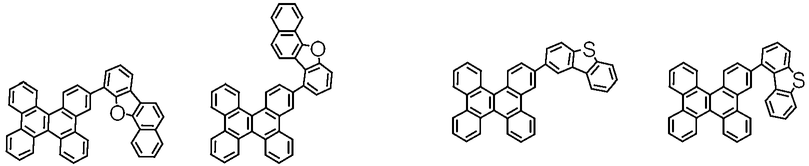

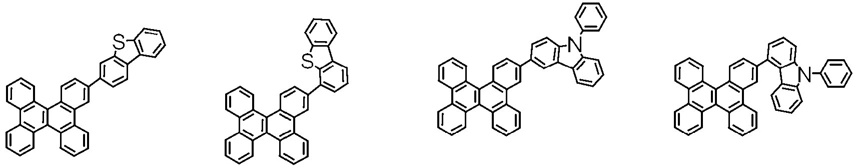

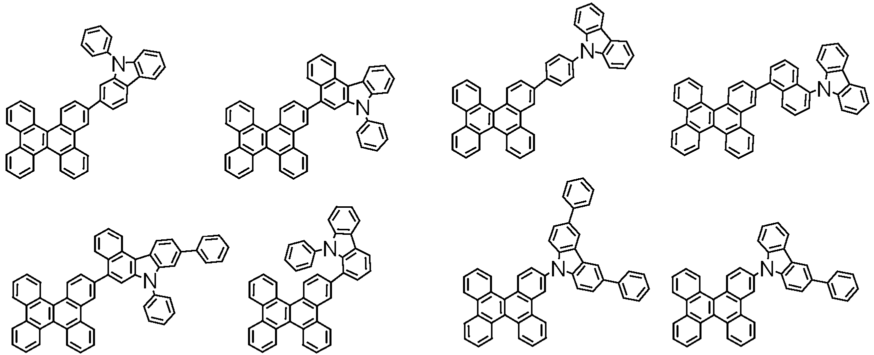

The above-described material for a light-emitting layer (host material and dopant material) can be used as a material for a light-emitting layer, even as a polymer compound obtained by polymerizing a reactive compound in which a reactive substituent is substituted into these as a monomer, or a polymer cross-linked body thereof, or a pendant type polymer compound obtained by reacting a main chain type polymer with the reactive compound, or a pendant type polymer crosslinked body thereof. For the reactive substituents in this case, the description of polycyclic aromatic compounds represented by equation (1) can be referred to.

### <Light Emitting Layer Containing an Assisting Dopant and an Emitting Dopant>

The light-emitting layer in the organic electroluminescent element may include a host compound as a first component, an assisting dopant (compound) as a second component, and an emitting dopant (compound) as a third component. The poly cyclic aromatic compound of the present invention is also preferably used as an emitting dopant. As the assisting dopant (compound), a thermally assisting delayed fluorescent material can be used.

In the following explanation, an organic electroluminescent element using a thermally assisting delay phosphor as an assisting dopant is sometimes referred to as a "TAF element" (TADF Assisting Fluorescence element).

"Host compound" in a TADF element means a compound such that the excited singlet energy level thereof derived from the shoulder of a peak on the short wavelength side of a fluorescence spectrum is higher than that of the thermally activated delayed fluorescence material as the second component and that of the emitting dopant as the third component.

"Thermally activated delayed fluorescence material" means a compound that absorbs heat energy to cause reverse intersystem crossing from an excited triplet state to an excited singlet state, and emits delayed fluorescence through radiative deactivation from the excited singlet state. Here, "thermally assisting delayed fluorescence" includes those that may take a higher triplet in an excitation process from an excited triplet state to an excited singlet state. For example, Monkamn, et al of Durham University (NATURE COMMUNICATIONS, 7:13680, DOI: 10.1038/ncomms 13680), Hosogai, et al of the National Institute of Advanced Industrial Science and Technology, Japan, by Sato, et al of Kyoto University (Scientific Reports, 7: 4820, DOI:10.1038/s41598-017-05007-7), and Sato, et al of Kyoto University in a conference presentation (98th Spring Annual Meeting, Announcement No. 2I4-15, Mechanism of High-Efficiency Light Emission in Organic EL using DABNA as light-emitting molecule, by the Graduate School of Engineering of Kyoto University) can be referred to. In the present invention, a sample containing a target compound is analyzed to measure the fluorescence lifetime at 300K, and when the sample gives a delayed fluorescence component, the target compound therein is judged to be a "thermally activated delayed fluorescence material". Here, "delayed fluorescence component" means one having a fluorescence lifetime of 0.1 µseconds or more. For measurement of fluorescence lifetime, for example, a fluorescence lifetime measuring device (by Hamamatsu Photonics, C11367-01) can be used.

The polycyclic aromatic compound of the present invention can function as an emitting dopant, and the "thermally activated delayed fluorescent material" can function as an assisting dopant which assists in light emission of the polycyclic aromatic compound of the present invention.

In this embodiment, as the host compound, a known compound can be used, and examples thereof include a compound having at least one of a carbazole ring and a furan ring, and among them, a compound in which at least one of furanyl and carbazolyl and at least one of an arylene and a heteroarylene are bonded is preferably used. Specific examples include mCP and mCBP.

The excited triplet energy level E(1,T,Sh) determined from the short-wavelength-side shoulder of the phosphorescence spectrum of the host compound is preferably higher than the excited triplet energy level E(2,T,Sh), E(3,T,Sh) of the emitting dopant or assisting dopant having the highest excited triplet energy level in the light emitting layer from the viewpoint of promoting without inhibiting the generation of TADF in the light emitting layer, and specifically, the excited triplet energy level E(1,T,Sh) of the host compound is preferably 0.01 eV or higher, more preferably 0.03 eV or higher, more preferably 0.1 eV or higher than E(2,T,Sh), E(3,T,Sh), Further, a TADF active compound may be used as the host compound.

For example, a compound represented by any one of the above Formulas (H1), (H2) and (H3) can be used as the host compound.

### <Thermally activated delayed fluorescence Material (Assisting Dopant)>

The thermally activated delayed fluorescence material (TADF compound) for use in the present invention is a donor-acceptor-type thermally activated delayed fluorescence material (D-A-type TADF compound) that is so designed that, using an electron-donating substituent called a donor and an electron-accepting substituent called an acceptor, HOMO (highest occupied molecular orbital) and LUMO (lowest unoccupied molecular orbital) in the molecule are localized to induce efficient reverse intersystem crossing. Here, in the present description, "electron-donating substituent" (donor) means a substituent and a partial structure in which HOMO is localized in the thermally activated delayed fluorescence material molecule, and "electron-accepting substituent" (acceptor) means a substituent and a partial structure in which LUMO is localized in the thermally activated delayed fluorescence material molecule.

In general, a thermally activated delayed fluorescence material using a donor and an acceptor has a large spin orbit coupling (SOC) owing to the structure thereof and has a small interaction between HOMO and LUMO to have a small ΔE(ST), and therefore the compound can have an extremely high reverse intersystem crossing speed.

However, by using a thermally activated delayed fluorescence material that employs a donor or acceptor as an assisting dopant in combination with an appropriate emitting dopant such as the polycyclic aromatic compounds of the present invention, it is possible to provide a device that satisfies any or all of the following characteristics: high efficiency, high color purity, and long lifetime. The thermally activated delayed fluorescence material may be any compound whose emission spectrum overlaps at least partially with the absorption spectrum of the polycyclic aromatic compounds of the present invention. The polycyclic aromatic compounds of the present invention and the thermally activated delayed fluorescence material may be included in the same layer or in adjacent layers.

As a thermally activated delayed fluorescence material in TAF elements, compounds in which donors and acceptors are directly or indirectly coupled via a spacer can be used. As an electron-donating group (donor-type structure) and an electron-accepting group (acceptor-like structure) for use in the thermally activated delayed fluorescence material in the present invention, for example, the structures described in Chemistry of Materials, 2017, 29, 1946-1963 are also usable. The donor-type structure includes carbazole, dimethylcarbazole, di-tert-butylcarbazole, dimethoxycarbazole, tetramethylcarbazole, benzofluorocarbazole, benzothienocarbazole, phenyldihydroindolocarbazole, phenylbicarbazole, bicarbazole, tercarbazole, diphenylcarbazolylamine, tetraphenylcarbazolyldiamine, phenoxazine, dihydrophenazine, phenothiazine, dimethyldihydroacridine, diphenylamine, bis(tert-butylphenyl)amine, N1-(4-(diphenylamino)phenyl) N4, N4-diphenylbenzene-1,4-diamine, dimethyltetraphenyldihydroacridinediamine, tetramethyl-dihydro-indenoacridine and diphenyl-dihydrodibenzazaserine. The acceptor-type structure includes sulfonyldibenzene, benzophenone, phenylenebis(phenylmethanone), benzonitrile, isonicotinonitrile, phthalonitrile, isophthalonitrile, paraphthalonitrile, benzenetricarbonitrile, triazole, oxazole, thiadiazole, benzothiazole, benzobis(thiazole), benzoxazole, benzobis(oxazole), quinoline, benzimidazole, dibenzoquinoxaline, heptaazaphenalene, thioxanthone dioxide, dimethylanthrazene, anthracenedione, 5H-cyclopenta[1,2-b:5,4-b']dipyridine, fluorenedicarbonitrile, triphenyltriazine, pyrazinecarbonitrile, pyrimidine, phenylpyrimidine, methylpyrimidine, pyridinedicarbonitrile, dibenzoquinoxalinedicarbonitrile, bis(phenylsulfonyl)benzene, dimethylthioxanthone dioxide, thianthrene tetroxide and tris(dimethylphenyl)borane. In particular, the thermally activated delayed fluorescence compound in TAF elements is preferably a compound having, as a partial structure, at least one selected from carbazole, phenoxazine, acridine, triazine, pyrimidine, pyrazine, thioxanthene, benzonitrile, phthalonitrile, isophthalonitrile, diphenyl sulfone, triazole, oxadiazole, thiadiazole and benzophenone.

The compound for use as the second component in the light-emitting layer in TAF element is preferably a thermally activated delayed fluorescence material whose emission spectrum overlaps at least partly with the absorption peak of an emitting dopant. Hereinafter, compounds that can be used as the second component in the light-emitting layer in TAF element (a thermally activated delayed fluorescence material) will be exemplified. However, the compounds that can be used as thermally activated delayed fluorescence materials in TAF element are not limitedly interpreted by the following exemplary compounds.

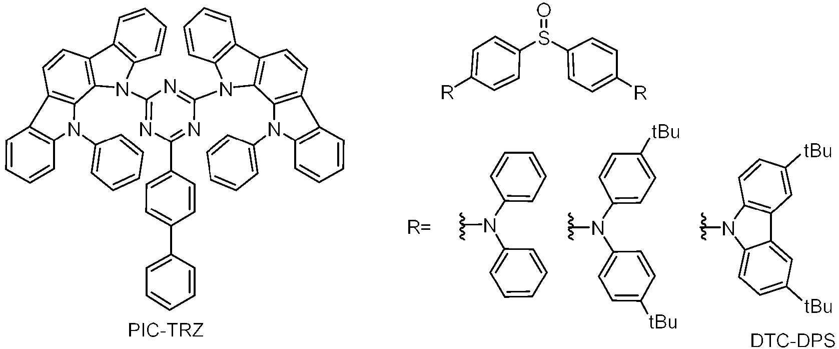

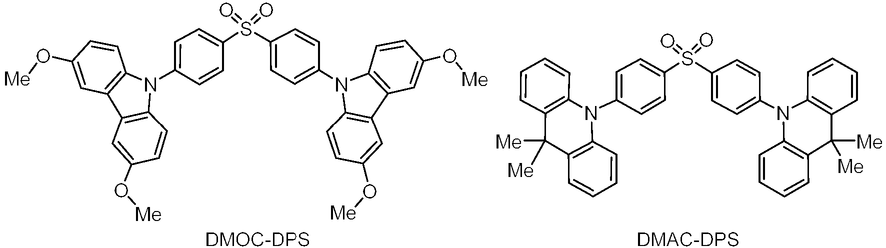

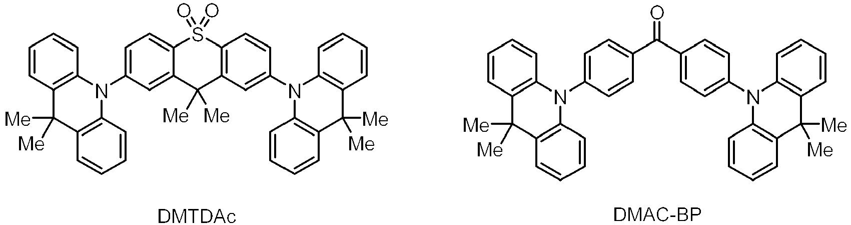

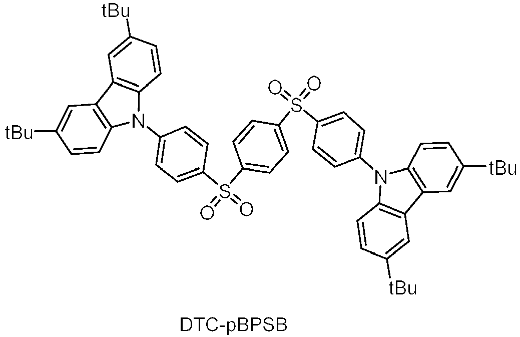

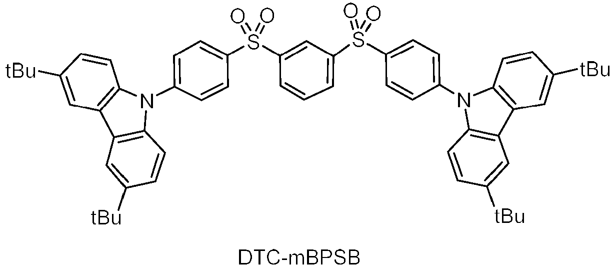

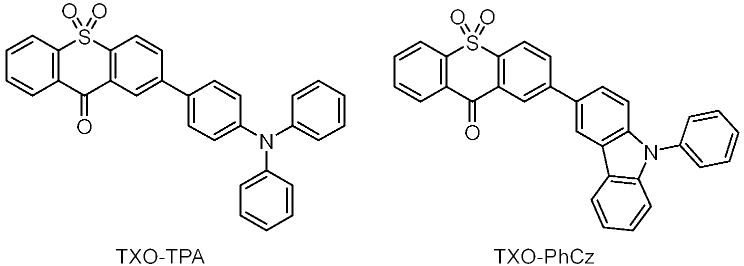

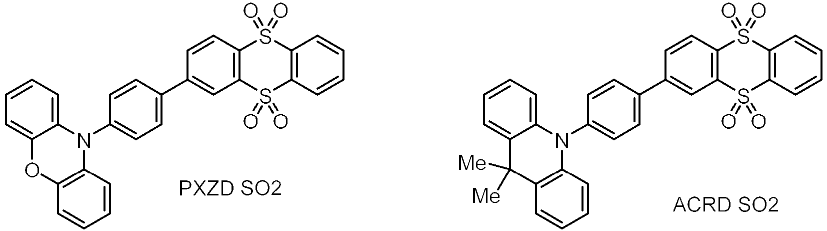

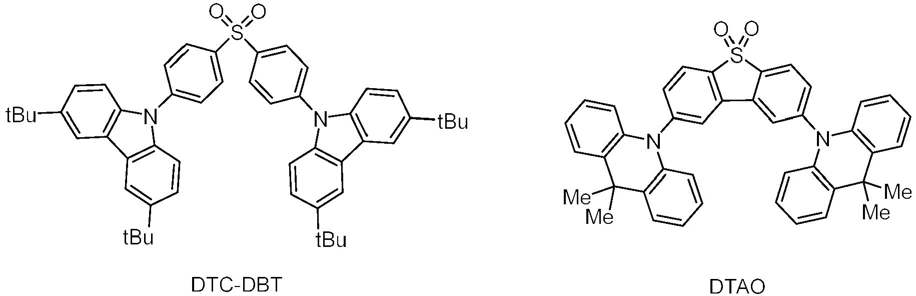

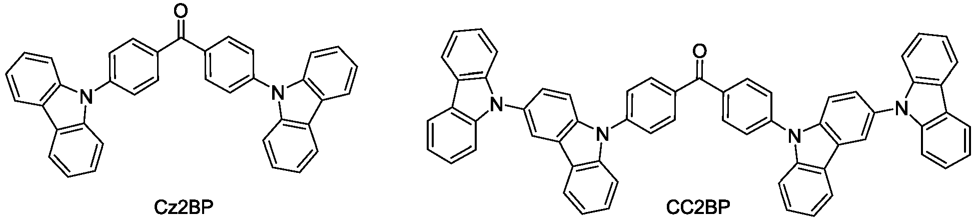

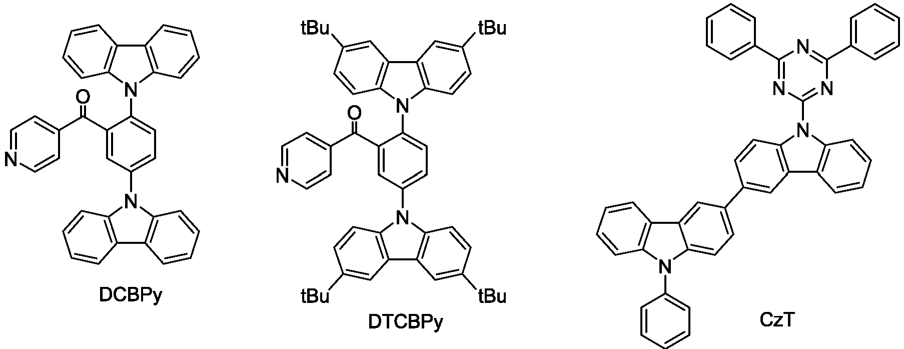

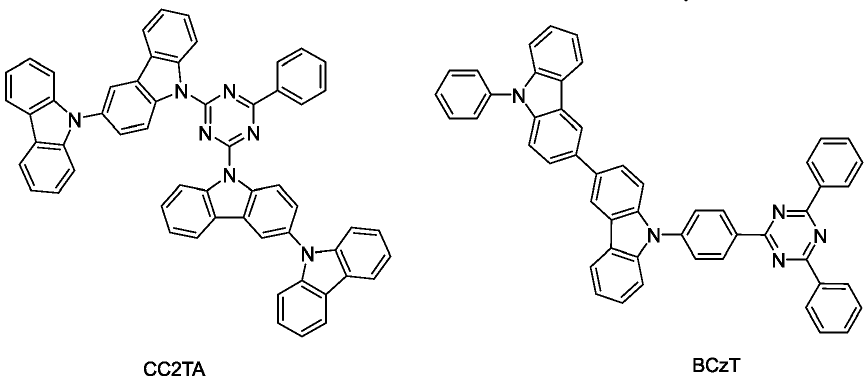

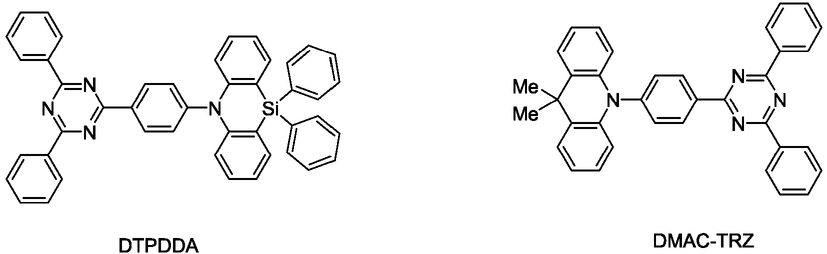

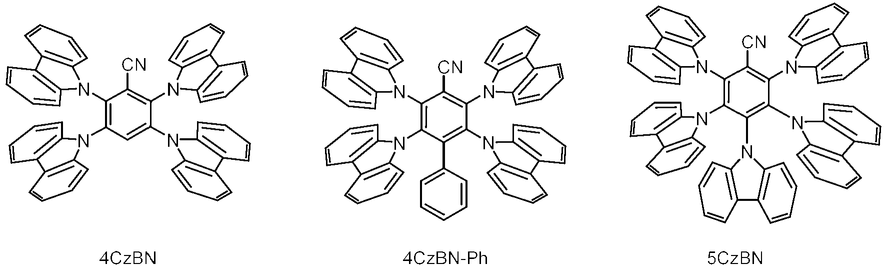

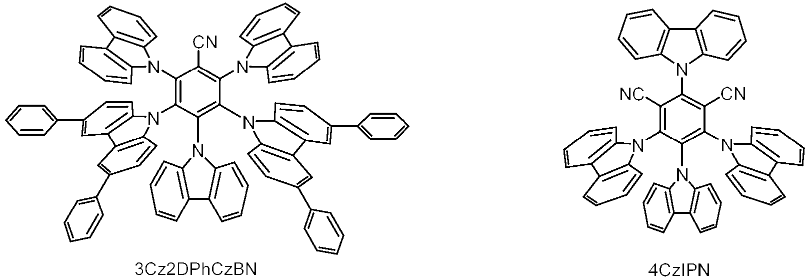

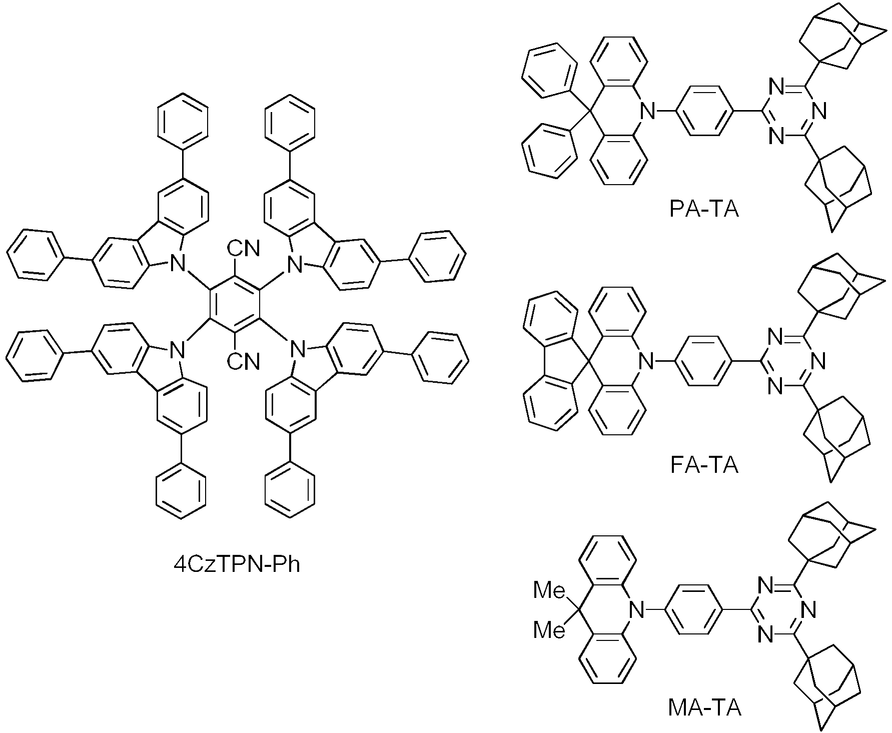

Further, as the thermally activated delayed fluorescence material, compounds represented by any of the following Formulas (AD1), (AD2) and (AD3) are also usable.

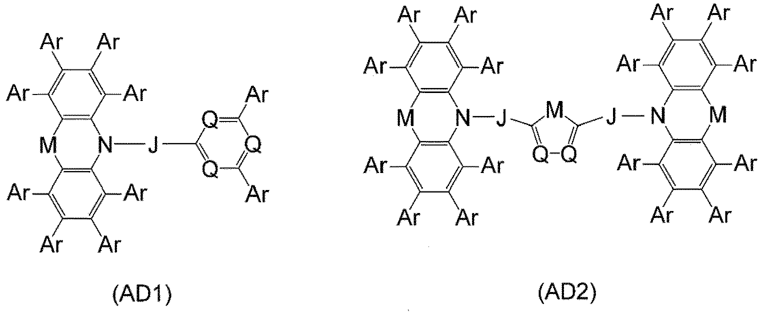

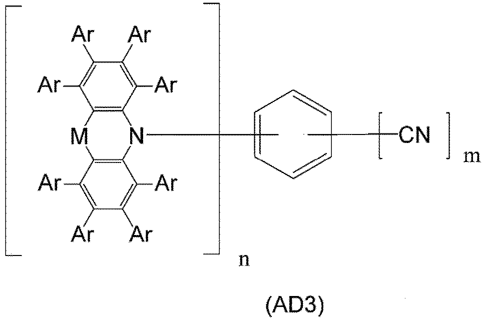

In the Formulas (AD1), (AD2), (AD3):
M is each independently a single bond, -O-, >N-Ar or >CAr₂, and is, from the viewpoint of the depth of HOMO of the formed partial structure and the height of the excited singlet energy level and the excited triplet energy level thereof, preferably a single bond, -O- or >N-Ar. J is a spacer structure to space the donor-type partial structure and the acceptor-type partial structure from each other, and each is independently an arylene having a carbon number of 6 to 18, and is, from the viewpoint of the size of the conjugation to run out from the donor-type partial structure and the acceptor-type partial structure, preferably an arylene having a carbon number of 6 to 12. More specifically, J includes a phenylene, a methylphenylene and a dimethylphenylene. Q is each independently =C(-H)- or =N-, and is, from the viewpoint of the shallowness of LUMO of the formed partial structure and the height of the excited singlet energy level and the excited triplet energy level thereof, preferably =N-. Ar is each independently a hydrogen, an aryl having a carbon number of 6 to 24, a heteroaryl having a carbon number of 2 to 24, an alkyl having a carbon number of 1 to 12, or a cycloalkyl having a carbon number of 3 to 18, and is, from the viewpoint of the depth of HOMO of the formed structure and the height of the excited singlet energy level and the excited triplet energy level thereof, preferably a hydrogen, an aryl having a carbon number of 6 to 12, a heteroaryl having a carbon number of 2 to 14, an alkyl having a carbon number of 1 to 4, or a cycloalkyl having a carbon number of 6 to 10, more preferably a hydrogen, a phenyl, a tolyl, a xylyl, a mesityl, a biphenyl, a pyridyl, a bipyridyl, a triazinyl, a carbazolyl, a dimethylcarbazolyl, a di-tert-butylcarbazolyl, a benzimidazolyl or a phenylbenzimidazolyl, even more preferably a hydrogen, a phenyl or a carbazolyl. m is 1 or 2. n is an integer of (6 - m) or less, and is, from the viewpoint of steric hindrance, preferably a number of 4 to (6 - m). At least one hydrogen in the compounds represented by any of the above formulae may be substituted with a halogen or a deuterium.

More specifically speaking, the compound for use as the second component tin the light-emitting layer in the present invention is preferably any of 4CzBN, 4CzBN-Ph, 5CzBN, 3Cz2DPhCzBN, 4CzIPN, 2PXZ-TAZ, Cz-TRZ3, BDPCC-TPTA, MA-TA, PA-TA, FA-TA, PXZ-TRZ, DMAC-TRZ, BCzT, DCzTrz, DDCzTRz, spiro-AC-TRZ, Ac-HPM, Ac-PPM, Ac-MPM, TCzTrz, TmCzTrz and DCzmCzTrz.

The compound used as the second component of the present embodiment may be a donor acceptor type TADF compound represented by D-A in which one donor D and one acceptor A are bonded via a direct bond or a linking group, but it is preferable that the compound has a structure represented by the following Formula (DAD 1) in which a plurality of donors D are bonded to one acceptor A via a direct bond or a linking group, because the characteristics of the organic electroluminescent element become more excellent.

(D¹-L¹)n-A¹ (DAD1)

A compound represented by Formula (DAD2) below is included in Formula (DAD1),

D²-L²-A²-L³-D³ (DAD2)

In Formulas (DAD1) and (DAD2), D¹, D² and D³ each independently represent a donor group. As the donor group, the above-described donor structure can be employed. A¹ and A² each independently represent an acceptor group. As the acceptor group, a structure having an acceptor property described above can be employed. L¹, L² and L³ each independently represent a single bind or a conjugated linking group. The conjugated linking group is a spacer structure separating a donor group and an acceptor group, and is preferably an arylene having 6 to 18 carbons, and more preferably an arylene having 6 to 12 carbons. More preferably, L¹, L² and L³ are each independently phenylene, methylphenylene or dimethylphenylene. n in Formula (DAD1) is two or more and represents an integer less than or equal to the largest number that A¹ can substitute. n may be selected, for example, within the range of 2 to 10, or may be selected within the range of 2 to 6. When n is 2, it becomes a compound represented by Formula (DAD2). n D¹'s may be the same or different to each other, n L¹ may be the same or different to each other. Preferred specific examples of the compounds represented by Formula (DAD1) and Formula (DAD2) include 2PXZ-TAZ and the following compounds, but the second component which can be used in the present invention is not limited to these compounds.

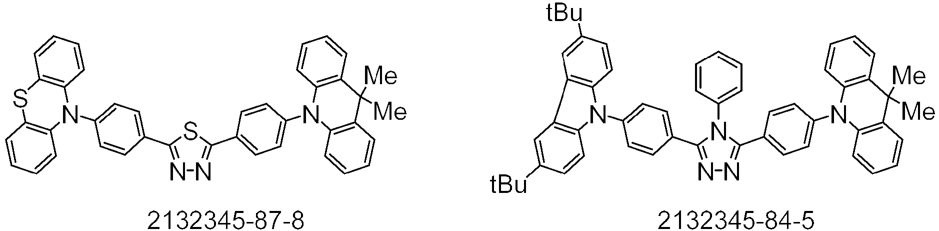

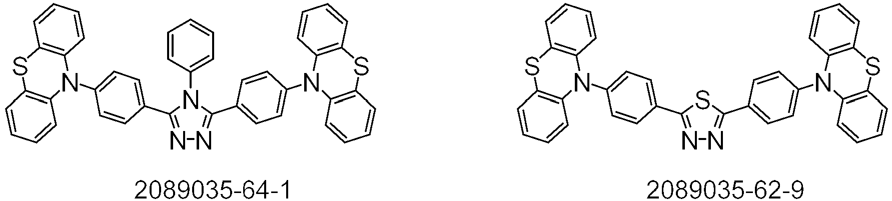

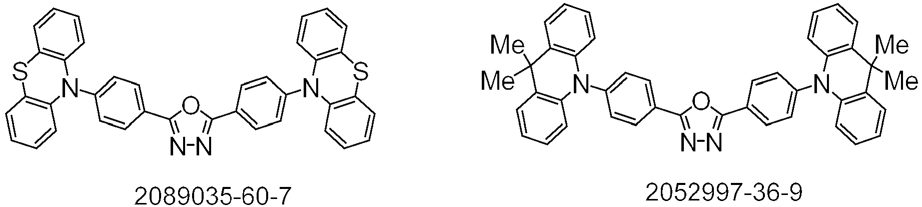

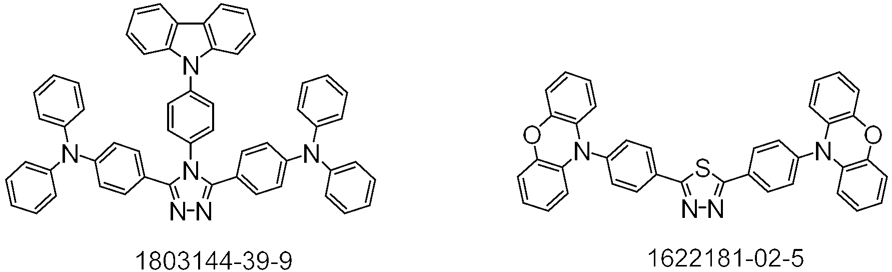

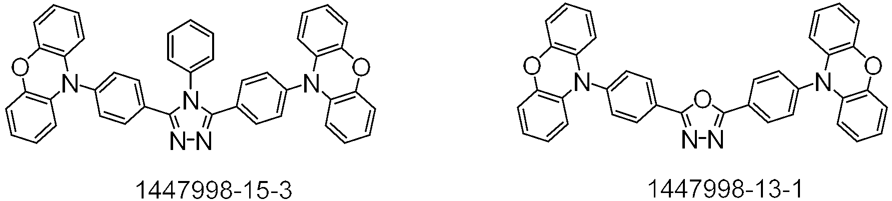

The light-emitting layer may he formed of a single layer or multiple layers. Further, the host compound, the thermally assisting delayed fluorescent material, and the polycyclic aromatic compound of the present invention may be contained in the same layer and may be contained in a plurality of layers such that at least one component is in each layer. Each of the host compound, the thermally assisting delayed fluorescent material, and the polycyclic aromatic compound of the present invention included in the light-emitting layer may be either a single type or a combination of a plurality types. The assisting dopant and the emitting dopant may be wholly contained in the host compound as a matrix or may be partially contained therein. The light emitting layer doped with the assisting dopant and the emitting dopant can be formed by a method of depositing the host compound, the assisting dopant, and the emitting dopant by a ternary co-deposition method, a method of depositing the host compound, the assisting dopant, the emitting dopant simultaneously after mixing them in advance, or a wet film deposition method in which a composition for forming a light emitting layer (paint) prepared by dissolving the host compound, the assisting dopant, and the emitting dopant in an organic solvent is applied.

The amount of the host compound to be used varies depending on the type of the host compound and may be determined according to the properties of the host compound. The amount of the host compound to be used is preferably 40 to 99% by mass, more preferably 50 to 98% by mass, and still more preferably 60 to 95% by mass, with respect to the total mass of the light-emitting layer. The range is preferred from the viewpoint of efficient charge transportation and efficient energy transfer to the dopant.

The amount of the assisting dopant (a thermally assisting delayed fluorescent material) to be used varies depending on the type of the assisting dopant, and may be determined according to the properties of the assisting dopant. The amount of the assisting dopant to be used is preferably 1 to 60% by mass, more preferably 2 to 50% by mass, and still more preferably 5 to 30% by mass, with respect to the total mass of the light emitting layer. The above range is preferable, for example, in that energy can be efficiently transferred to the emitting dopant.

The amount of the emitting dopant (compounds containing boron) to be used varies depending on the type of the emitting dopant may be determined according to the properties of the emitting dopant. The amount of the emitting dopant to be used is preferably 0.001% to 30% by mass, more preferably 0.01% to 20% by mass, and still more preferably 0.1% to 10% by mass, with respect to the total mass of the light emitting layer. The above range is preferable from the viewpoint of capability of preventing a concentration quenching phenomenon, for example.

It is preferable that the amount of the emitting dopant used is low in terms of preventing concentration quenching phenomenon. A high concentration of the assisting dopant is preferable from the viewpoint of the efficiency of the thermally assisting delayed fluorescence mechanism. Furthermore, from the viewpoint of the efficiency of the thermally assisting delayed fluorescence mechanism of the assisting dopant, it is preferable that the amount of emitting dopant used is lower than the amount of assisting dopant used.

### <2-1-3.Substrate in Organic electroluminescent element>

The substrate 101 is a support of the organic electroluminescent element, for which generally used are quartz, glass, metals plastics, etc. The substrate 101 is shaped in a tabular form, a filmy form or a sheet form depending on the intended use, and for example, glass plates, metal plates, metal foils, plastic films and plastic sheets are used. Above all, glass plates, and transparent synthetic resin plates of polyester, polymethacrylate, polycarbonate or polysulfone are preferred. For glass substrates, soda lime glass and alkali-free glass are usable, and the thickness may be one that is enough for securing mechanical strength, and is, for example, 0.2 mm or more. The upper limit of the thickness is, for example, 2 mm or less, preferably 1 mm or less. Regarding the glass material, alkali-free glass is preferred as releasing fewer ions. However, soda lime glass coated with a barrier coat of SiO₂ or the like is available on the market and can be used here. For increasing gas barrier performance, the substrate 101 may be provided with a gas barrier film of a dense silicon oxide film or the like on at least one surface thereof, and in particular, in the case where a synthetic resin plate, film or sheet having low gas barrier performance is used as the substrate 101, such a gas barrier film is preferably provided.

### <2-1-4.Anode in Organic electroluminescent element>

The anode 102 plays a role of injecting holes into the light-emitting layer 105. In the case where the hole injection layer 103 and/or the hole transport layer 104 are/is arranged between the anode 102 and the light-emitting layer 105, holes are injected into the light-emitting layer 105 via these.

The material to form the anode 102 includes an inorganic compound and an organic compound. Examples of the inorganic compound include metals (e.g., aluminum, gold, silver, nickel, palladium, chromium), metal oxides (e.g., indium oxide, tin oxide, indium-tin oxide (ITO), indium-zinc oxide (IZO)), metal halides (e.g., copper iodide), copper sulfide, carbon black, ITO glass and NESA glass. Examples of the organic compound include polythiophenes such as poly(3-methylthiophene, and conductive polymers such as polypyrrole and polyaniline. In addition, the material for use herein can be appropriately selected from substances that are used as an anode of an organic EL element.

The resistance of the transparent electrode is not limited so far as sufficient current for light emission from light-emitting devices can be supplied, but from the viewpoint of power consumption by light-emitting devices, the resistance is preferably low. For example, an ITO substrate with 300 Ω/square or less can function as a device electrode, but at present, a substrate with 10 Ω/square or so is available, and therefore, low-resistance substrates with, for example, 100 to 5 Ω/square, preferably 50 to 5 Ω/square are especially preferably used. The thickness of ITO can be arbitrarily selected in accordance with the resistance value thereof and is generally within a range of 50 to 300 nm in many cases.

### <2-1-5.Hole injection layer, and Hole transport layer in Organic electroluminescent element>

The hole injection layer 103 plays a role of efficiently injecting the holes having transferred from the anode 102, into the light-emitting layer 105 or the hole transport layer 104. The hole transport layer 104 plays a role of efficiently transporting the holes injected from the anode 102 or the holes injected from the anode 102 via the hole injection layer 103, into the light-emitting layer 105. The hole injection layer 103 and the hole transport layer 104 each are formed by laminating or mixing one or more of hole injection/transport materials or are formed from a mixture of a hole injection/transport material and a polymer binder. An inorganic salt such as iron (III) chloride may be added to the hole injection/transport material to form a layer.

The hole injection/transport substance needs to efficiently inject and transport the holes from the positive electrode between electrodes given an electric field and is one having a high hole injection efficiency and capable of efficiently transporting the injected holes. For that purpose, preferably, the substance has a small ionization potential and has a large hole mobility and is excellent in stability and hardly generates impurities to be traps in production and during use.

The material to form the hole injection layer 103 and the hole transport layer 104 can be arbitrarily selected from compounds heretofore generally used as a charge transport material for holes in a photoconductive material, as well as p-type semiconductors and other known compounds that are used in a hole injection layer and a hole transport layer in an organic electroluminescent element. Specific examples thereof include a carbazole derivative (e.g., N-phenylcarbazole, polyvinylcarbazole), a biscarbazole derivative such as bis(N-arylcarbazole) or bis(N-alkylcarbazole), a triarylamine derivative (e.g., 4,4',4"-Tris(N-carbazolyl)triphenylamine, a polymer having an aromatic tertiary amino group in the main chain or the side chain, a triphenylamine derivative such as 1,1-bis(4-di-p-tolylaminophenyl)cyclohexane, N,N'-diphenyl-N,N'-di(3-methylphenyl)-4,4'-diaminobiphenyl, N,N'-diphenyl-N,N'-dinaphthyl-4,4'-diaminobiphenyl, N,N'-diphenyl-N,N'-di(3-methylphenyl)-4,4'-diphenyl-1,1'-diamine, N,N'-dinaphthyl-N,N'-diphenyl-4,4'-diphenyl-1,1'-diamine, N⁴,N⁴-diphenyl-N⁴,N⁴-bis(9-phenyl-9H-carbazol-3-yl)-[1,1'-biphenyl]-4,4'-diamine, N⁴,N⁴,N^{4'},N^{4'}-tetra[1,1'-biphenyl]-4-yl)-[1,1'-biphenyl]-4,4'-diamine, and 4,4',4"-tris(3-methylphenyl(phenyl)amino)triphenylamine, and a starburst amine derivative), a stilbene derivative, a phthalocyanine derivative (e.g., metal-free, or copper phthalocyanine), a pyrazoline derivative, a hydrazone compound, a benzofuran derivative, a thiophene derivative, an oxadiazole derivative, a quinoxaline derivative (e.g., 1,4,5,8,9,12-hexazatriphenylene-2,3,6,7,10,11-hexacarbonitrile), a heterocyclic compound such as a porphyrin derivative, and a polysilane. Regarding the polymer-type substances, a polycarbonate, a styrene derivative, a polyvinyl carbazole and a polysilane having the above-mentioned monomer in the side chain are preferred but are not specifically limited so far as the compounds can form a thin film necessary for production of light-emitting devices and can inject holes from an anode and further can transport holes.

It is known that electric conductivity of organic semiconductors is strongly influenced by doping. Such organic semiconductor matrix substances are formed of compounds having good electron donating performance, or compounds having good electron acceptability. For doping with an electron-donating substance, an electron acceptor such as tetracyanoquinonedimethane (TCNQ) or 2,3,5,6-tetrafluorotetracyano-1,4-benzoquinonedimethane (F4TCNQ) is known (for example, see literature of M. Pfeiffer, A. Beyer, T. Fritz, K. Leo, Appl. Phys. Lett., 73(22), 3202-3204 (1998), and literature of J. Blochwitz, M. Pfeiffer, T. Fritz, K. Leo, Appl. Phys. Lett., 73(6), 729-731 (1998)). These form so-called holes by an electron transfer process in an electron-donating base substance (hole transport substance). Depending on the number of holes and the mobility thereof, the conductivity of the base substance greatly varies. As the matrix substance having a hole transporting property, for example, there are known a benzidine compound (e.g., TPD), and a starburst amine derivative (e.g., TDATA), or a specific metal phthalocyanine (especially, zinc phthalocyanine (ZnPc) or the like) (see JP 2005-167175 A). The polycyclic aromatic compounds of the present invention may be used as materials for forming a hole injection layer or a hole transport layer.

### <2-1-6. Electron blocking layer in Organic electroluminescent element>

An electron blocking layer may be provided between the hole injection/transport layer and the light-emitting layer to prevent the diffusion of electrons from the light-emitting layer. The electron blocking layer may be formed using a compound represented by any of the above-mentioned Formulas (H1), (H2), and (H3). The polycyclic aromatic compounds of the present invention may also be used as materials for forming the electron blocking layer.

### <2-1-7. Electron injection layer and an electron transport layer in Organic electroluminescent element>

Electron injection layer 107 plays a role of efficiently injecting electrons moved from cathode 108 into light-emitting layer 105 or electron transport layer 106. Electron transport layer 106 plays a role of efficiently transport the electrons injected from cathode 108 or the electrons injected from cathode 108 through electron injection layer 107 to light-emitting layer 105. Electron injection layer 107 and electron transport layer 106 are formed by lamination and mixing one kind or two or more kinds of electron injection/transport materials or formed by a mixture of electron injection/transport materials and polymer binders.

An electron injection/transport layer means a layer that manages injection of the electrons from the cathode and transportation of the electrons, and desirably has high electron injection efficiency and efficiently transports the electrons injected. Accordingly, a material having large electron affinity, large electron mobility and excellent stability, and hard to generate impurities to be a trap during production and use is preferred. However, in consideration of a transport balance between the holes and the electrons, when the material mainly plays a role of being able to efficiently inhibit the holes from the anode from flowing to a cathode side without recombination, even if the material has a comparatively low electron transport capability, the material has an effect on improving luminescent efficiency as high as a material having high electron transport capability. Accordingly, the electron injection/transport layer in the present embodiment may also include a function of a layer that can efficiently inhibit movement of the holes.

A material (electron transport material) that forms electron transport layer 106 or electron injection layer 107 can be selected and used from a compound which has been commonly used so far as an electron transfer compound in a photoconductive material, and a publicly known compound used for a hole injection layer and a hole transport layer of an organic EL element.

A material used for the electron transport layer or the electron injection layer preferably contains at least one kind selected from a compound formed of an aromatic ring or a complex aromatic ring composed of one or more atoms selected from carbon, hydrogen, oxygen, sulfur, silicon and phosphorus, a pyrrole derivative and a fused ring derivative thereof and a metal complex having electron accepting nitrogen. Specific examples thereof include a fused ring-based aromatic ring derivative such as naphthalene and anthracene, a styryl-based aromatic ring derivative typified by 4,4'-bis(diphenylethenyl)biphenyl, a perinon derivative, a coumarin derivative, a naphthalimide derivative, a quinone derivative such as anthraquinone and diphenoquinone, a phosphine oxide derivative, an aryl nitrile derivative, and an indole derivative. Specific examples of the metal complex having electron accepting nitrogen include a hydroxy azole complex such as a hydroxyphenyl oxazole complex, an azomethine complex, a tropolone metal complex, a flavonol metal complex and a benzoquinoline metal complex. The above materials may be used alone, or in combination of a different material.

Specific examples of other electron transport compounds include a pyridine derivative, a naphthalene derivative, a fluoranthene derivative, a BO derivative, an anthracene derivative, a phenanthroline derivative, a perinone derivative, a coumarin derivative, a naphthalimide derivative, an anthraquinone derivative, a diphenoquinone derivative, a diphenylquinone derivative, a perylene derivative, an oxadiazole derivative (such as 1,3-bis[(4-t-butylphenyl)1,3,4-oxadiazolyl]phenylene), a thiophene derivative, a triazole derivative (such as N-naphthyl-2,5-diphenyl-1,3,4-triazole), a thiadiazole derivative, a metal complex of an oxime derivative, a quinolinol metal complex, a quinoxaline derivative, a polymer of a quinoxaline derivative, a benzazole compound, a gallium complex, a pyrazol derivative, a perfluorophenylene derivative, a triazine derivative, a pyrazine derivative, a benzoquinoline derivative (such as 2,2'-bis(benzo[h]quinolin-2-yl)-9,9'-spirobifluorene), an imidazopyridine derivative, a borane derivative, a benzimidazole derivative (such as tris(N-phenylbenzimidazole-2-yl)benzene), a benzooxazol derivative, a thiazole derivative, a benzothiazole derivative, a quinoline derivative, an oligo pyridine derivative such as terpyridine, a bipyridine derivative, a terpyridine derivative (such as 1,3-bis(2,2':6',2"-terpyridin-4'-yl)benzene), a naphthyridine derivative (such as bis(1-naphthyl)-4-(1,8-naphthyridine-2-yl)phenyl phosphine oxide), an aldazine derivative, a pyrimidine derivative, an aryl nitrile derivative, an indole derivative, a phosphorus oxide derivative, a bisstyryl derivative, a shirol derivatives and an azoline derivative.

Moreover, a metal complex having electron accepting nitrogen can also be used, and specific examples thereof include a quinolinol-based metal complex, a hydroxyazole complex such as a hydroxyphenyloxazole complex, an azomethine complex, a tropolone metal complex, a flavonol metal complex and a benzoquinoline metal complex.

The above materials may be used alone, or in combination of a different material.

Among the above-mentioned materials, a borane derivative, a pyridine derivative, a fluoranthene derivative, a BO-based derivative, an anthracene derivative, a benzofluorene derivative, a phosphine oxide derivative, a pyrimidine derivative, an aryl nitrile derivative, a triazine derivative, a benzimidazole derivative, a phenanthroline derivative, a quinolinol metal complex, a thiazole derivative, a benzothiazole derivative, a shirol derivatives and an azoline derivative are preferred.

The polycyclic aromatic compounds of the present invention may be used as materials for forming an electron injection layer or an electron transport layer.

The electron transport layer or the electron injection layer may further include a substance that can reduce a material forming the electron transport layer or the electron injection layer. Various substances are used as the reducing substance if the substance has predetermined reducing properties. For example, at least one selected from the group of alkali metal, alkaline earth metal, rare earth metal, an oxide of alkali metal, a halide of alkali metal, an oxide of alkaline earth metal, a halide of alkaline earth metal, an oxide of rare earth metal, a halide of rare earth metal, an organic complex of alkali metal, an organic complex of alkaline earth metal and an organic complex of rare earth metal can be preferably used.

Specific examples of the preferred reducing substance include alkali metal such as Na (work function: 2.36 eV), K (work function: 2.28 eV), Rb (work function: 2.16 eV) or Cs (work function 1.95 eV), and alkaline earth metal such as Ca (work function: 2.9 eV), Sr (work function: 2.0 to 2.5 eV) or Ba (work function: 2.52 eV), and a substance having a work function of 2.9 eV or less is particularly preferred. Among the above substances, as the reducing substance, alkali metal of K, Rb or Cs is preferred, Rb or Cs is further preferred, and Cs is most preferred. The above alkali metals have particularly high reduction capability, and improvement in luminance and extension of a service life in the organic EL element can be achieved by adding a relatively small amount thereof to the material forming the electron transport layer or the electron injection layer. Moreover, as the reducing substance having a work function of 2.9 eV or less, a combination of two or more kinds of alkali metals is preferred, and a combination including Cs, for example, a combination of Cs and Na, Cs and K, Cs and Rb, or Cs and Na and K is particularly preferred. The reduction capability can be efficiently exhibited by containing Cs, and improvement in luminance and extension of a service life in the organic EL element can be achieved by adding Cs to the material forming the electron transport layer or the electron injection layer.

### <2-1-8. Cathode in Organic electroluminescent element>

Cathode 108 plays a role of injecting electrons into light-emitting layer 105 through electron injection layer 107 and electron transport layer 106.

A material forming cathode 108 is not particularly limited, as long as the material can efficiently inject electrons into an organic layer, and a material similar to the material forming anode 102 can be used. Particularly, metal such as tin, indium, calcium, aluminum, silver, copper, nickel, chromium, gold, platinum, iron, zinc, lithium, sodium, potassium, cesium and magnesium, or alloy thereof (such as magnesium-silver alloy, magnesium-indium alloy and aluminum-lithium alloy such as lithium fluoride/aluminum), or the like is preferred. In order to enhance electron injection efficiency to improve device characteristics, lithium, sodium, potassium, cesium, calcium, magnesium, or alloy containing the above low-work-function metals is effective. However, the above low-work-function metals are generally unstable in atmospheric air in many cases. In order to improve the above point, a method of doping a small amount of lithium, cesium and magnesium to an organic layer, and using an electrode having high stability is known, for example. As other dopants, inorganic salt such as lithium fluoride, cesium fluoride, lithium oxide and cesium oxide can also be used, but not limited thereto.

Further, preferred examples for protecting the electrode include lamination of metals such as platinum, gold, silver, copper, iron, tin, aluminum and indium, alloy using the above metals, inorganic substances such as silica, titania and silicon nitride, polyvinyl alcohol, polyvinyl chloride, a hydrocarbon-based polymer compound, or the like. A method of preparing the above electrodes is not particularly limited, as long as conduction, such as resistance heating, electron beam vapor deposition, sputtering, ion plating and coating, can be achieved.

### <2-1-9. Binding agent that may be used in each layer>

The above materials used for the hole injection layer, the hole transport layer, the light-emitting layer, the electron transport layer and the electron injection layer can form each layer alone, but can also be dispersed and used, as a polymer binding agent, in a solvent-soluble resin such as polyvinyl chloride, polycarbonate, polystyrene, poly(N-vinylcarbazole), polymethylmethacrylate, polybutylmethacrylate, polyester, polysulfone, polyphenylene oxide, polybutadiene, a hydrocarbon resin, a ketone resin, a phenoxy resin, polyamide, ethyl cellulose, a vinyl acetate resin, an ABS resin and a polyurethane resin; or a curable resin such as a phenolic resin, a xylene resin, a petroleum resin, a urea resin, a melamine resin, an unsaturated polyester resin, an alkyd resin, an epoxy resin and a silicone resin.

### <2-1-10. Production method for Organic electroluminescent element>

The layers constituting the organic EL element can be formed each as a thin film of a material to constitute each layer, according to a vapor deposition method, a low resistance vapor deposition method, an electron beam vapor deposition method, a sputtering method, a molecular lamination method, a printing method, an inkjet method, a spin coating method, a casting method or a coating method. The thickness of each layer thus formed in the manner is not specifically limited and can be appropriately set depending on the properties of the material. In general, the thickness falls within a range of 2 nm to 5000 nm. The film thickness can be measured generally according to a crystal oscillation-type thickness meter. In the case where a thin film is formed according to a vapor deposition method, the deposition condition varies depending on the kind of the material, and the crystal structure and the association structure intended for the film. In general, it is preferable to appropriately set the vapor deposition conditions in the ranges of a heating temperature for the boat for deposition of +50 to +400°C, a degree of vacuum of 10⁻⁶ to 10⁻³ Pa, a rate of deposition of 0.01 to 50 nm/sec, a substrate temperature of -150 to + 300°C, and a film thickness of 2 nm to 5 µm.

Next, as one example of a method for producing an organic electroluminescent element, a production method for an organic electroluminescent element having a layer configuration of an anode/a hole injection layer/a hole transport layer/a light-emitting layer containing a host material and a dopant material /an electron transport layer/an electron injection layer/a cathode is described. On an appropriate substrate, a thin film of an anode material is formed according to a vapor deposition method to be an anode, and on the anode, thin films of a hole injection layer and a hole transport layer are formed. On this, a host material and a dopant material are co-deposited to form a thin film to be a light-emitting layer, then on the light-emitting layer, an electron transport layer and an electron injection layer are formed, and further a thin film of a cathode substance is formed according to a vapor deposition method to be a cathode, thereby providing an intended organic EL element. In production of the organic EL element, the process order may be reversed to form the layers in reverse order of a cathode, an electron injection layer, an electron transport layer, a light-emitting layer, a hole transport layer, a hole injection layer and an anode.

In a case where a direct current voltage is applied to the organic electroluminescent element thus obtained, it is only required to apply the voltage by assuming a positive electrode as a positive polarity and assuming a negative electrode as a negative polarity. By applying a voltage of about 2 to 40 V, light emission can be observed from a transparent or semitransparent electrode side (the positive electrode or the negative electrode, or both the electrodes). Furthermore, this organic EL element also emits light even in a case where a pulse current or an alternating current is applied. A waveform of an alternating current applied may be any waveform.

### <2-1-11. Application for Organic electroluminescent element>

An organic EL element is also applicable to a display device or a lighting device.

The display device and the lighting device equipped with an organic EL element can be produced by connecting the organic EL element and a known driving device, according to a known method, and can be driven appropriately using a known driving method of direct current driving, pulse driving or alternate current driving.

Examples of the lighting device include panel displays such as color flat panel displays, and flexible displays such as flexible color organic electroluminescent (EL) displays (for example, see JP 10-335066 A, JP 2003-321546 A, JP 2004-281086 A). Examples of the display system include either one of a matrix and segment system. A matrix display and a segment display may co-exist in the same panel.

In a matrix, pixels for display are two-dimensionally arranged such as in a lattice-like or mosaic-like form, and pixel aggregation displays a letter and an image. The shape and the size of pixels are determined depending on the intended use. For example, for image and letter display on personal computers, monitors and televisions, square pixels of 300 µm or less on each side are generally used, while in the case of a large-size display such as a display panel, pixels of mm order on each side are used. In the case of monochromatic display, pixels of the same color may be aligned, but in the case of color display, pixels of red, green, and blue are aligned and displayed. In this case, typically, there is known a delta type and a stripe type. Regarding the driving method for the matrix, any of a line-sequential drive method or an active-matrix method may be employed. A line-sequential drive method has an advantage that the structure is simple, but in consideration of operation characteristics, an active matrix may often be superior to it, as the case may be. Accordingly, the two need to be used individually depending on the intended use.

In a segment type, patterns are formed so as to display previously determined information, and a determined region is made to emit light. Examples thereof include time and temperature display in digital watches and thermometers, operating state display in audio instruments and induction cookers, and panel display in automobiles.

Examples of the lighting device include a lighting device for in-room lighting, and a backlight in liquid-crystal display devices (for example, see JP 2003-257621 A, JP 2003-277741 A, and JP 2004-119211 A). A backlight is used mainly for the purpose of improving the visibility in non-luminescent devices, and is used, for example, in liquid-crystal display devices, watches, audio instruments, automobile panels, display boards and sign boards. In particular, regarding a backlight for liquid-crystal displays, especially for personal computers whose issue is to be thinned, a conventional system uses a fluorescent lamp or a light guide plate and is therefore difficult to thin, and taking this into consideration, a backlight using the light-emitting device is characterized in that it is thin and light.

### <2-2. Other Organic devices>

The polycyclic aromatic compound according to the present invention can be used for manufacturing an organic field effect transistor, an organic thin film solar cell, or the like, in addition to the organic electroluminescent element described above.

The organic field effect transistor is a transistor that controls a current by means of an electric field generated by voltage input, and is provided with a source electrode, a drain electrode, and a gate electrode. When a voltage is applied to the gate electrode, an electric field is generated, and the organic field effect transistor can control a current by arbitrarily damming a flow of electrons (or holes) flowing between the source electrode and the drain electrode. The field effect transistor can be easily miniaturized compared with a simple transistor (bipolar transistor) and is often used as an element constituting an integrated circuit or the like.

The structure of the organic field effect transistor is usually as follows. That is, a source electrode and a drain electrode are provided in contact with an organic semiconductor active layer formed using the polycyclic aromatic compound according to the present invention, and it is only required to further provide a gate electrode so as to interpose an insulating layer (dielectric layer) in contact with the organic semiconductor active layer. Examples of the element structure include the following structures.
(1) Substrate/gate electrode/insulator layer/source electrode and drain electrode/organic semiconductor active layer.
(2) Substrate/gate electrode/insulator layer/organic semiconductor active layer/source electrode and drain electrode.
(3) Substrate/organic semiconductor active layer/source electrode and drain electrode/insulator layer/gate electrode.
(4) Substrate/source electrode and drain electrode/organic semiconductor active layer/insulator layer/gate electrode.

An organic field effect transistor thus configured can be applied as a pixel driving switching element of an active matrix driving type liquid crystal display or an organic electroluminescent display, or the like.

An organic thin film solar cell has a structure in which a positive electrode such as ITO, a hole transport layer, a photoelectric conversion layer, an electron transport layer, and a negative electrode are laminated on a transparent substrate of glass or the like. The photoelectric conversion layer has a p-type semiconductor layer on the positive electrode side and has an n-type semiconductor layer on the negative electrode side. The polycyclic aromatic compound according to the present invention can be used as a material for a hole transport layer, a p-type semiconductor layer, an n-type semiconductor layer, or an electron transport layer depending on physical properties thereof. The polycyclic aromatic compound according to the present invention can function as a hole transport material or an electron transport material in an organic thin film solar cell. The organic thin film solar cell may appropriately include a hole blocking layer, an electron blocking layer, an electron injection layer, a hole injection layer, a smoothing layer, and the like, in addition to the members described above. For the organic thin film solar cell, known materials used for an organic thin film solar cell can be appropriately selected and used in combination.

### <3. Wavelength conversion material>

The polycyclic aromatic compound of the present invention may be used as a wavelength conversion material.

Currently, the application of a multicoloring technique by a color conversion method to a liquid crystal display, an organic EL display, illumination, and the like has been energetically studied. Color conversion refers to a wavelength conversion of emitted light from a light-emitting substance into light with a longer wavelength and includes, for example, conversion of UV light or blue light into green light or red emitted light. By molding a wavelength conversion material having this color conversion function into a film and then combining the film with a blue light source, three primary colors of blue, green, and red can be taken out; that is, white light can be taken out from a blue light source. A full-color display can be constructed using such a white light source, in which a blue light source is combined with a wavelength conversion film having a color conversion function, as a light source unit and combining the white light source with a liquid crystal-driving part and a color filter. When a liquid crystal-driving part is omitted, such a white light source is used as a white light source as it is and can be applied to a white light source for, for example, an LED illumination. A full-color organic EL display can be constructed without a metal mask using a combination of a blue organic EL element as a light source and a wavelength conversion film that converts blue light into green light and red light. A low-cost full-color organic micro-LED display can be constructed by using a combination of a blue micro-LED as a light source and a wavelength conversion film that converts blue light into green light and red light.

The polycyclic aromatic compound of the present invention may be used as this wavelength conversion material. By using a wavelength conversion material containing a polycyclic aromatic compound of the present invention, light from a light source or a light-emitting element that generates UV light or blue light with a shorter wavelength into blue light or green light with high color purity, suitable for the use in a display device (a display device using an organic EL element or a liquid crystal display device). The color to be converted may be adjusted by appropriately selecting the substituent of the polycyclic aromatic compound of the present invention, a binder resin used in a wavelength-converting composition that will be described below, or the like. The wavelength conversion material may be prepared as a wavelength-converting composition containing a polycyclic aromatic compound of the present invention. A wavelength conversion film may be formed by using this wavelength-converting composition.

The wavelength-converting composition may contain a binder resin, another additive, and a solvent in addition to the polycyclic aromatic compound of the present invention. As the binder resin, for example, those disclosed in paragraphs [0173] to [0176] of WO 2016/190283 may be used. As the other additive, for example, those disclosed in paragraphs [0177] to [0181] of WO 2016/190283 may be used. As the solvent, the description about the solvents contained in the light-emitting layer forming composition may be referred to.

The wavelength conversion film includes a wavelength conversion layer formed by curing a wavelength-converting composition. A known film formation method may be referred to as a method for constructing a wavelength conversion layer from a wavelength-converting composition. The wavelength conversion film may consist only of wavelength conversion layers formed from a composition containing a polycyclic aromatic compound of the present invention and may include other wavelength conversion layers (for example, a wavelength conversion layer converting blue light into green light or red light, or a wavelength conversion layer converting blue light into green light or red light). Furthermore, the wavelength conversion film may include a substrate layer or a barrier layer for preventing deterioration of a color conversion layer due to oxygen, moisture, or heat.

### Examples

Hereinunder the present invention is described specifically with reference to Examples, but the present invention is not whatsoever restricted by these Examples.

In the examples, APCI-MS refers to atmospheric pressure chemical ionization mass spectrometry.

### << Synthesis Example>>

### <Synthesis Example (1): Synthesis of Compound (1-1-1)>

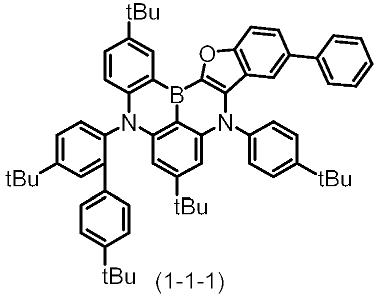

Under a nitrogen atmosphere, Intermediate (Int-1-1-1-1), 41.4 g, 5-t-butyl-1,2,3-trichlorobenzene (23.8 g), palladium catalyst dichlorobis[di-t-butyl (4-dimethylaminophenyl) phosphino]palladium (II) (Pd-132, 2.1 g), tBuONa (14.4 g), and toluene (ml) were placed in a flask and heated at reflux temperature for 8 hours. After the reaction was complete, water and ethyl acetate were added to the reaction mixture, stirred, and the organic layer was separated and washed with water. The organic layer was then concentrated, and the crude product obtained was purified using a silica gel short column (elution solvent: toluene/heptane = 1/4 (volume ratio)) to obtain Intermediate (Int-1-1-1-2) (55.5 g).

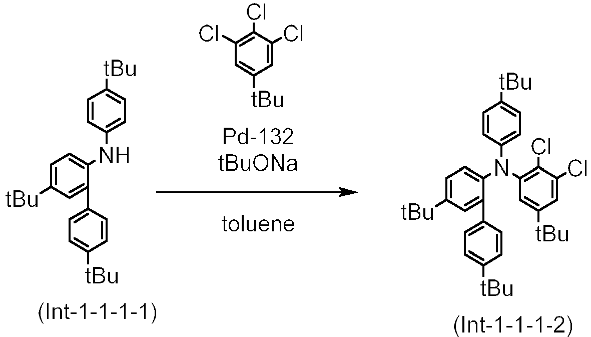

Under a nitrogen atmosphere, Intermediate (Int-1-1-1-2) (30.7 g), intermediate (Int-1-1-3) (17.1 g), palladium catalyst Pd-132 (1.1 g), t-BuONa (7.2 g), and toluene (300 mL) were placed in a flask, and heated at the reflux temperature for 6 hours. After the reaction was complete, water and ethyl acetate were added to the reaction mixture, stirred, and the organic layer was separated and washed with water. The organic layer was concentrated, and the crude product obtained was purified using silica gel short column chromatography (elution solvent: toluene/heptane = 1/5 (volume ratio)) to obtain Intermediate (Int-1-1-1) (22.2 g).

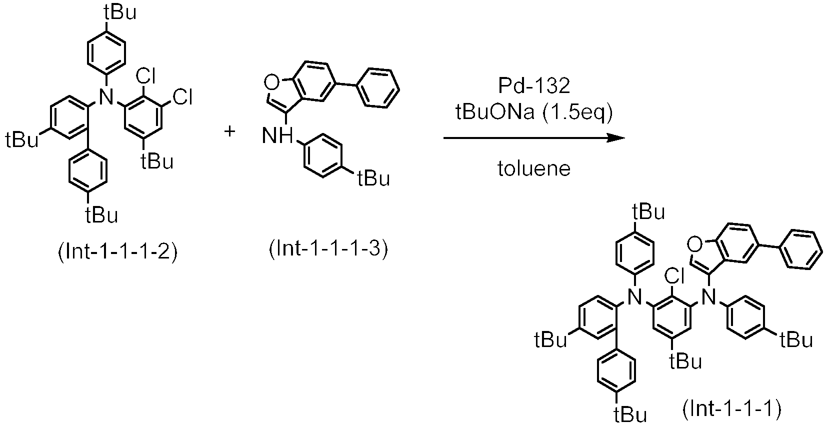

To a flask containing Intermediate (Int-1-1-1) (9.2g) and tert-butylbenzene (100ml) was added a 1.60M of t-butyllithium pentane solution (13.8 ml) at 0°C under a nitrogen atmosphere. After completion of the dropwise addition, the temperature was increased to 70 °C, and the reaction mixture was stirred for 0.5 hours, and then the components having a lower boiling point than that of t-butylbenzene were distilled off under reduced pressure. The reaction mixture was cooled to -50 °C, added with boron tribromide (3.0 g), and stirred for 0.5 hours after the temperature was increased to room temperature. Thereafter, the reaction mixture was cooled again to 0°C and added with N,N-diisopropylethylamine (3.9 g), and stirred at room temperature until exothermic heat had settled, and then heated and stirred for 1 hours at a temperature increased to 100°C. The reaction mixture was cooled to room temperature, added with an aqueous sodium acetate solution cooled in an ice bath, followed by ethyl acetate and the mixture was separated. After concentrating the organic layer, purification was performed using a silica gel short column (elution solvent: toluene/heptane = 1/5 (volume ratio)). The crude product obtained was recrystallized from toluene to obtain Compound (1-1-1) (2.0 g).

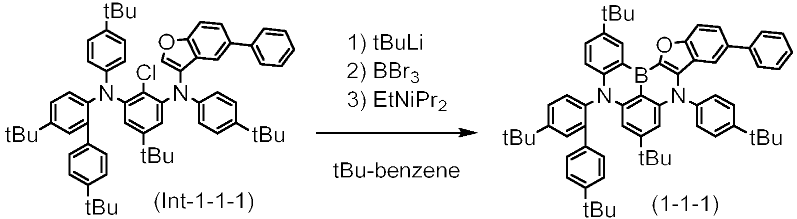

The target product of m/z(M+H) =893.56 was confirmed by APCI-MS.

### Synthesis Example (2): Synthesis of Compound (1-1-3)

Compound (1-1-3) was obtained by the same procedure as in Synthesis Example (1) from Intermediate (Int-1-1-3).

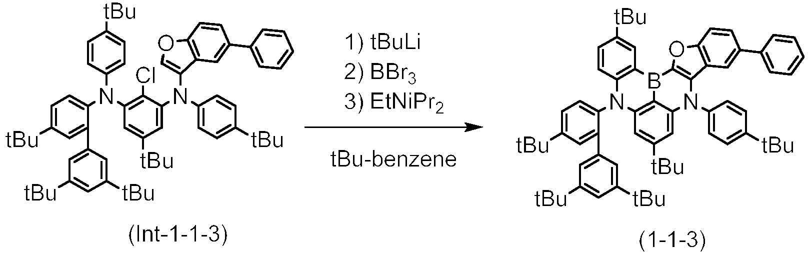

The target product of m/z(M+H) =949.62 was confirmed by APCI-MS.

### Synthesis Example (3): Synthesis of Compound (1-1-5)

Compound (1-1-5) was obtained by the same procedure as in Synthesis Example (1) from Intermediate (Int-1-1-5).

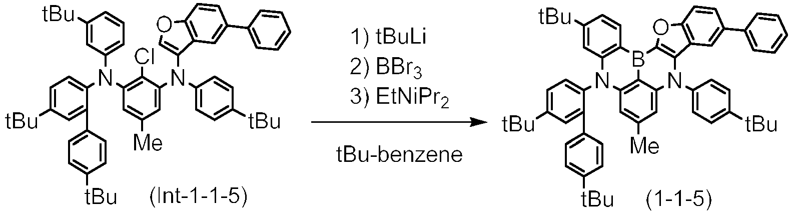

The target product of m/z(M+H) =851.51 was confirmed by APCI-MS.

### Synthesis Example (4): Synthesis of Compound (1-1-10)

Compound (1-1-10) was obtained by the same procedure as in Synthesis Example (1) from Intermediate (Int-1-1-10).

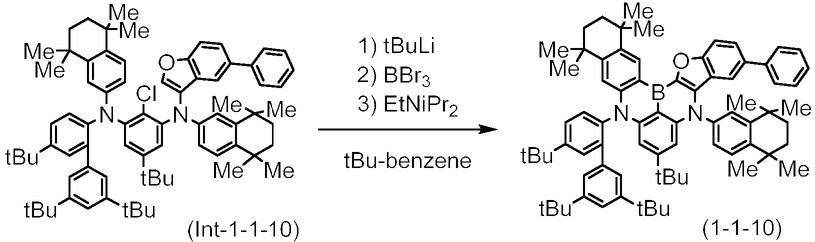

The target product of m/z(M+H) =1057.71 was confirmed by APCI-MS.

### Synthesis Example (5): Synthesis of Compound (1-2-7)

Compound (1-2-7) was obtained by the same procedure as in Synthesis Example (1) from Intermediate (Int-1-2-7).

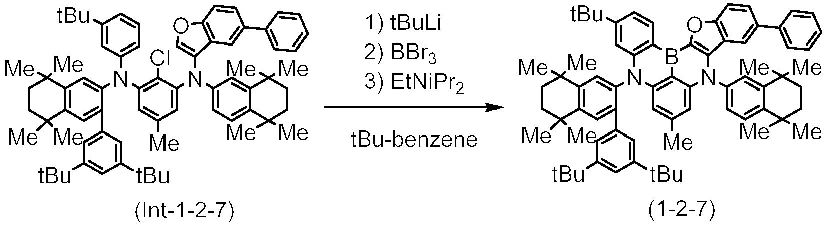

The target product of m/z(M+H) =1015.67 was confirmed by APCI-MS.

### Synthesis Example (6): Synthesis of Compound (1-3-4)

Compound (1-3-4) was obtained by the same procedure as in Synthesis Example (1) from Intermediate (Int-1-3-4).

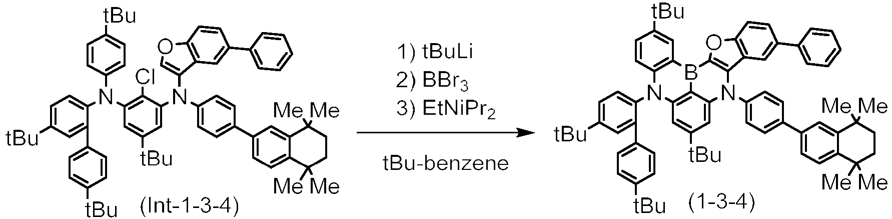

The target product of m/z(M+H) =1023.64 was confirmed by APCI-MS.

### Synthesis Example (7): Synthesis of Compound (1-3-6)

Compound (1-3-6) was obtained by the same procedure as in Synthesis Example (1) from Intermediate (Int-1-3-6).

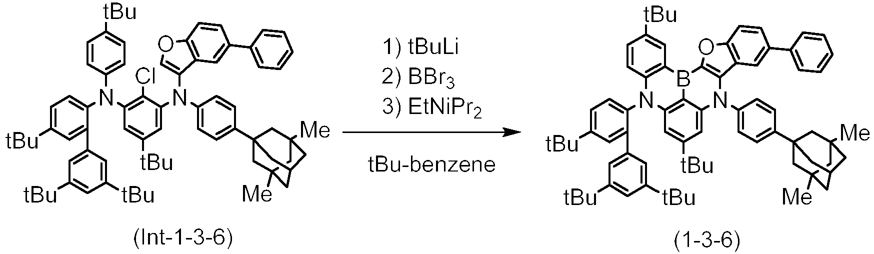

The target product of m/z(M+H) =1055.70 was confirmed by APCI-MS.

### Synthesis Example (8): Synthesis of Compound (1-3-9)

Compound (1-3-9) was obtained by the same procedure as in Synthesis Example (1) from Intermediate (Int-1-3-9).

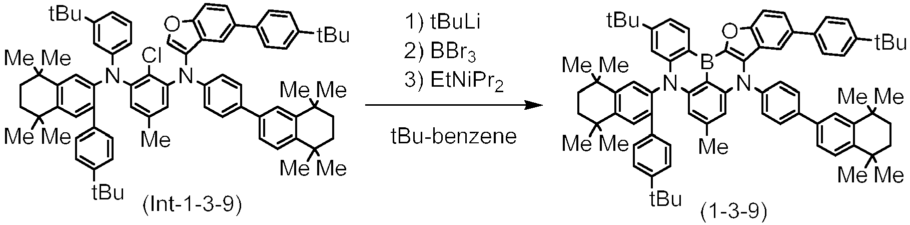

The target product of m/z(M+H) =1091.70 was confirmed by APCI-MS.

### Synthesis Example (9): Synthesis of Compound (1-3-10)

Compound (1-3-10) was obtained by the same procedure as in Synthesis Example (1) from Intermediate (Int-1-3-10).

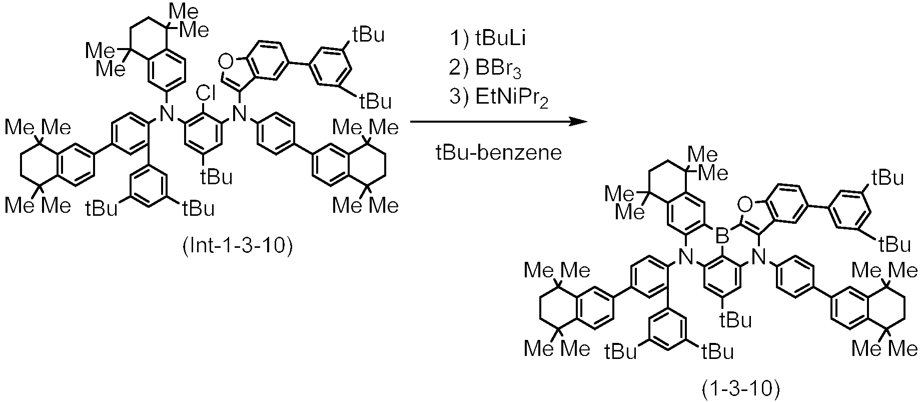

The target product of m/z(M+H) =1375.95 was confirmed by APCI-MS.

### Synthesis Example (10): Synthesis of Compound (1-4-2)

Compound (1-4-2) was obtained by the same procedure as in Synthesis Example (1) from Intermediate (Int-1-4-2).

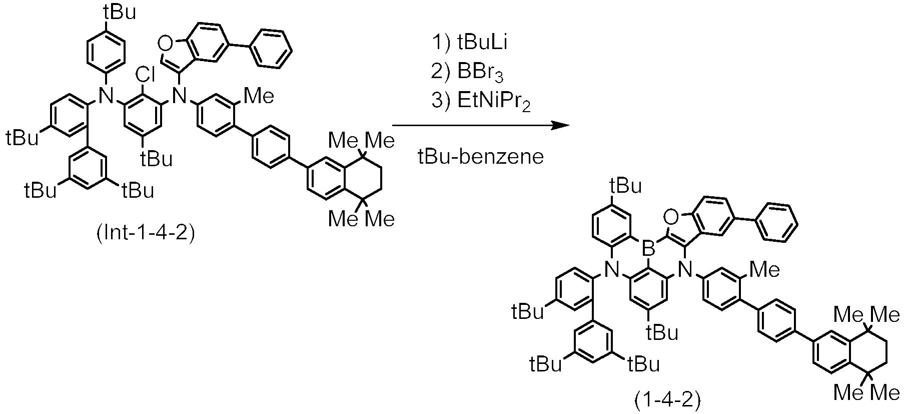

The target product of m/z(M+H) =1169.75 was confirmed by APCI-MS.

### Synthesis Example (11): Synthesis of Compound (1-4-5)

Compound (1-4-5) was obtained by the same procedure as in Synthesis Example (1) from Intermediate (Int-1-4-5).

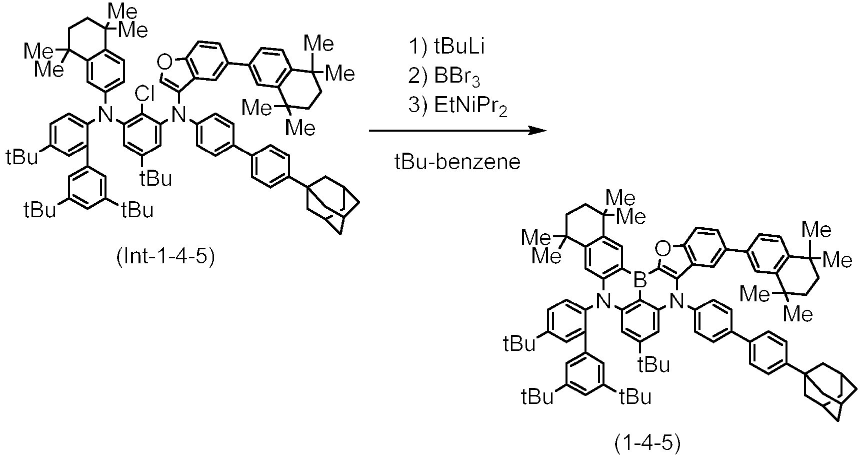

The target product of m/z(M+H) =1267.86 was confirmed by APCI-MS.

### Synthesis Example (12): Synthesis of Compound (1-5-8)

Compound (1-5-8) was obtained by the same procedure as in Synthesis Example (1) from Intermediate (Int-1-5-8).

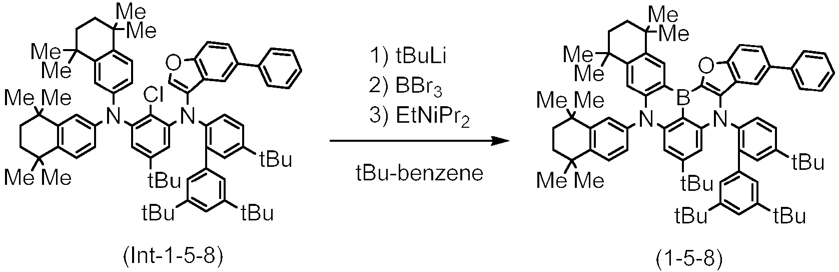

The target product of m/z(M+H) =1057.71 was confirmed by APCI-MS.

### Synthesis Example (13): Synthesis of Compound (1-6-2)

Compound (1-6-2) was obtained by the same procedure as in Synthesis Example (1) from Intermediate (Int-1-6-2).

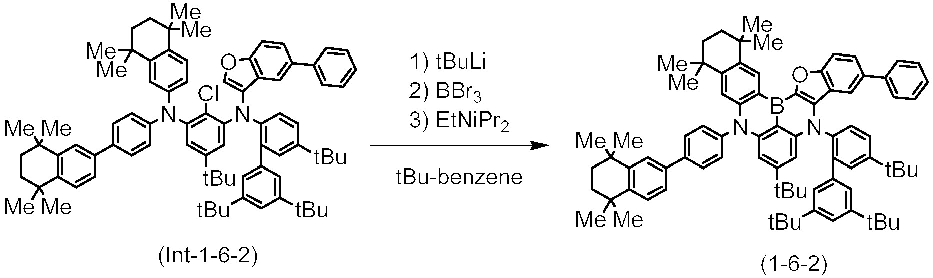

The target product of m/z(M+H) =1133.75 was confirmed by APCI-MS.

### Synthesis Example (14): Synthesis of Compound (1-6-6)

Compound (1-6-6) was obtained by the same procedure as in Synthesis Example (1) from Intermediate (Int-1-6-6).

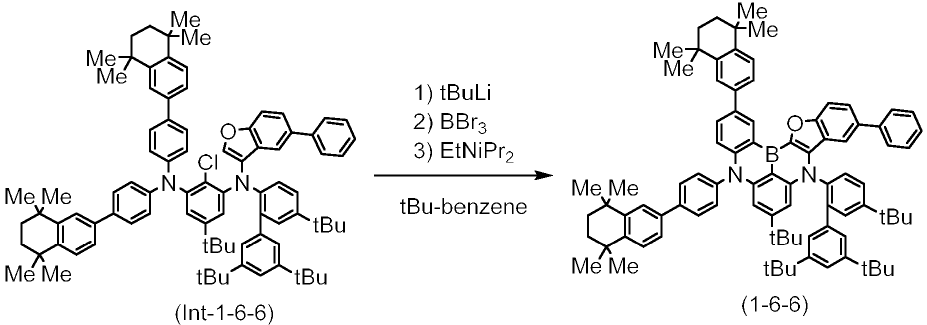

The target product of m/z(M+H) =1209.78 was confirmed by APCI-MS.

### Synthesis Example (15): Synthesis of Compound (1-6-10)

Compound (1-6-10) was obtained by the same procedure as in Synthesis Example (1) from Intermediate (Int-1-6-10).

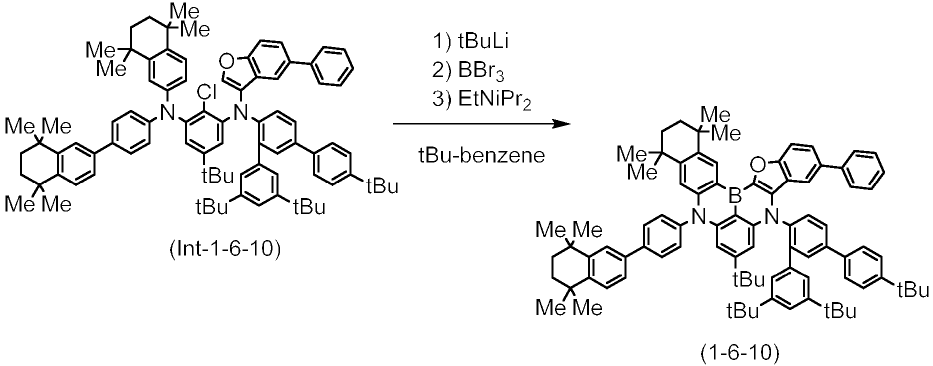

The target product of m/z(M+H) =1209.78 was confirmed by APCI-MS.

### Synthesis Example (16): Synthesis of Compound (1-7-3)

Compound (1-7-3) was obtained by the same procedure as in Synthesis Example (1) from Intermediate (Int-1-7-3).

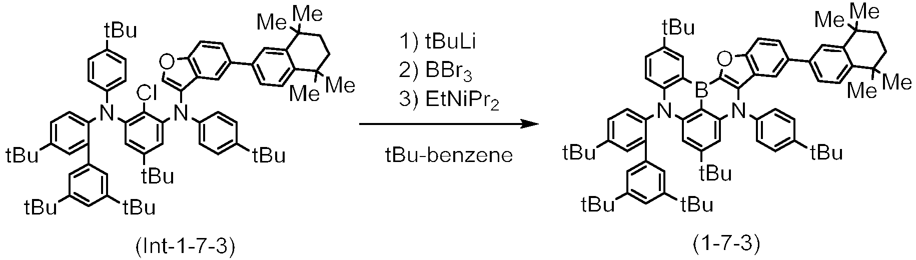

The target product of m/z(M+H) =1059.73 was confirmed by APCI-MS.

### Synthesis Example (17): Synthesis of Compound (1-8-2)

Compound (1-8-2) was obtained by the same procedure as in Synthesis Example (1) from Intermediate (Int-1-8-2).

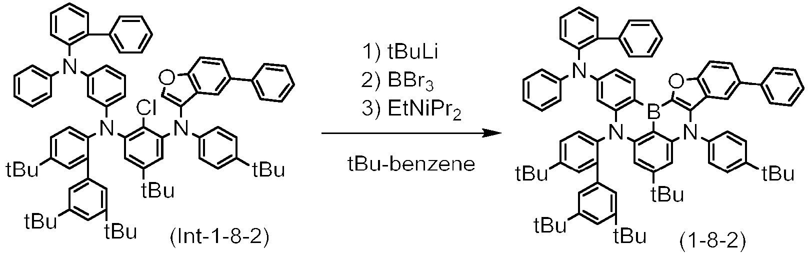

The target product of m/z(M+H) =1136.66 was confirmed by APCI-MS.

### Synthesis Example (18): Synthesis of Compound (1-8-6)

Compound (1-8-6) was obtained by the same procedure as in Synthesis Example (1) from Intermediate (Int-1-8-6).

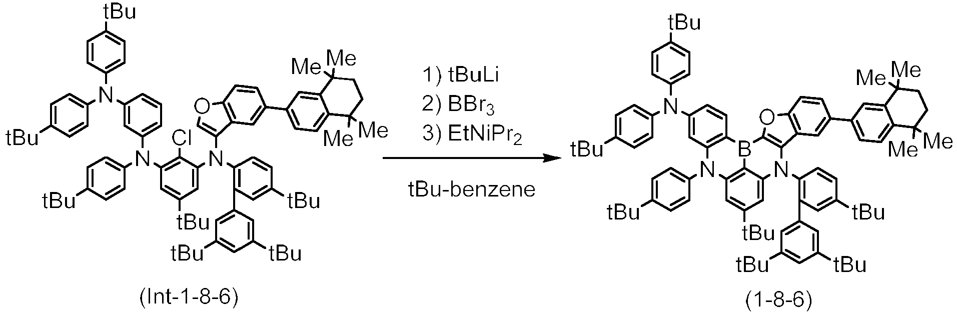

The target product of m/z(M+H) =1282.87 was confirmed by APCI-MS.

### Synthesis Example (19): Synthesis of Compound (1-9-2)

Compound (1-9-2) was obtained by the same procedure as in Synthesis Example (1) from Intermediate (Int-1-9-2).

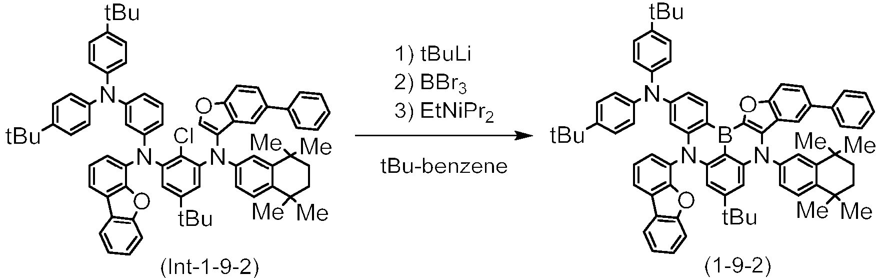

The target product of m/z(M+H) =1072.60 was confirmed by APCI-MS.

### Synthesis Example (20): Synthesis of Compound (1-9-5)

Compound (1-9-5) was obtained by the same procedure as in Synthesis Example (1) from Intermediate (Int-1-9-5).

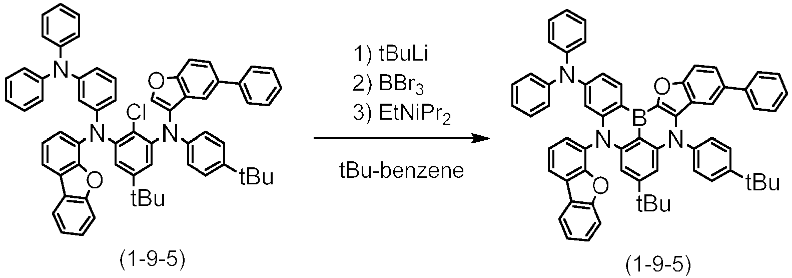

The target product of m/z(M+H) =906.42 was confirmed by APCI-MS.

### Synthesis Example (21): Synthesis of Compound (1-9-9)

Compound (1-9-9) was obtained by the same procedure as in Synthesis Example (1) from Intermediate (Int-1-9-9).

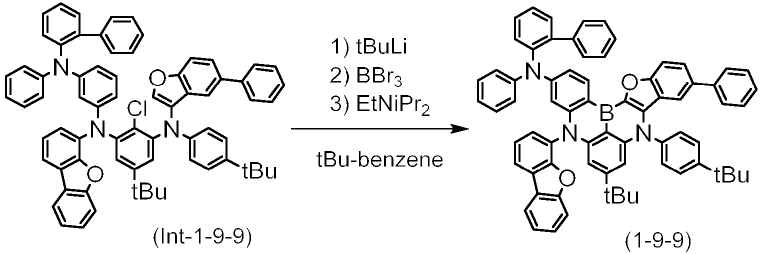

The target product of m/z(M+H) =982.45 was confirmed by APCI-MS.

### Synthesis Example (22): Synthesis of Compound (1-11-8)

Compound (1-11-8) was obtained by the same procedure as in Synthesis Example (1) from Intermediate (Int-1-11-8).

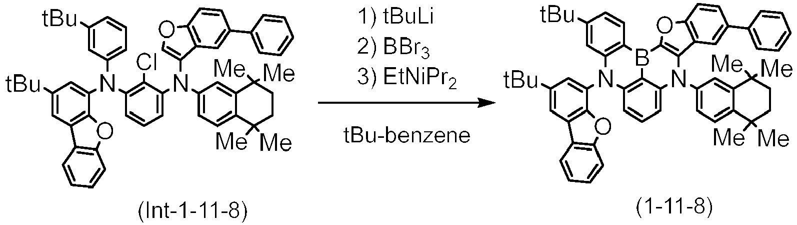

The target product of m/z(M+H) =849.46 was confirmed by APCI-MS.

### Synthesis Example (23): Synthesis of Compound (1-15-2)

Compound (1-15-2) was obtained by the same procedure as in Synthesis Example (1) from Intermediate (Int-1-15-2).

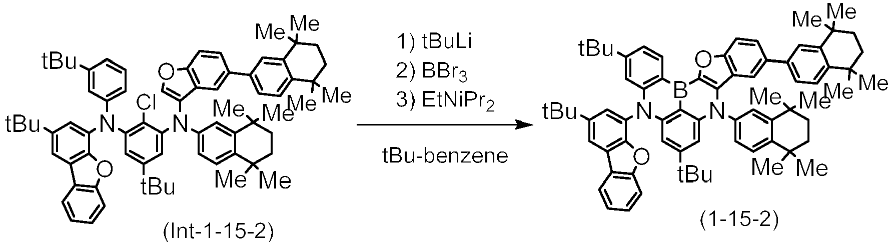

The target product of m/z(M+H) =1015.63 was confirmed by APCI-MS.

### Synthesis Example (24): Synthesis of Compound (1-15-9)

Compound (1-15-9) was obtained by the same procedure as in Synthesis Example (1) from Intermediate (Int-1-15-9).

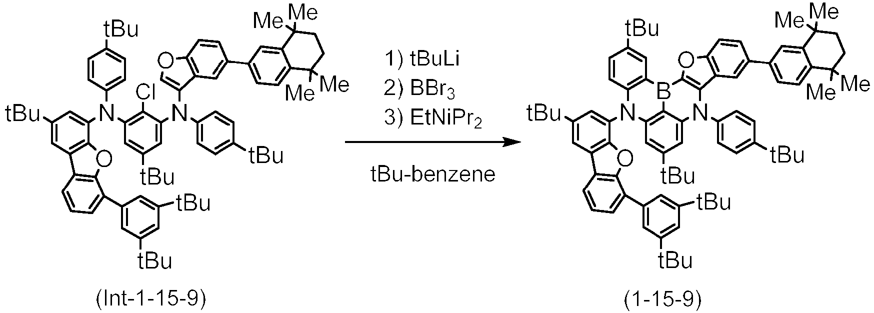

The target product of m/z(M+H) =1149.47 was confirmed by APCI-MS.

### Synthesis Example (25): Synthesis of Compound (1-16-6)

Compound (1-16-6) was obtained by the same procedure as in Synthesis Example (1) from Intermediate (Int-1-16-6).

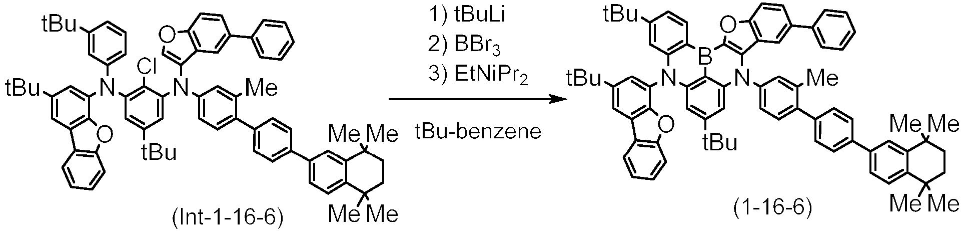

The target product of m/z(M+H) =1071.60 was confirmed by APCI-MS.

### Synthesis Example (26): Synthesis of Compound (1-16-8)

Compound (1-16-8) was obtained by the same procedure as in Synthesis Example (1) from Intermediate (Int-1-16-8).

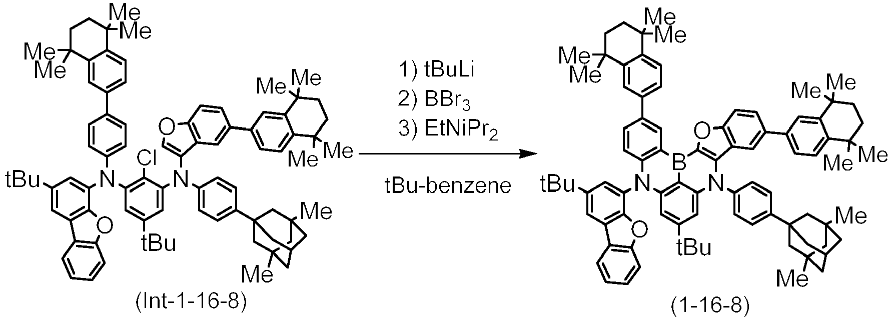

The target product of m/z(M+H) =1197.74 was confirmed by APCI-MS.

### Synthesis Example (27): Synthesis of Compound (1-17-1)

Compound (1-17-1) was obtained by the same procedure as in Synthesis Example (1) from Intermediate (Int-1-17-1).

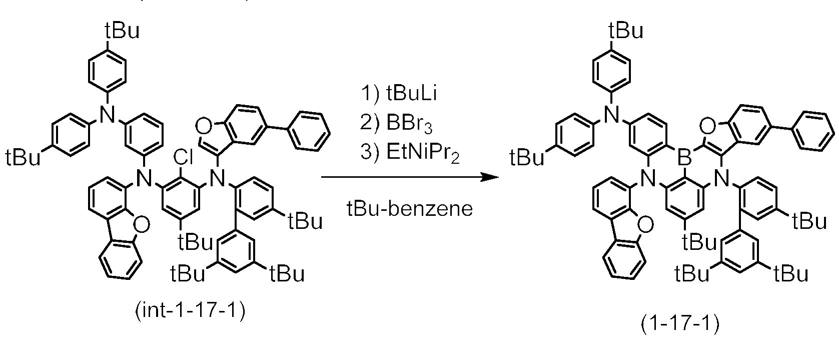

The target product of m/z(M+H) =1206.70 was confirmed by APCI-MS.

### Synthesis Example (28): Synthesis of Compound (1-17-3)

Compound (1-17-3) was obtained by the same procedure as in Synthesis Example (1) from Intermediate (Int-1-17-3).

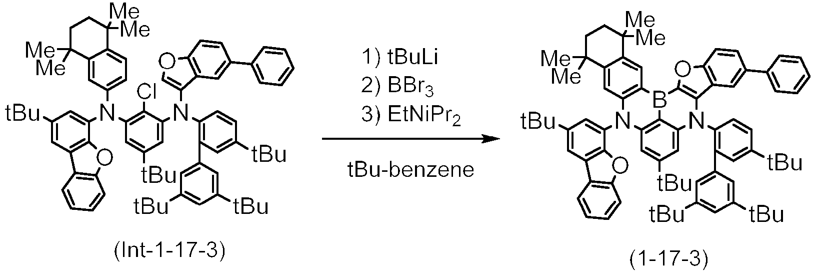

The target product of m/z(M+H) =1093.68 was confirmed by APCI-MS.

### Synthesis Example (29): Synthesis of Compound (1-17-5)

Compound (1-17-5) was obtained by the same procedure as in Synthesis Example (1) from Intermediate (Int-1-17-5).

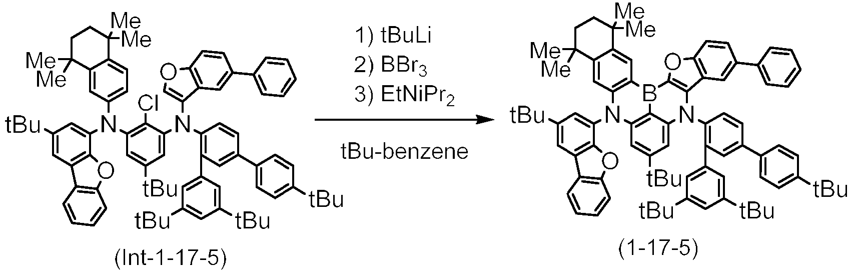

The target product of m/z(M+H) =1169.71 was confirmed by APCI-MS.

### Synthesis Example (30): Synthesis of Compound (1-17-10)

Compound (1-17-10) was obtained by the same procedure as in Synthesis Example (1) from Intermediate (Int-1-17-10).

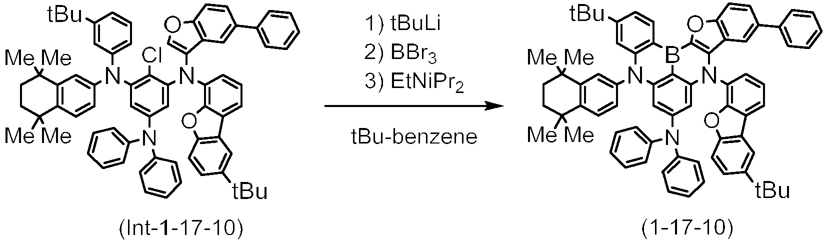

The target product of m/z(M+H) =1016.53 was confirmed by APCI-MS.

### Synthesis Example (31): Synthesis of Compound (1-19-1)

Compound (1-19-1) was obtained by the same procedure as in Synthesis Example (1) from Intermediate (Int-1-19-1).

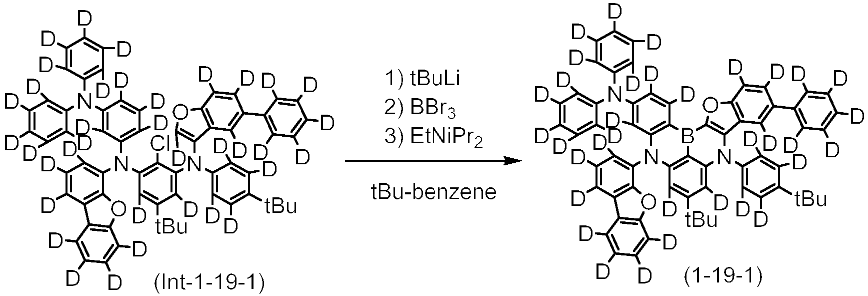

The target product of m/z(M+H) =940.64 was confirmed by APCI-MS.

### Synthesis Example (32): Synthesis of Compound (1-19-3)

Compound (1-19-3) was obtained by the same procedure as in Synthesis Example (1) from Intermediate (Int-1-19-3).

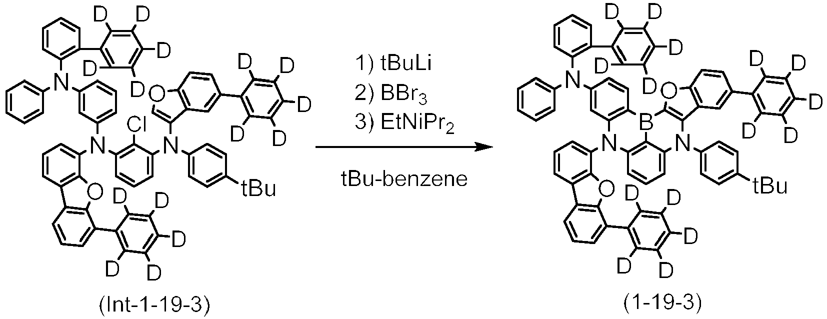

The target product of m/z(M+H) =1017.52 was confirmed by APCI-MS.

### Synthesis Example (33): Synthesis of Compound (1-19-8)

Compound (1-19-8) was obtained by the same procedure as in Synthesis Example (1) from Intermediate (Int1-19-8).

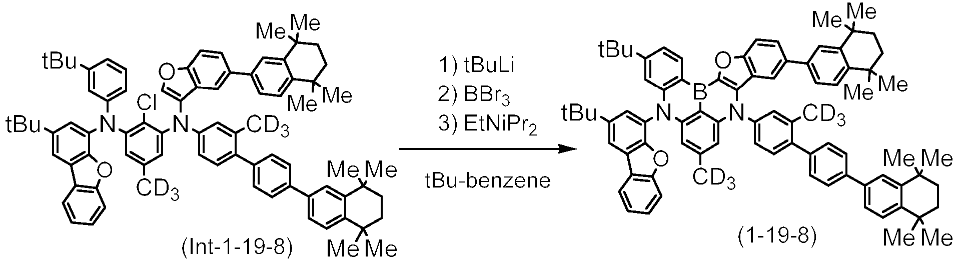

The target product of m/z(M+H) =1145.70 was confirmed by APCI-MS.

### Synthesis Example (34): Synthesis of Compound (1-20-1)

Compound (1-20-1) was obtained by the same procedure as in Synthesis Example (1) from Intermediate (Int-1-20-1).

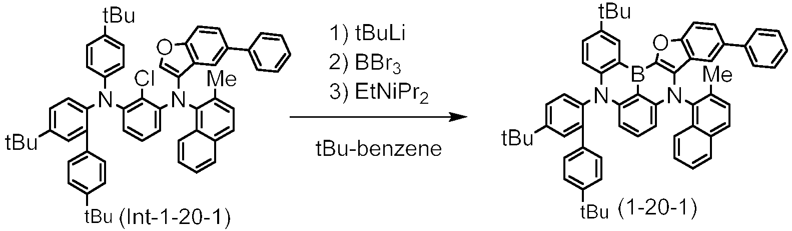

The target product of m/z(M+H) =845.46 was confirmed by APCI-MS.

### Synthesis Example (35): Synthesis of Compound (1-20-2)

Compound (1-20-2) was obtained by the same procedure as in Synthesis Example (1) from Intermediate (Int-1-20-2).

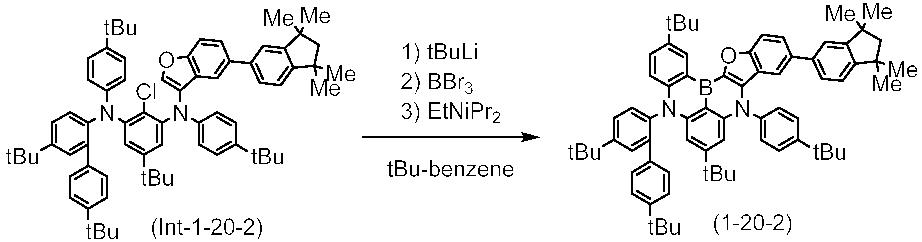

The target product of m/z(M+H) =989.65 was confirmed by APCI-MS.

### Synthesis Example (36): Synthesis of Compound (1-20-3)

Compound (1-20-3) was obtained by the same procedure as in Synthesis Example (1) from Intermediate (Int-1-20-3).

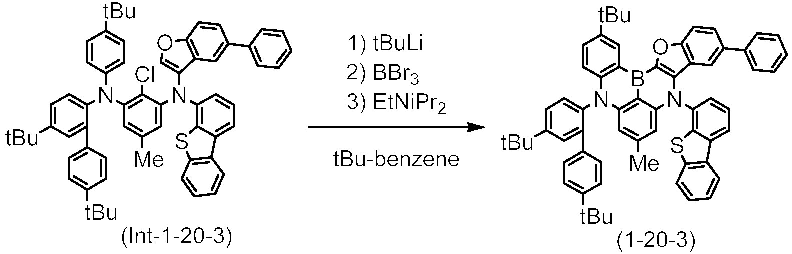

The target product of m/z(M+H) =901.44 was confirmed by APCI-MS.

### Synthesis Example (37): Synthesis of Compound (1-20-4)

Compound (1-20-4) was obtained by the same procedure as in Synthesis Example (1) from Intermediate (Int-1-20-4).

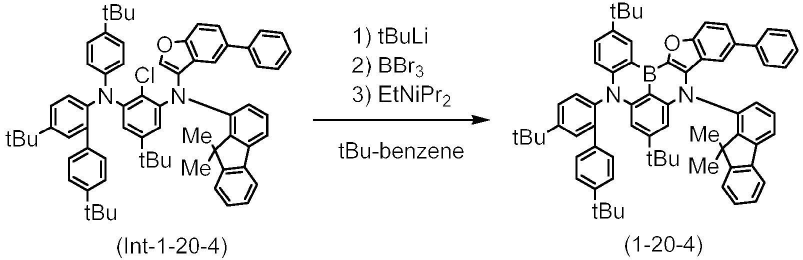

The target product of m/z(M+H) =953.56 was confirmed by APCI-MS.

### Synthesis Example (38): Synthesis of Compound (1-20-7)

Compound (1-20-7) was obtained by the same procedure as in Synthesis Example (1) from Intermediate (Int-1-20-7).

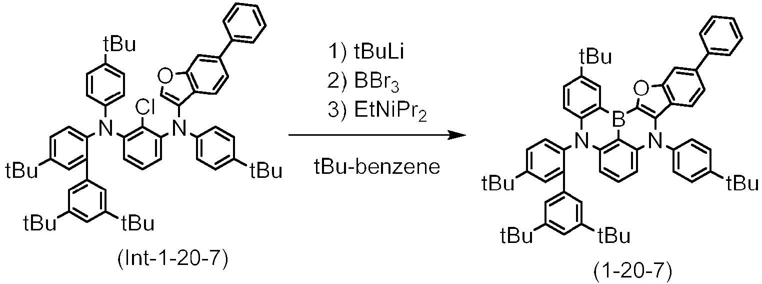

The target product of m/z(M+H) =893.56 was confirmed by APCI-MS.

### Synthesis Example (39): Synthesis of Compound (1-20-10)

Compound (1-20-10) was obtained by the same procedure as in Synthesis Example (1) from Intermediate (Int-1-20-10).

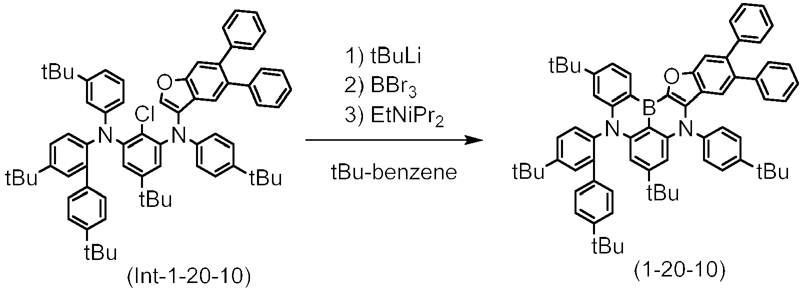

The target product of m/z(M+H) =969.59 was confirmed by APCI-MS.

### Synthesis Example (40): Synthesis of Compound (1-21-1)

Compound (1-21-1) was obtained by the same procedure as in Synthesis Example (1) from Intermediate (Int-1-21-1).

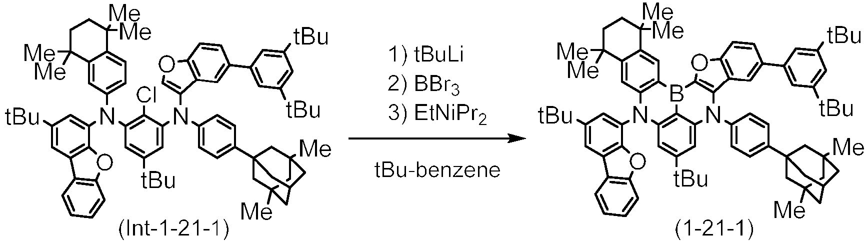

The target product of m/z(M+H) =1123.73 was confirmed by APCI-MS.

### Synthesis Example (41): Synthesis of Compound (1-21-4)

Compound (1-21-4) was obtained by the same procedure as in Synthesis Example (1) from Intermediate (Int-1-21-4).

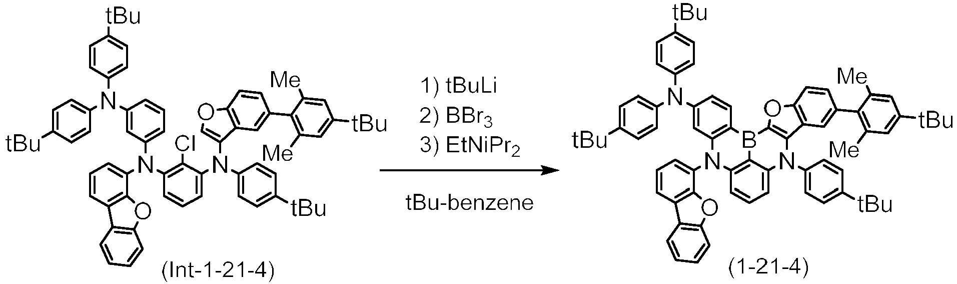

The target product of m/z(M+H) =1046.58 was confirmed by APCI-MS.

### Synthesis Example (42): Compound (1-21-12)

Compound (1-21-12) was obtained by the same procedure as in Synthesis Example (1) from Intermediate (Int-1-21-12).

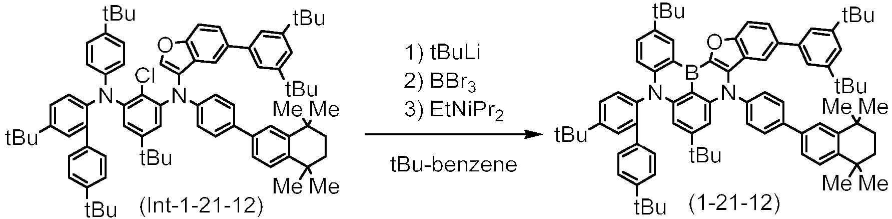

The target product of m/z(M+H) =1135.76 was confirmed by APCI-MS.

### Synthesis Example (43): Synthesis of Compound (1-21-15)

Compound (1-21-15) was obtained by the same procedure as in Synthesis Example (1) from Intermediate (Int-1-21-15).

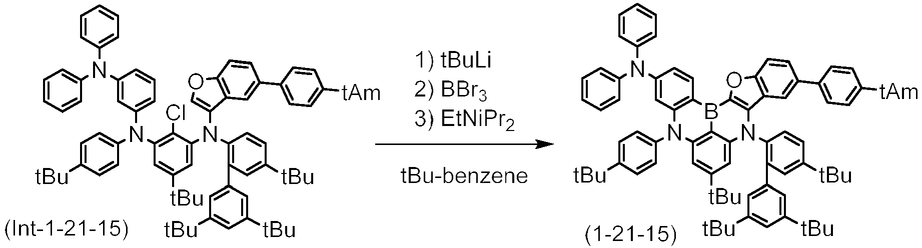

The target product of m/z(M+H) =1130.71 was confirmed by APCI-MS.

### Synthesis Example (44): Synthesis of Compound (1-21-23)

Compound (1-21-23) was obtained by the same procedure as in Synthesis Example (1) from Intermediate (Int-1-21-23).

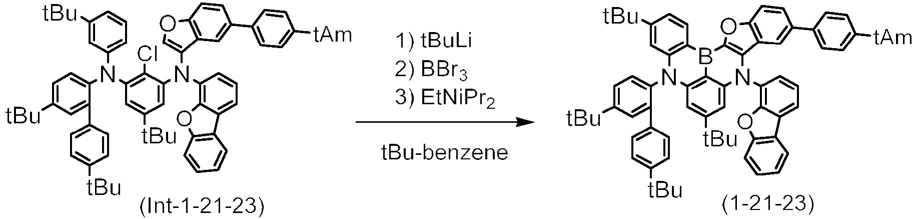

The target product of m/z(M+H) =997.58 was confirmed by APCI-MS.

### Synthesis Example (45): Synthesis of Compound (1-22-1)

Compound (1-22-1) was obtained by the same procedure as in Synthesis Example (1) from Intermediate (Int-1-22-1).

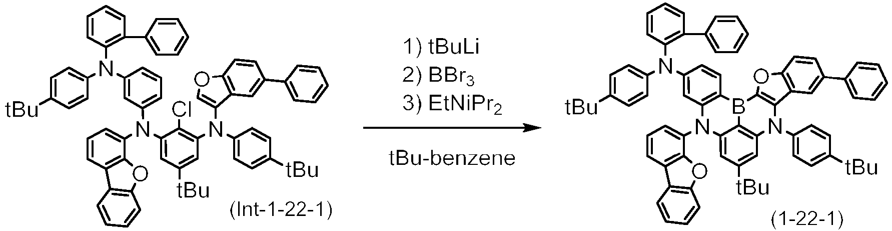

The target product of m/z(M+H) =1038.51 was confirmed by APCI-MS.

### Synthesis Example (46): Synthesis of Compound (1-22-4)

Compound (1-22-4) was obtained by the same procedure as in Synthesis Example (1) from Intermediate (Int-1-22-4).

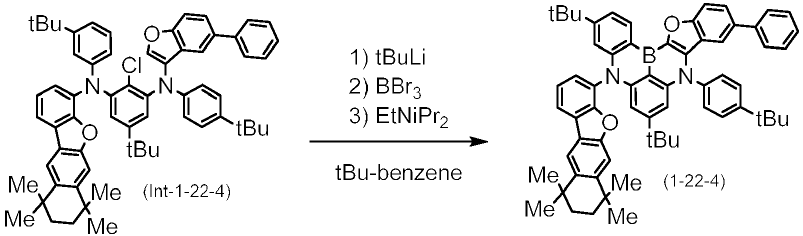

The target product of m/z(M+H) =905.52 was confirmed by APCI-MS.

### Synthesis Example (47): Synthesis of Compound (1-22-5)

Compound (1-22-5) was obtained by the same procedure as in Synthesis Example (1) from Intermediate (Int-1-22-5) except that boron trichloride (BBr₃) was changed to boron trichloride in which the boron atoms were replaced with isotopes of boron, namely ¹¹B atoms (¹¹BBr₃).

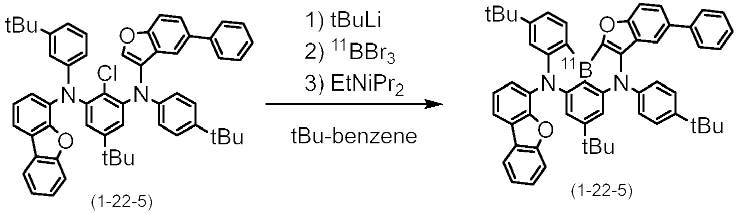

The target product of m/z(M+H) =795.41 was confirmed by APCI-MS.

### <Possibility of application to organic EL elements>

The compounds of the present invention are expected to be characterized by an appropriate energy gap (Eg), high minimum triplet excitation energy levels (ET), and small ΔEST, and therefore can be applied to light-emitting layers and charge transport layers, and are particularly expected to be applied to light-emitting layers.

### <<Production and evaluation of organic EL elements of vapor-deposited type>>

Next, the production and evaluation of organic EL elements using the polycyclic aromatic compounds of the present invention will be described.

### <Structure of Organic EL Element>

An organic EL device was manufactured using the polycyclic aromatic compounds of the present invention.

The material compositions of each layer in the organic EL elements of Examples B1 to B47 and Comparative Examples B1 to B6 are shown in Table 1 below.

**[Table 1]**

| | |
|---|---|
| Cathode 1nm/100nm | LiF/Al |
| Electron Transport Layer 2 (25nm) | ET-2+Liq |
| Electron Transport Layer 1 (5nm) | ET-1 |
| Light-Emitting Layer (25nm) | Host (97%):BH, |
| | Dopant (3%): Compounds listed in Table 2 or 3 |
| Hole Transport Layer 2 (10nm) | HT-2 |
| Hole Transport Layer 1 (45nm) | HT-1 |
| Electron Injection Layer 2 (5nm) | HAT-CN |
| Electron Injection Layer 1 (40nm) | HI |

The chemical structures of "HI," "HAT-CN," "HT-1," "HT-2," "BH," "ET-1," "ET-2," "Liq," the "Comparative Compound (1)" described in WO2022/050710, the "Comparative Compound (2)" and "Comparative Compound (4)" described in the specification of U.S. Patent Application Publication No. 2022/0310924, "Comparative Compound (3)" and "Comparative Compound (5)" described in WO 2021/107743, and "Comparative Compound (6)" described in WO2022/191570, which are in Table 1 and Table 3, are shown below.

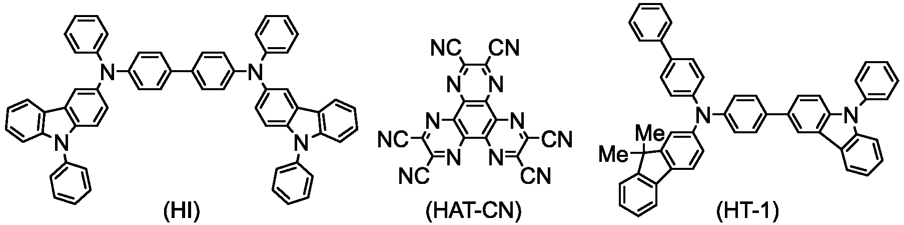

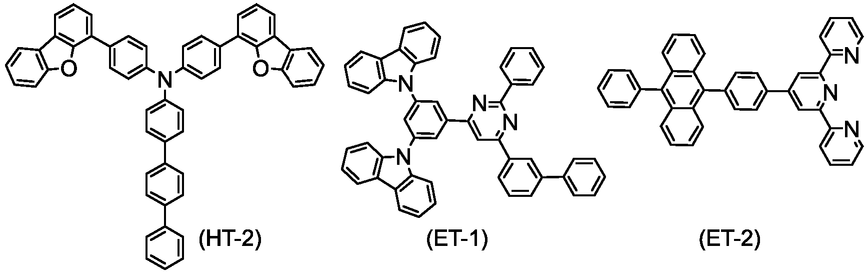

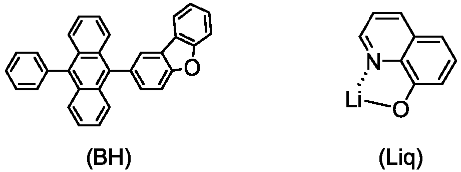

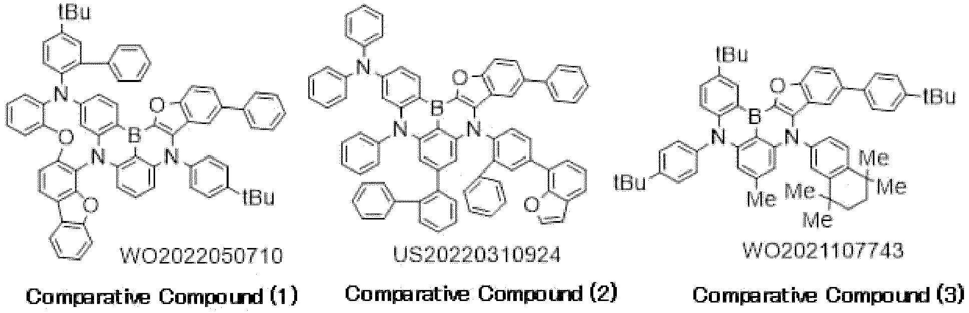

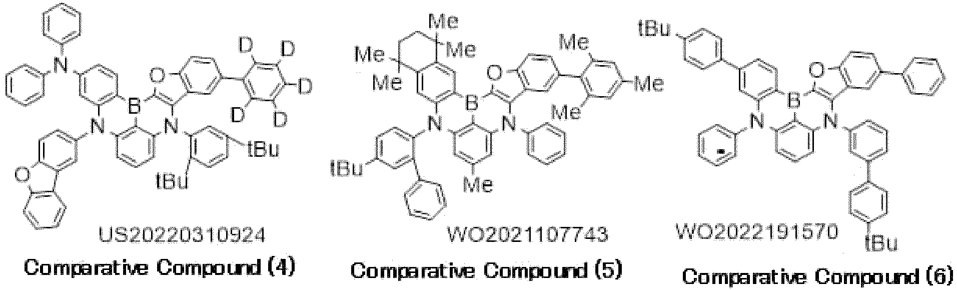

### <Element in Comparative Example B1>

A glass substrate having a size of 26 mm × 28 mm × 0.7 mm prepared by forming a film of ITO having a thickness of 180 nm by sputtering and polishing the ITO film to 150 nm (manufactured by Opto Science, Inc.) is used as a transparent supporting substrate. The transparent support substrate was fixed to a substrate holder of a commercially available deposition apparatus (manufactured by Showa Vacuum Co., Ltd.), and molybdenum deposition boats each containing HI, HAT-CN, HT-1, HT-2, BH, Comparative Compound (1), ET-1, and ET-2 respectively, and aluminum nitride deposition boat containing Liq, LiF and aluminum were mounted.

The following layers were sequentially formed on the ITO film of the transparent supporting substrate. The vacuum chamber was depressurized to 5×10⁴Pa, and deposition was performed by heating first HI to a thickness of 40 nm, then HAT-CN to a thickness of 5 nm, then HT-1 to a thickness of 45 nm, and HT-2 to a thickness of 10 nm to form a four-layered hole layer. Next, a deposition was performed by simultaneously heating BH and Comparative Compound (1) to form a light-emitting layer to a thickness of 25 nm. The deposition rate was adjusted so that the mass ratio of BH and Comparative Compound (1) was approximately 97 to 3. Further, depositions were performed by heating ET-1 to a thickness of 5 nm and then simultaneously heating ET-2 and Liq to a thickness of 25 nm to form a two-layered electron layer. The deposition rate was adjusted so that the mass ratios of ET-2 and Liq were approximately 50 to 50. The deposition rate of each of the above layers was 0.01 to 1 nm/sec. Thereafter, a deposition was performed by heating LiF at a deposition rate of 0.01 to 0.1nm/sec to a film thickness of 1nm, and then a deposition was performed by heating aluminum to a film thickness of 100 nm to form a cathode, thereby obtaining an organic EL element.

### <Examples B1 to B47 and Comparative Examples B2 to B6>

Except for using the compounds listed in Tables 2 to 3 as dopant materials instead of Comparative Compound (1), the same procedure as in Comparative Example B1 was followed to obtain the organic EL elements of Examples B1 to B47 and Comparative Examples B2 to B6.

### <Evaluation of Characteristics of Organic EL elements>

For organic EL elements of Examples B1 to B47 and Comparative Examples B1 to B6, DC voltage was applied to the ITO electrode as an anode and the LiF/Al electrode as a cathode, and the drive voltage, external quantum efficiency, and element lifetime at 1000 cd/m2 luminescence were measured. The element life was defined as the time to maintain at least 95% of the initial luminance when continuously driven at the voltage of 1000 cd/m2 luminescence. The results are shown in Tables 2 and 3.

The quantum efficiency of a light emitting element includes internal quantum efficiency and external quantum efficiency. The internal quantum efficiency represents a proportion at which external energy injected as electrons (or holes) into the luminescent layer of the light emitting element is converted into photons in a pure manner. On the other hand, the external quantum efficiency is calculated based on an amount of photons emitted to an outside of the light emitting element. The photons generated in the luminescent layer are continuously partly absorbed or reflected inside the light emitting element and are not emitted to the outside of the light emitting element, and therefore the external quantum efficiency becomes lower than the internal quantum efficiency.

A method of measuring the external quantum efficiency is as described below.
Luminescence of an element is produced by applying a voltage at which luminance of the device reached 1000 cd/m² by using a voltage/current generator R6144 made by Advantest Corporation. A spectral radiance in a visible light region was measured from a direction perpendicular to the luminescent surface by using a spectroradiometer SR-3AR made by Topcon Technohouse Corporation. A numerical value obtained by dividing a measured spectral radiance value of each wavelength component under assumption that the luminescent surface is a completely diffusing surface by wavelength energy and multiplying the resulting value with π is the number of photons at each wavelength. Next, the number of photons in the whole wavelength region observed was integrated, and the resulting value was taken as the total number of photons emitted from the device. A numerical value obtained by dividing an applied current value by an elementary charge was taken as the number of carriers injected into the device. Then, a numerical value obtained by dividing the total number of photons emitted from the device by the number of carriers injected into the device is the external quantum efficiency.

**[Table 2]**

| | Dopant | Characteristics at 1000cd/m² luminance | Element Lifetime (hrs) |
|---|---|---|---|
| | | external quantum efficiency(%) | |
| Example B1 | Compound (1-1-1) | 8.0 | 189 |
| Example B2 | Compound (1-1-3) | 7.9 | 182 |
| Example B3 | Compound (1-1-5) | 8.3 | 222 |
| Example B4 | Compound (1-1-10) | 8.0 | 218 |
| Example B5 | Compound (1-2-7) | 8.1 | 188 |
| Example B6 | Compound (1-3-4) | 7.9 | 175 |
| Example B7 | Compound (1-3-6) | 7.9 | 203 |
| Example B8 | Compound (1-3-9) | 7.8 | 198 |
| Example B9 | Compound (1-3-10) | 8.2 | 204 |
| Example B10 | Compound (1-4-2) | 8.0 | 215 |
| Example B11 | Compound (1-4-5) | 7.6 | 231 |
| Example B12 | Compound (1-5-8) | 8.1 | 199 |
| Example B13 | Compound (1-6-2) | 7.9 | 185 |
| Example B14 | Compound (1-6-6) | 8.3 | 193 |
| Example B15 | Compound (1-6-10) | 8.0 | 202 |
| Example B16 | Compound (1-7-3) | 7.5 | 208 |
| Example B17 | Compound (1-8-2) | 8.2 | 193 |
| Example B18 | Compound (1-8-6) | 7.6 | 169 |
| Example B19 | Compound (1-9-2) | 8.3 | 177 |
| Example B20 | Compound (1-9-5) | 7.8 | 195 |
| Example B21 | Compound (1-9-9) | 8.2 | 193 |
| Example B22 | Compound (1-11-8) | 7.9 | 228 |
| Example B23 | Compound (1-15-2) | 7.6 | 239 |
| Example B24 | Compound (1-15-9) | 7.5 | 199 |
| Example B25 | Compound (1-16-6) | 7.9 | 292 |
| Example B26 | Compound (1-16-8) | 7.5 | 186 |
| Example B27 | Compound (1-17-1) | 8.3 | 303 |
| Example B28 | Compound (1-17-3) | 8.3 | 305 |
| Example B29 | Compound (1-17-5) | 8.4 | 298 |
| Example B30 | Compound (1-17-10) | 8.2 | 210 |
| Example B31 | Compound (1-19-1) | 7.9 | 231 |
| Example B32 | Compound (1-19-3) | 8.0 | 245 |
| Example B33 | Compound (1-19-8) | 7.6 | 203 |
| Example B34 | Compound (1-20-1) | 8.2 | 222 |
| Example B35 | Compound (1-20-2) | 7.6 | 243 |
| Example B36 | Compound (1-20-3) | 7.9 | 196 |
| Example B37 | Compound (1-20-4) | 8.0 | 177 |
| Example B38 | Compound (1-20-7) | 8.1 | 310 |
| Example B39 | Compound (1-20-10) | 8.9 | 188 |
| Example B40 | Compound (1-21-1) | 8.4 | 169 |
| Example B41 | Compound (1-21-4) | 8.3 | 177 |
| Example B42 | Compound (1-21-12) | 8.1 | 188 |
| Example B43 | Compound (1-21-15) | 8.2 | 175 |
| Example B44 | Compound (1-21-23) | 8.5 | 305 |
| Example B45 | Compound (1-22-1) | 8.6 | 315 |
| Example B46 | Compound (1-22-4) | 8.2 | 300 |
| Example B47 | Compound (1-22-5) | 8.5 | 369 |

**[Table 3]**

| | Dopant | Characteristics at 1000cd/m² luminance | Element Lifetime (hrs) |
|---|---|---|---|
| | | external quantum efficiency(%) | |
| Comparative Example B1 | Comparative Compond(1) | 6.3 | 112 |
| Comparative Example B2 | Comparative Compond(2) | 6.1 | 99 |
| Comparative Example B3 | Comparative Compond(3) | 5.9 | 120 |
| Comparative Example B4 | Comparative Compond(4) | 6.4 | 103 |
| Comparative Example B5 | Comparative Compond(5) | 6.5 | 109 |
| Comparative Example B6 | Comparative Compond(6) | 6.9 | 111 |

### Industrial Applicability

The polycyclic aromatic compound of the present invention is useful as a material for an organic device, especially as a material for a light-emitting layer for forming a light-emitting layer in an organic electroluminescent element. By using the polycyclic aromatic compounds of the present invention as dopants for the light-emitting layer, an organic electroluminescent element with long lifetime, low driving voltage, and high light-emitting efficiency, particularly lifetime and high light-emitting efficiency, can be obtained.

### Reference Signs List

- 100: Organic Electroluminescent Element
- 101: Substrate
- 102: Anode
- 103: Hole Injection Layer
- 104: Hole Transport Layer
- 105: Light-Emitting Layer
- 106: Electron Transport Layer
- 107: Electron Injection Layer
- 108: Cathode

## Claims

1. A polycyclic aromatic compound having a structure consisting of one or two or more structural units represented by Formula (1); 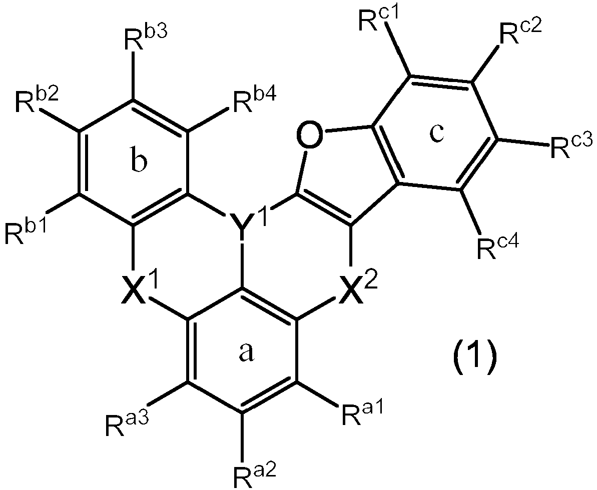 in Formula (1),
R^{a1} to R^{a3}, R^{b1} to R^{b4}, and R^{c1} to R^{c4} are each independently hydrogen or a substituent,
any two adjacent groups of R^{a1} to R^{a3}, R^{b1} to R^{b4}, and R^{c1} to R^{c4} may be bonded to each other to form a substituted or unsubstituted aryl ring or a substituted or unsubstituted heteroaryl ring together with the two carbon atoms to which they are bonded,
provided that at least one of R^{c1} to R^{c4} is a substituted or unsubstituted aryl or a substituted or unsubstituted heteroaryl,
Y¹ is B, P, P=O, P=S, Al, Ga, As, Si-R, or Ge-R, and R in the Si-R and the Ge-R is a substituted or unsubstituted aryl, a substituted or unsubstituted heteroaryl, a substituted or unsubstituted alkyl, or a substituted or unsubstituted cycloalkyl;
X¹ and X² are each independently >O, >N-R^{NX}, >C(-R^{CX})₂, >Si(-R^{IX})₂, >S, or >Se, R^{NX} is hydrogen, a substituted or unsubstituted aryl, a substituted or unsubstituted heteroaryl, a substituted or unsubstituted alkyl, or a substituted or unsubstituted cycloalkyl, R^{CX} are each independently hydrogen, a substituted or unsubstituted aryl, a substituted or unsubstituted heteroaryl, a substituted or unsubstituted alkyl, or a substituted or unsubstituted cycloalkyl, the two R^{CX} may form a ring by bonding to each other, R^{IX} are each independently hydrogen, a substituted or unsubstituted aryl, a substituted or unsubstituted heteroaryl, a substituted or unsubstituted alkyl, or a substituted or unsubstituted cycloalkyl, the two R^{IX} may form a ring by bonding to each other, and R^{NX} and/or R^{CX} may be bonded to R^{a3} and/or R^{b1}, or R^{a1} and/or R^{c4} via a linking group or single bond,
provided that at least one selected from the group consisting of X¹ and X² is >N-R^{NX} having R^{NX} that is a group represented by Formula (G-1) or Formula (G-2), 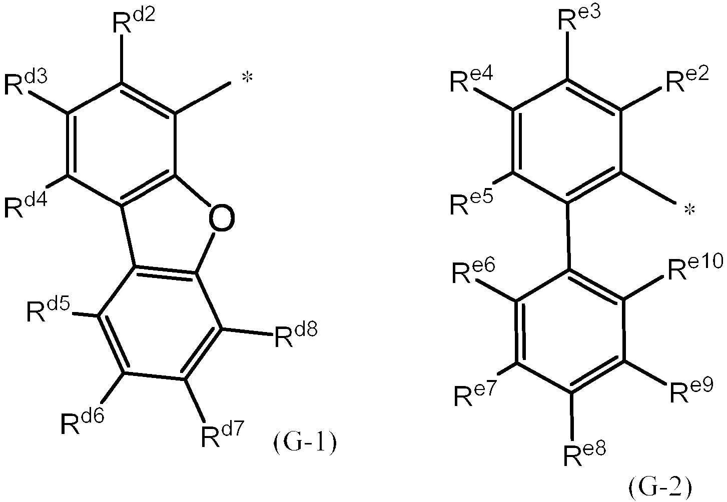
in Formula (G-1),
R^{d2} to R^{d8} are each independently hydrogen or a substituent,
any two adjacent groups of R^{d2} to R^{d8} may be bonded to each other to form a substituted or unsubstituted aryl ring or a substituted or unsubstituted heteroaryl ring together with the two carbon atoms to which they are bonded,
* indicates a bonding position with the nitrogen atom,
in Formula (G-2),
R^{e2} to R^{e10} are each independently hydrogen or a substituent,
provided that at least one selected from the group consisting of R^{e6} to R^{e10} is a substituent selected from the group consisting of an alkyl, a cycloalkyl that may be substituted with at least one alkyl, and an aryl that may be substituted with at least one alkyl or an optionally alkyl-substituted cycloalkyl, or at least one of the aryl rings or heteroaryl rings in Formula (G-2) is condensed with at least one cycloalkane, at least one hydrogen in the cycloalkane may be replaced with a substituent, and at least one -CH₂- in the cycloalkane may be replaced with -O-,
* indicates a bonding position with the nitrogen atom,
at least one of the aryl rings or heteroaryl rings in said structure may be condensed with at least one cycloalkane, at least one hydrogen in the cycloalkane may be replaced with a substituent, and at least one -CH₂- in the cycloalkane may be replaced with -O-,
in said structure, at least one hydrogen may be replaced with deuterium, at least one nitrogen may be replaced with nitrogen-15 (¹⁵N), at least one sulfur may be replaced with sulfur-33 (³³S), sulfur-34 (³⁴S), or sulfur-36 (³⁶S), at least one oxygen may be replaced with oxygen-17 (¹⁷O) or oxygen-18 (¹⁸O), at least one carbon may be replaced with carbon-13 (¹³C), and at least one boron may be replaced with boron-11 (¹¹B).

2. The polycyclic aromatic compound according to claim 1, wherein any aryl ring or heteroaryl ring in R^{c1} to R^{c4} is not condensed with the cycloalkane.

3. The polycyclic aromatic compound according to claim 1, wherein R^{c3} is an aryl that may be substituted with an alkyl, and each of R^{c1}, R^{c2}, and R^{c4} is hydrogen.

4. The polycyclic aromatic compound according to claim 3, wherein R^{c3} is phenyl that may be substituted with t-butyl.

5. The polycyclic aromatic compound according to claim 1 having a structure consisting of one structural unit represented by Formula (1), wherein
Y¹ is B,
R^{a1}, R^{a3}, R^{b1}, R^{b4}, R^{c1}, and R^{c4} are each hydrogen,
R^{a2} is hydrogen, an unsubstituted alkyl, a cycloalkyl which may be substituted with methyl, an aryl which may be substituted with an alkyl or a cycloalkyl that may be substituted with methyl, a heteroaryl which may be substituted with an alkyl or a cycloalkyl that may be substituted with methyl, a diarylamino which may be substituted with an alkyl or a cycloalkyl that may be substituted with methyl, an arylheteroarylamino which may be substituted with an alkyl or a cycloalkyl that may be substituted with methyl, or a carbazolyl which may be substituted with an alkyl or a cycloalkyl that may be substituted with methyl,
R^{b2} and R^{b3} are each independently hydrogen, an unsubstituted alkyl, a cycloalkyl which may be substituted with methyl, an aryl which may be substituted with an alkyl or a cycloalkyl that may be substituted with methyl, a heteroaryl which may be substituted with an alkyl or a cycloalkyl that may be substituted with methyl, a diarylamino which may be substituted with an alkyl or a cycloalkyl that may be substituted with methyl, an arylheteroarylamino which may be substituted with an alkyl or a cycloalkyl that may be substituted with methyl, or a carbazolyl which may be substituted with an alkyl or a cycloalkyl that may be substituted with methyl,
one of R^{c2} and R^{c3} is an aryl which may be substituted with an alkyl, and the other is hydrogen or an aryl which may be substituted with an alkyl,
X¹ and X² are each independently >N-R^{NX},
R^{NX} that is not a group represented by Formula (G-1) or Formula (G-2), if present, is an aryl which may be substituted with an alkyl or a cycloalkyl that may be substituted with an alkyl (excluding a group represented by Formula (G-2)), or a heteroaryl which may be substituted with an alkyl or a cycloalkyl that may be substituted with an alkyl (excluding a group represented by Formula (G-1)),
in Formula (G-1),
R^{d2} to R^{d8} are each independently hydrogen, an unsubstituted alkyl, a cycloalkyl which may be substituted with methyl, an aryl which may be substituted with an alkyl or a cycloalkyl that may be substituted with methyl, or a heteroaryl which may be substituted with an alkyl or a cycloalkyl that may be substituted with methyl,
any two adjacent groups of R^{d2} to R^{d8} may be bonded to each other to form benzene ring together with the two carbon atoms to which they are bonded, the benzene ring may be substituted with an unsubstituted alkyl, a cycloalkyl which may be substituted with methyl, an aryl which may be substituted with an alkyl or a cycloalkyl that may be substituted with methyl, or a heteroaryl which may be substituted with an alkyl or a cycloalkyl that may be substituted with methyl,
in Formula (G-2),
at least one selected from the group consisting of R^{e6} to R^{e10} is an unsubstituted alkyl, a cycloalkyl which may be substituted with methyl, or an aryl which may be substituted with an alkyl or a cycloalkyl that may be substituted with methyl, or any two adjacent groups of R^{e2} to R^{e10} are bonded to each other to form a partial structure represented by Formula (B-1) or Formula (B-2),
at least one of aryl rings or heteroaryl rings in Formula (1) other than c ring may have Formula (B-1) or Formula (B-2) as a substituent, 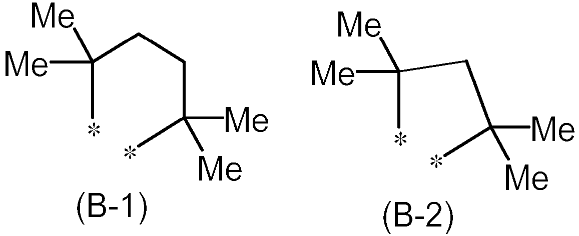
in Formula (B-1) or Formula (B-2), * indicates a position bonding to each of the adjacent ring constituting atoms,
at least one hydrogen in said structure may be replaced with deuterium.

6. The polycyclic aromatic compound according to claim 1, wherein
at least one selected from the group consisting of X¹ and X² is >N-R^{NX} having R^{NX} that is a group represented by Formula (G-1), and
said structure does not contain >N-R^{NX} having R^{NX} that is a group represented by Formula (G-2) as X¹ or X².

7. The polycyclic aromatic compound according to claim 6, which is represented by any one of the following formulas; 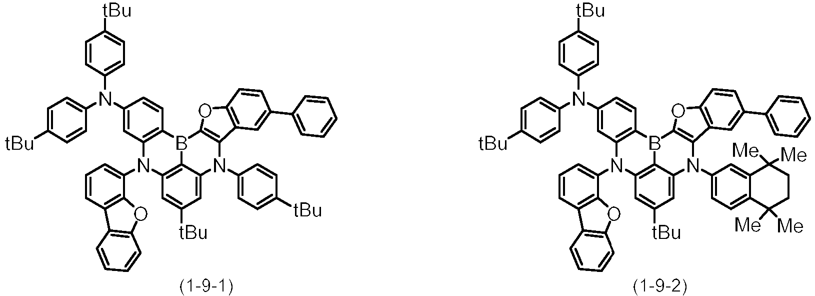 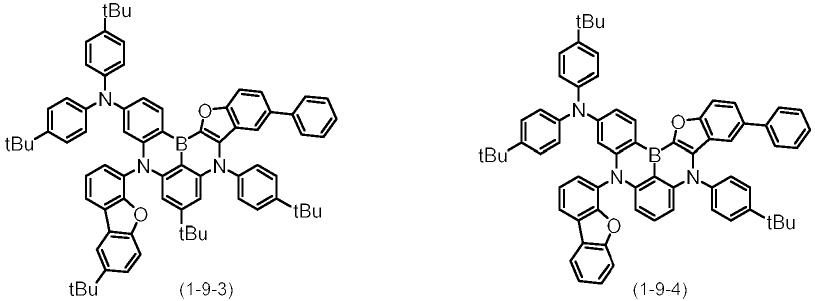 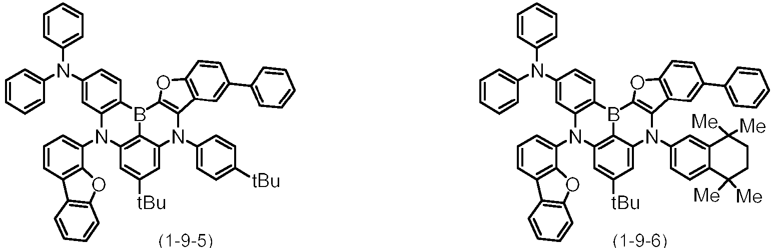 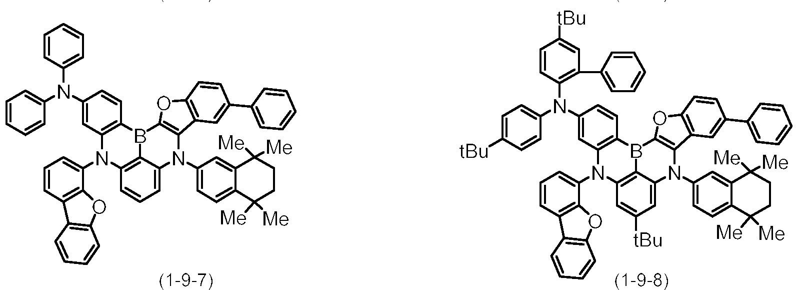 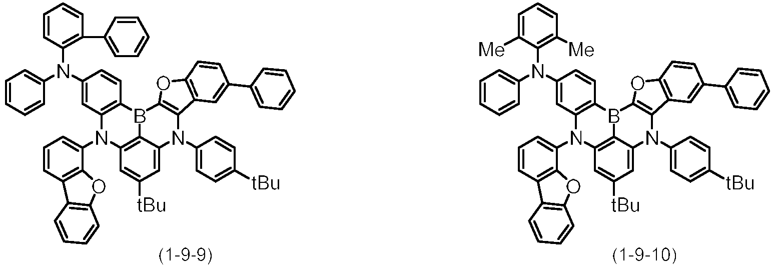 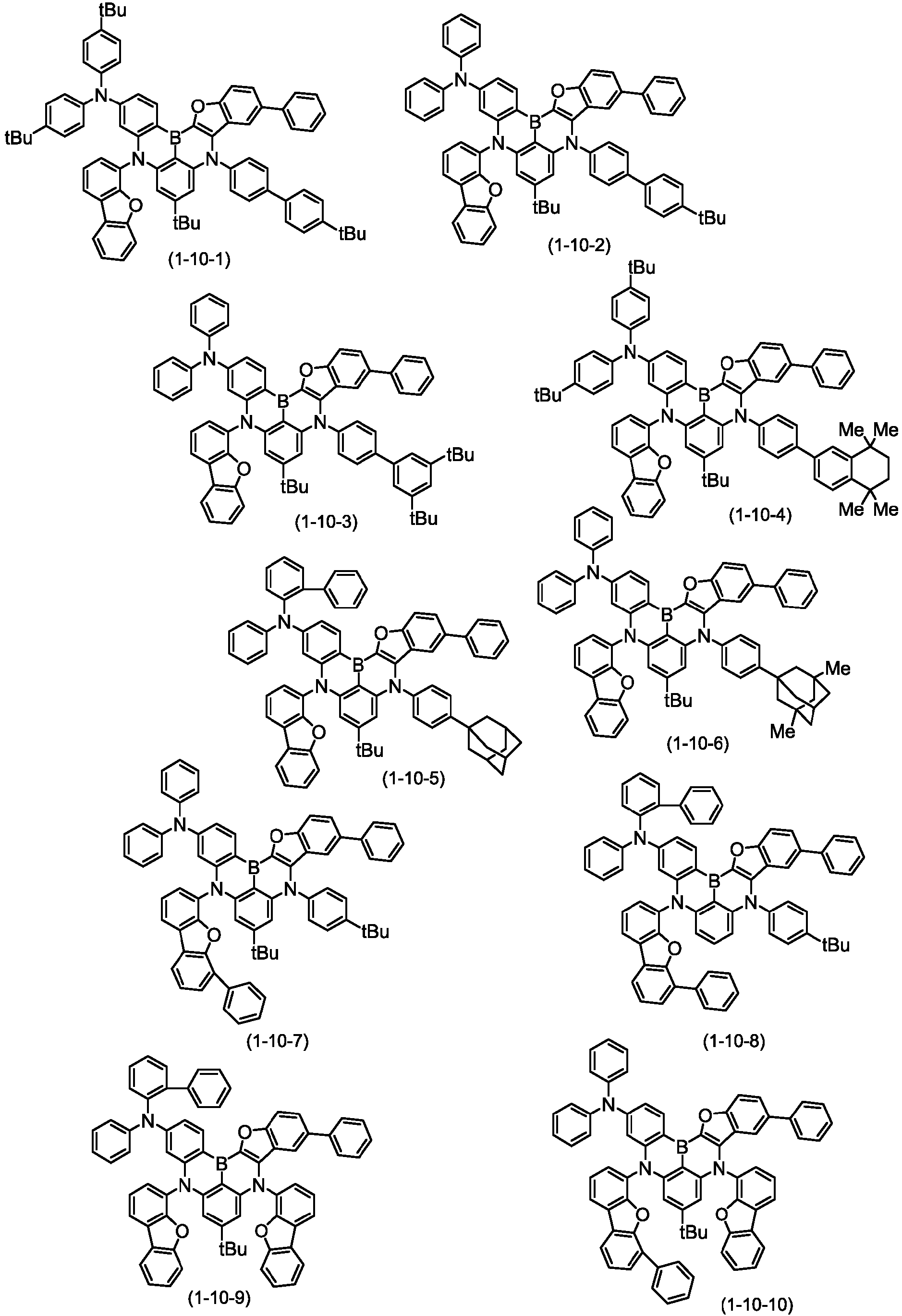 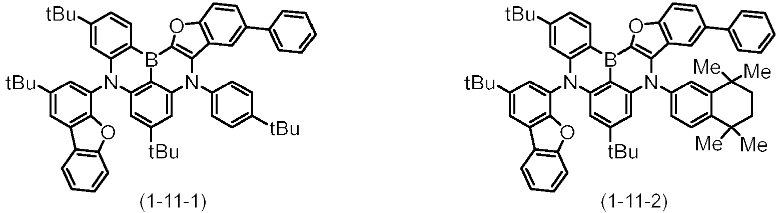 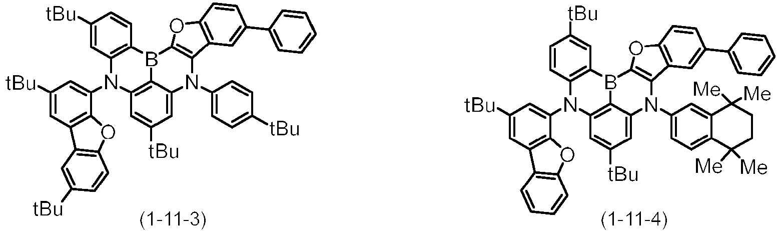 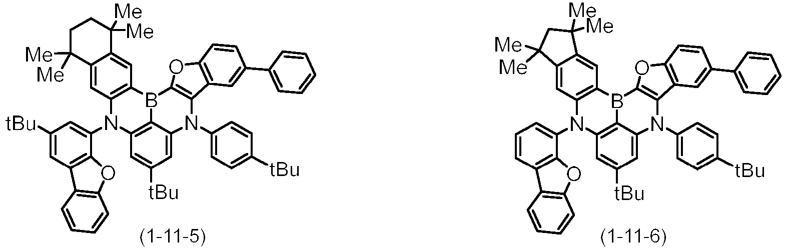 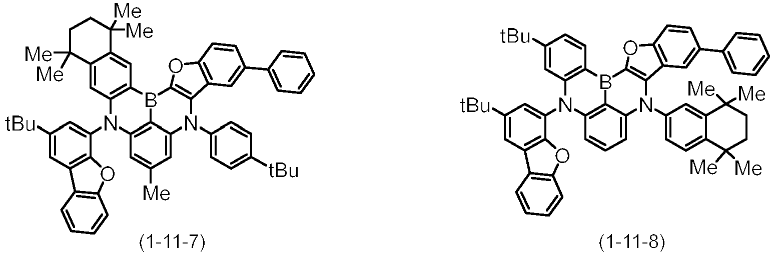 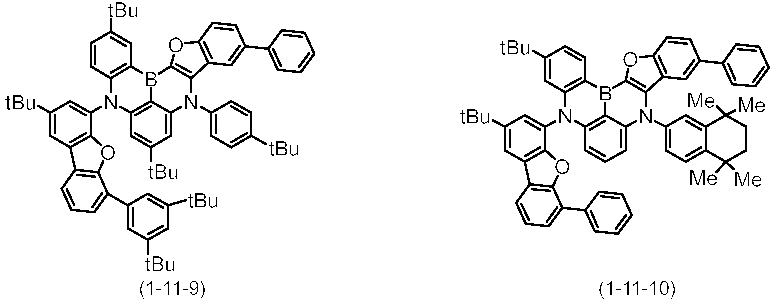 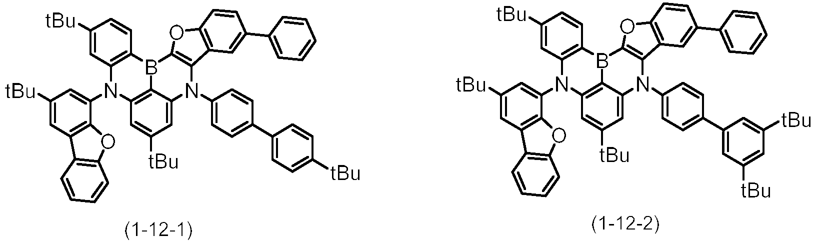 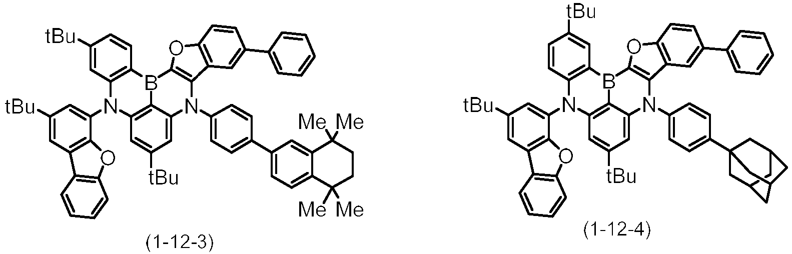 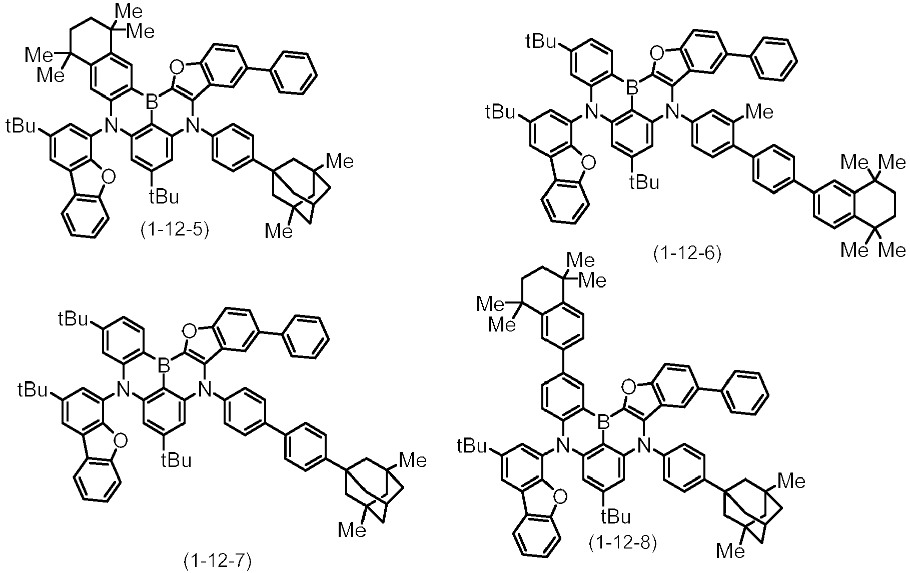 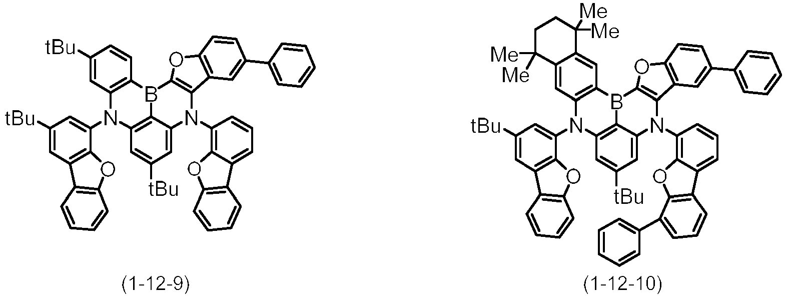 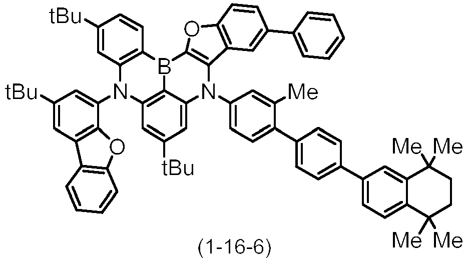 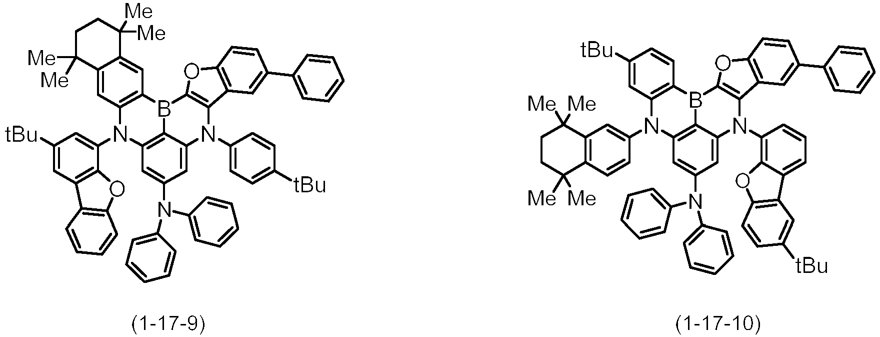 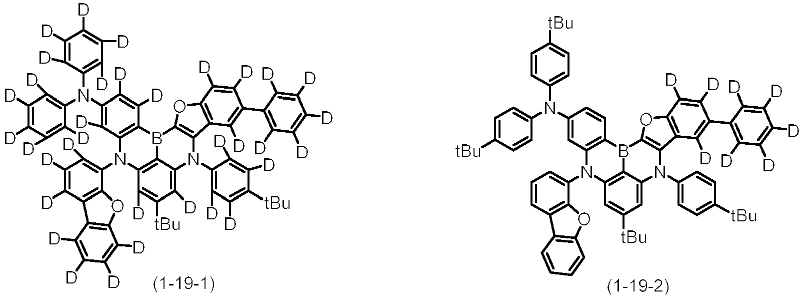 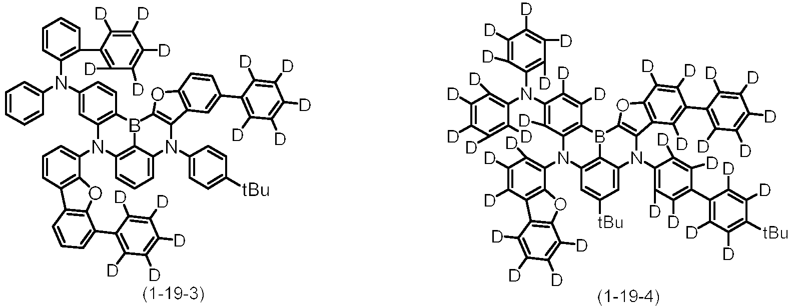 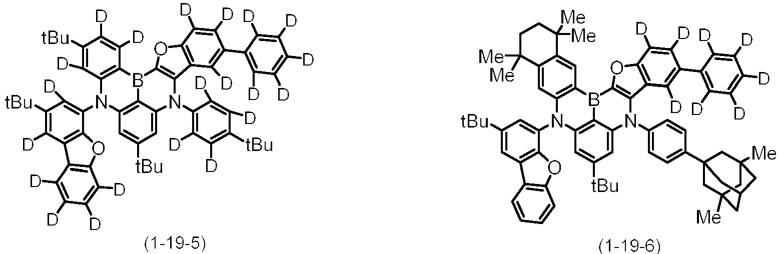 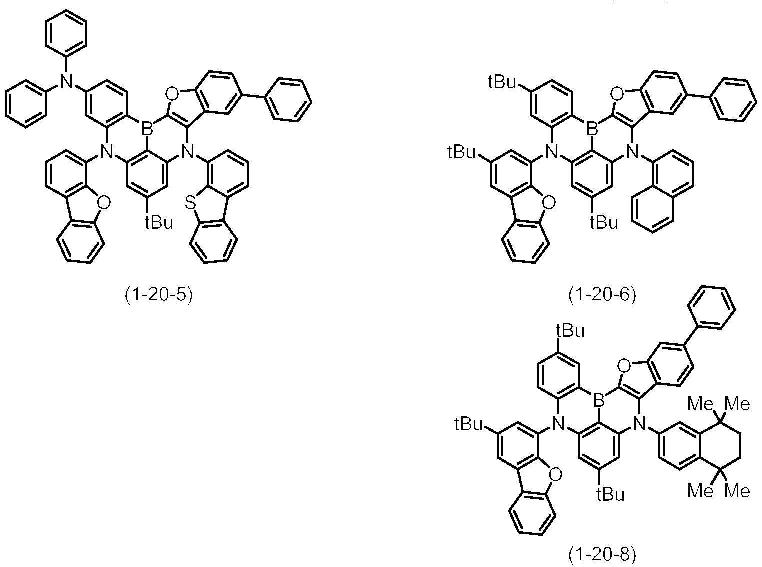 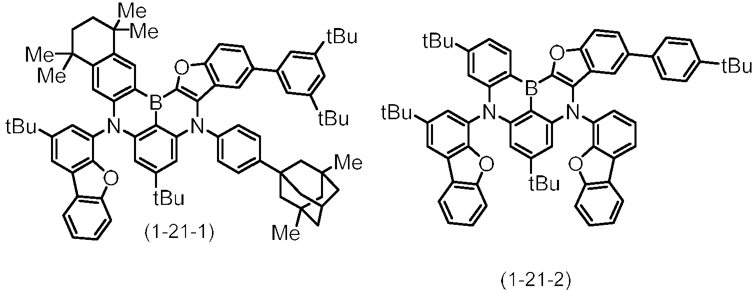 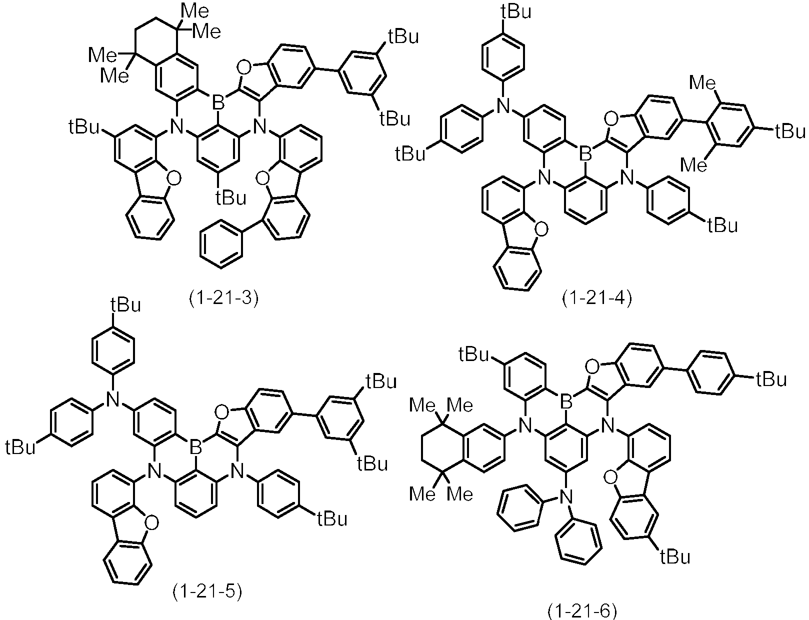 wherein Me is methyl, tBu is t-butyl, and D is deuterium.

8. The polycyclic aromatic compound according to claim 7, which is represented by Formula (1-9-2), Formula (1-9-5), Formula (1-9-9), Formula (1-11-8), Formula (1-17-10), Formula (1-19-1), Formula (1-19-3), Formula (1-21-1), or Formula (1-21-4).

9. The polycyclic aromatic compound according to claim 1, wherein
at least one selected from the group consisting of X¹ and X² is >N-R^{NX} having R^{NX} that is a group represented by Formula (G-2), and
the structure does not contain >N-R^{NX} having R^{NX} that is a group represented by Formula (G-1) as X¹ or X².

10. The polycyclic aromatic compound according to claim 9, which is represented by any one of the following formulas; 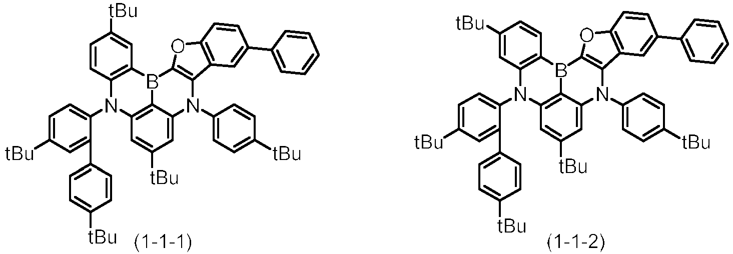 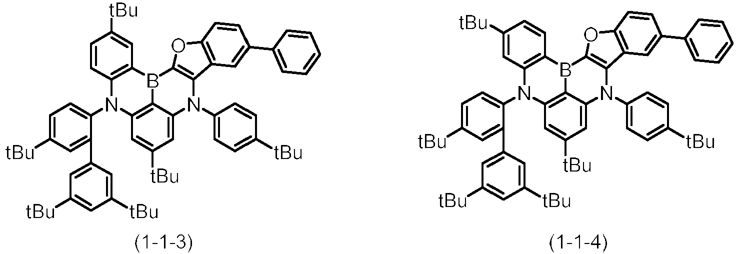 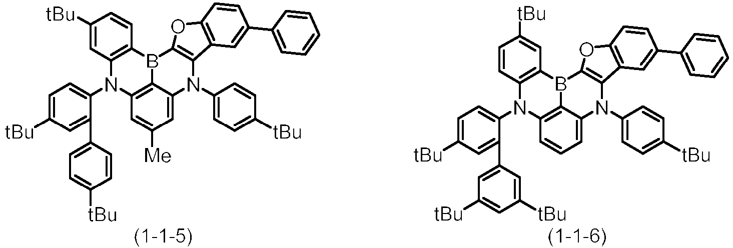 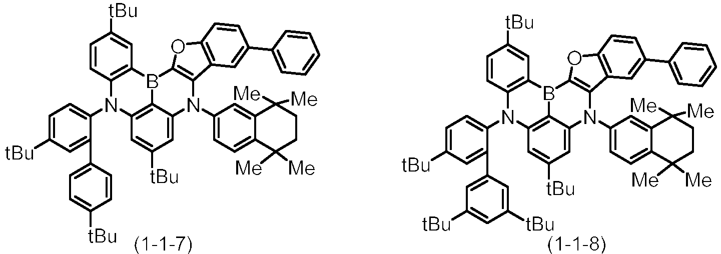 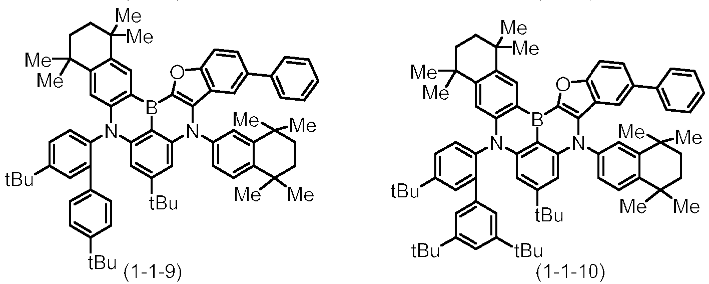 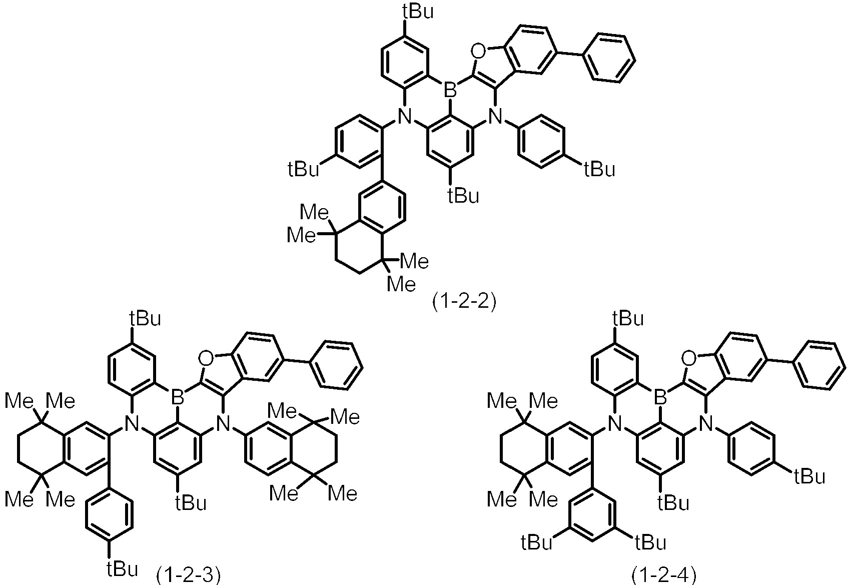 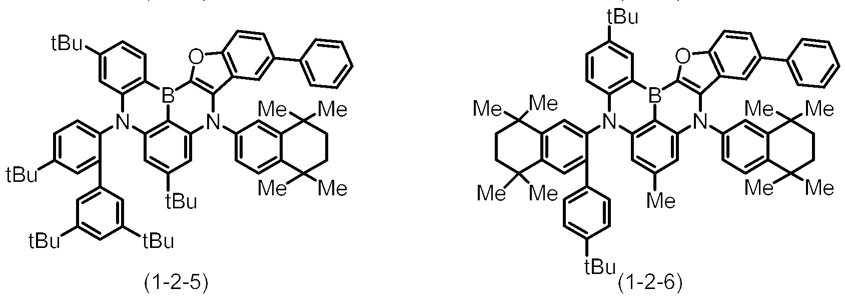 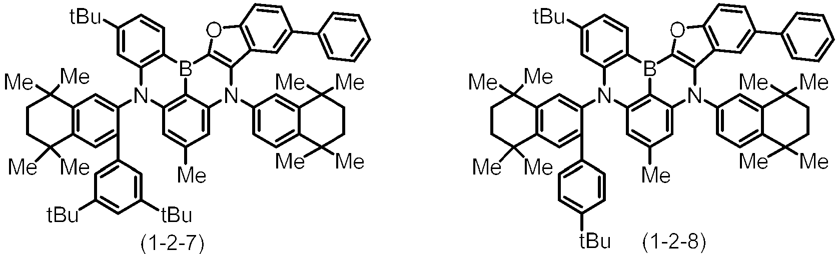 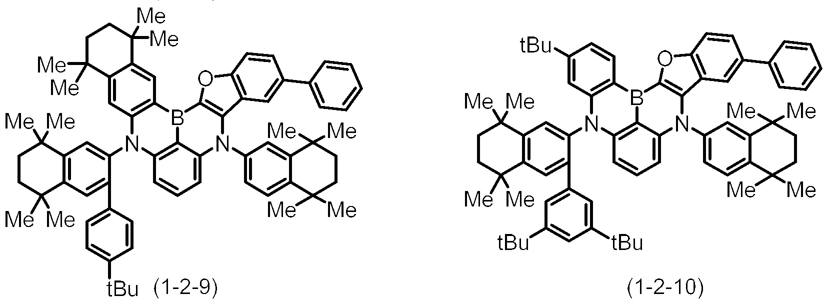 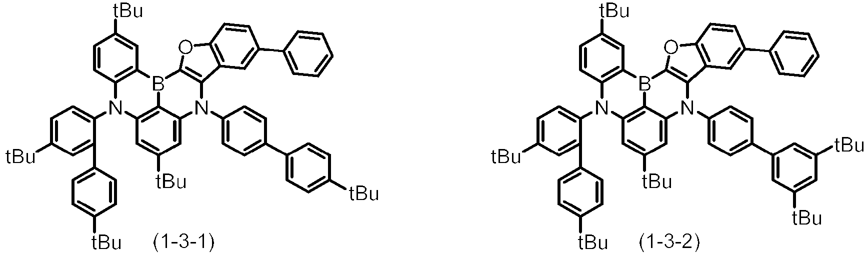 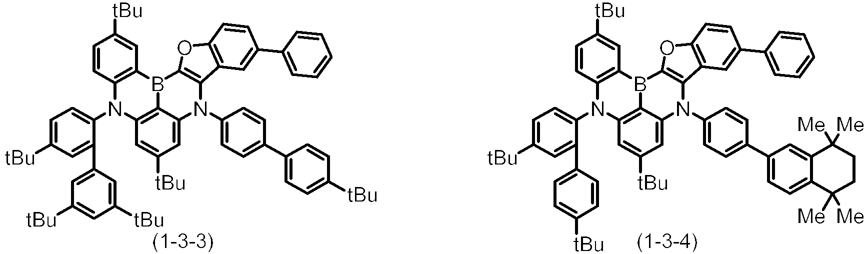 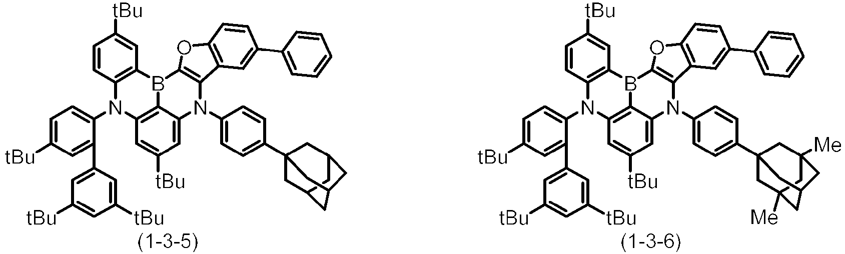 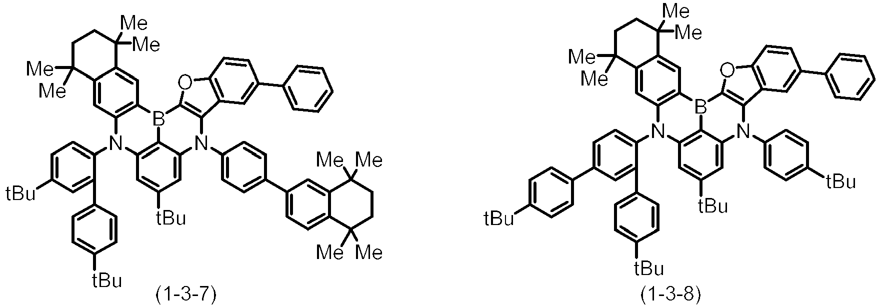 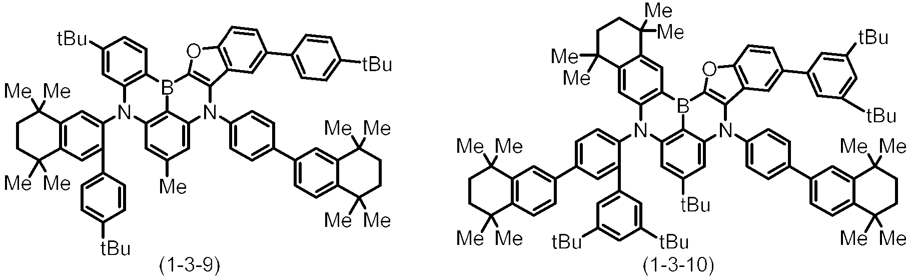 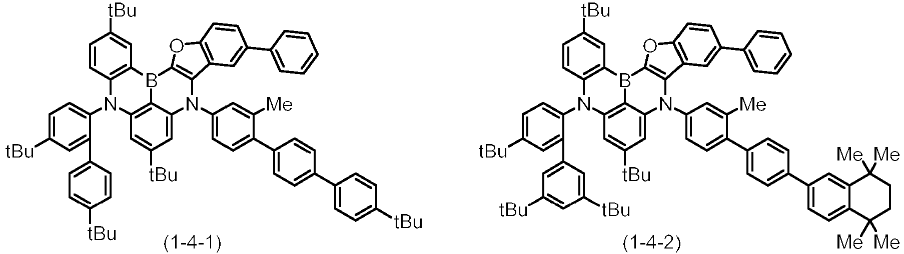 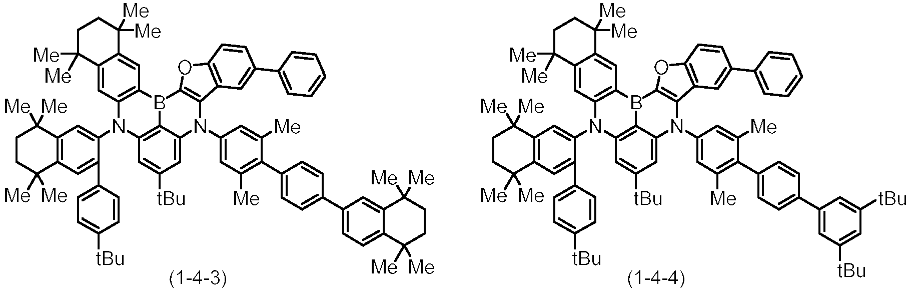 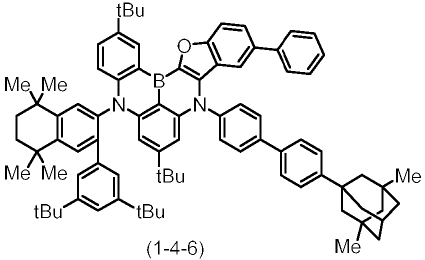 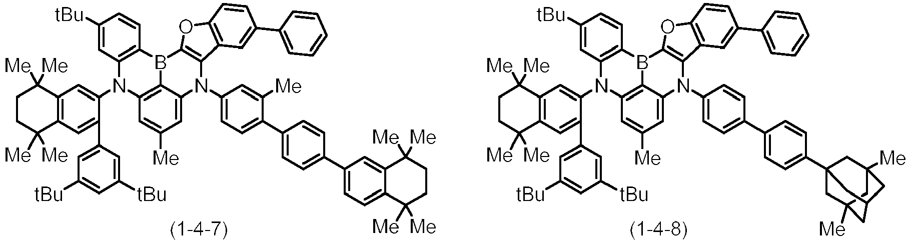 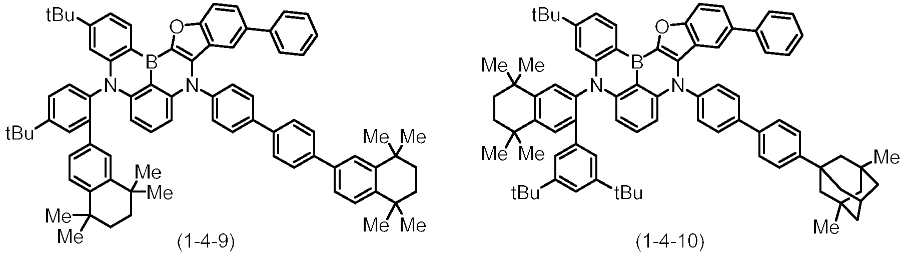 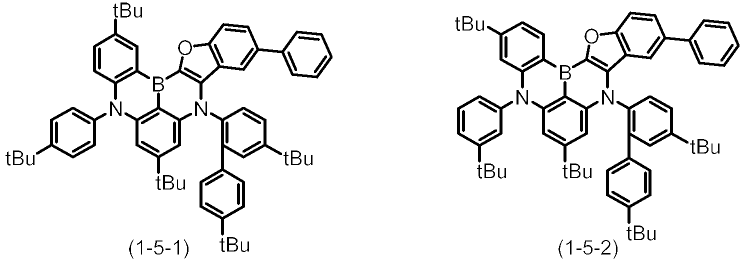 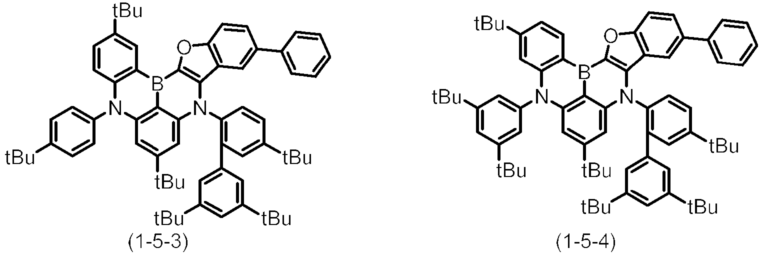 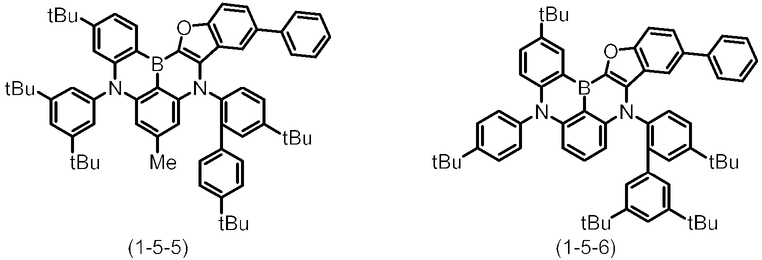 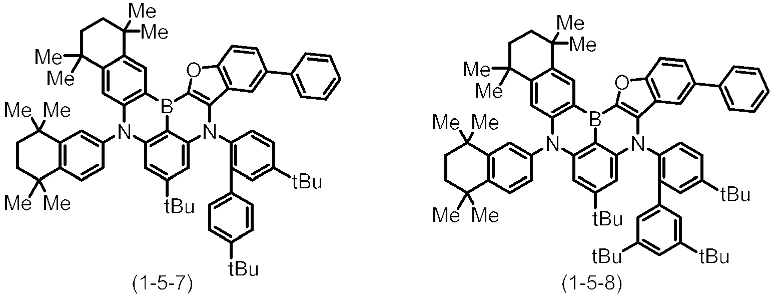 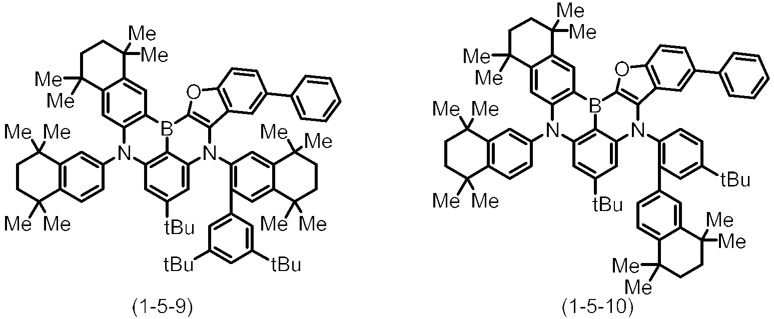 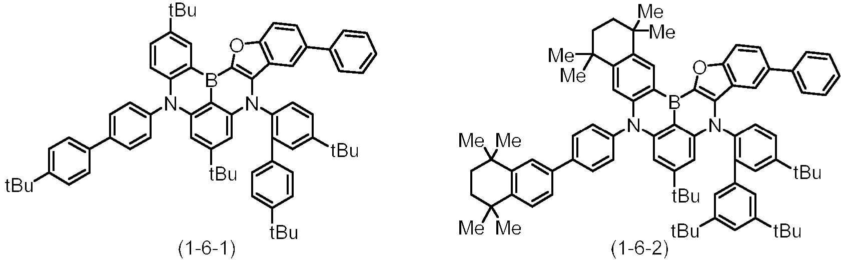 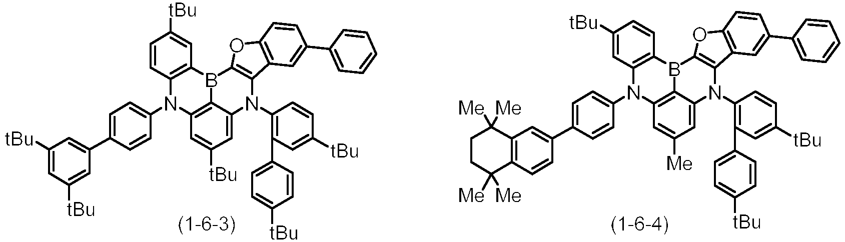 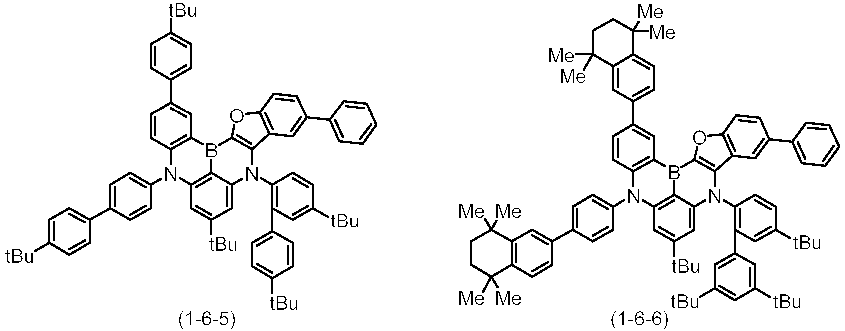 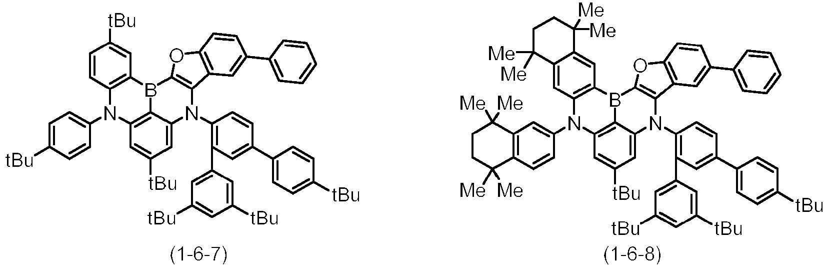 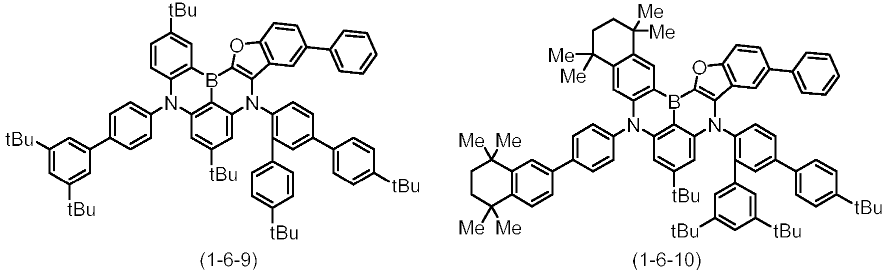 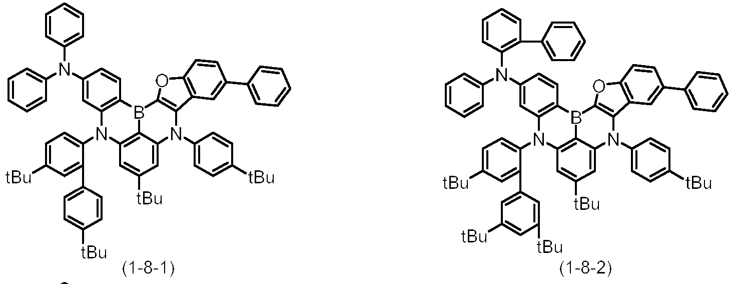 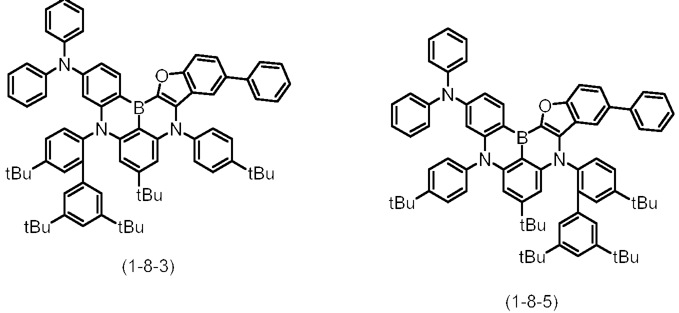 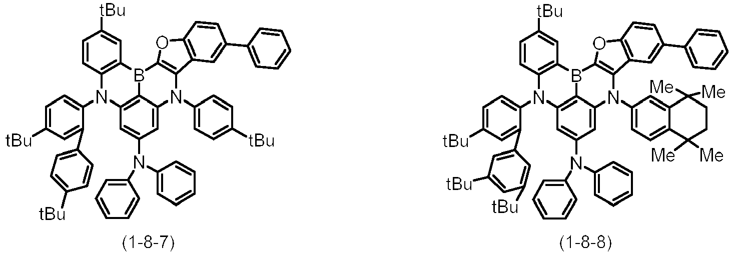 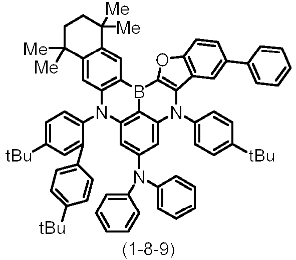 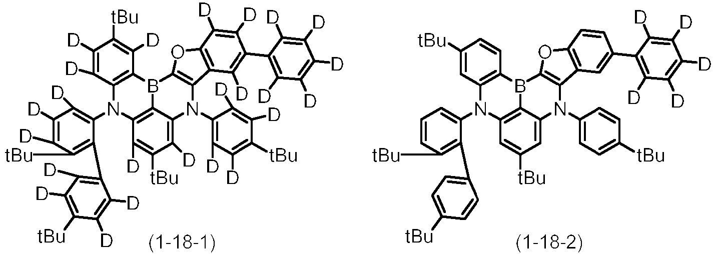 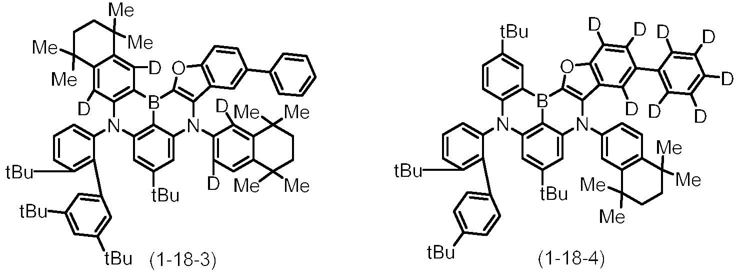 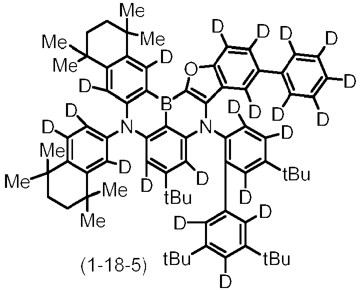 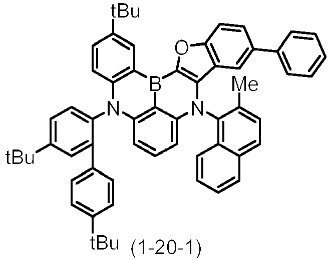 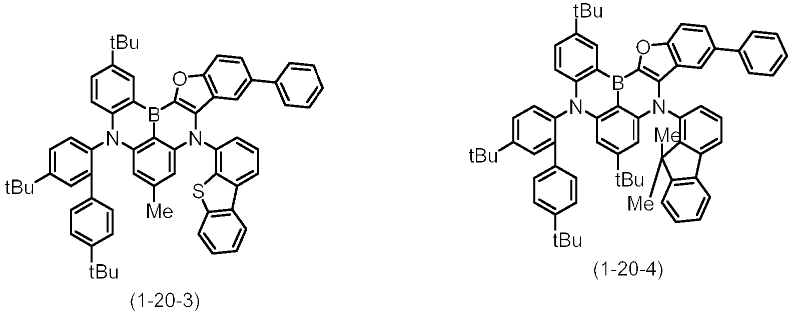 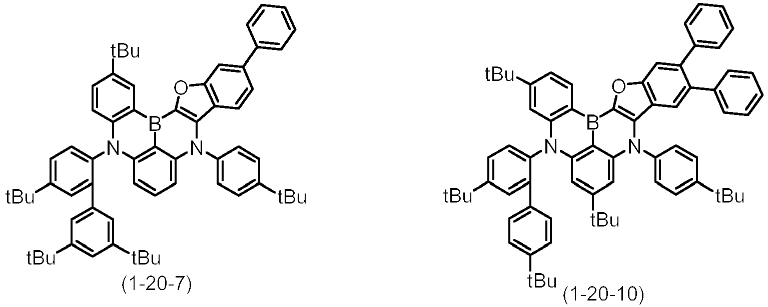 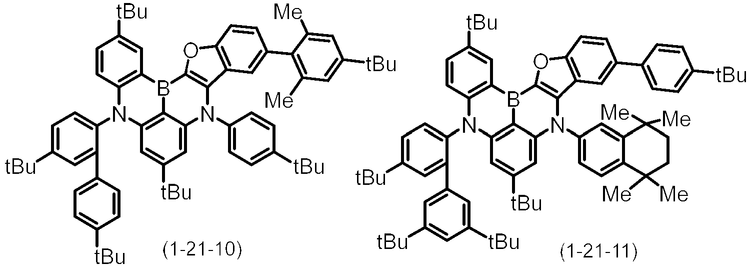 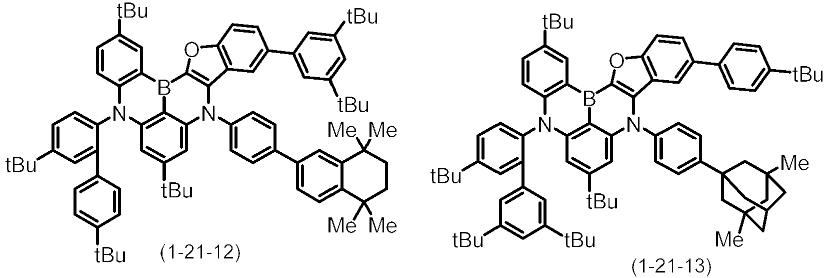 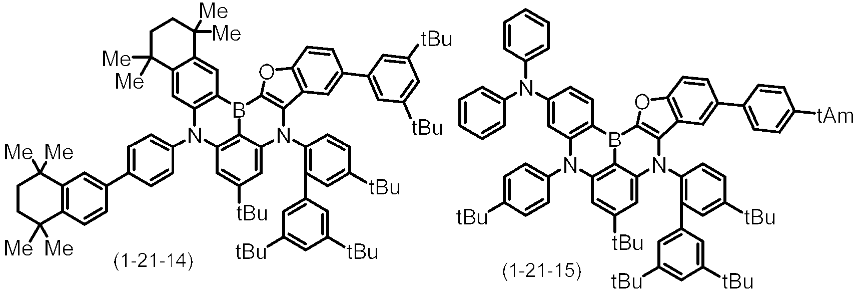 wherein Me is methyl, tBu is t-butyl, tAm is t-amyl, and D is deuterium.

11. The polycyclic aromatic compound according to claim 10, which is represented by Formula(1-1-1), Formula (1-1-3), Formula (1-1-5), Formula (1-1-10), Formula (1-2-7), Formula (1-3-4), Formula (1-3-6), Formula (1-3-9), Formula (1-3-10), Formula (1-4-2), Formula (1-5-8), Formula (1-6-2), Formula (1-6-6), Formula (1-6-10), Formula (1-8-2), Formula (1-16-6), Formula (1-20-1), Formula (1-20-3), Formula (1-20-4), Formula (1-20-7), Formula (1-20-10), Formula (1-21-12), or Formula(1-21-15).

12. The polycyclic aromatic compound according to claim 10, which is represented by Formula (1-1-1) or Formula (1-20-10).

13. The polycyclic aromatic compound according to claim 1, wherein
one of X¹ and X² is >N-R^{NX} having R^{NX} that is a group represented by Formula (G-1), and the other is >N-R^{NX} having R^{NX} that is a group represented by Formula (G-2).

14. The polycyclic aromatic compound according to claim 12, which is represented by any one of the following formulas; 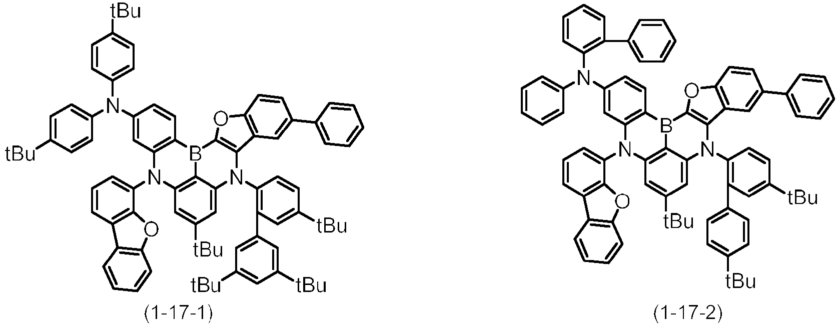 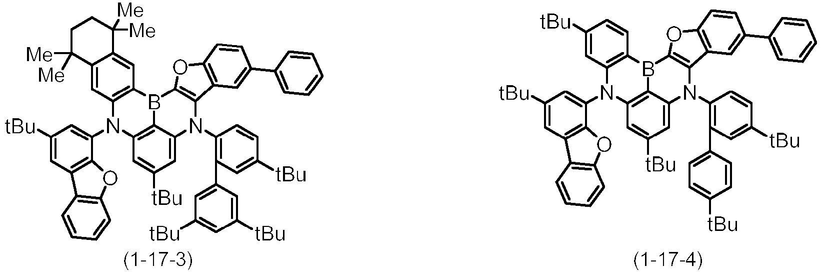 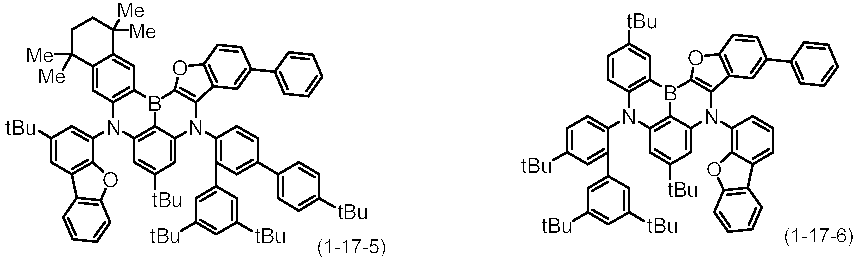 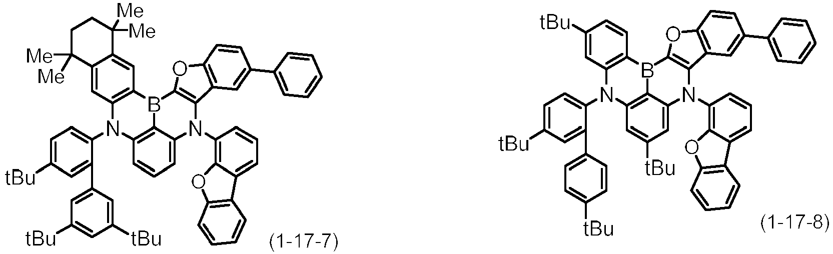 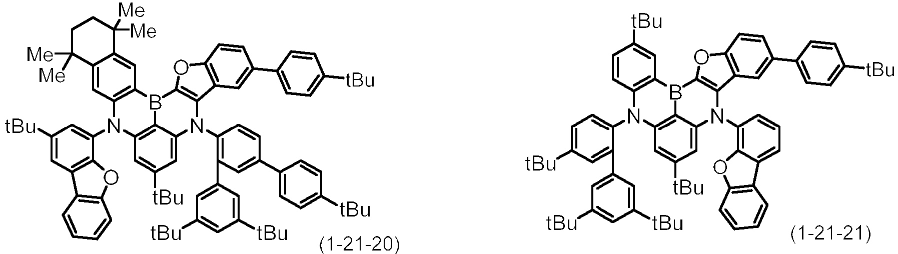 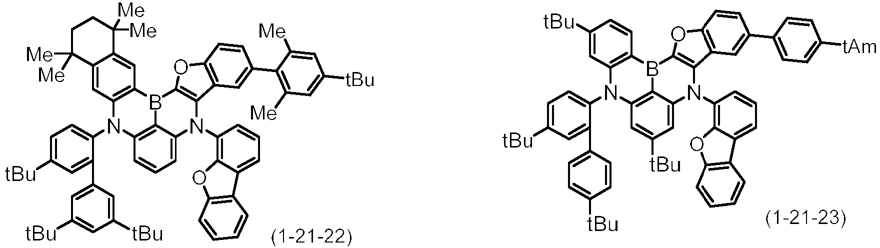 wherein Me is methyl, tBu is t-butyl, tAm is t-amyl, and D is deuterium.

15. The polycyclic aromatic compound according to claim 14, which is represented by Formula (1-17-1), Formula (1-17-3), Formula (1-17-5), or Formula (1-21-23).

16. The polycyclic aromatic compound according to claim 6, which is represented by any one of the following formulas; 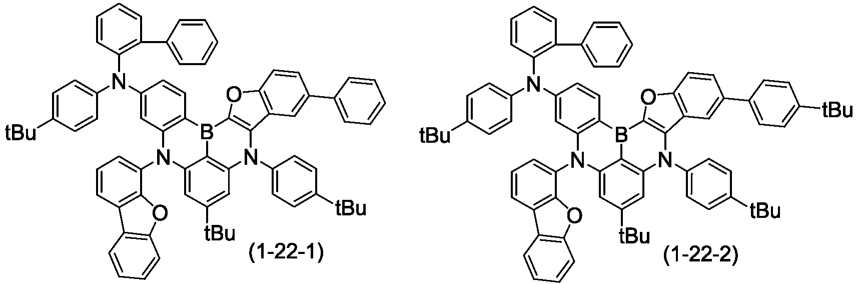 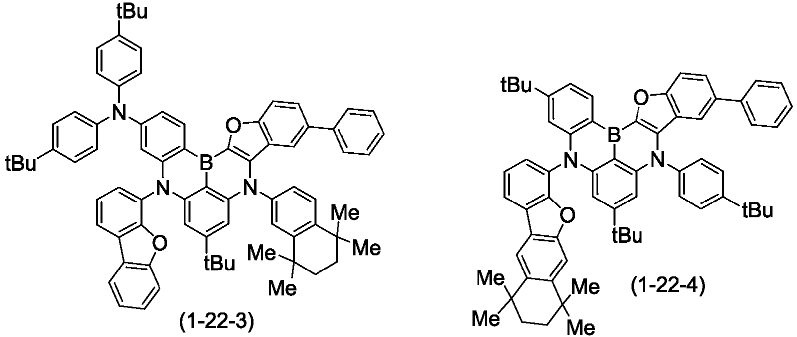 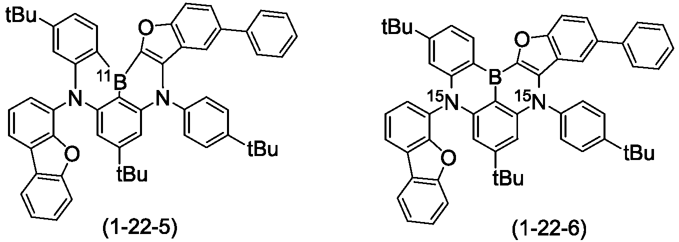 wherein Me is methyl, tBu is t-butyl.

17. The polycyclic aromatic compound according to claim 1, which is represented by any one of the following formulas; 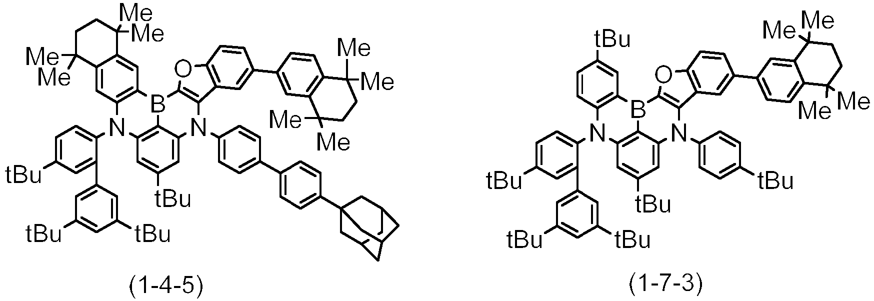 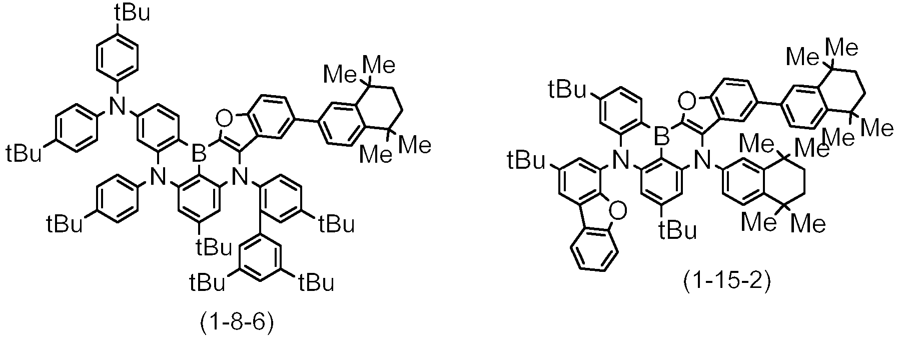 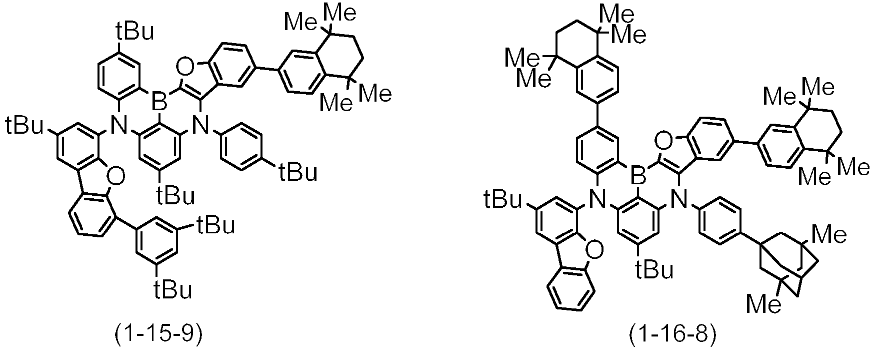 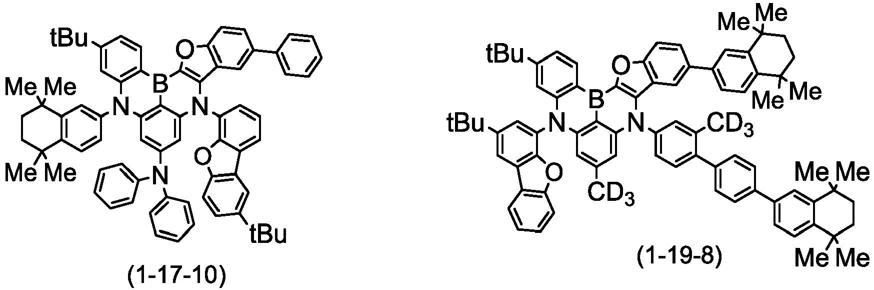 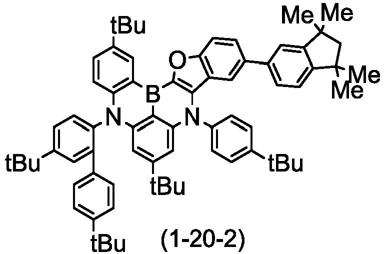 wherein Me is methyl, tBu is t-butyl, and D is deuterium.

18. A material for an organic device, which comprises the polycyclic aromatic compound according to any one of claims 1 to 17.

19. An organic electroluminescent element, which comprises a pair of electrodes comprising an anode and a cathode, and a light-emitting layer disposed between the pair of electrodes,
wherein the light-emitting layer comprises the polycyclic aromatic compound according to any one of claims 1 to 17.

20. The organic electroluminescent element according to claim 19, wherein the light-emitting layer comprises a host and the polycyclic aromatic compound as a dopant.

21. The organic electroluminescent element according to claim 20, wherein the host is an anthracene-based compound, a fluorene-based compound, or a dibenzochrysene-based compound.

22. A display device or a lighting device comprising an organic electroluminescent element according to claim 19.
